# EUROPEAN PATENT APPLICATION

(11) **EP 2 055 709 A2**
(43) Date of publication of application: **06.05.2009**
(21) Application number: 08168095.1
(22) Date of filing: 31.10.2008
(51) Int. Cl.: C07F 15/00, H01J 63/04, H05B 33/14, C09K 11/06

(54) **Novel red electroluminescent compounds and organic electroluminescent device using the same**

(30) Priority: 02.11.2007 KR 20070111327
(71) Applicant: Gracel Display Inc., Seoul 133-833 (KR)
(72) Inventor: Kim, Jin Ho 1404 Sungwon Santeview, 133-727, Seoul (KR); Eum, Sung Jin 104-805 Shinsung Misozium, 152-053, Seoul (KR); Cho, Young Jun 101-1111, Samsung Apt.,, 136-060, Seoul (KR); Kwon, Hyuck Joo 224-2001, Samsung Raemian 2 Cha Apt., 130-100, Seoul (KR); Kim, Bong Ok, 135-090, Seoul (KR); Kim, Sung Min 102-ho, Salremhouse, 157-886, Seoul-city (KR); Yoon, Seung Soo, 135-884, Seoul (KR)
(74) Representative: Kent, Venetia Katherine

(57) **Abstract**

The present invention relates to novel red phosphorescent compounds exhibiting high luminous efficiency, and organic electroluminescent devices comprising the same. The red phosphorescent compounds according to the invention are represented by Chemical Formula (1):

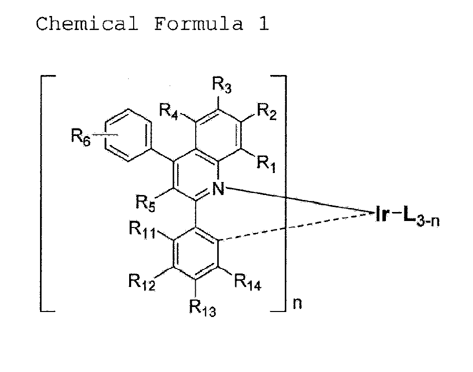

## Description

### FIELD OF THE INVENTION

The present invention relates to novel organic electroluminescent compounds exhibiting high luminous efficiency and organic electroluminescent devices using the same.

### BACKGROUND OF THE INVENTION

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Japan, Europe and America.

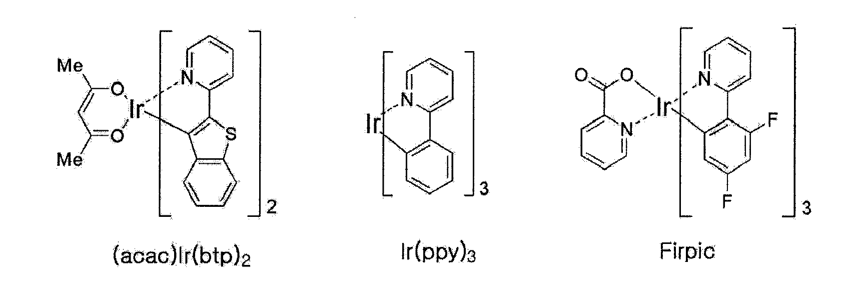

Among conventional red phosphorescent materials, several materials have been reported to have good EL (electroluminescence) properties. However, very rare materials among them have reached the level of commercialization. As the best material, an iridium complex of 1-phenyl isoquinoline may be mentioned, which is known to have excellent EL property and to exhibit color purity of dark red with high luminous efficiency. [See A. Tsuboyama et al., J. Am. Chem. Soc. 2003, 125(42), 12971-12979.]

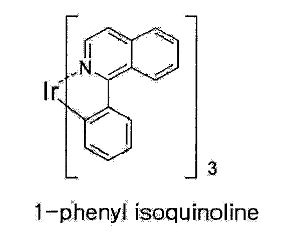

Moreover, the red materials, having no significant problem of life time, have tendency of easy commercialization if they have good color purity or luminous efficiency. Thus, the above-mentioned iridium complex is a material having very high possibility of commercialization due to its excellent color purity and luminous efficiency.

However, the iridium complex is still construed only as a material which is applicable to small displays, while higher levels of EL properties than those of known materials are practically required for an OLED panel of medium to large size.

### SUMMARY OF THE INVENTION

With intensive efforts of the present inventors to overcome the problems of conventional techniques as described above, they have researched for developing novel organic electroluminescent compounds to realize an organic EL device having excellent luminous efficiency and surprisingly improved lifetime. Thus, the object of the invention is to provide novel organic electroluminescent compounds having the skeletal to give more excellent properties as compared to those of conventional red phosphorescent materials. Another object of the invention is to provide novel organic electroluminescent compounds which are applicable to OLED panels of medium to large size. Another object of the present invention is to provide organic solar cells comprising the novel organic electroluminescent compounds.

Thus, the present invention relates to novel organic electroluminescent compounds and organic electroluminescent devices employing the same in an electroluminescent layer. Specifically, the organic electroluminescent compounds according to the invention are characterized in that they are represented by Chemical Formula (1): 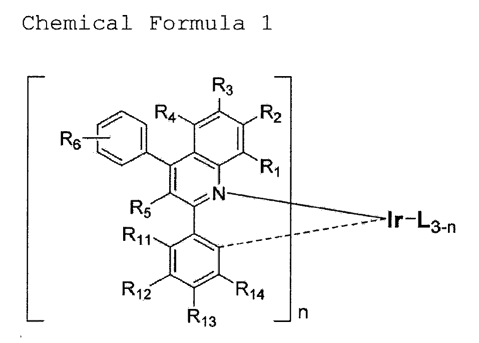 wherein, L is an organic ligand;
R₁ through R₅ independently represent hydrogen, (C₁-C₂₀)alkyl, (C₁-C₂₀)alkoxy, (C₃-C₁₂) cycloalkyl, halogen, tri(C₁-C₂₀)alkylsilyl or tri (C₆-C₂₀) arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri (C₁-C₂₀) alkylsilyl, tri (C₆-C₂₀)arylsilyl, (C₁-C₂₀) alkoxy, (C₁-C₂₀)alkylcarbonyl, (C₆-C₂₀) arylcarbonyl, di (C₁-C₂₀) alkylamino, di (C₆-C₂₀) arylamino, phenyl, naphthyl, anthryl, fluorenyl, spirobifluorenyl or 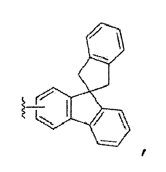 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂) alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri (C₆-C₂₀) arylsilyl, (C₁-C₂₀) alkylcarbonyl, (C₆-C₂₀) arylcarbonyl, di(C₁-C₂₀) alkylamino, di (C₆-C₂₀) arylamino and (C₆-C₂₀) aryl;
provided that R₁₁ through R₁₄ cannot be hydrogen all at the same time; and
n is an integer from 1 to 3.

### BRIEF DESCRIPTION OF THE DRAWINGS

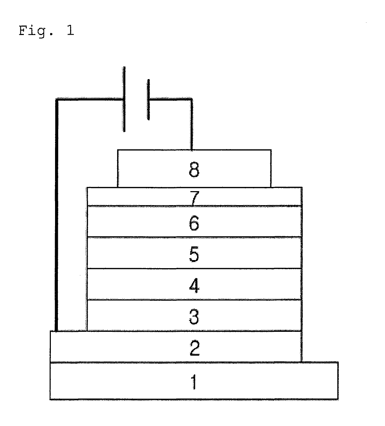

Fig. 1 is a cross-sectional view of an OLED.

### DETAILED DESCRIPTION OF THE INVENTION

Referring now to the Drawings, Fig. 1 illustrates a cross-sectional view of OLED comprising Glass 1, Transparent electrode 2, Hole injection layer 3, Hole transport layer 4, Electroluminescent layer 5, Electron transport layer 6, Electron injection layer 7 and Al cathode 8.

The term "alkyl" described herein and any substituents comprising "alkyl" moiety include both linear and branched species.

The term "aryl" described herein means an organic radical derived from aromatic hydrocarbon via elimination of one hydrogen atom. Each ring comprises a monocyclic or fused ring system containing from 4 to 7, preferably from 5 to 6 cyclic atoms. Specific examples include phenyl, naphthyl, biphenyl, anthryl, tetrahydronaphthyl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S and remaining carbon atom(s) as aromatic cyclic backbone atoms. The heteroaryl may be a 5- or 6-membered monocyclic heteroaryl or a polycyclic heteroaryl which is fused with one or more benzene rings, and may be partially saturated. Heteroatoms in a heteroaryl group may be oxidized or quaternized to form a divalent aryl group such as N-oxide and quaternary salt. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzisothiazolyl, benzisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenathridinyl and benzodioxolyl; and corresponding N-oxides (for example, pyridyl N-oxide, quinolyl N-oxide) and quaternary salts thereof; but they are not restricted thereto.

The naphthyl of Chemical Formula (1) may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The alicyclic ring, or the monocyclic or polycyclic aromatic ring formed from two adjacent groups from R₁₁ through R₁₄ in Chemical Formula (1) by linkage via (C₃-C₁₂)alkylene or (C₃-C₁₂)alkenylene with or without a fused ring is benzene, naphthalene, anthracene, fluorene, indene or phenanthrene. The compound within the square bracket ([]) serves as a primary ligand of iridium, and L serves as a subsidiary ligand. The organic electroluminescent compounds according to the present invention also include the complex with the ratio of primary ligand: subsidiary ligand = 2:1 (n=2) and the complex with the ratio of primary ligand: subsidiary ligand = 1:2 (n=1), as well as tris-chelated complexes without subsidiary ligand (L) (n=3).

R₁₁ through R₁₄ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, methylcarbonyl, ethylcarbonyl, t-butylcarbonyl, phenylcarbonyl, dimethylamino, diphenylamino, phenyl, naphthyl, anthryl, fluorenyl or 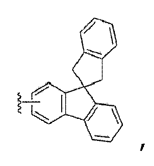 and the fluorenyl may be further substituted by methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, phenyl, naphthyl, anthryl, trimethylsilyl, tripropylsilyl, tri(t-butyl)silyl, t-butyldimethylsilyl or triphenylsilyl.

The organic electroluminescent compound according to the invention may be exemplified by the compounds represented by one of Chemical Formulas (2) to (5): 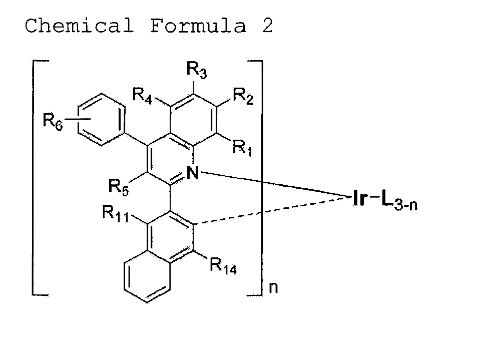 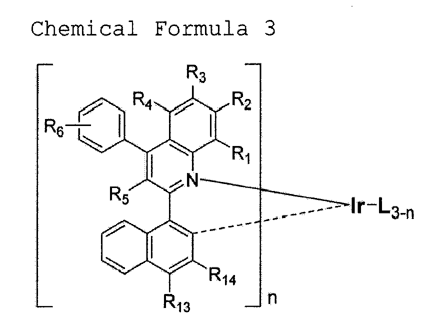 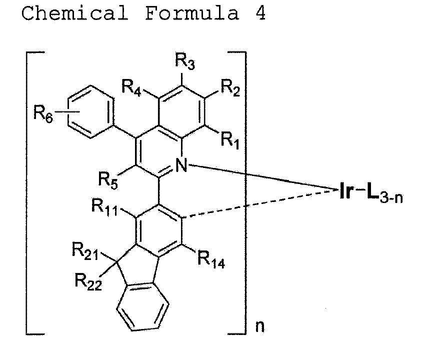 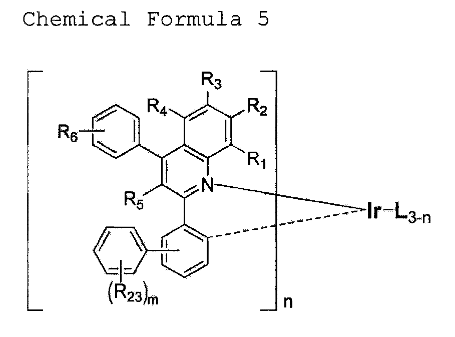 wherein, L, R₁, R₂, R₃, R₄, R₅, R₆, R₁₁, R₁₃, R₁₄ and n are defined as in Chemical Formula (1);
R₂₁ and R₂₂ independently represent hydrogen, (C₁-C₂₀)alkyl, (C₆-C₂₀)aryl, or R₂₁ and R₂₂ may be linked each other via (C₃-C₁₂)alkylene or (C₃-C₁₂)alkenylene with or without a fused ring to form an alicyclic ring, or a monocyclic or polycyclic aromatic ring;
R₂₃ represents (C₁-C₂₀)alkyl, halogen, cyano, tri(C₁-C₂₀)alkylsilyl, tri (C₆-C₂₀) arylsilyl, (C₁-C₂₀) alkoxy, (C₁-C₂₀) alkylcarbonyl, (C₆-C₂₀)arylcarbonyl, phenyl, di (C₁-C₂₀)alkylamino, di (C₆-C₂₀)arylamino, naphthyl, 9, 9-di (C₁-C₂₀)alkylfluorenyl or 9,9-di(C₆-C₂₀)arylfluorenyl; and
m is an integer from 1 to 5.

R₁ through R₅ of Chemical Formula (1) independently represent hydrogen, methyl, ethyl, n-propyl, i-propyl, n-butyl, i-butyl, t-butyl, n-pentyl, i-pentyl, n-hexyl, n-heptyl, n-octyl, ethylhexyl, methoxy, ethoxy, butoxy, cyclopropyl, cyclohexyl, cycloheptyl, fluoro, trimethylsilyl, tripropylsilyl, tri(t-butyl)silyl, t-butyldimethylsilyl or triphenylsilyl; and R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl, naphthyl, anthryl, fluorenyl or spirobifluorenyl.

The organic electroluminescent compounds according to the present invention can be specifically exemplified by the following compounds, but they are not restricted thereto: 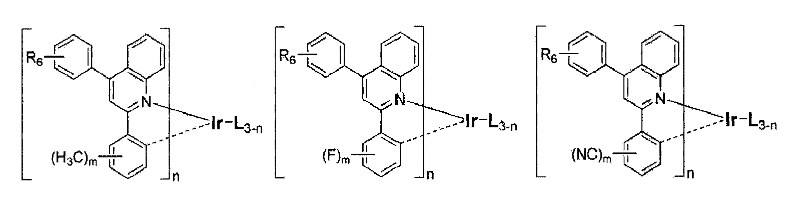 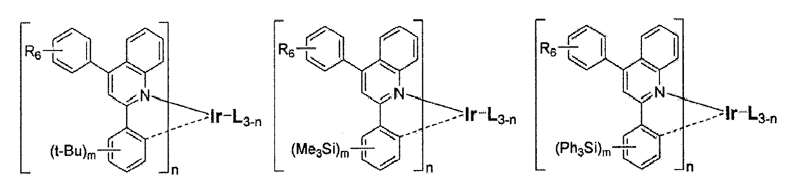 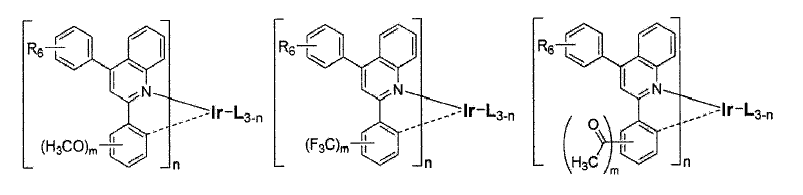 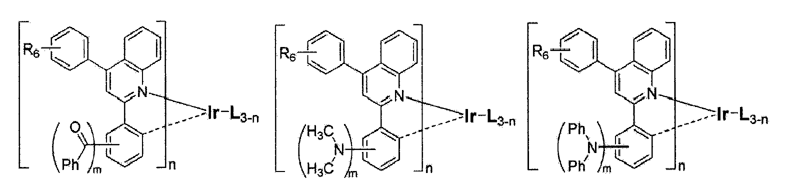 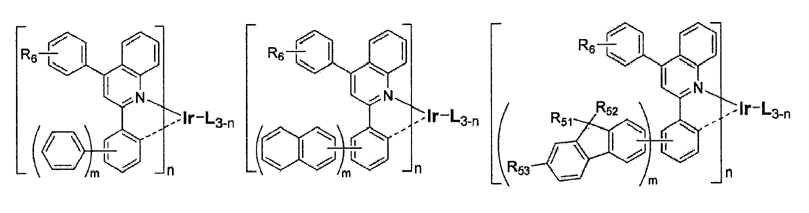 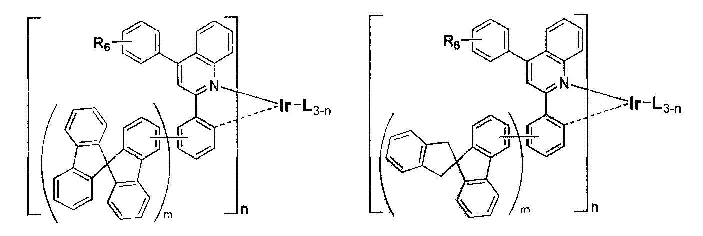 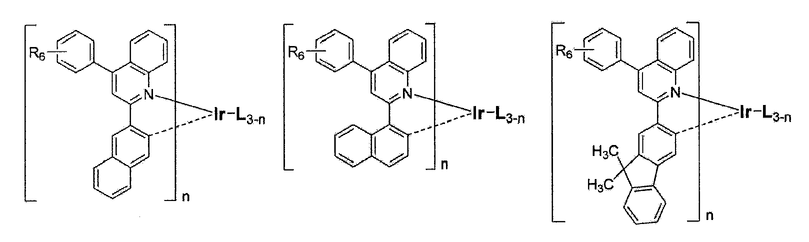 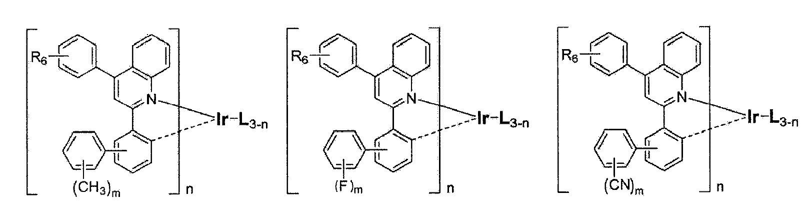 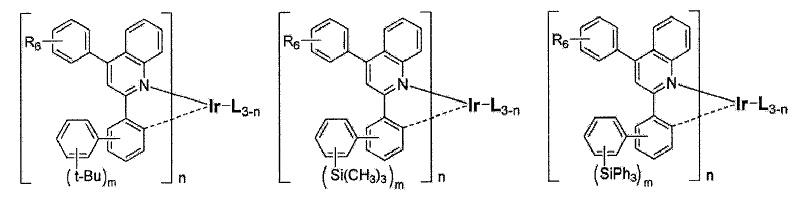 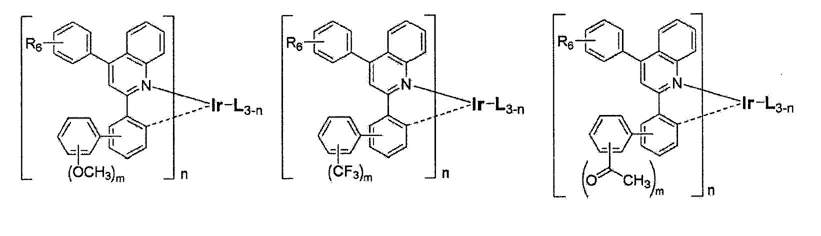 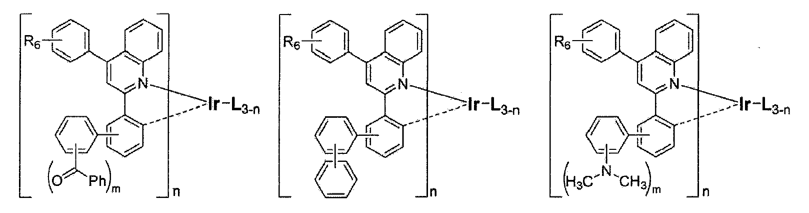 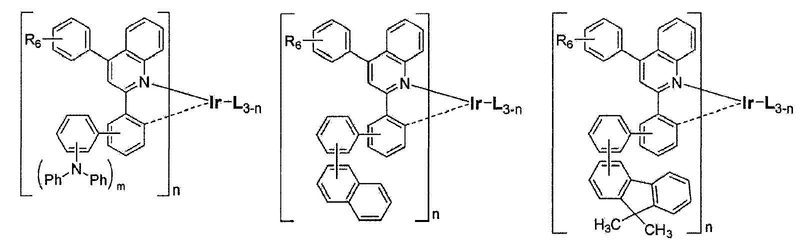 wherein, L represents an organic ligand;
R₆ represents hydrogen, methyl, ethyl, n-propyl, i-propyl, n-butyl, i-butyl, t-butyl, n-pentyl, i-pentyl, n-hexyl, n-heptyl, n-octyl, ethylhexyl, fluoro, phenyl or naphthyl;
R₅₁ and R₅₂ independently represent methyl, ethyl, n-propyl, i-propyl, n-butyl, i-butyl, t-butyl, n-pentyl, i-pentyl, n-hexyl, n-heptyl, n-octyl, ethylhexyl, phenyl or naphthyl, or R₅₁ and R₅₂ may be linked each other via (C₃-C₁₂)alkylene or (C₃-C₁₂)alkenylene with or without a fused fing to form an alicyclic ring, or a monocyclic or polycyclic aromatic ring;
R₅₃ represents hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, trimethylsilyl, tripropylsilyl, tri(t-butyl)silyl, t-butyldimethylsilyl, triphenylsilyl, phenyl or naphthyl;
m is an integer from 1 to 3; and
n is an integer from 1 to 3.

The subsidiary ligands (L) of the organic electroluminescent compounds according to the present invention include the following structures: 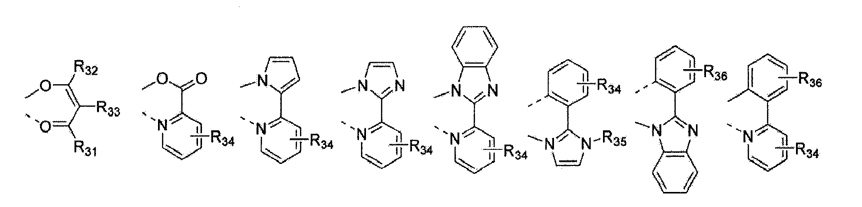 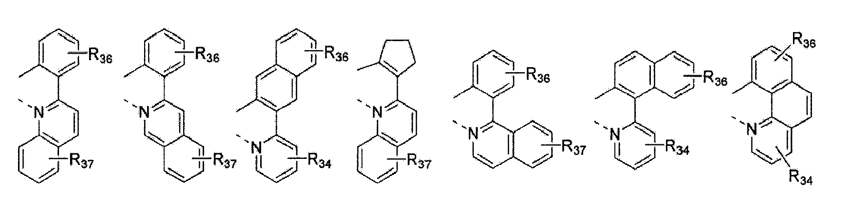 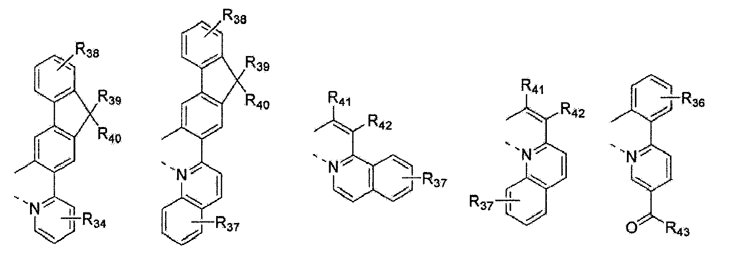 wherein, R₃₁ and R₃₂ independently represent hydrogen, (C₁-C₂₀)alkyl with or without halogen substituent(s), phenyl with or without (C₁-C₂₀)alkyl substituent(s) or halogen;
R₃₃ through R₃₈ independently represent hydrogen, (C₁-C₂₀)alkyl, phenyl with or without (C₁-C₂₀)alkyl substituent(s)*,* tri(C₁-C₂₀)alkylsilyl or halogen;
R₃₉ through R₄₂ independently represent hydrogen, (C₁-C₂₀)alkyl, phenyl with or without (C₁-C₂₀)alkyl substituent(s); and

R₄₃ represents (C₁-C₂₀)alkyl, phenyl with or without (C₁-C₂₀)alkyl substituent(s), or halogen.

The subsidiary ligands (L) of the organic electroluminescent compounds according to the present invention can be exemplified by the following structures, but they are not restricted thereto:

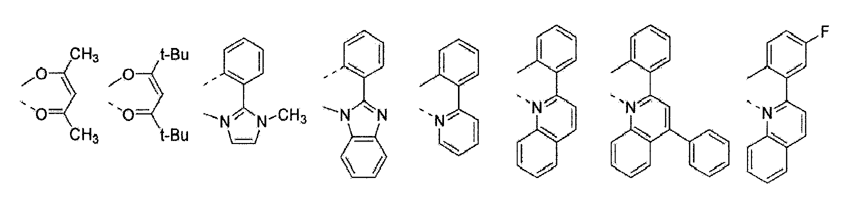

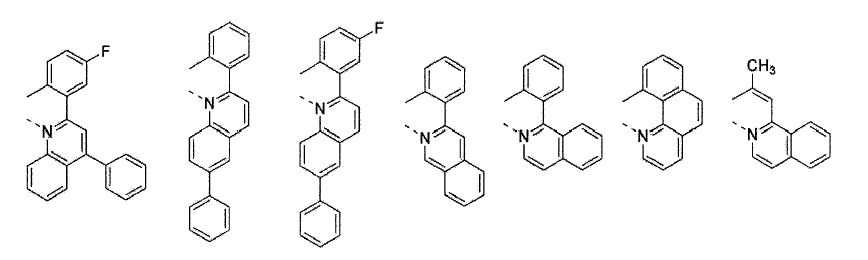

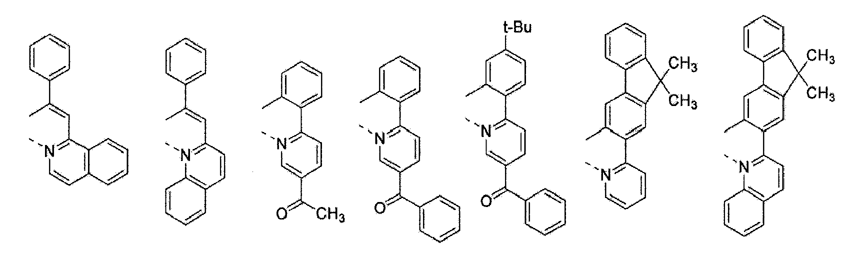

The processes for preparing the organic electroluminescent compounds according to the present invention are described by referring to Reaction Schemes (1) to (3) shown below: 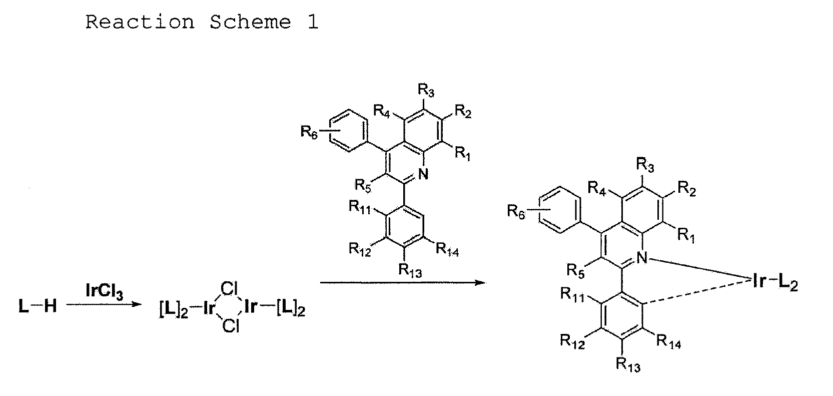 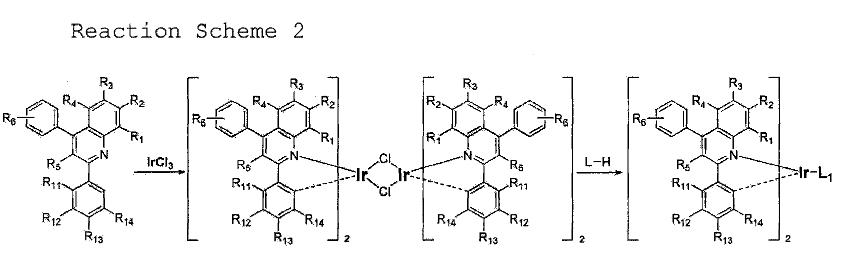 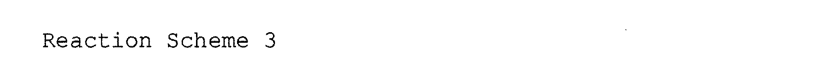 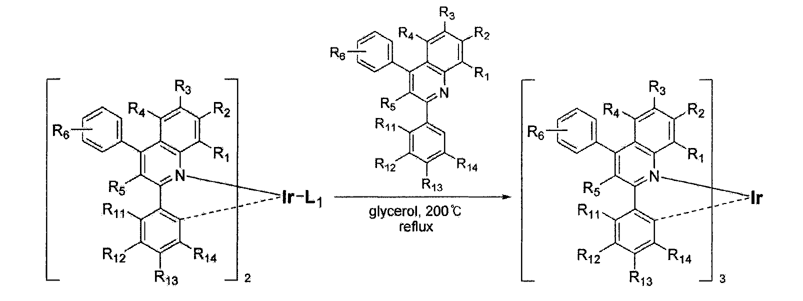 wherein, R₁, R₂, R₃, R₄, R₅, R₆, R₁₁, R₁₂, R₁₃, R₁₄ and L are defined as in Chemical Formula (1).

Reaction Scheme (1) provides a compound of Chemical Formula (1) with n=1, in which iridium trichloride (IrCl₃) and subsidiary ligand compound (L-H) are mixed in a solvent at a molar ratio of 1:2~3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with a primary ligand compound in organic solvent to provide an organic phosphorescent iridium compound having the ratio of primary ligand: subsidiary ligand of 1:2 as the final product. The reaction is carried out with AgCF₃SO₃, Na₂CO₃ or NaOH being admixed with organic solvent such as 2-ethoxyethanol and 2-methoxyethylether.

Reaction Scheme (2) provides a compound of Chemical Formula (1) with n=2, in which iridium trichloride (IrCl₃) and a primary ligand compound are mixed in a solvent at a molar ratio of 1:2~3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixture. The isolated diiridium dimer is then heated with the subsidiary ligand compound (L-H) in organic solvent to provide an organic phosphorescent iridium compound having the ratio of primary ligand: subsidiary ligand of 2:1 as the final product.

The molar ratio of the primary ligand compound and the subsidiary ligand (L) in the final product is determined by appropriate molar ratio of the reactant depending on the composition. The reaction may be carried out with AgCF₃SO₃, Na₂CO₃ or NaOH being admixed with organic solvent such as 2-ethoxyethanol, 2-methoxyethylether and 1,2-dichloroethane.

Reaction Scheme (3) provides a compound of Chemical Formula (1) with n=3, in which iridium complex prepared according to Reaction Scheme (2) and a primary ligand compound are mixed in glycerol at a molar ratio of 1:2~3, and the mixture is heated under reflux to obtain organic phosphorescent iridium complex coordinated with three primary ligands.

The compounds employed as a primary ligand in the present invention can be prepared according to Reaction Scheme (4), on the basis of conventional processes. 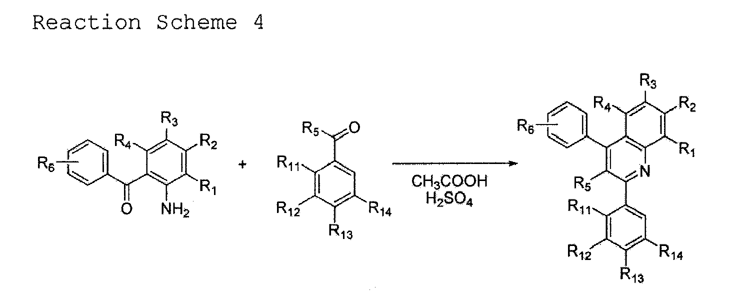 wherein, R₁ through R₆ and R₁₁ through R₁₄ are defined as in Chemical Formula (1).

The compounds employed as a primary ligand of Chemical Formula (1), which have various substituents, can be prepared from (2-aminophenyl)(phenyl)metanone derivatives and acetophenone derivatives.

Further, the present invention provides organic solar cells, which are characterized by comprising one or more organic electroluminescent compound(s) represented by Chemical Formula (1).

The present invention also provides an organic electroluminescent device which is comprised of a first electrode; a second electrode; and at least one organic layer(s) interposed between the first electrode and the second electrode; wherein the organic layer comprises one or more compound(s) represented by Chemical Formula (1).

The organic electroluminescent device according to the present invention is characterized in that the organic layer comprises an electroluminescent region, which comprises one or more organic electroluminescent compound(s) represented by Chemical Formula (1) as electroluminescent dopant in an amount of 0.01 to 10% by weight, and one or more host(s). The host to be applied to the organic electroluminescent device according to the invention is not particularly restricted, but may be exemplified by 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane or the compounds represented by one of Chemical Formulas (6) to (9):

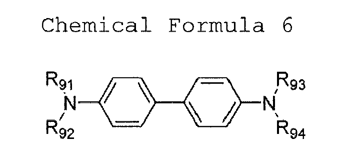

In Chemical Formula (6), R₉₁ through R₉₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

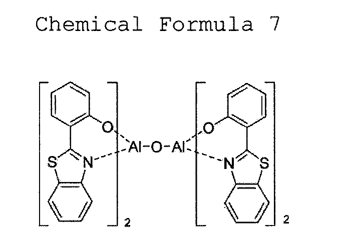

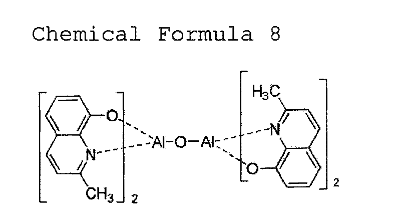

Chemical Formula 9 L¹L²M(Q)_{y}

wherein, the ligands, L¹ and L² independently represent one of the following structures: 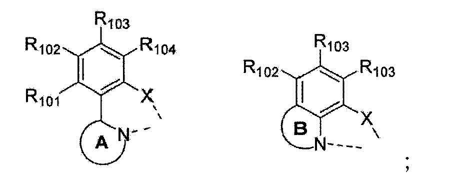 M is a bivalent or trivalent metal;
y is 0 when M is a bivalent metal, while y is 1 when M is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C1-C60)alkyl, phenyl or naphthyl with or without (C1-C60)alkyl substituent(s);
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of ring A and R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

The ligands, L¹ and L² are independently selected from the following structures: 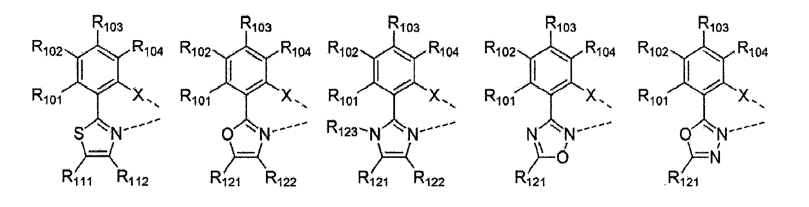 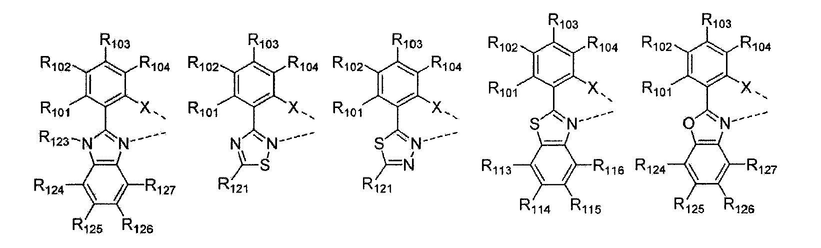 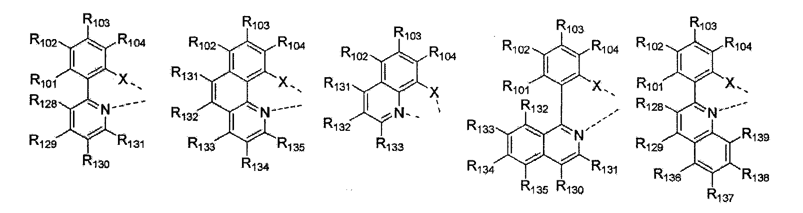 wherein, X represents O, S or Se;
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
R₁₁₁ through R₁₁₆ and R₁₂₁ through R₁₃₉ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₁₁ through R₁₁₆ and R₁₂₁ through R₁₃₉ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₁₀₁ through R₁₀₄, R₁₁₁ through R₁₁₆, and R₁₂₁ through R₁₃₉, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicyclaalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In Chemical Formula (9), M is a bivalent metal selected from Be, Zn, Mg, Cu and Ni, or a trivalent metal selected from Al, Ga, In and B, and Q is selected from the following structures.

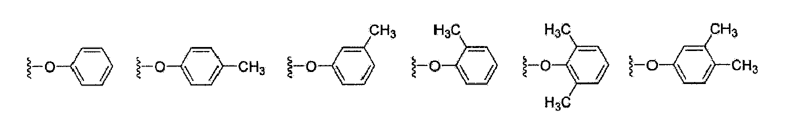

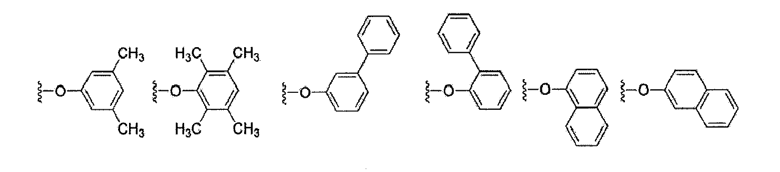

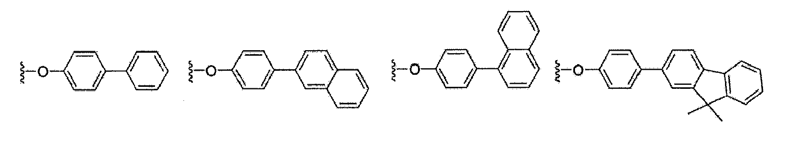

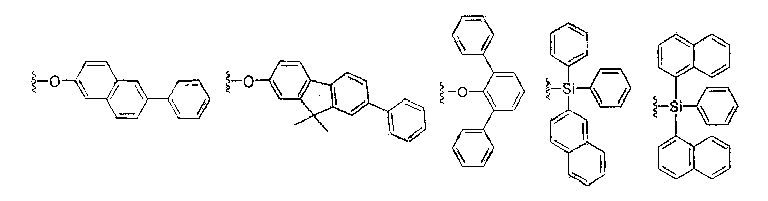

The compounds represented by Chemical Formula (6) may be specifically exemplified by the compounds with one of the following structures, but they are not restricted thereto.

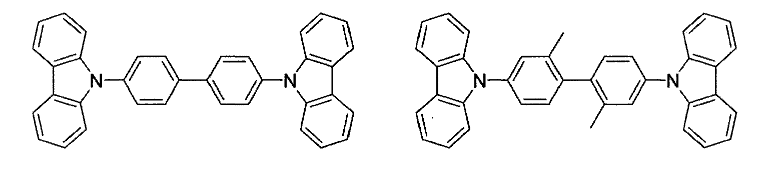

The compounds represented by one of Chemical Formulas (7) to (9) may be specifically exemplified by the compounds with one of the following structures, but they are not restricted thereto.

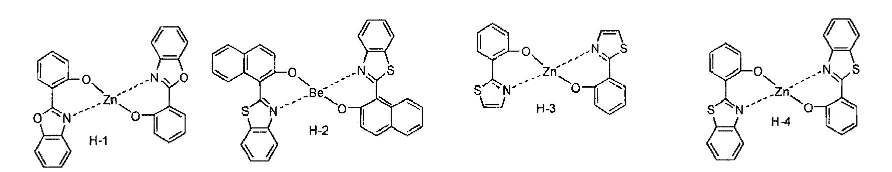

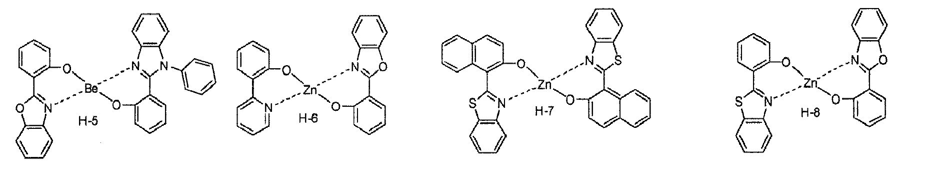

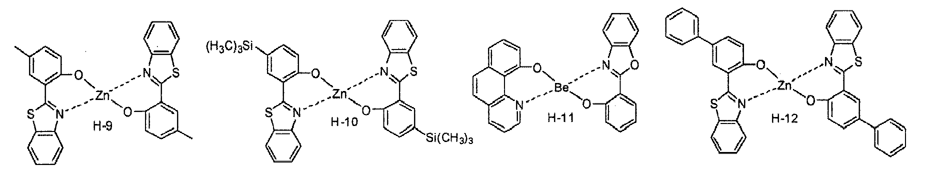

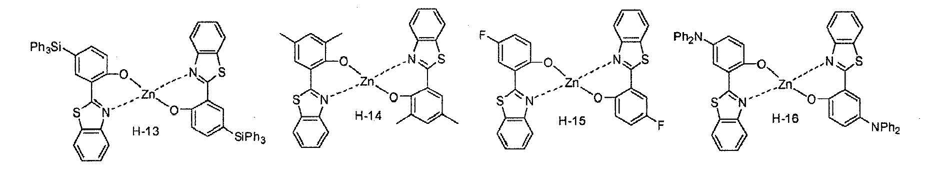

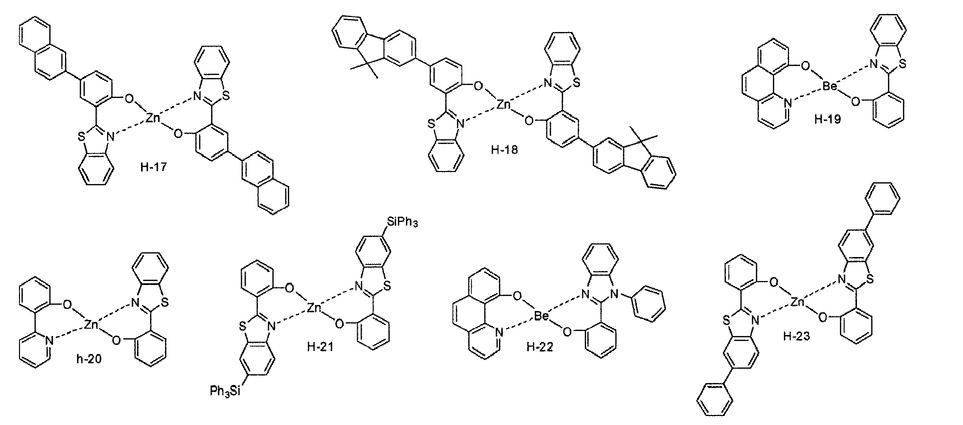

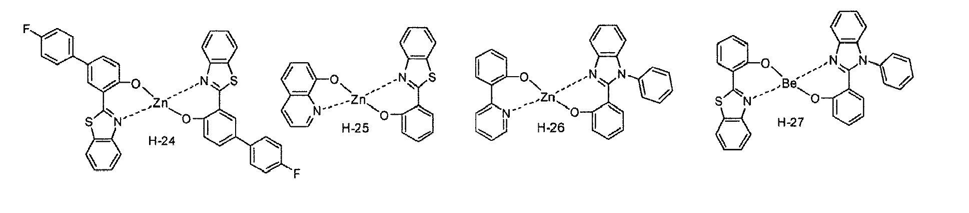

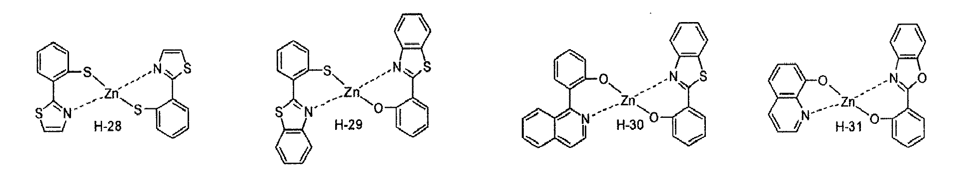

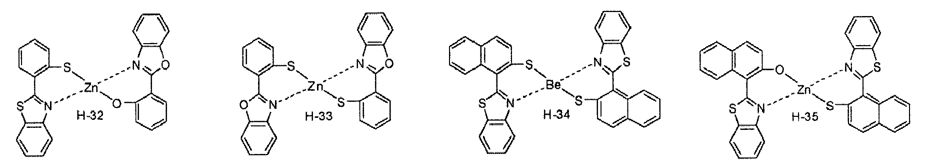

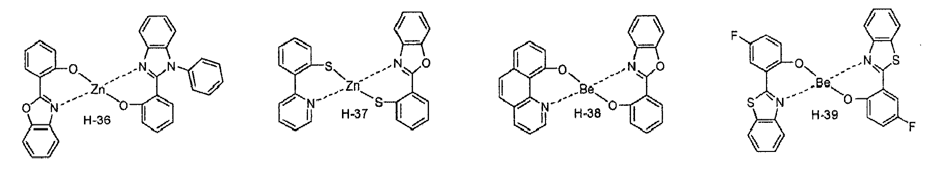

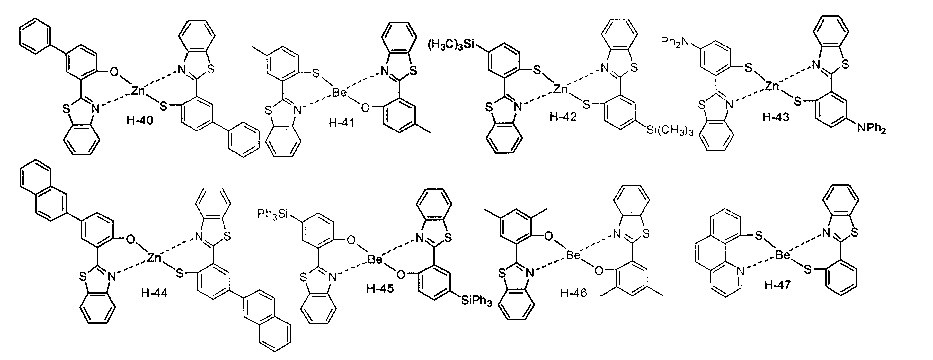

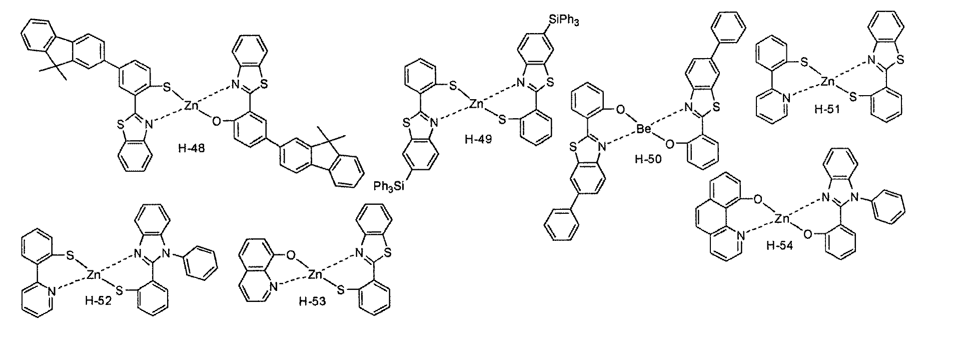

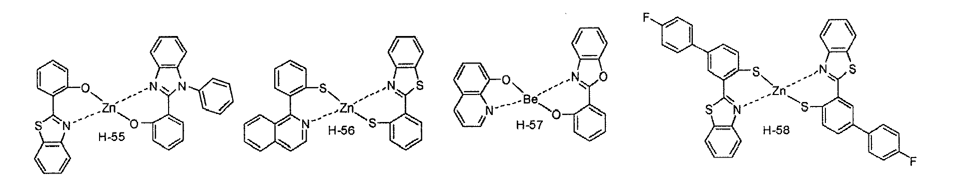

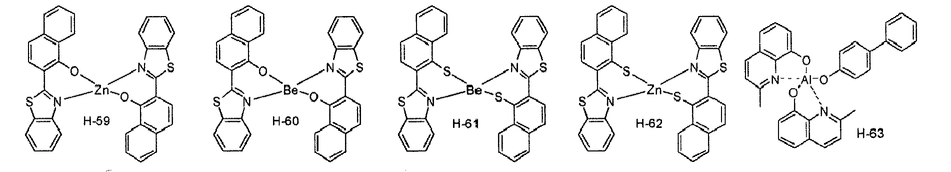

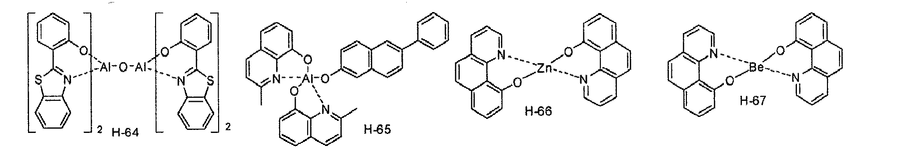

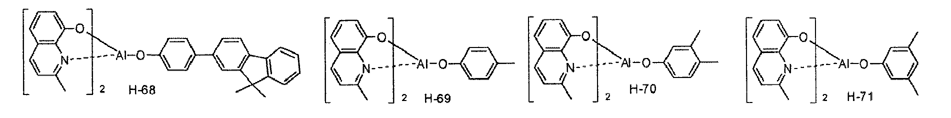

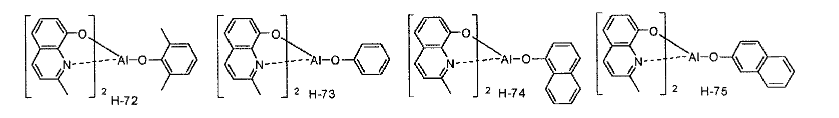

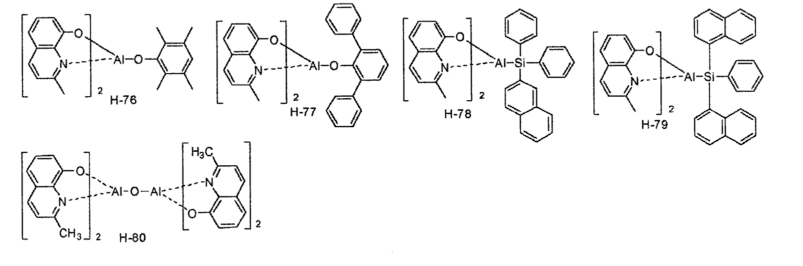

The electroluminescent layer means the layer where electroluminescence occurs, and it may be a single layer or a multi-layer consisting of two or more layers stacked. When a mixture of host-dopant is used according to the construction of the present invention, noticeable improvement in device life as well as in luminous efficiency could be confirmed.

The organic electroluminescent device according to the invention may further comprise one or more compound(s) selected from arylamine compounds and styrylarylamine compounds, as well as the organic electroluminescent compound represented by Chemical Formula (1). Examples of arylamine or styrylarylamine compounds include the compound represented by Chemical Formula (10), but they are not restricted thereto: 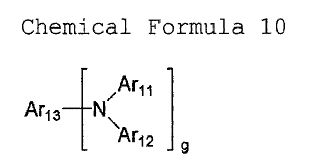 wherein, Ar₁₁ and Ar₁₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when g is 1, Ar₁₃ represents (C6-C60)aryl or (C4-C60)heteroaryl or an aryl represented by the following structural formula: 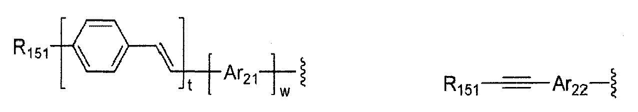 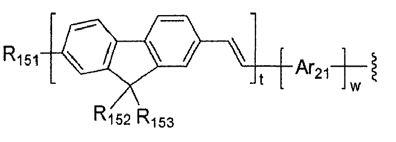 when g is 2, Ar₁₃ represents (C6-C60)arylene or (C4-C60)heteroarylene or an arylene represented by the following structural formula: 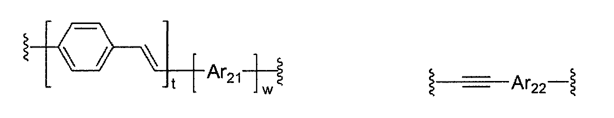 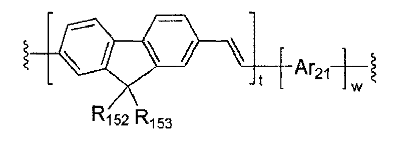 wherein Ar₂₁ and Ar₂₂ independently represent (C6-C60)arylene or (C4-C60)heteroarylene;
R₁₅₁, R₁₅₂ and R₁₅₃ independently represent hydrogen, (C1-C60)alkyl or (C6-C60)aryl;
t is an integer from 1 to 4, w is an integer of 0 or 1; and
the alkyl, aryl, heteroaryl, arylamino, alkylamino, cycloalkyl or heterocycloalkyl of Ar₁₁ and Ar₁₂, or the aryl, heteroaryl, arylene or heteroarylene of Ar₁₃, or the arylene or heteroarylene of Ar₂₁ and Ar₂₂, or the alkyl or aryl of R₁₅₁ through R₁₅₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

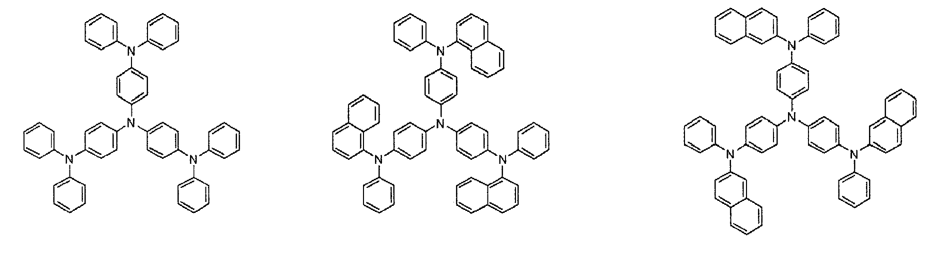

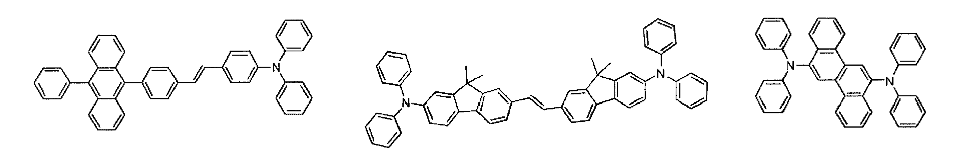

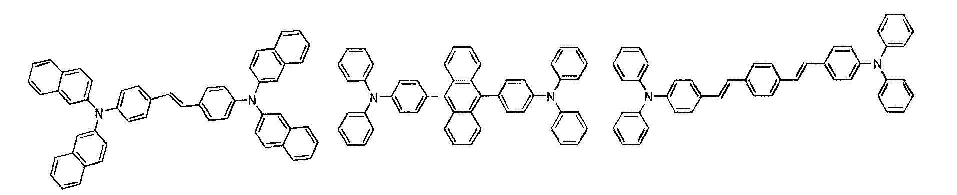

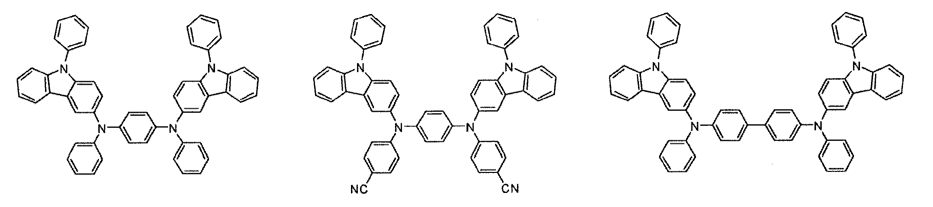

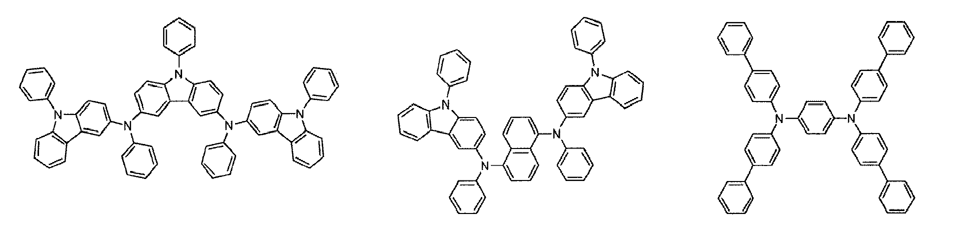

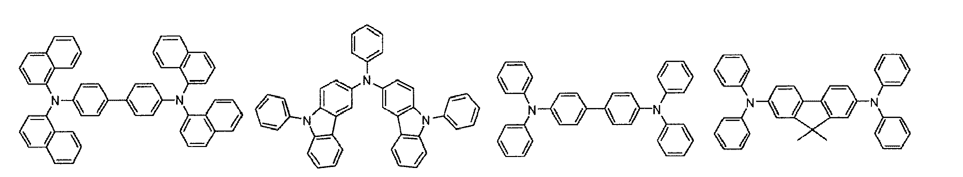

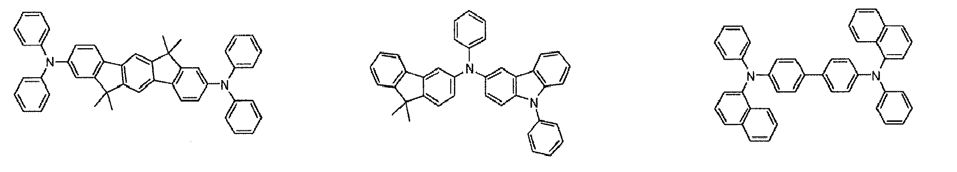

In an organic electroluminescent device according to the present invention, the organic layer may further comprises one or more metal(s) selected from a group consisting of organic metals of Group 1, Group 2, 4^{th} period and 5^{th} period transition metals, lanthanide metals and d-transition elements, as well as the organic electroluminescent compound represented by Chemical Formula (1). The organic layer may comprise a charge generating layer in addition to the electroluminescent layer.

The present invention can realize an electroluminescent device having a pixel structure of independent light-emitting mode, which comprises an organic electroluminescent device containing the compound of Chemical Formula (1) as a sub-pixel and one or more sub-pixel (s) comprising one or more compound(s) selected from a group consisting of arylamine compounds and styrylarylamine compounds are patterned in parallel at the same time.

Further, the organic electroluminescent device is an organic display which comprises one or more compound(s) selected from compounds having electroluminescent peak of wavelength of blue or green, at the same time. The compounds having electroluminescent peak of wavelength of blue or green may be exemplified by the compounds represented by one of Chemical Formulas (11) to (15), but they are not restricted thereto.

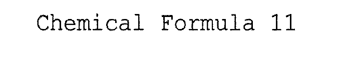

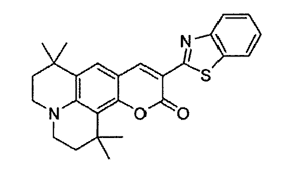

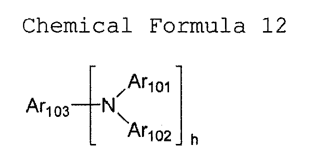

In Chemical Formula (12), Ar₁₀₁ and Ar₁₀₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl or Ar₁₀₁ and Ar₁₀₂ may be linked via (C3-C60)alkylene or (C3-C60)alkenylene with or without a fused ring to form an alicyclic ring, or a monocyclic or polycyclic aromatic ring;
when h is 1, Ar₁₀₃ represents (C6-C60)aryl or (C4-C60)heteroaryl or an aryl represented by the following structural formula: 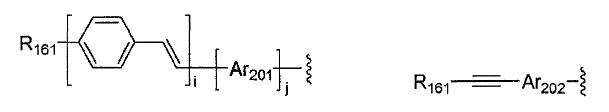 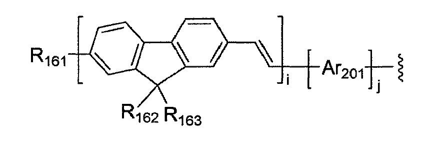 when h is 2, Ar₁₃ represents (C6-C60)arylene, (C4-C60)heteroarylene, or an arylene represented by one of the following structural formulas: 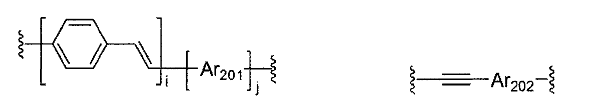 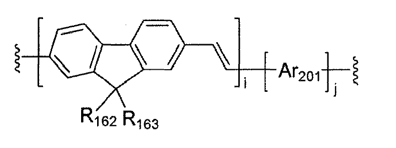 wherein Ar₂₀₁ and Ar₂₀₂ independently represent (C6-C60)arylene or (C4-C60)heteroarylene;
R₁₆₁, R₁₆₂ and R₁₆₃ independently represent hydrogen, (C1-C60)alkyl or (C6-C60)aryl;
i is an integer from 1 to 4, j is an integer of 0 or 1; and
the alkyl, aryl, heteroaryl, arylamino, alkylamino, cycloalkyl or heterocycloalkyl of Ar₁₀₁ and Ar₁₀₂, or the aryl, heteroaryl, arylene or heteroarylene of Ar₁₀₃, or the arylene or heteroarylene of Ar₂₀₁ and Ar₂₀₂, or the alkyl or aryl of R₁₆₁ through R₁₆₃ may be further substituted by one or more substituent(s) selected from a group consisting of halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

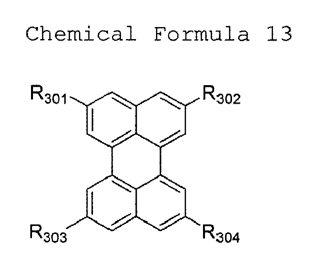

In Chemical Formula (13), R₃₀₁ through R₃₀₄ independently represents hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

Chemical Formula 14 (Ar₃₀₁)ₚ-L₁₁- (Ar₃₀₂) _{q}

Chemical Formula 15 (Ar₃₀₃)ᵣ-L₁₂- (Ar₃₀₄)ₛ

In Chemical Formulas (14) and (15),
L₁₁ represents (C6-C60)arylene or (C4-C60)heteroarylene;
L₁₂ represents anthracenylene;
Ar₃₀₁ through Ar₃₀₄ are independently selected from hydrogen, (C1-C60)alkyl, (C1-C60)alkoxy, halogen, (C4-C60)heteroaryl, (C5-C60)cycloalkyl and (C6-C60)aryl, and the cycloalkyl, aryl or heteroaryl of Ar₃₀₁ through Ar₃₀₄ may be further substituted by one or more substituent(s) selected from a group consisting of (C6-C60)aryl or (C4-C60)heteroaryl with or without at least one substituent(s) selected from a group consisting of (C1-C60)alkyl, halo(C1-C60)alkyl, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
p, q, r and s independently represent an integer from 0 to 4.

The compounds represented by Chemical Formula (14) or (15) may be exemplified by anthracene derivatives and benz[a]anthracene derivatives represented by one of Chemical Formulas (16) through (19).

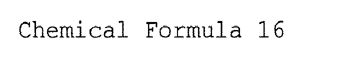

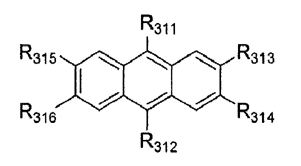

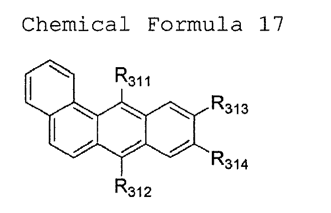

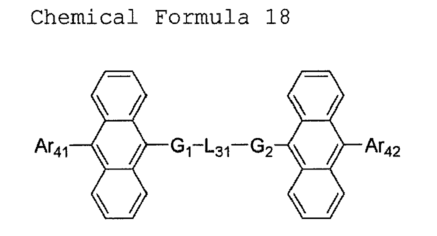

In Chemical Formulas (16) to (18), R₃₁₁ and R₃₁₂ independently represent (C6-C60)aryl, (C4-C60)heteroaryl or a 5- or 6-membered heterocycloalkyl containing one or more heteroatom(s) selected from N, O and S, or (C3-C60)cycloalkyl and the aryl or heteroaryl of R₃₁₁ and R₃₁₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₃₁₃ through R₃₁₆ independently represent hydrogen, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₃₁₃ and R₃₁₆ may be further substituted by one or more substituent(s) selected from a group consisting of (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G1 and G2 independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₄₁ and Ar₄₂ represent (C4-C60)heteroaryl or aryl selected from the following structures: 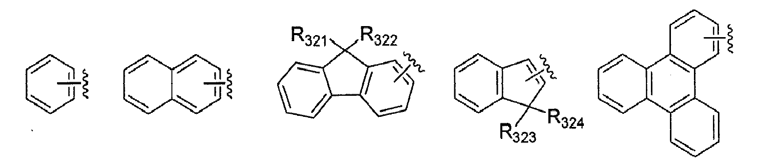 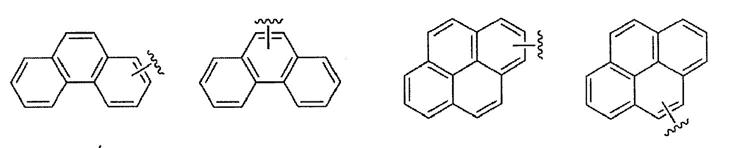 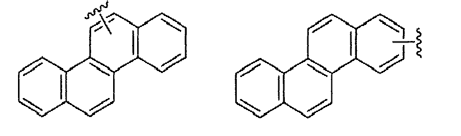 the aryl or heteroaryl of Ar₄₁ and Ar₄₂ may be substituted by one or more substituent(s) selected from (C1-C60)alkyl, (C1-C60)alkoxy, (C6-C60)aryl and (C4-C60)heteroaryl;
L₃₁ represents (C6-C60)arylene, (C4-C60)heteroarylene or a compound represented by the following structure: 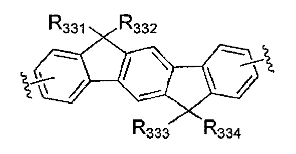 the arylene or heteroarylene of L₃₁ may be substituted by one or more substituent(s) selected from (C1-C60)alkyl, (C1-C60)alkoxy, (C6-C60)aryl, (C4-C60)heteroaryl and halogen;
R₃₂₁, R₃₂₂, R₃₂₃ and R₃₂₄ independently represent hydrogen, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₃₃₁, R₃₃₂, R₃₃₃ and R₃₃₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring. 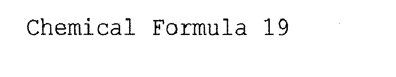 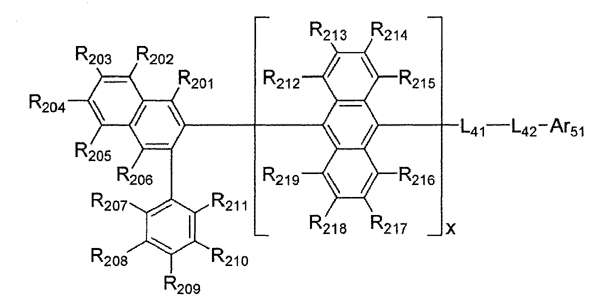 In Chemical Formula 19,
L₄₁ and L₄₂ independently represent a chemical bond, or (C6-C60)arylene or (C3-C60)heteroarylene, and the arylene or heteroarylene of L₄₁ and L₄₂ may be further substituted by one or more substituent(s) selected from (C1-C60)alkykl, halogen, cyano, (C1-C60)alkoxy, (C3-C60)cycloalkyl, (C6-C60)aryl, (C3-C60)heteroaryl, tri(C1-C30)alkylsilyl, di(C1-C30)alkyl(C6-C30)arylsilyl and tri(C6-C30)arylsilyl;
R₂₀₁ through R₂₁₉ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₂₀₁ through R₂₁₉ may be linked to an adjacent substituent via (C3-C60)alkylene or (C3-C60)alkenylene with or without a fused ring to form an alicyclic ring, or a monocyclic or polycyclic aromatic ring;

Ar₅₁ represents (C6-C60)aryl, (C4-C60)heteroaryl, a 5- or 6-membered heterocycloalkyl containing one or more heteroatom(s) selected from N, O and S, (C3-C60)cycloalkyl, adamantyl, (C7-C60)bicycloalkyl, or a substituent selected from the following structures:

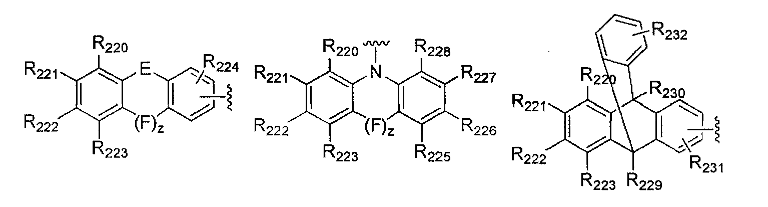

R₂₂₀ through R₂₃₂ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
E and F independently represent a chemical bond, CR₂₃₃R₂₃₄, NR₂₃₅, S, O, SiR₂₃₆R₂₃₇, PR₂₃₈, CO, BR₂₃₉, InR₂₄₀, Se, GeR₂₄₁R₂₄₂, SnR₂₄₃R₂₄₄, GaR₂₄₅ or CR₂₄₆=CR₂₄₇;
R₂₃₃ through R₂₄₇ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₂₃₃ through R₂₄₇ may be linked to an adjacent substituent via (C3-C60)alkylene or (C3-C60)alkenylene with or without a fused ring to form an alicyclic ring, or a monocyclic or polycyclic aromatic ring;
the aryl, heteroaryl, heterocycloalkyl, adamantyl or bicycloalkyl of Ar₅₁, or the alkyl, alkenyl, alkynyl, cycloalkyl, heterocycloalkyl, aryl, heteroaryl, arylsilyl, alkylsilyl, alkylamino or arylamino of R₂₀₁ through R₂₃₂ may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkaxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; x is an integer from 1 to 4; and z is an integer from 0 to 4.

The organic compounds and organometallic compounds with green or blue electroluminescence can be more specifically exemplified by the following compounds, but they are not restricted thereto.

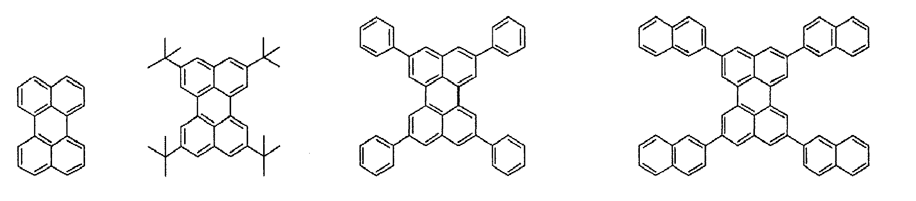

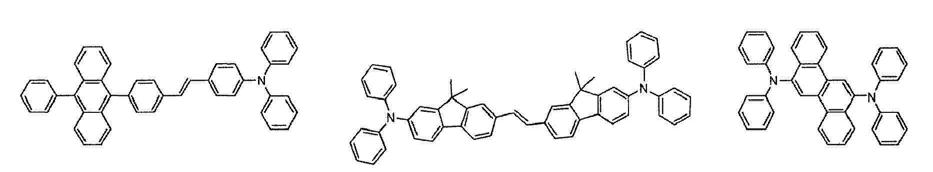

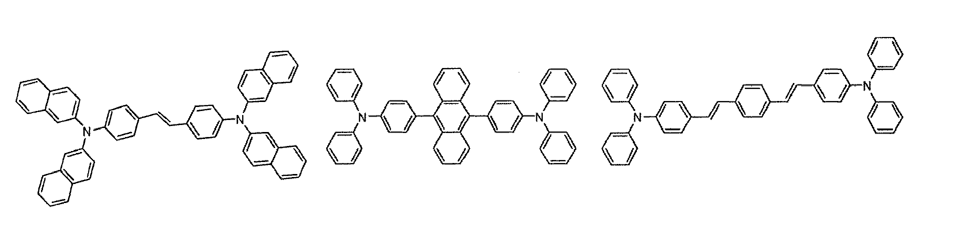

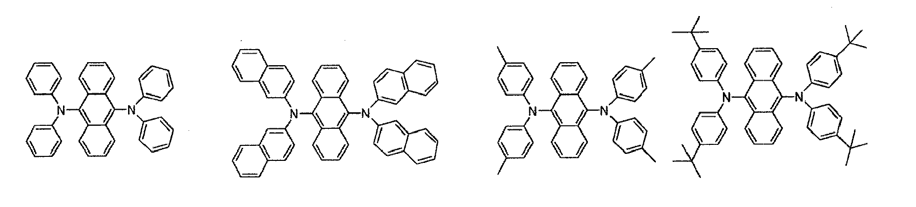

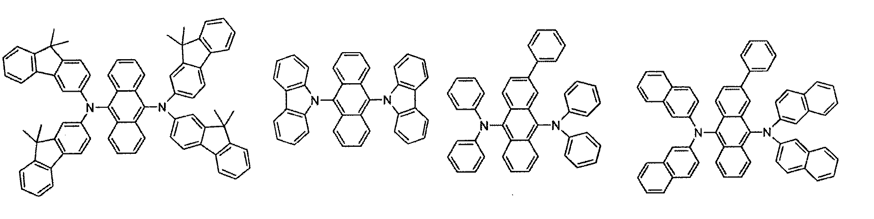

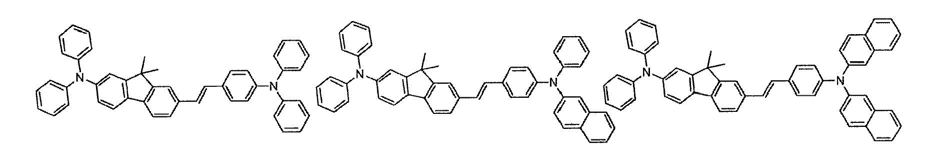

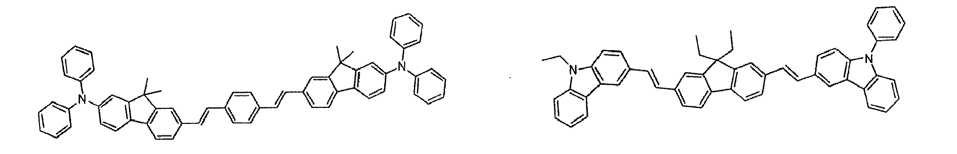

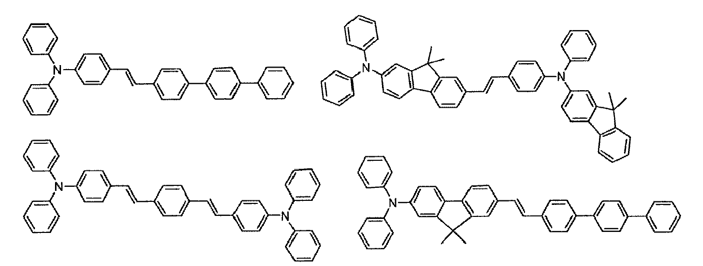

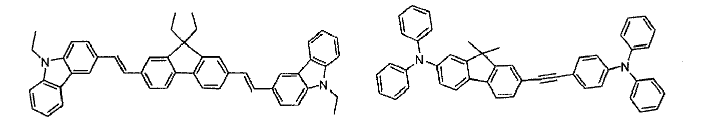

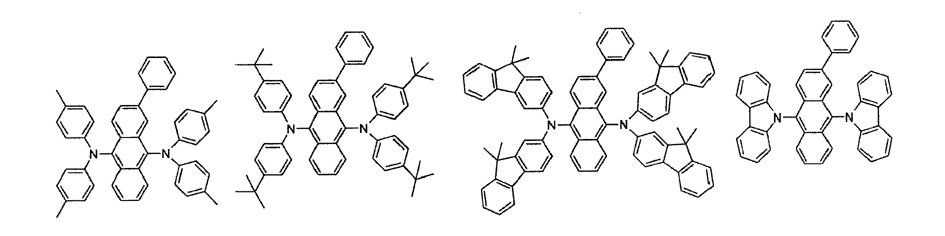

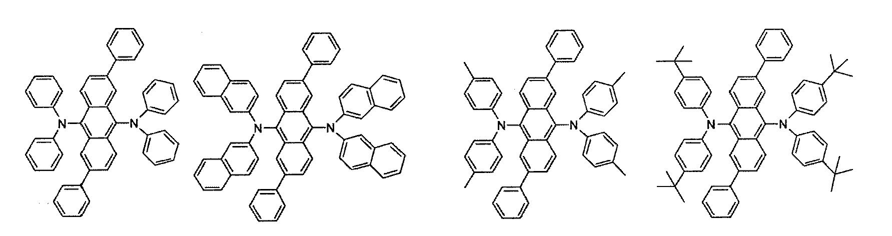

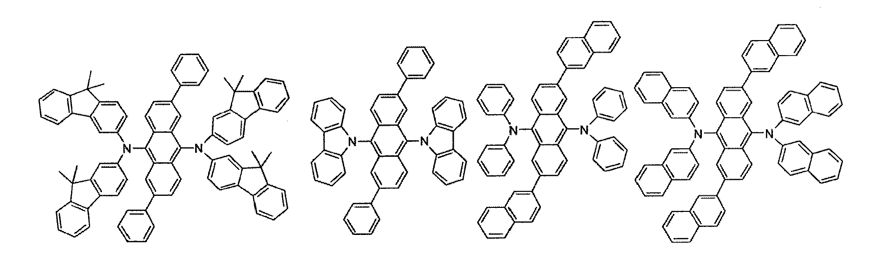

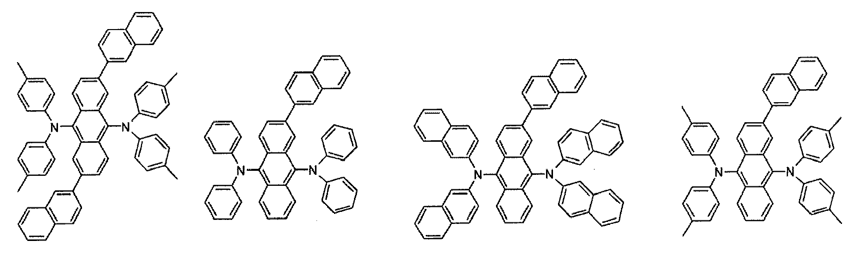

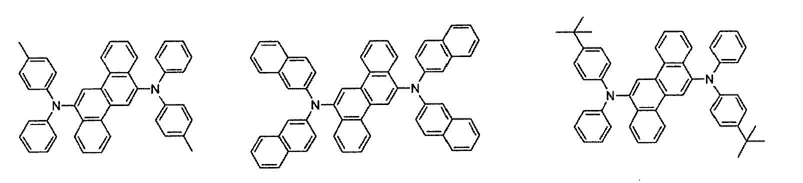

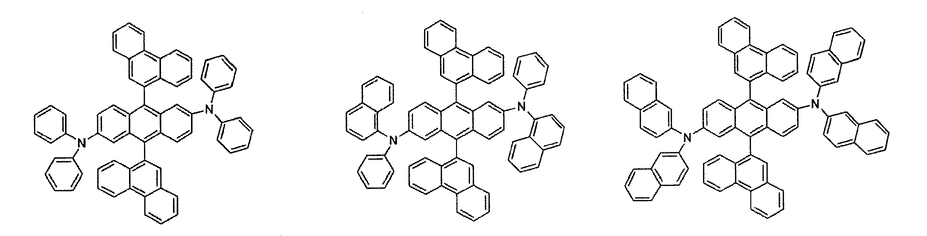

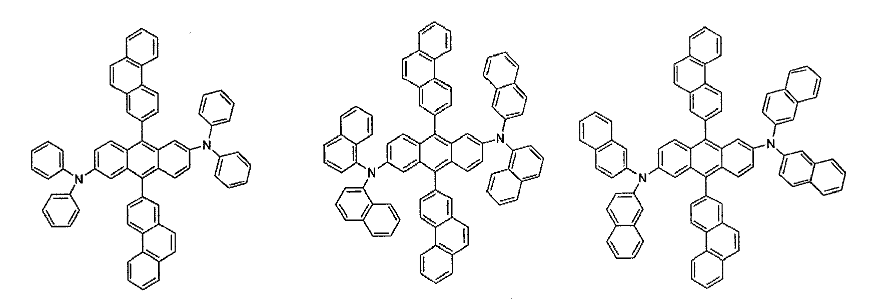

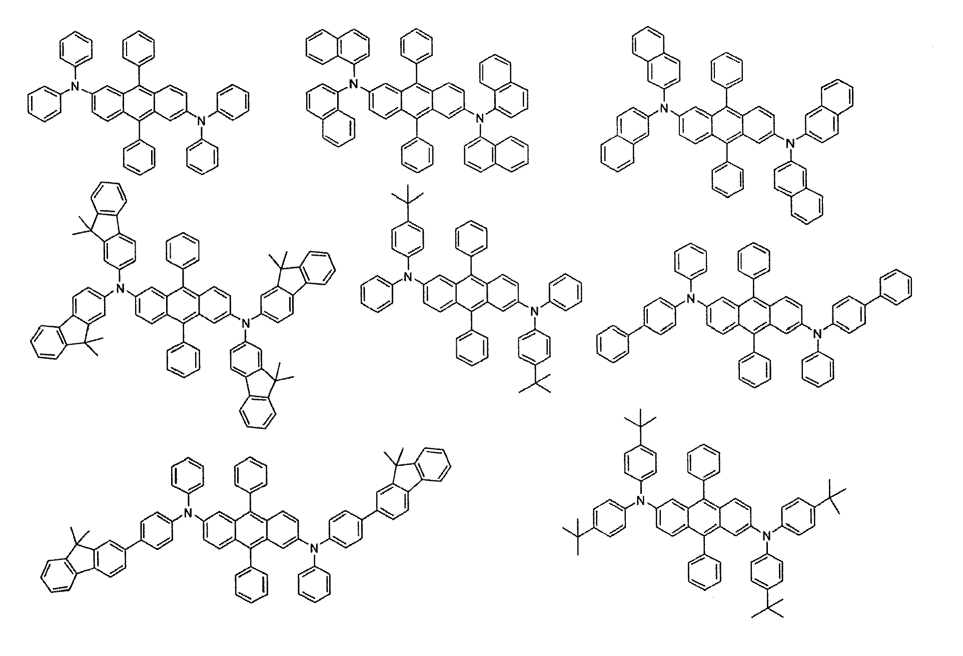

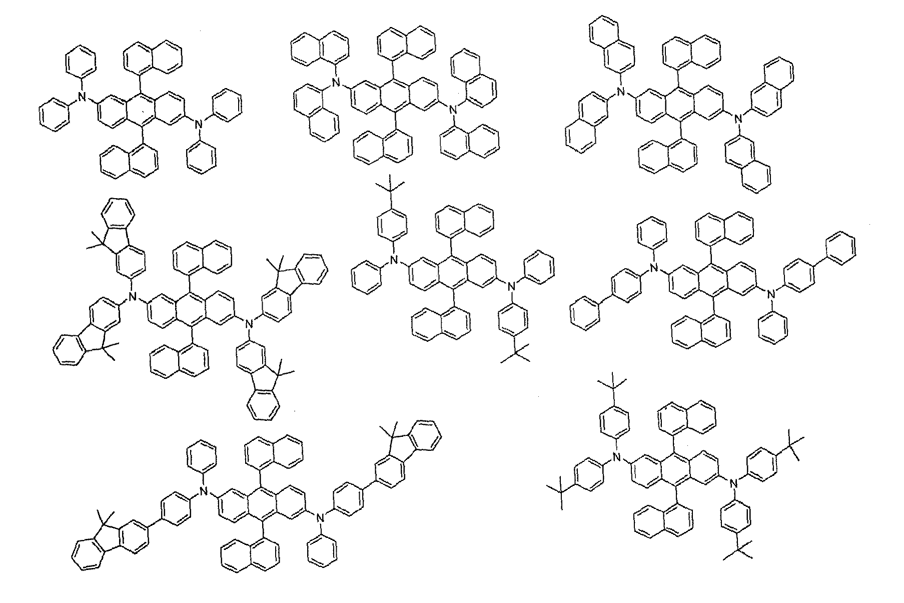

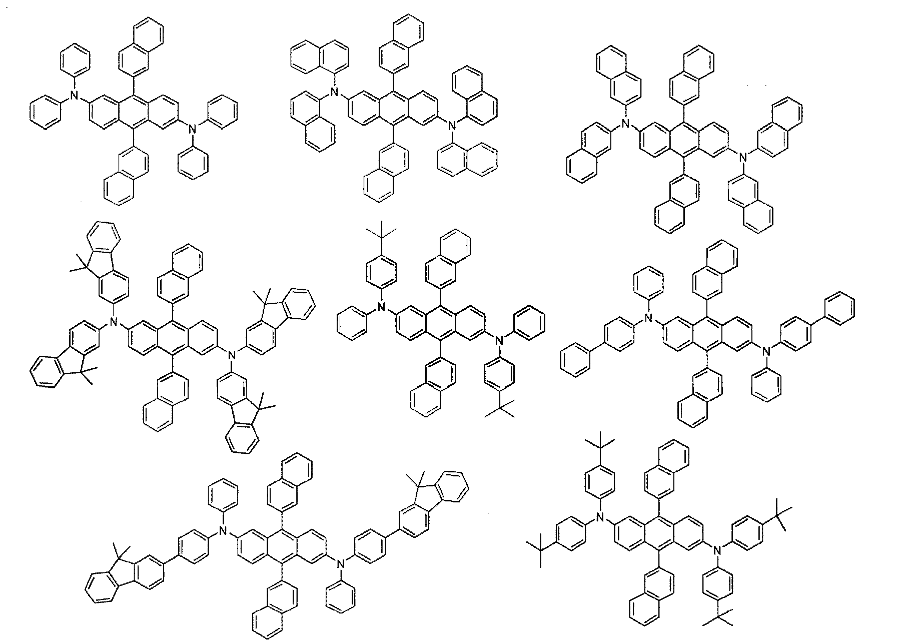

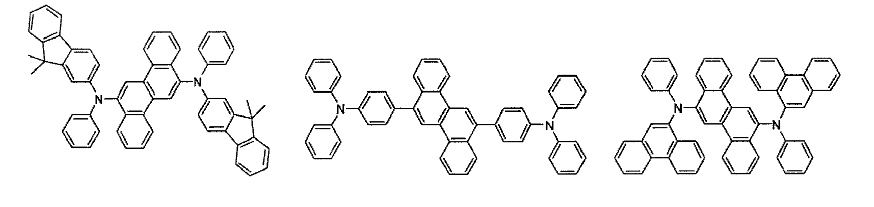

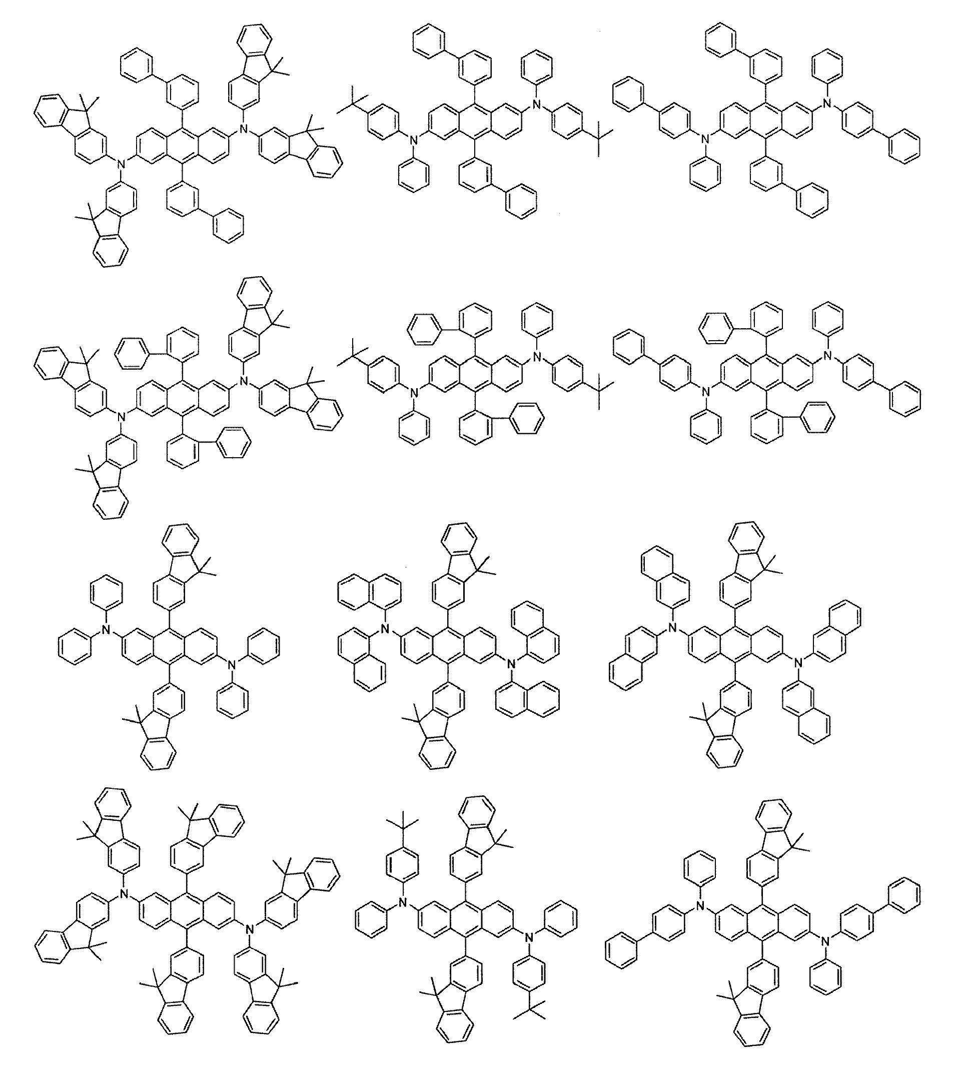

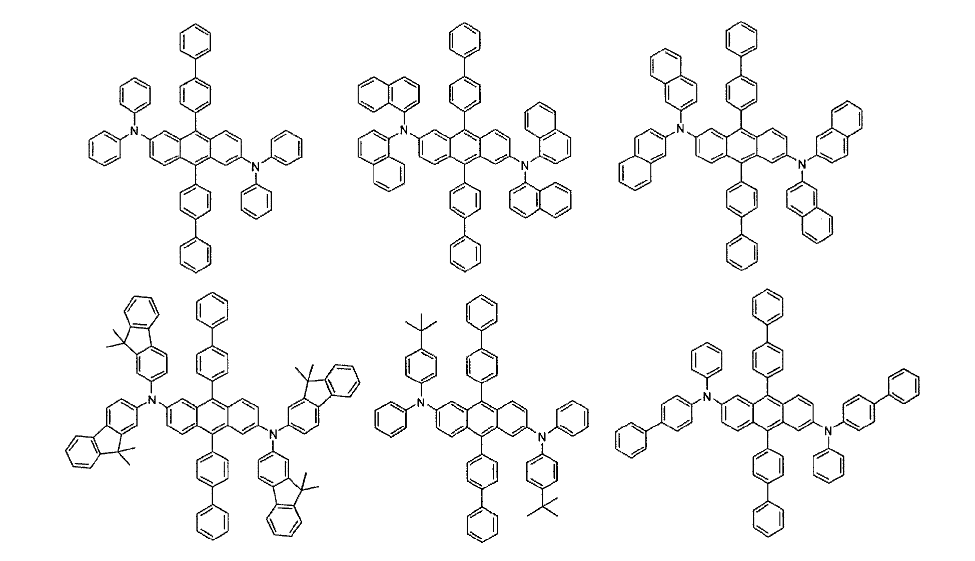

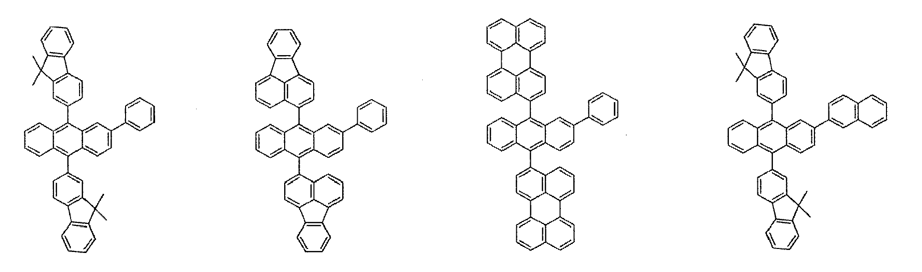

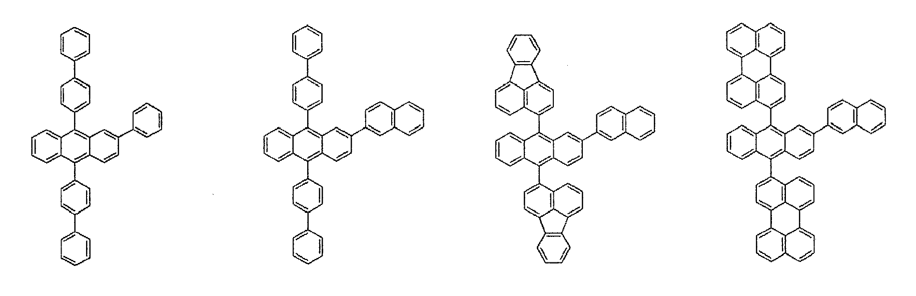

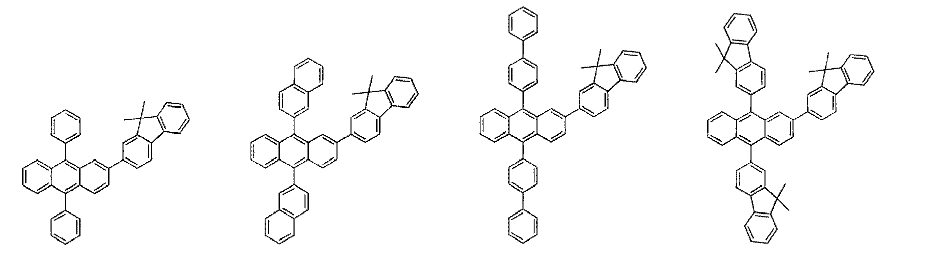

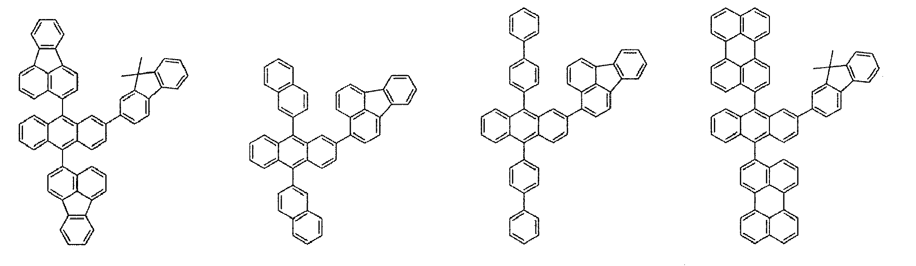

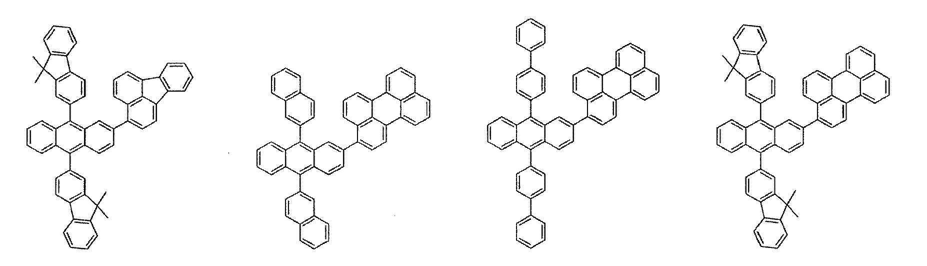

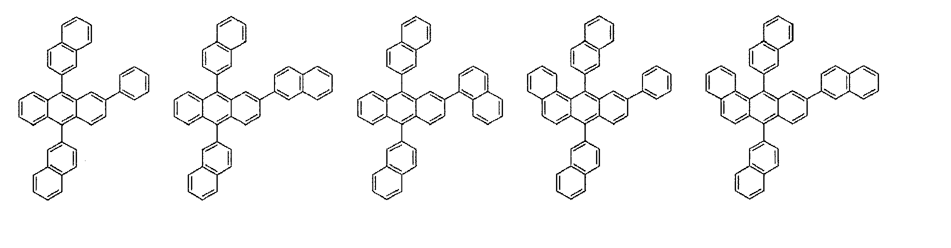

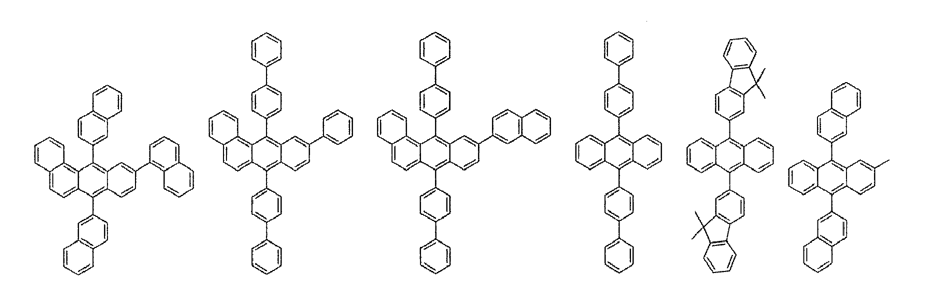

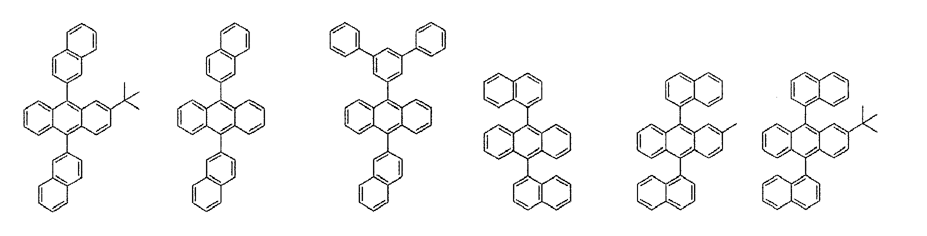

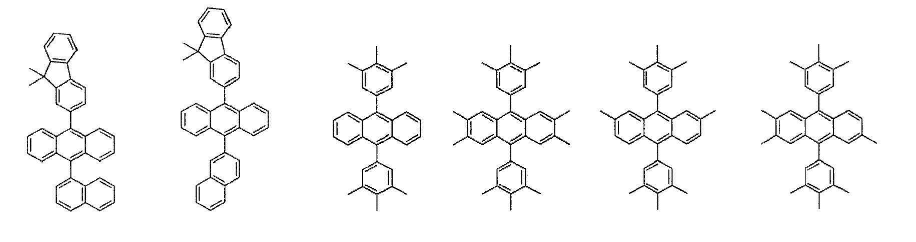

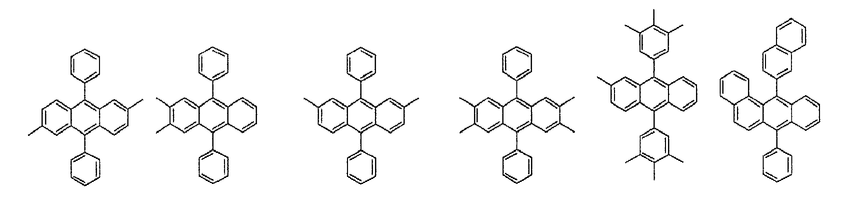

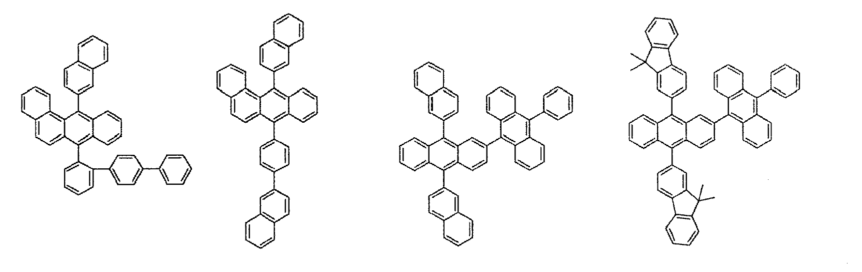

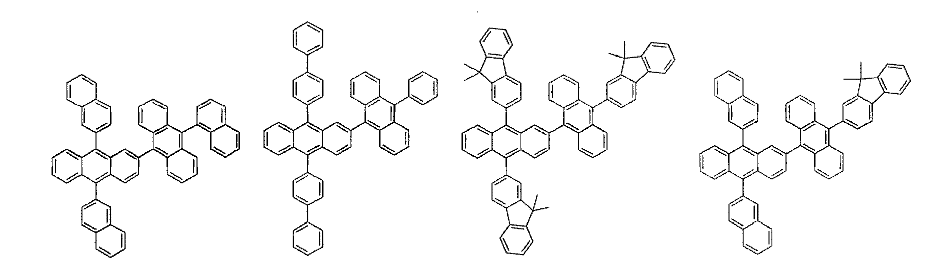

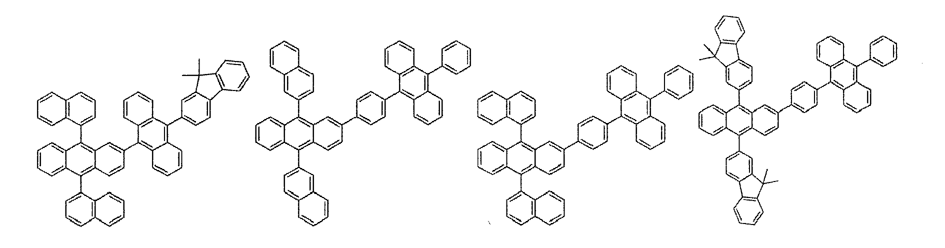

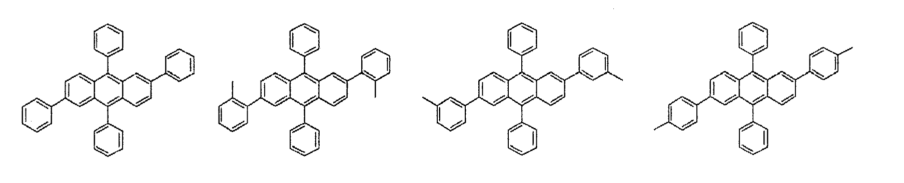

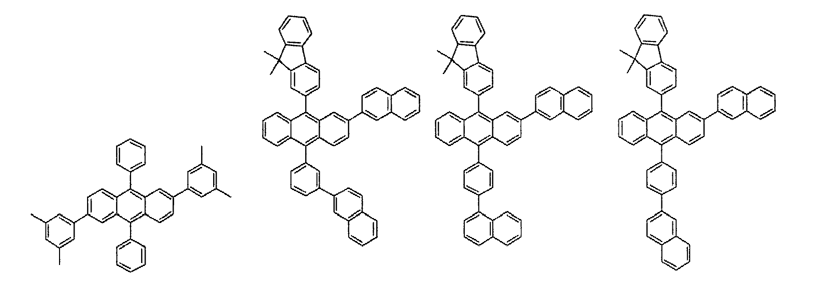

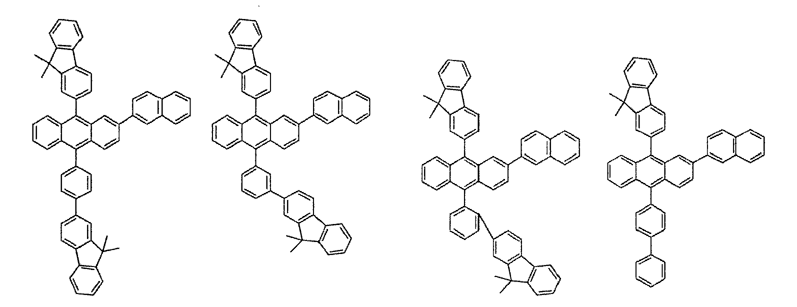

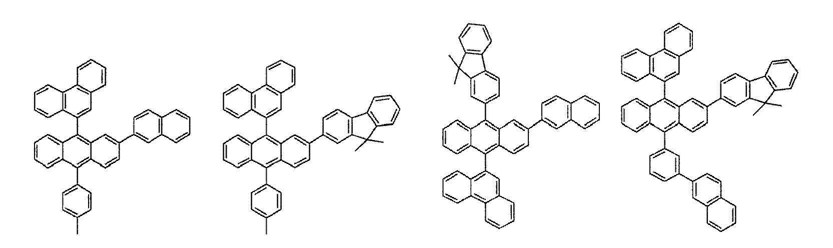

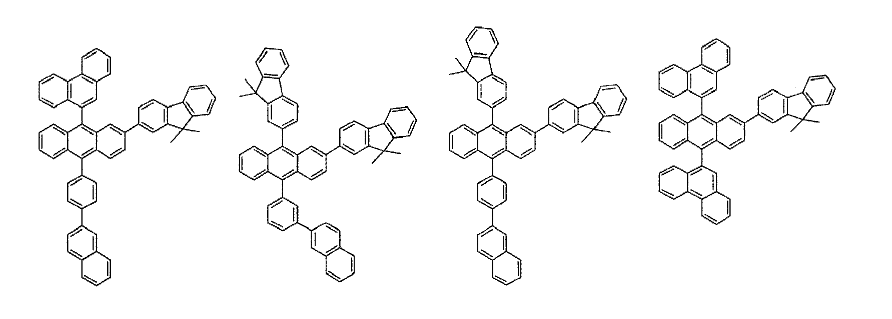

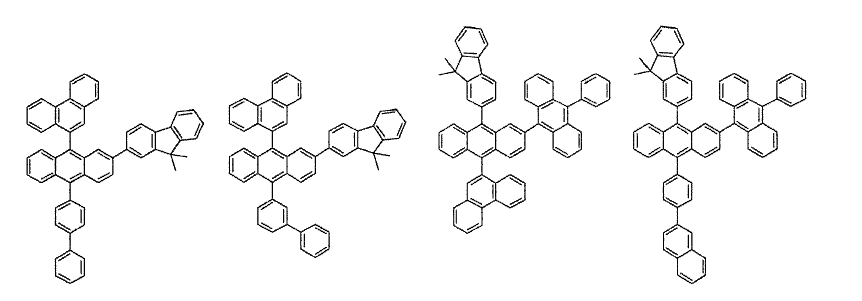

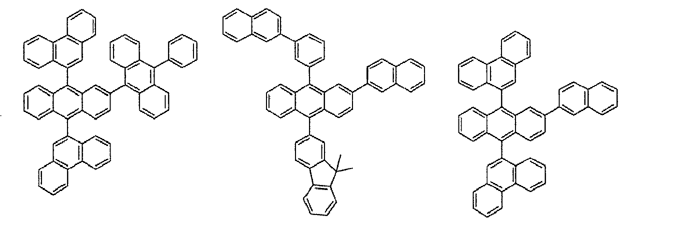

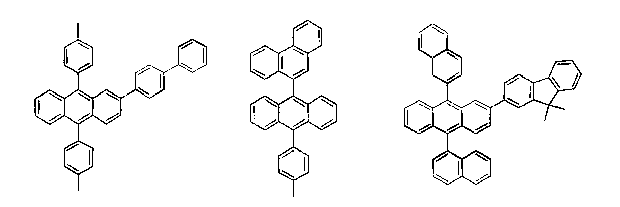

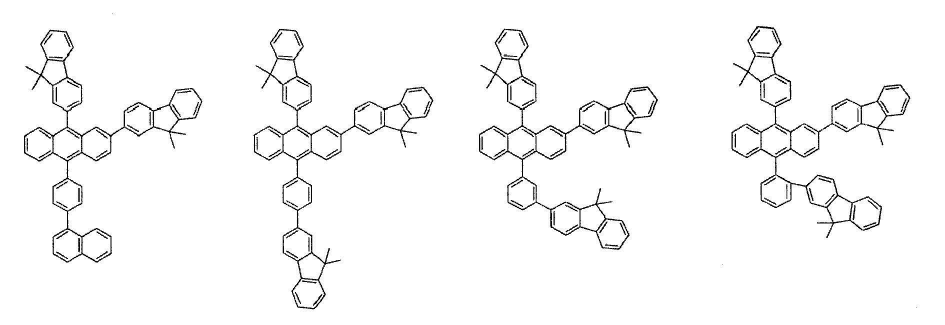

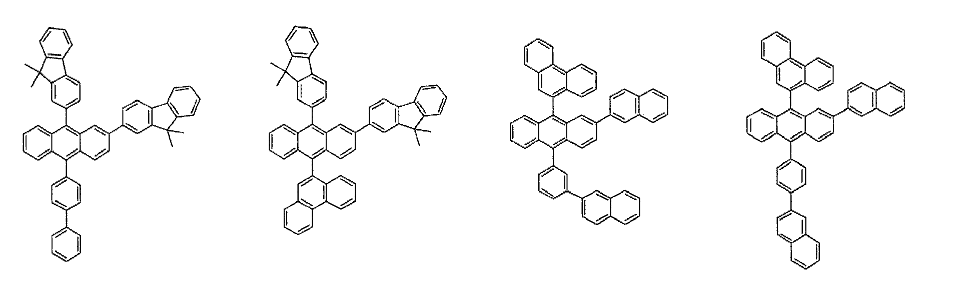

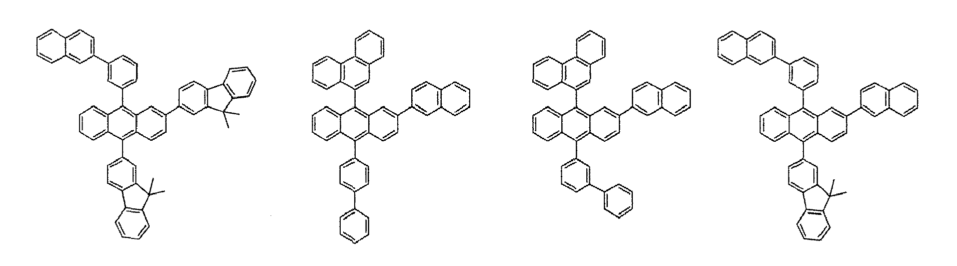

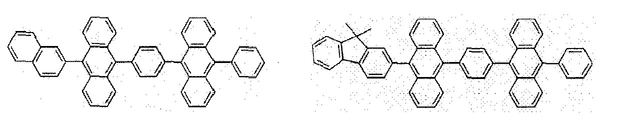

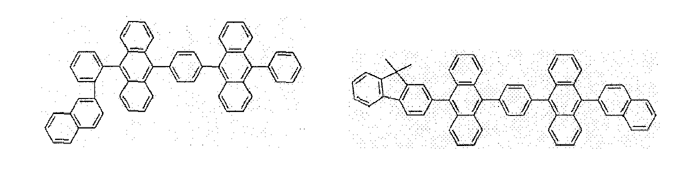

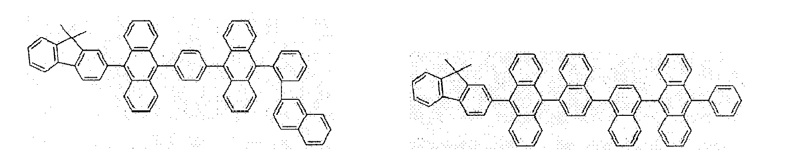

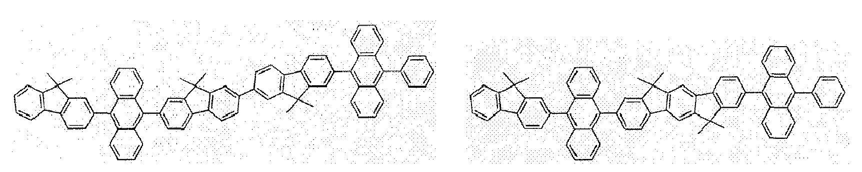

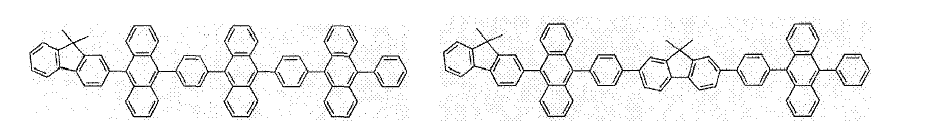

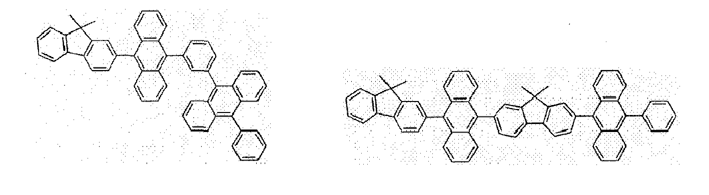

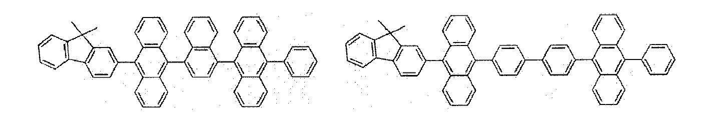

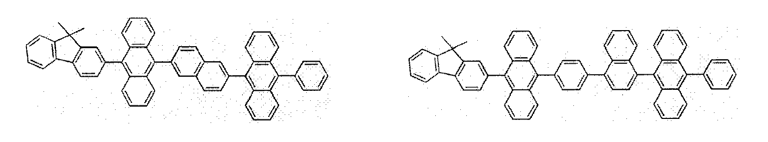

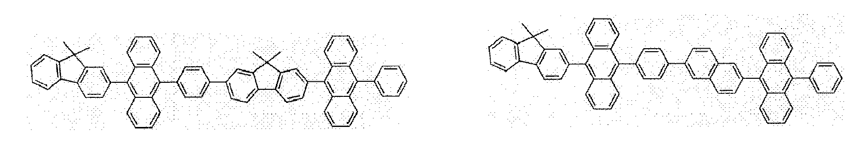

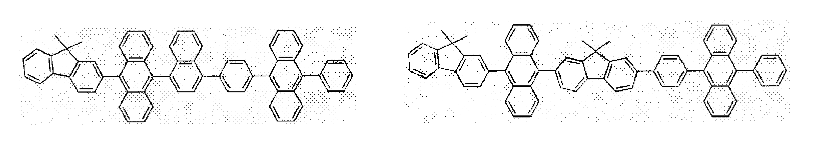

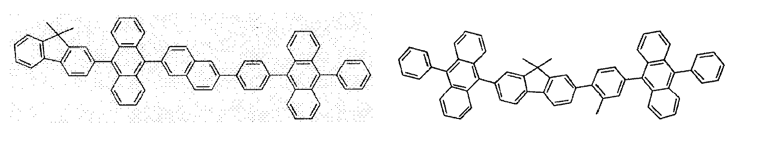

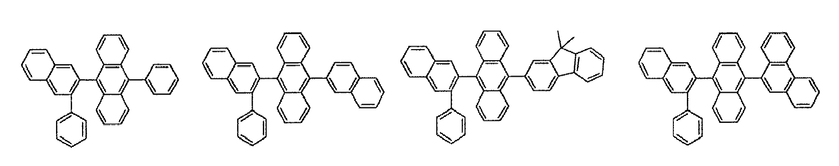

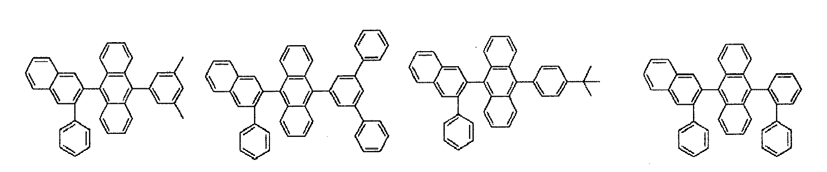

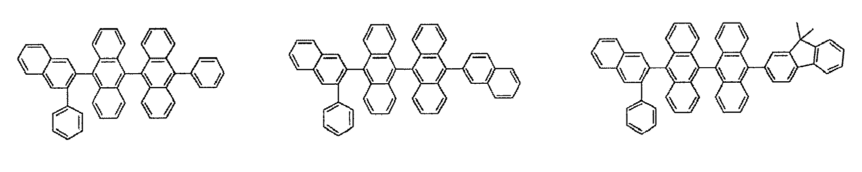

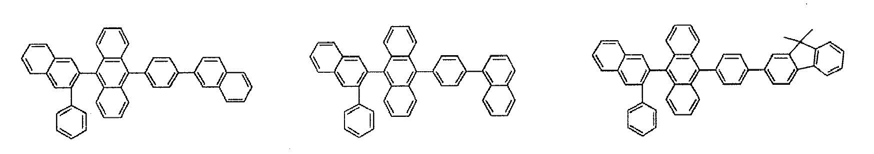

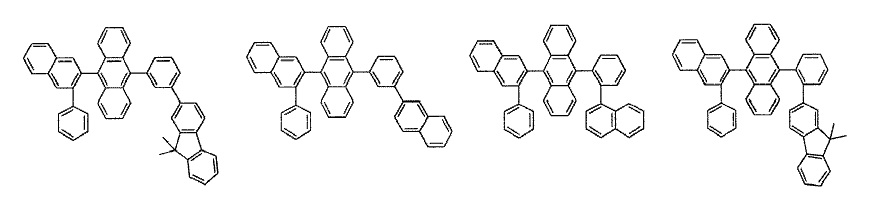

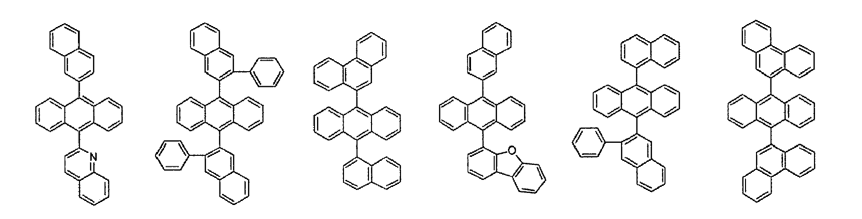

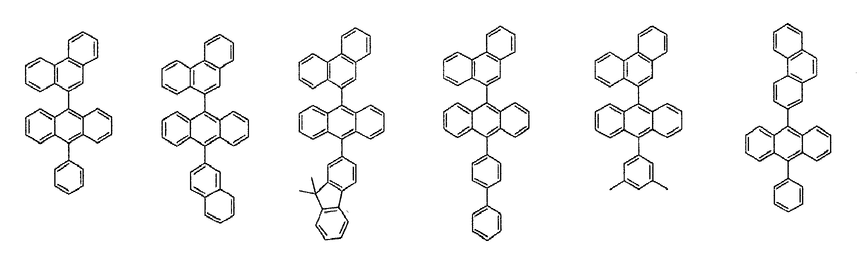

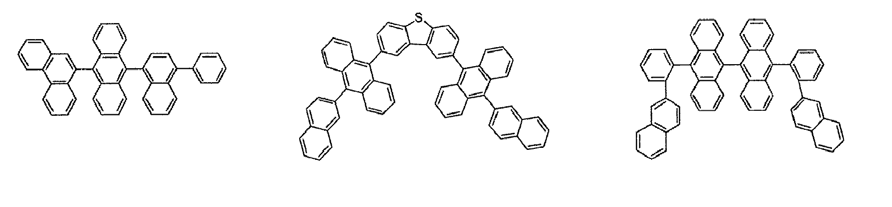

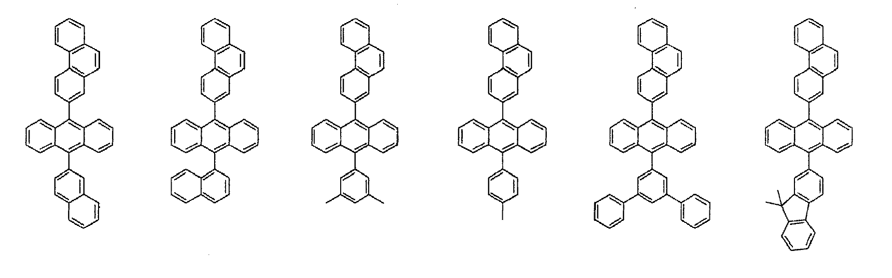

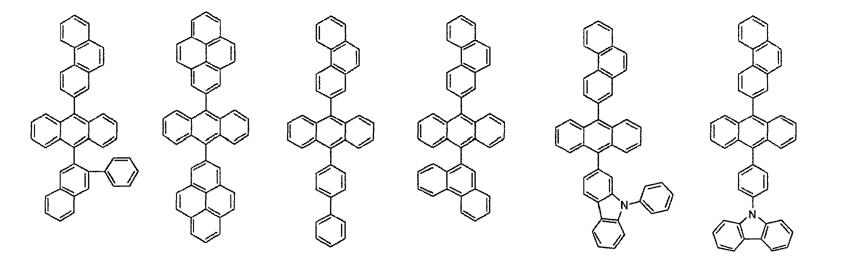

In an organic electroluminescent device according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of lanthanides or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the invention, having a backbone of more excellent EL properties and thermal stability than conventional phosphorescent materials, provide higher quantum efficiency and lower operation voltage as compared to conventional materials. Thus, if an organic electroluminescent compound according to the present invention is applied to an OLED panel, further enhanced results are anticipated in development of OLED's having medium to large size. If the compound is applied to an organic solar cell as a material of high efficiency, more excellent properties are anticipated as compared to conventional materials.

### Best Mode

The present invention is further described with respect to the processes for preparing novel organic electroluminescent compounds according to the invention by referring to Examples, which are provided for illustration only but are not intended to limit the scope of the invention by any means.

### Preparation Examples

### [Preparation Example 1] Preparation of Compound (104)

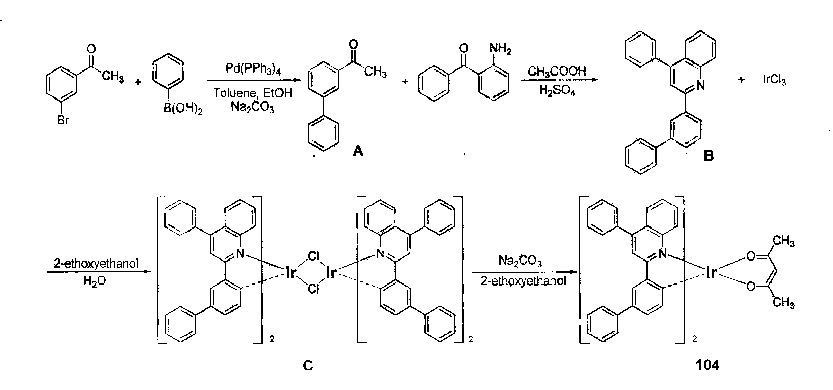

### Preparation of Compound (A)

In toluene (180 mL) and ethanol (90 mL), dissolved were 3'-bromoacetophenone (15.0 g, 75.4 mmol), phenylboronic acid (11.0 g, 90.5 mmol) and tetrakispalladium (0) triphenylphosphine (Pd(PPh₃)₄) (8.7 g, 7.5 mmol). Aqueous 2M sodium carbonate solution (180 mL) was added to the solution, and the mixture was stirred under reflux at 120°C for 4 hours. Then, the reaction mixture was cooled to 25°C, and the reaction was quenched by adding distilled water (200 mL). The mixture was extracted with ethyl acetate (300 mL), and the extract was dried under reduced pressure. Purification via silicagel column chromatography gave Compound (A) (10.1 g, 51.5 mmol).

### Preparation of Compound (B)

In acetic acid (172 mL), dissolved were Compound (A) (10.1 g, 51.5 mmol) and 2-aminobenzophenone (10.2 g, 51.5 mmol). Sulfuric acid (H₂SO₄) was added thereto, and the mixture was stirred at 130°C under reflux. When the reaction was completed, excess amount of NH₄OH was added to the reaction mixture, which was then extracted in organic phase. Purification via column chromatography gave Compound (B) (13.4 g, 38.8 mmol).

### Preparation of Compound (C)

In 2-ethoxyethanol (220 mL) and distilled water (74 mL), dissolved were Compound (B) (13.4 g, 38.8 mmol) and iridium chloride (IrCl₃) (5.1 g, 17.1 mmol), and the solution was stirred under reflux for 24 hours. When the reaction was completed, the mixture was cooled at room temperature, with solid produced then. The solid was filtered and dried to obtain Compound (C) (9.1 g, 4.8 mmol).

### Preparation of Compound (104)

Compound (C) (9.1 g, 4.8 mmol), 2,4-pentanedione (1.0 g, 9.7 mmol) and Na₂CO₃ (2.6 g, 24.2 mmol) were dissolved in 2-ethoxyethanol (240 mL), and the solution was heated for 4 hours. When the reaction was completed, the reaction mixture was cooled to room temperature, and the solid precipitate produced was filtered. Purification via silicagel column chromatography and recrystallization gave Compound (104) (5.7 g, 2.7 mmol, overall yield: 16%) as red crystal.

According to the same procedure as Preparation Example 1, organic electroluminescent compounds (Compound 1 through Compound 997) in Table 1 were prepared, of which the ¹H NMR and MS/FAB data are listed in Table 2.

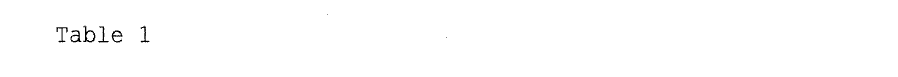

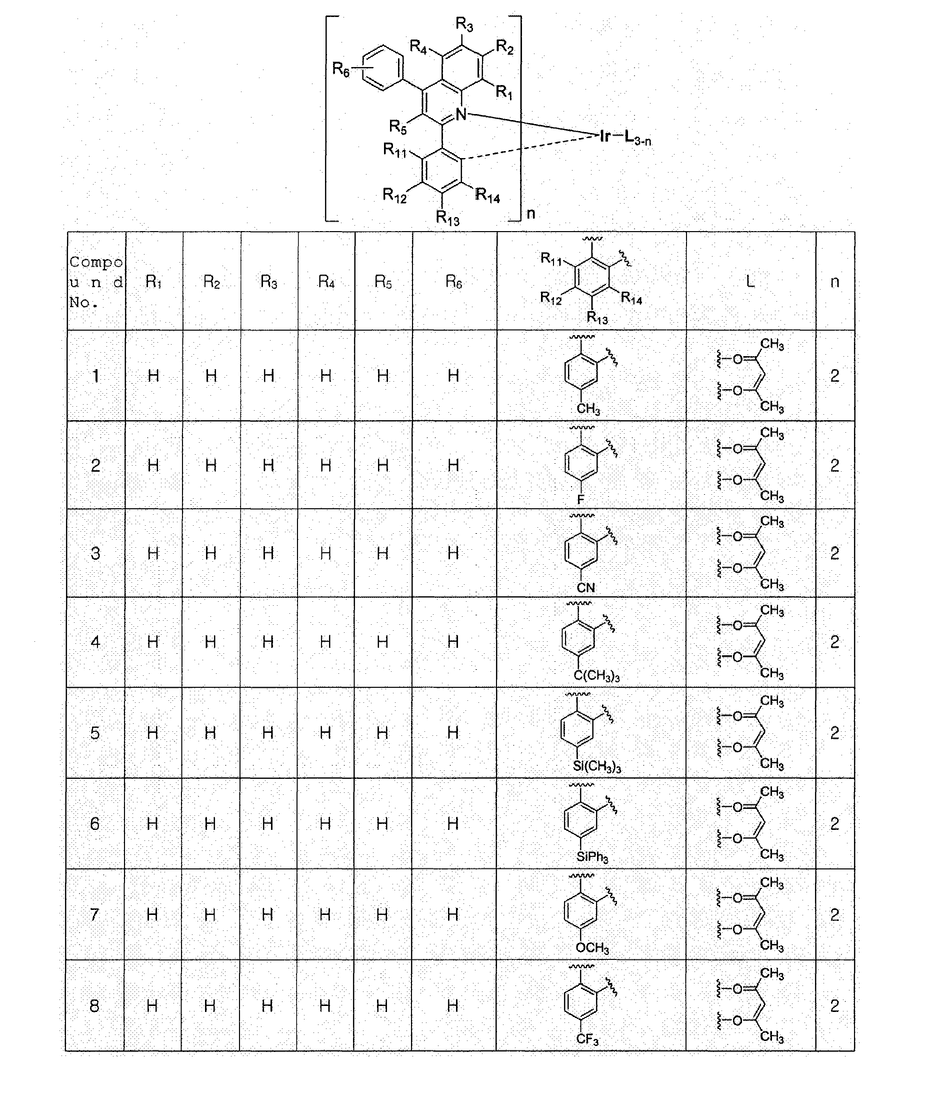

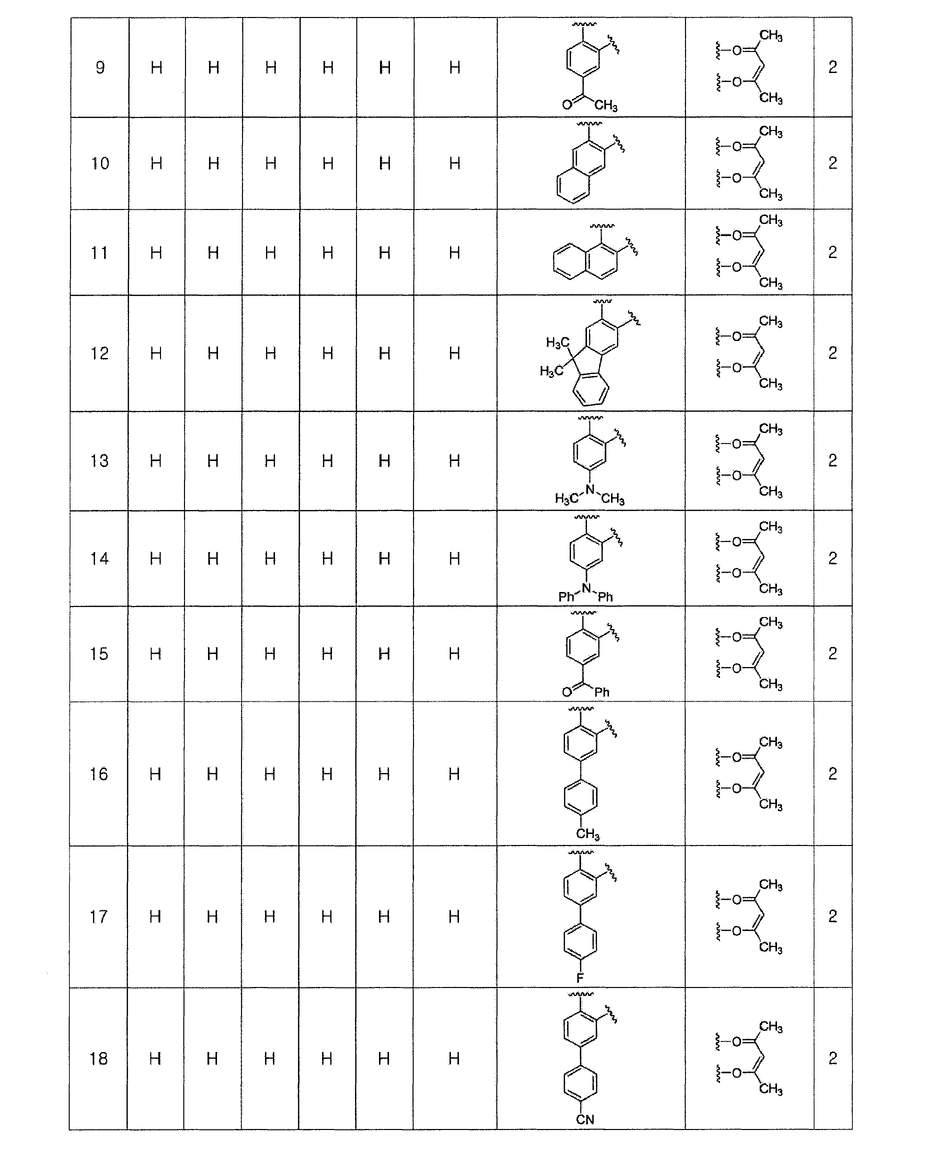

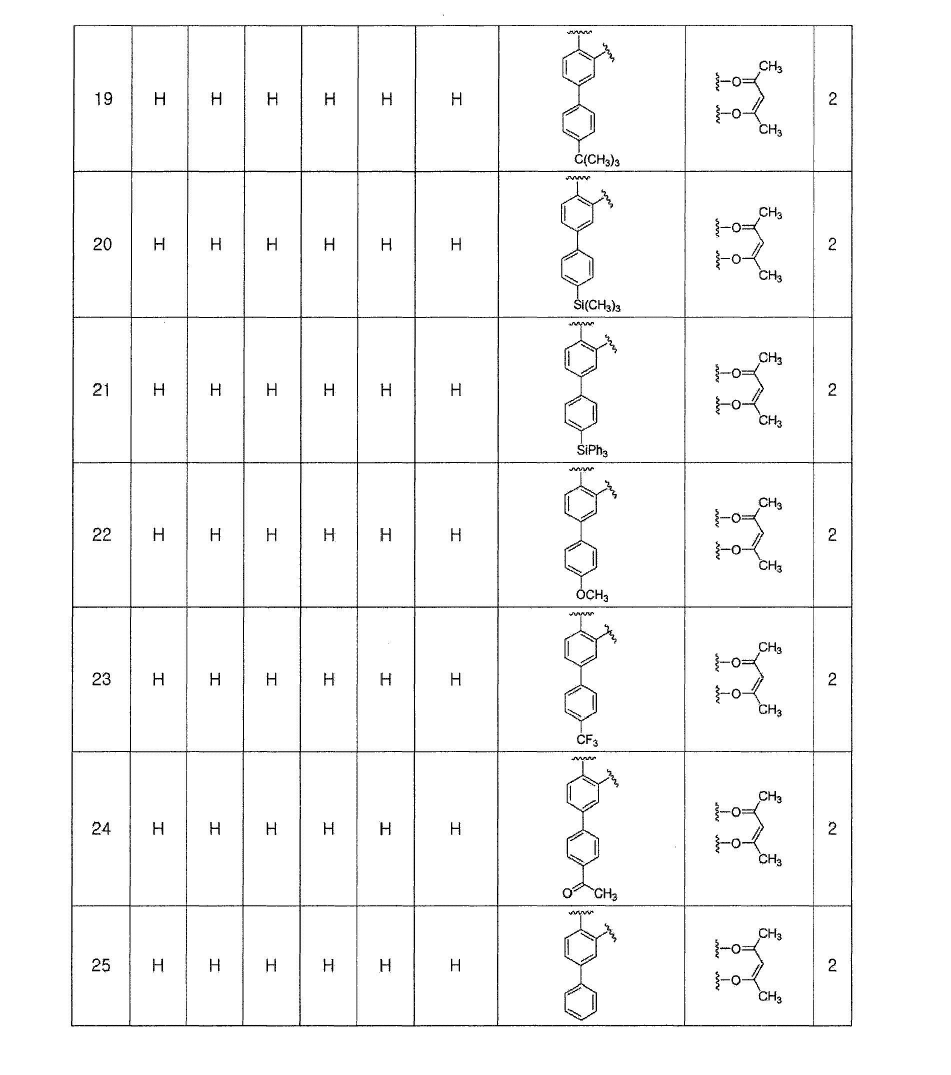

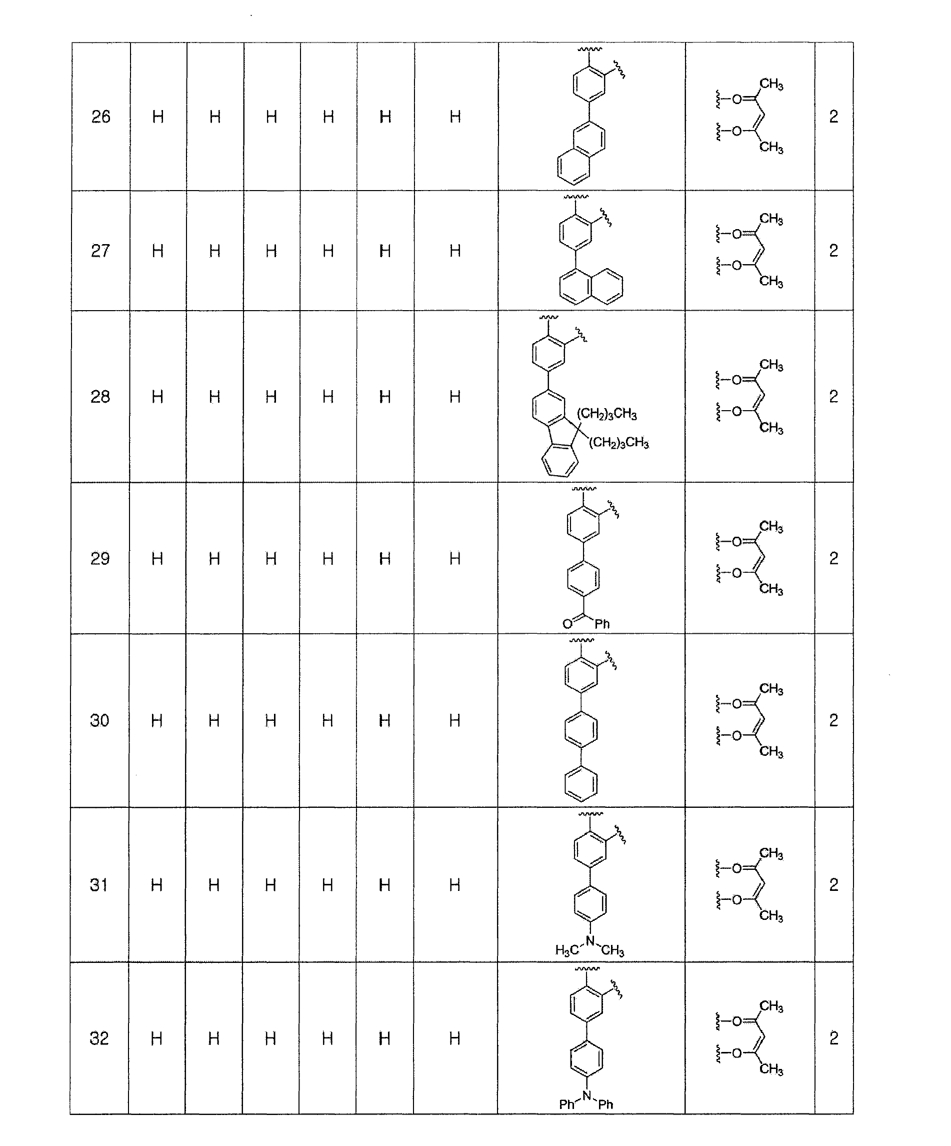

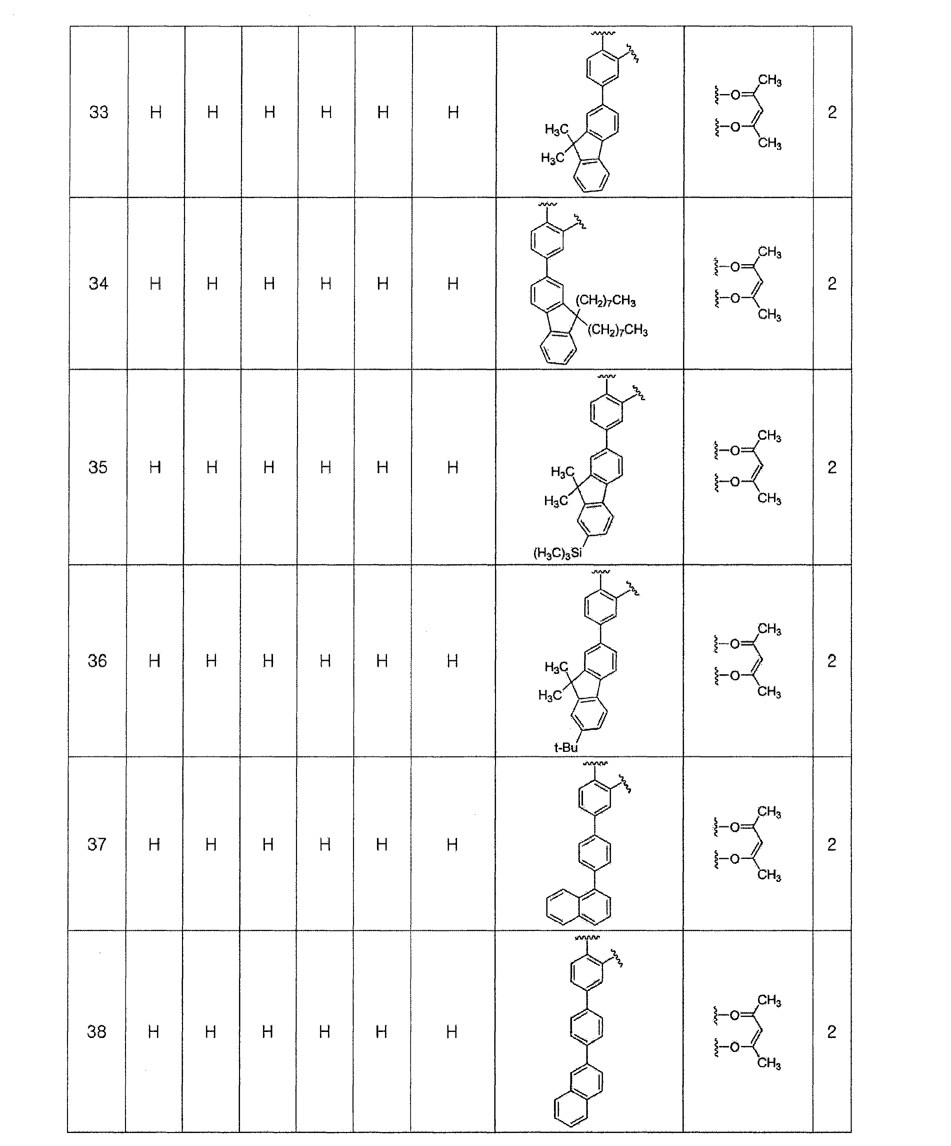

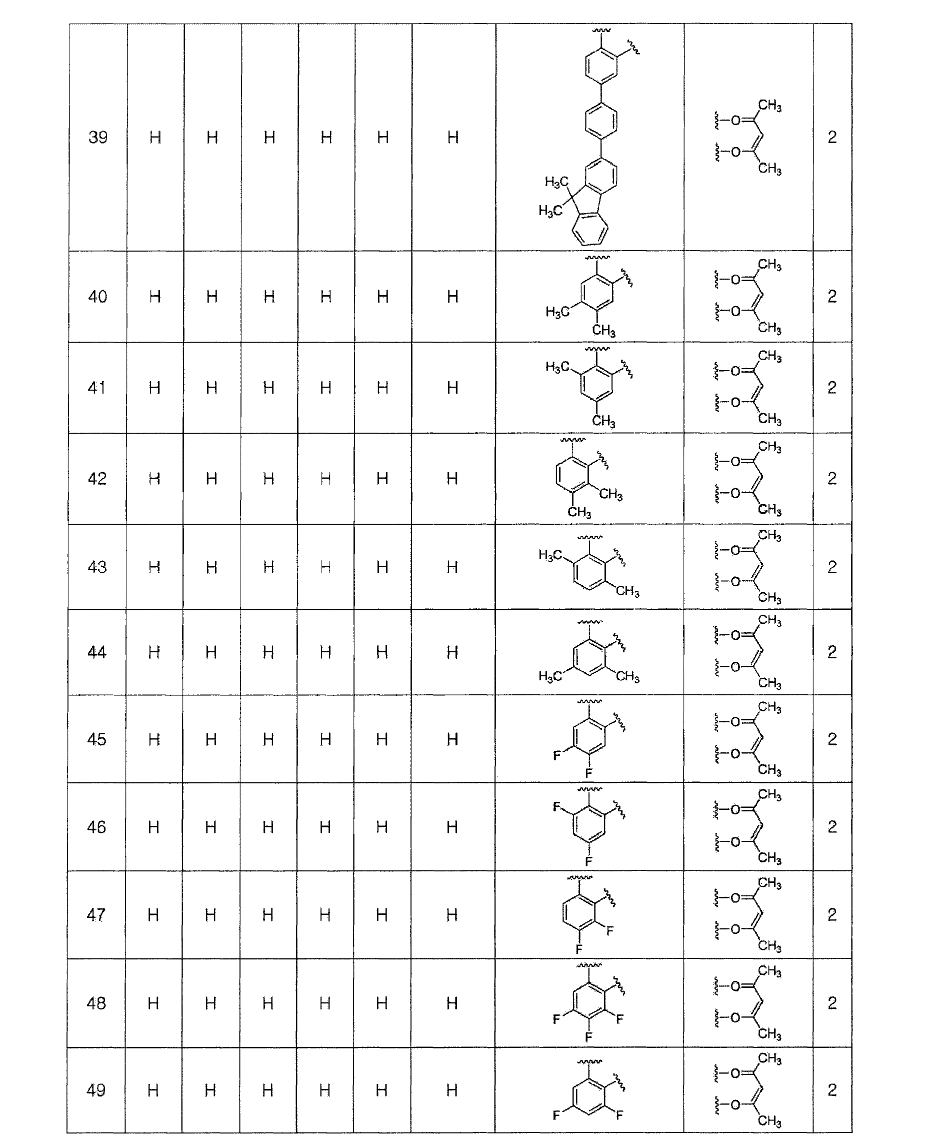

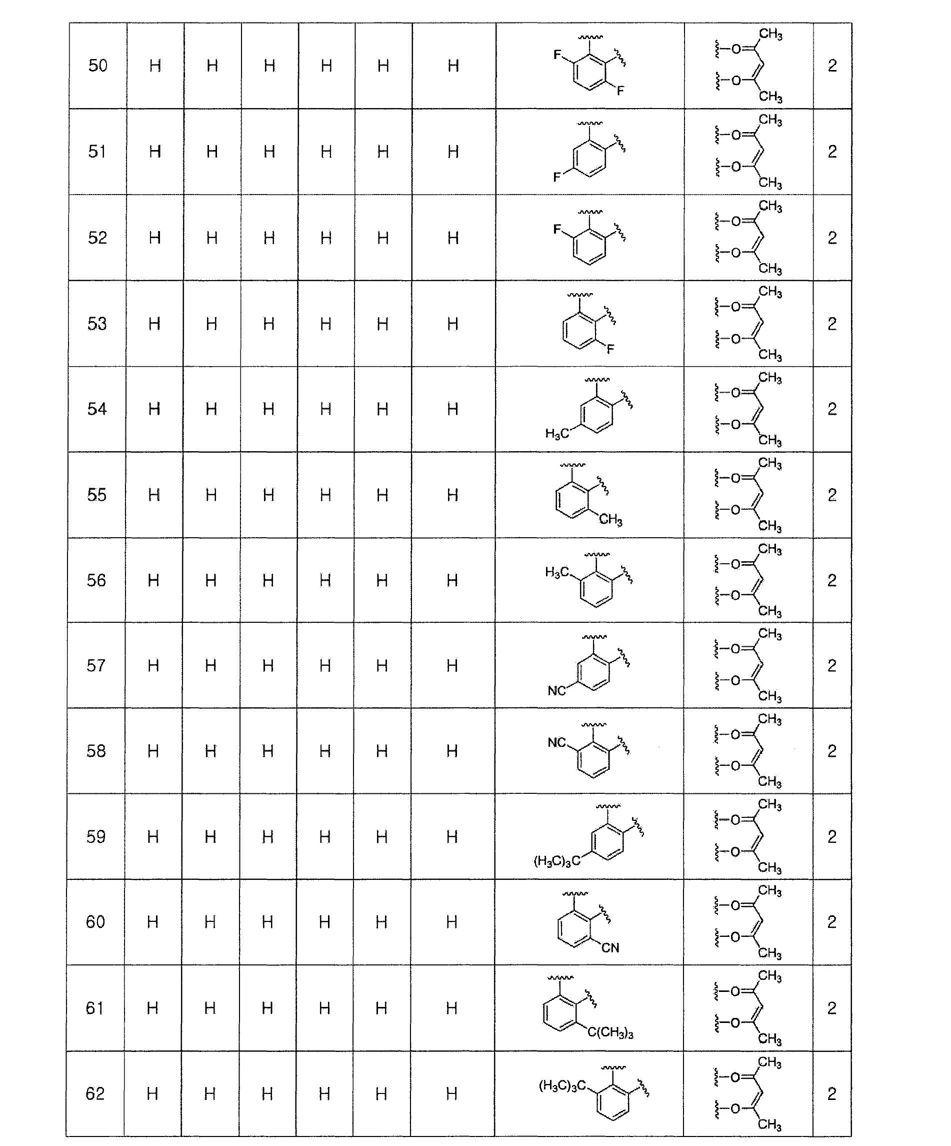

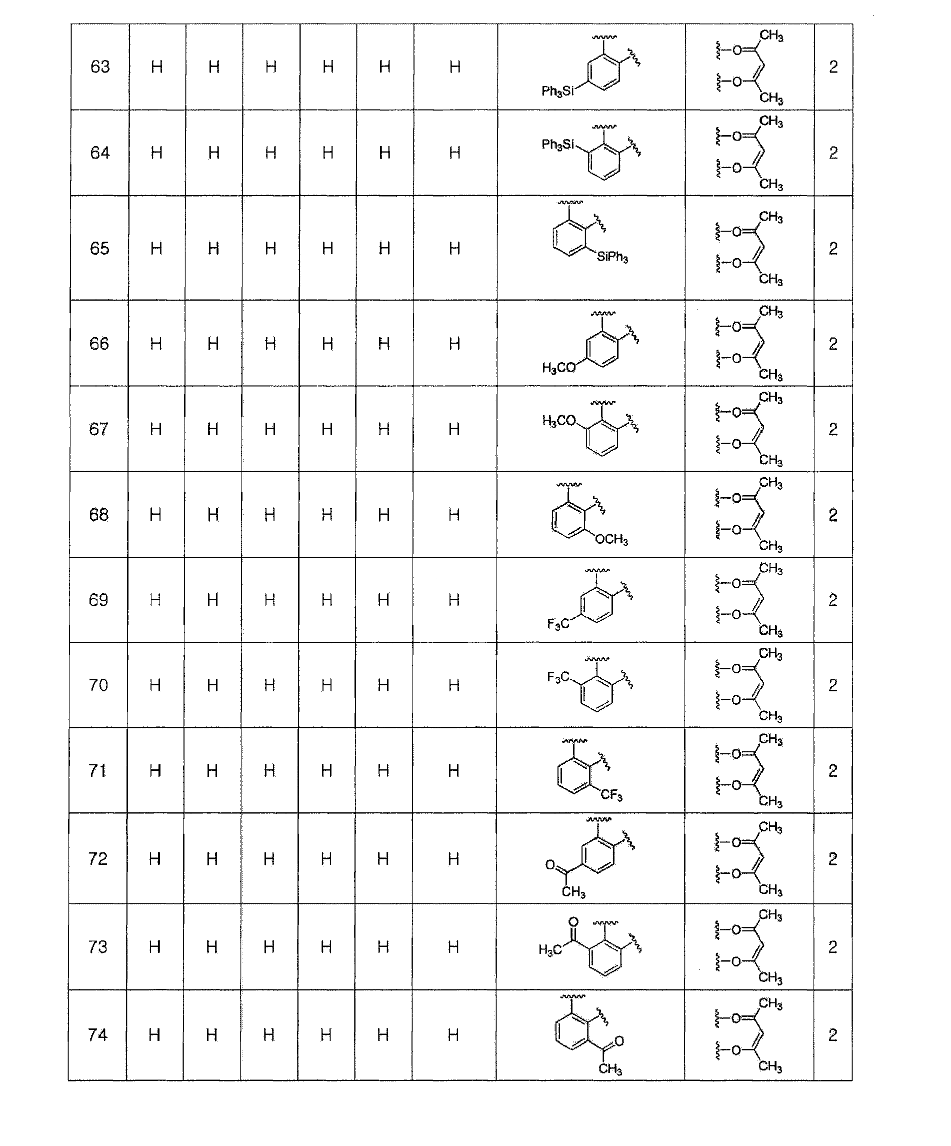

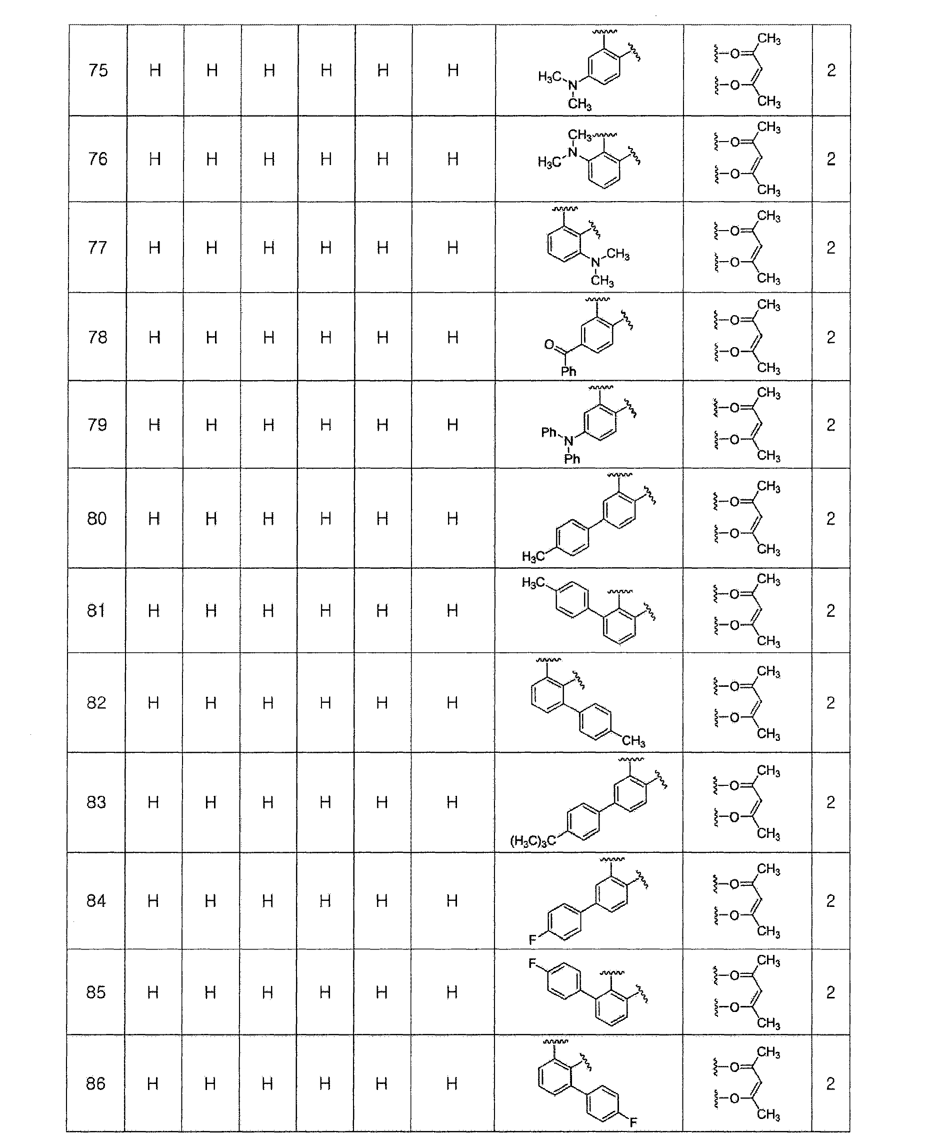

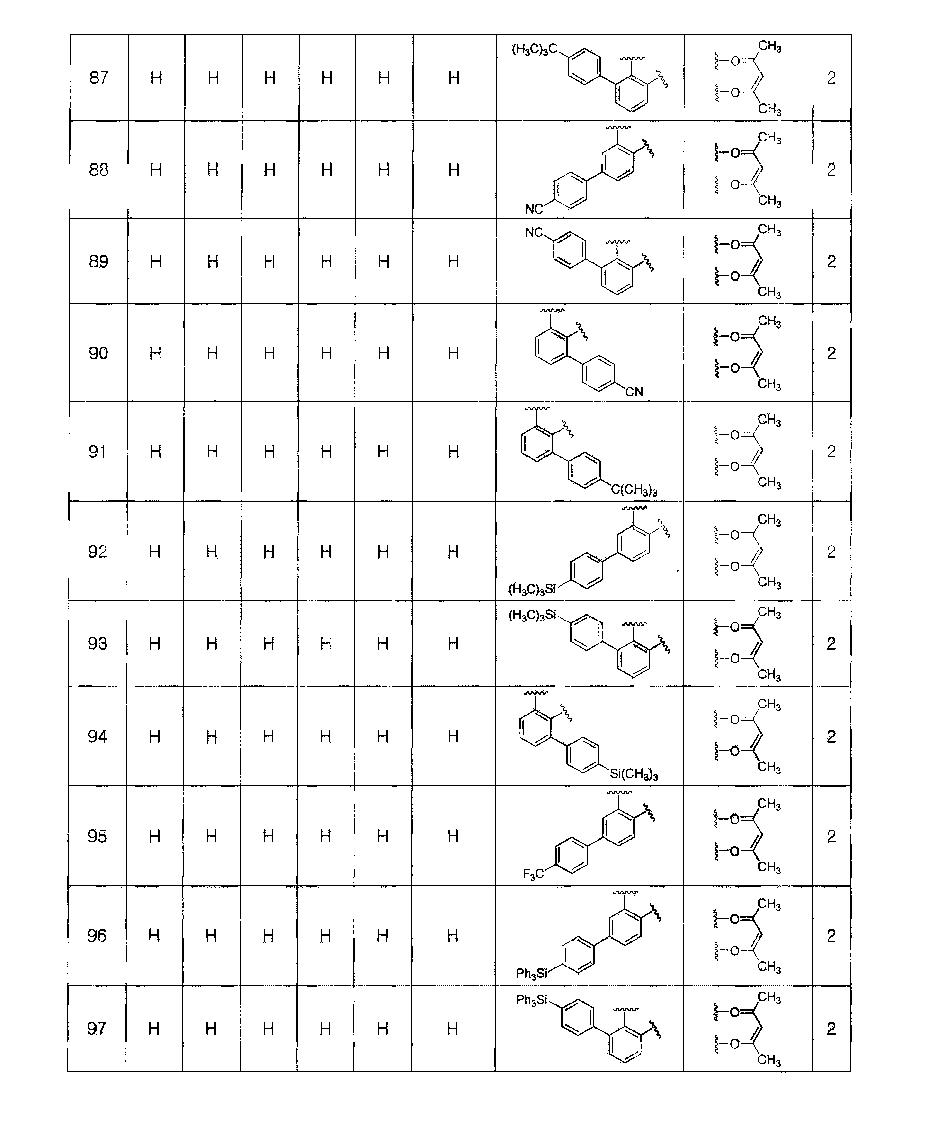

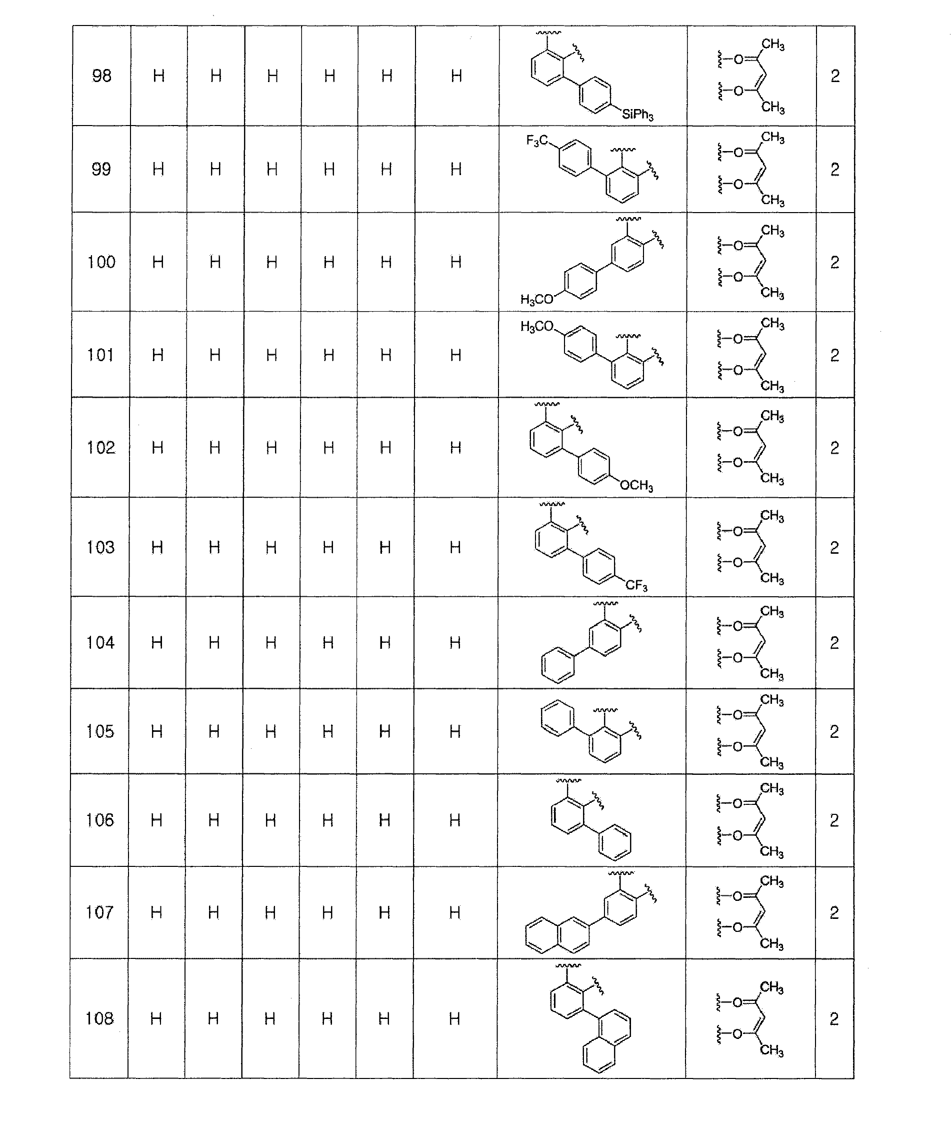

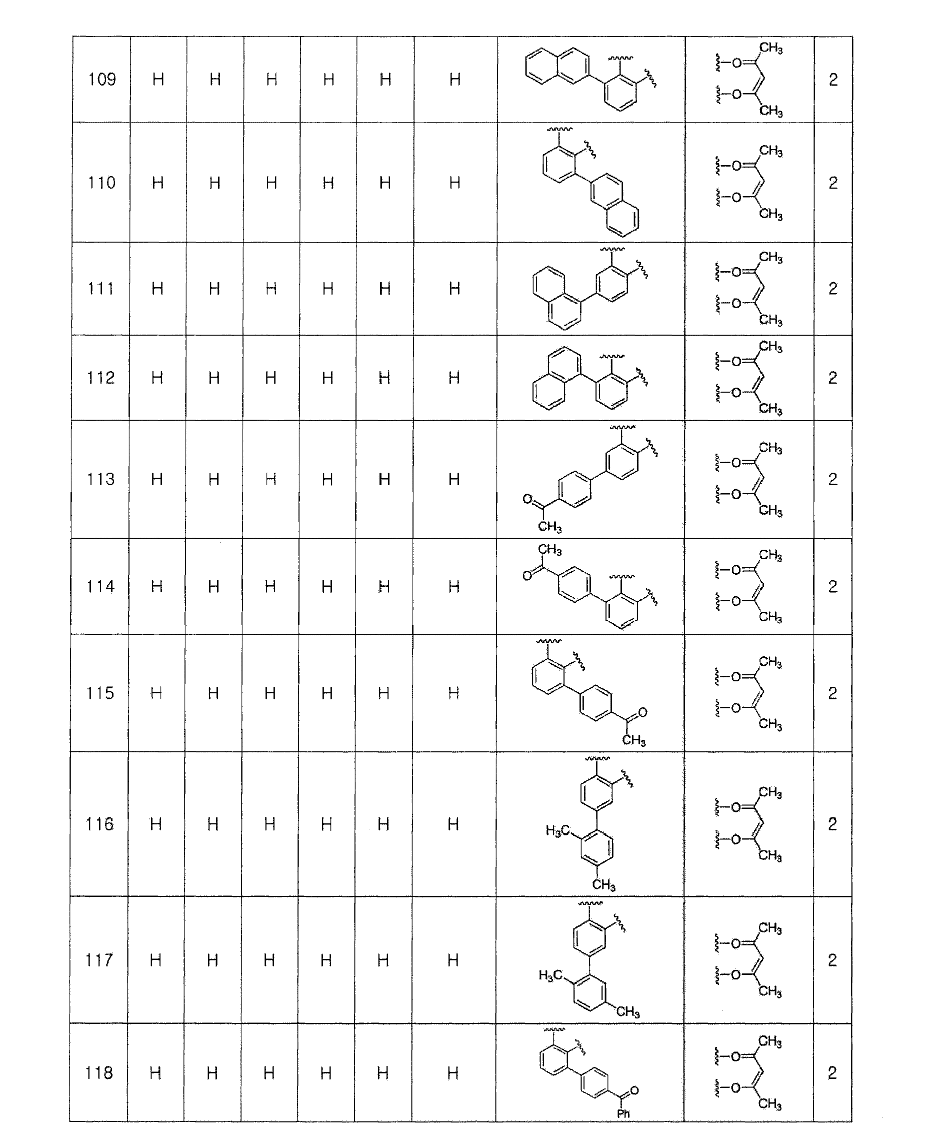

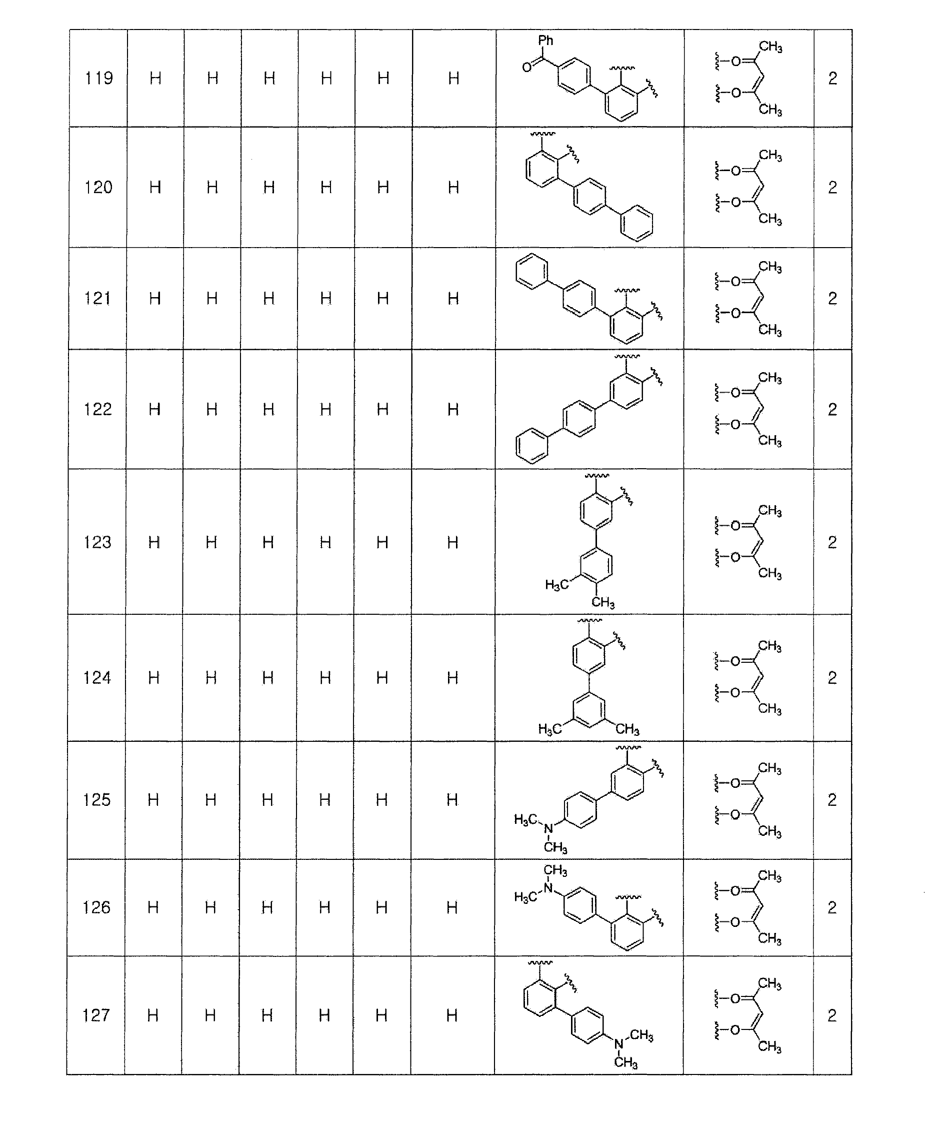

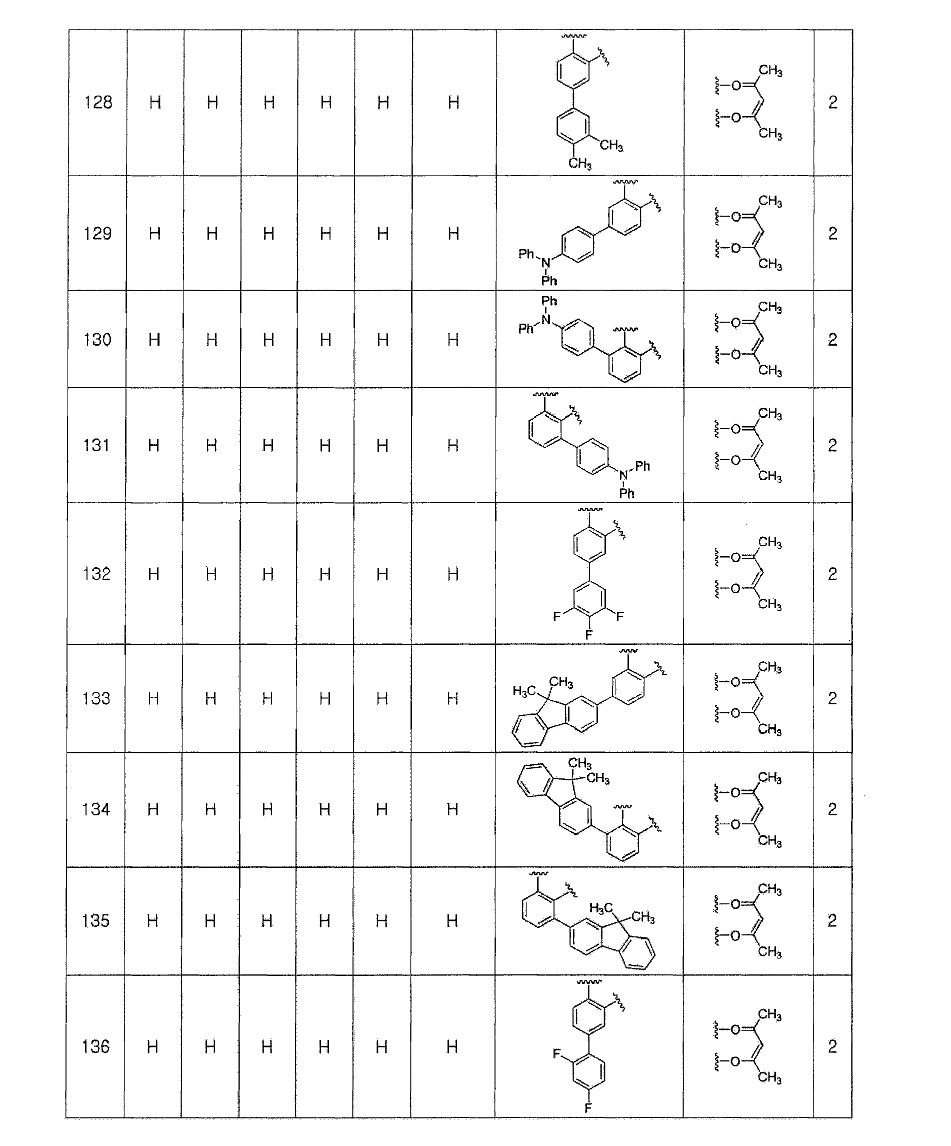

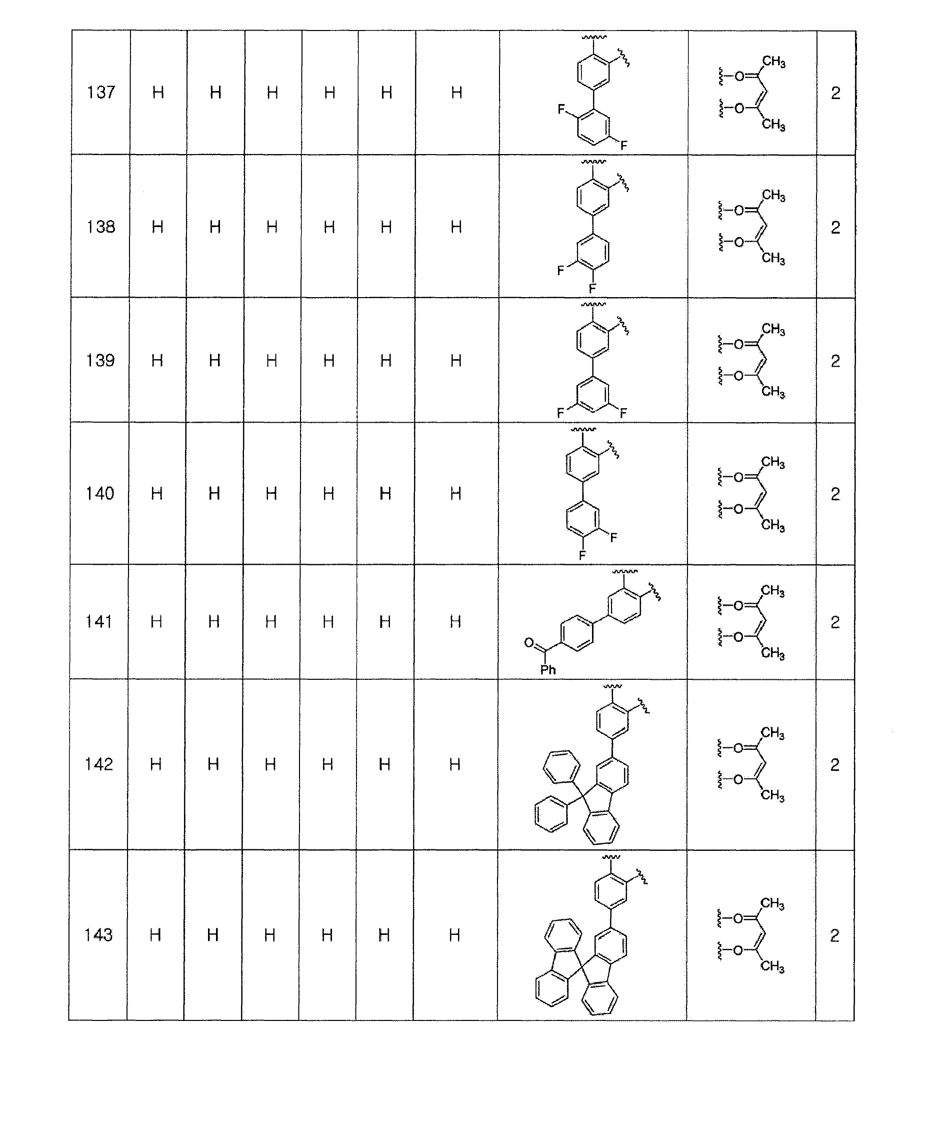

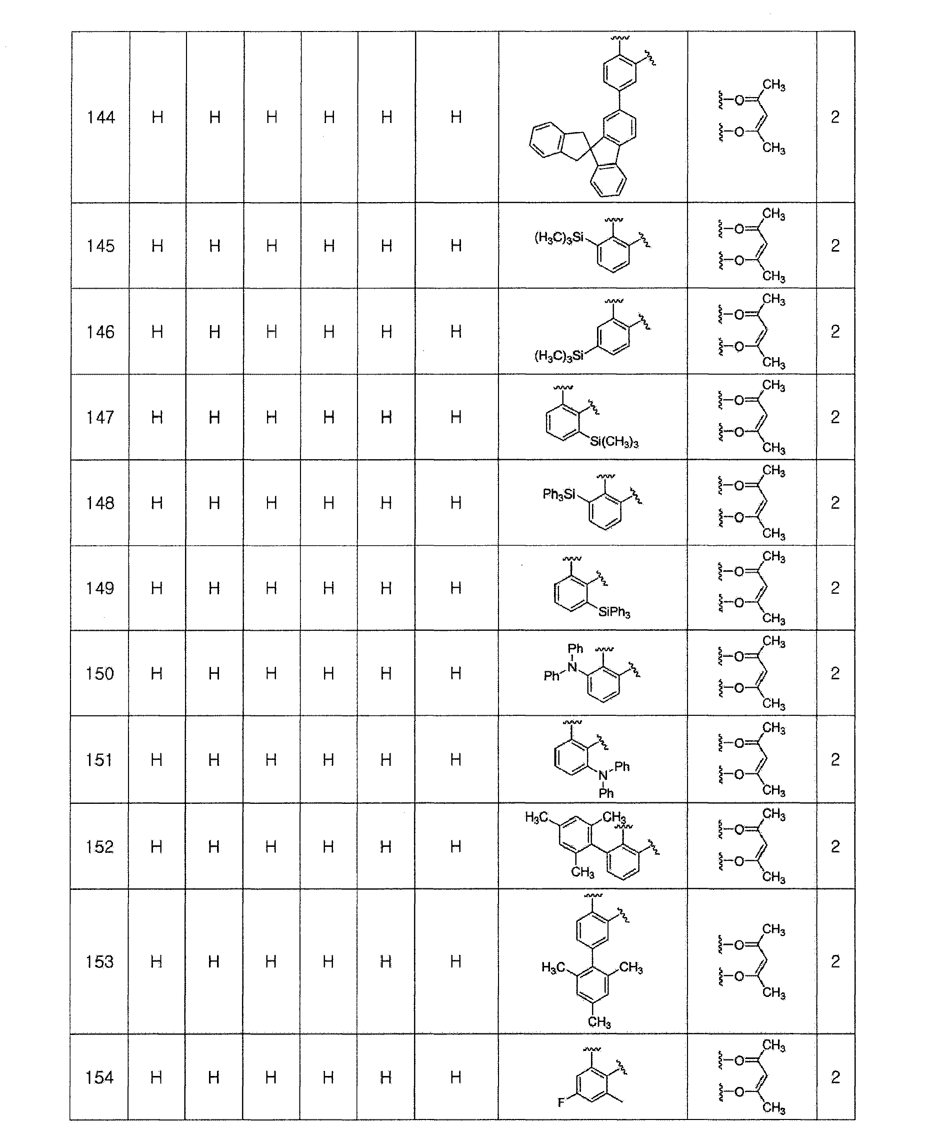

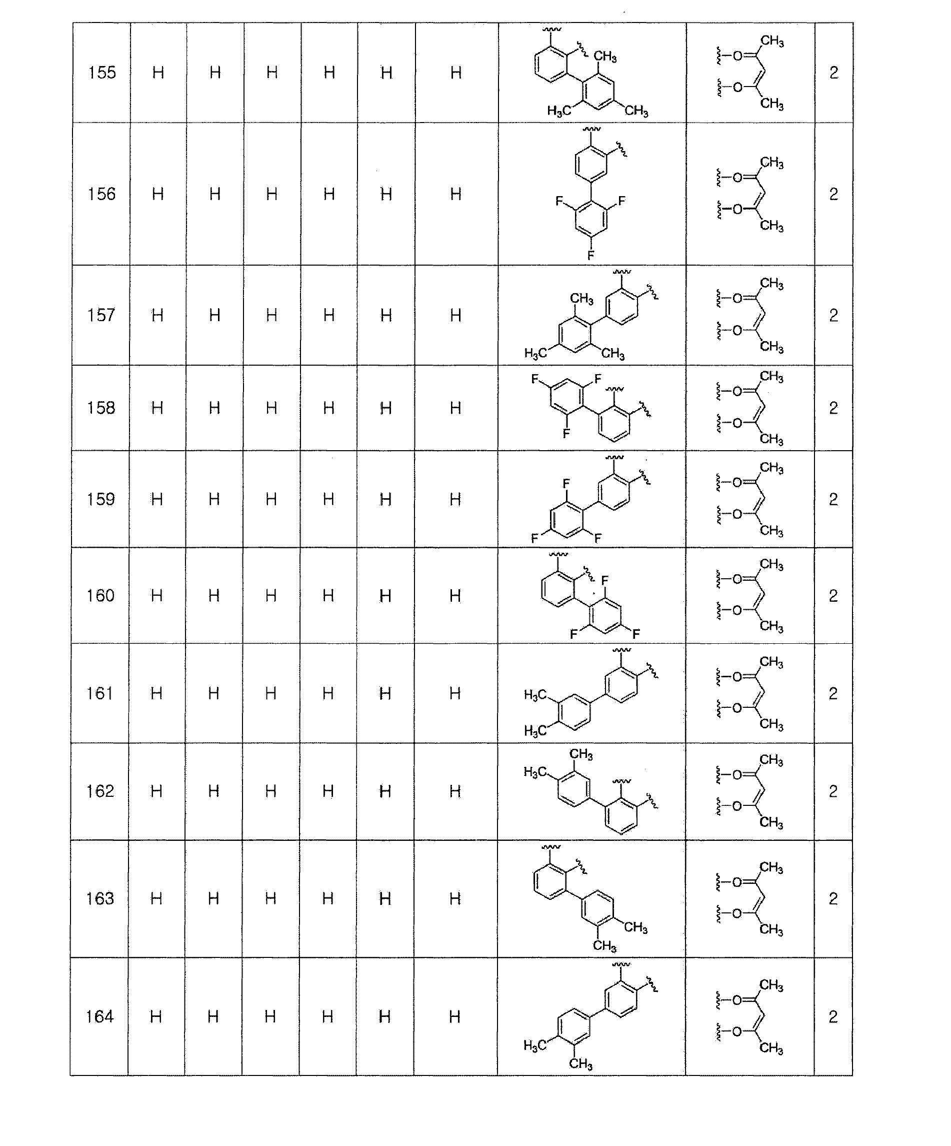

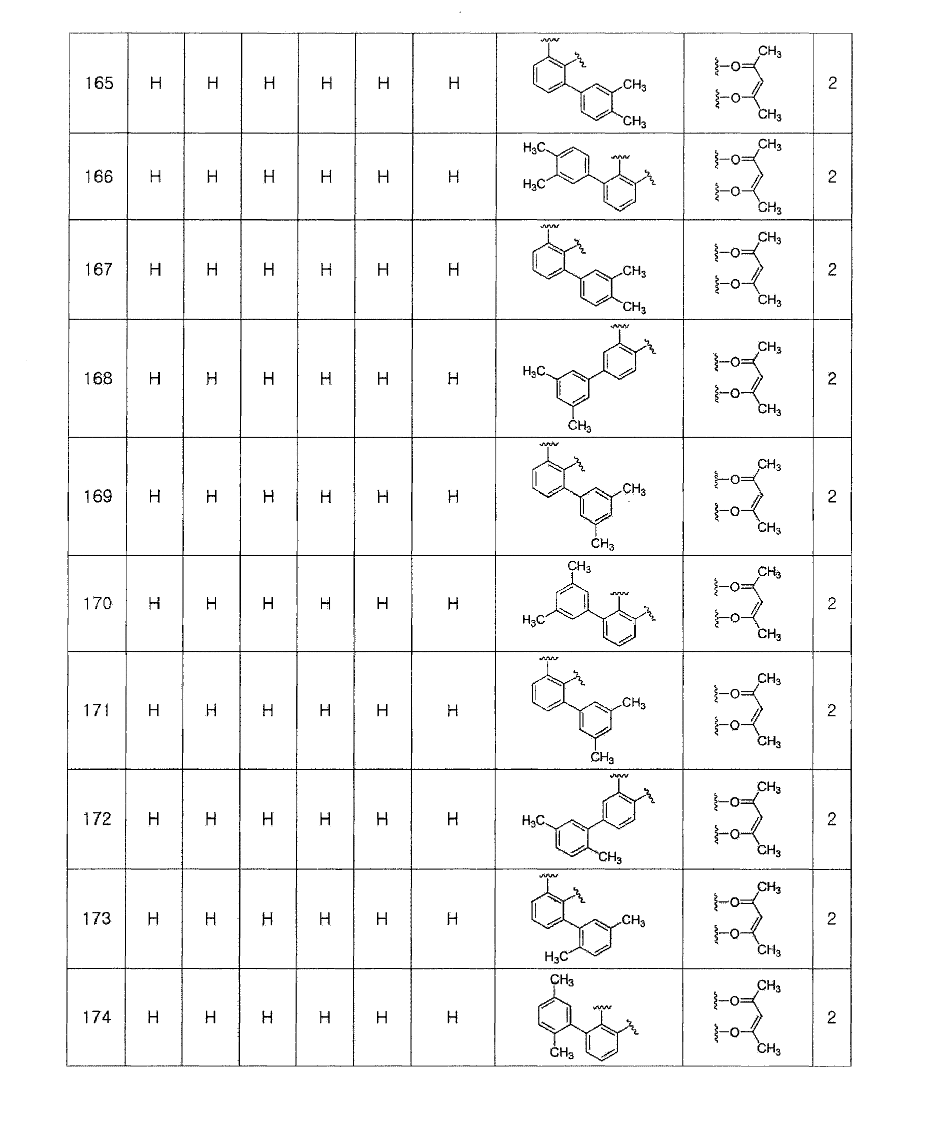

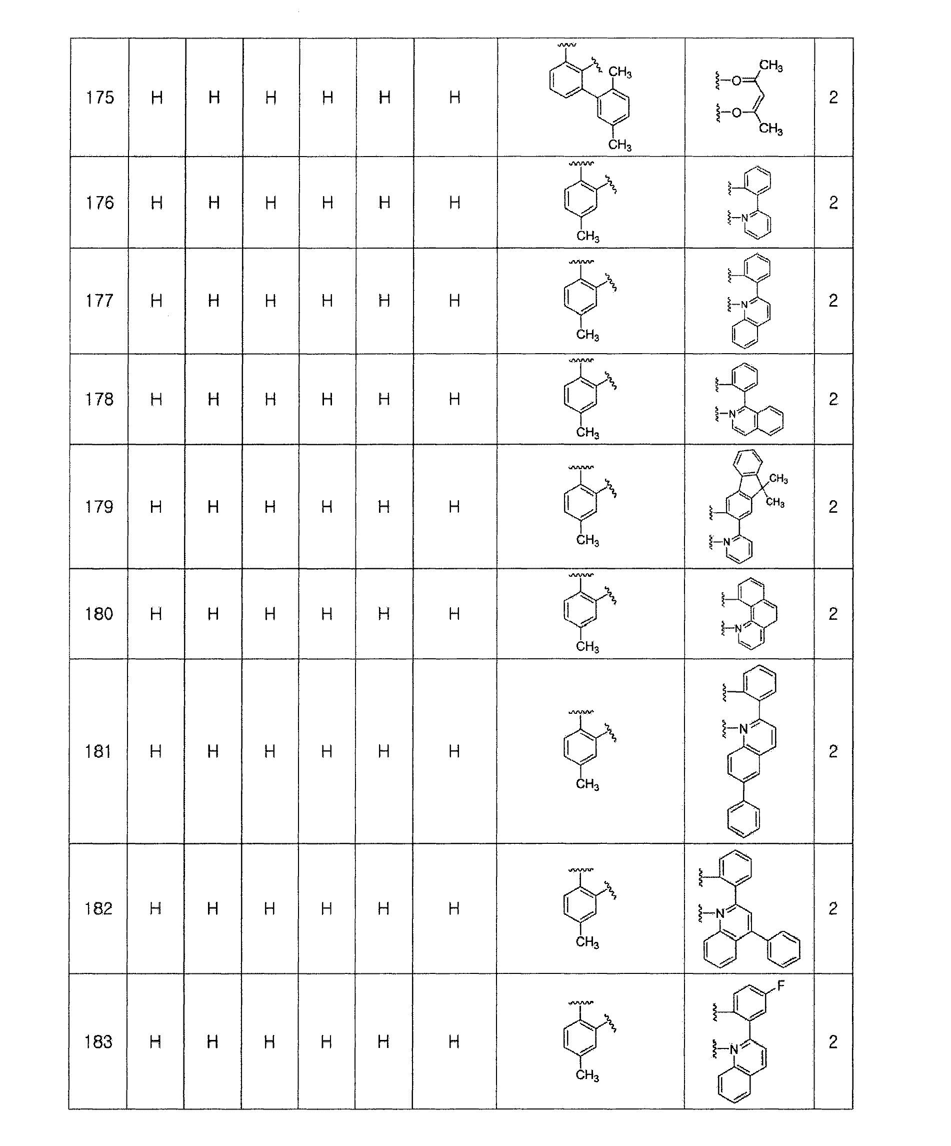

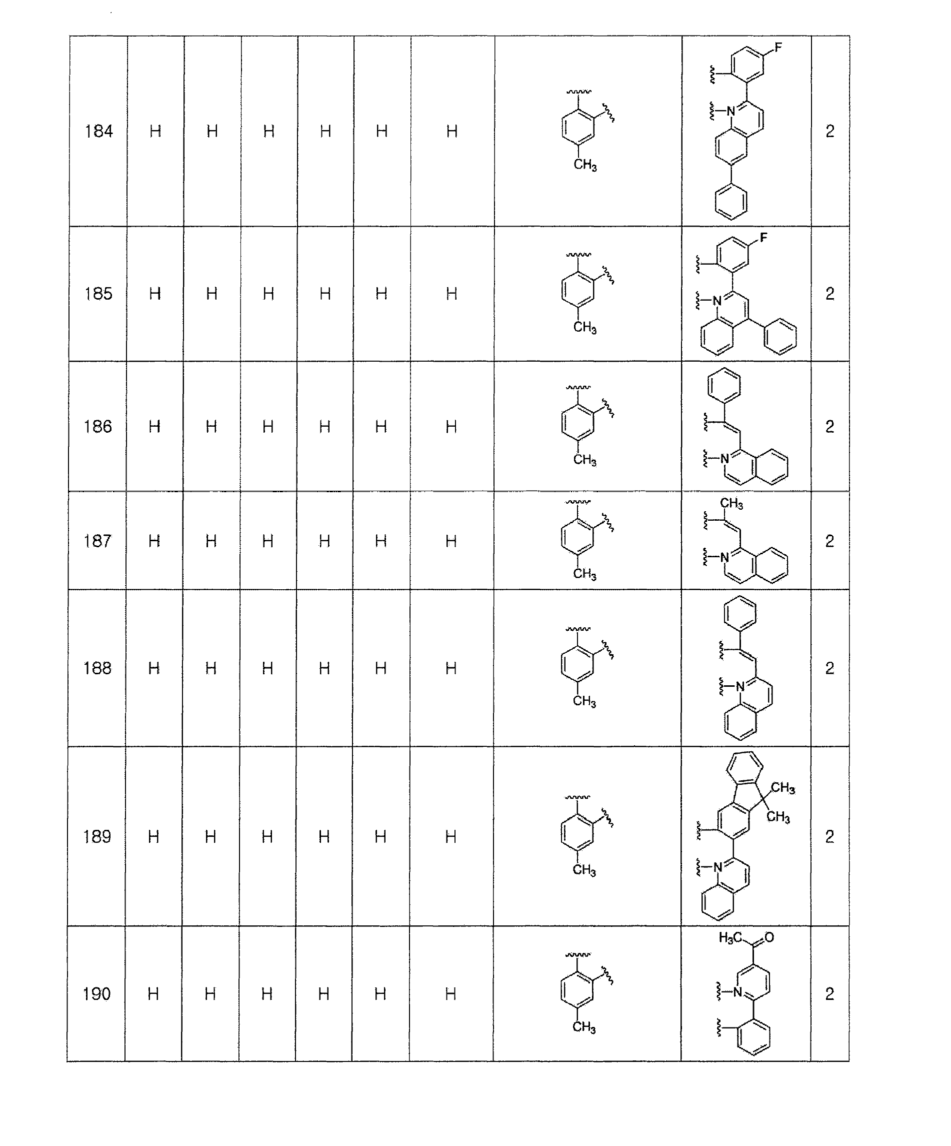

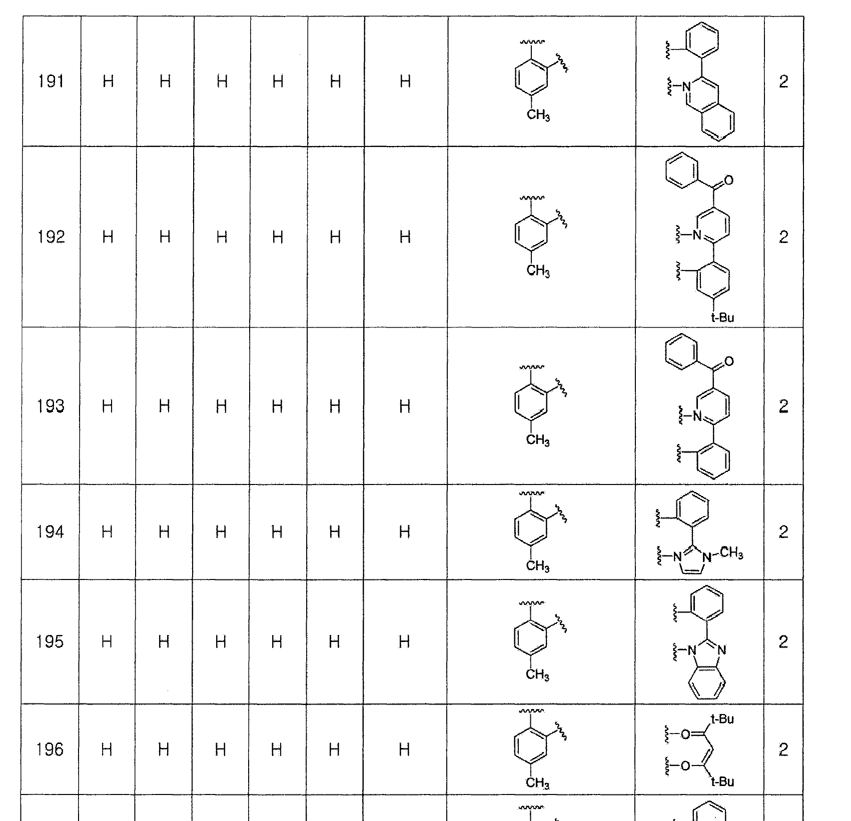

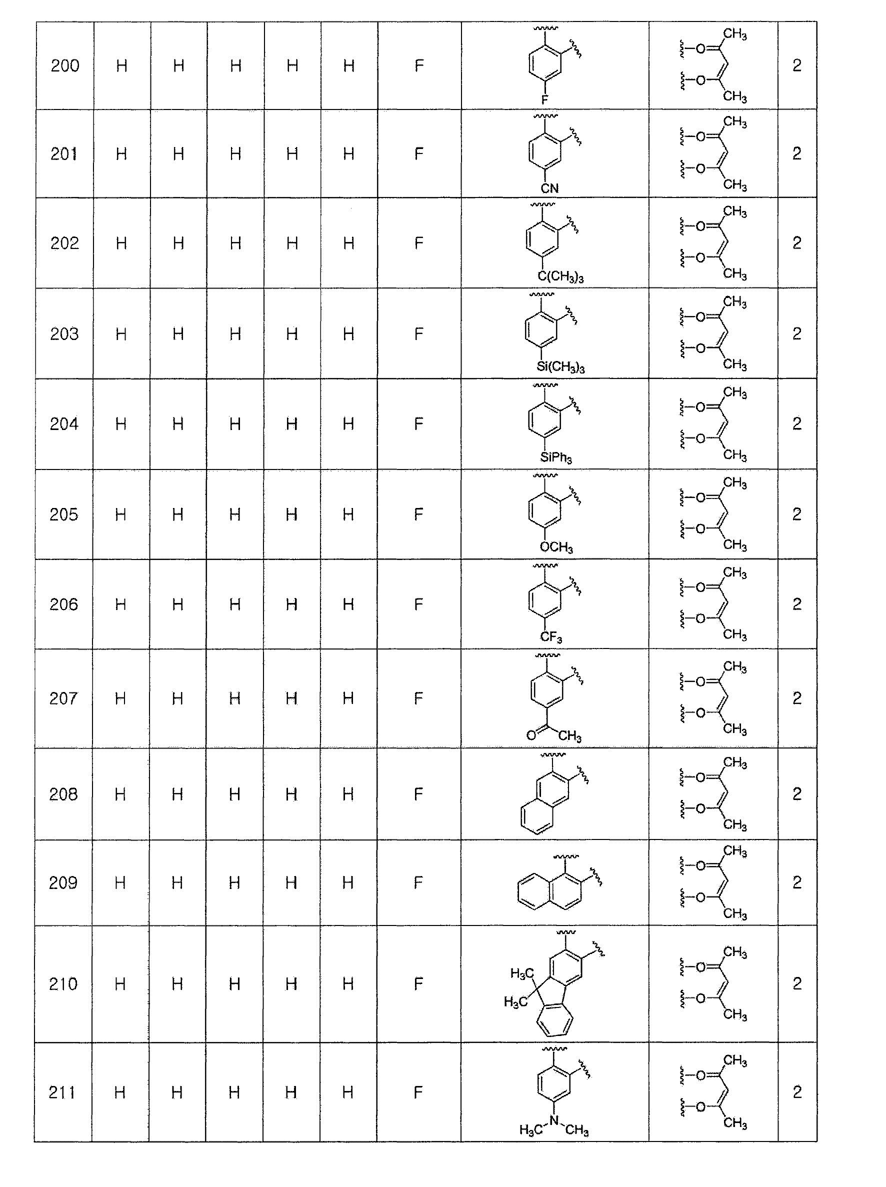

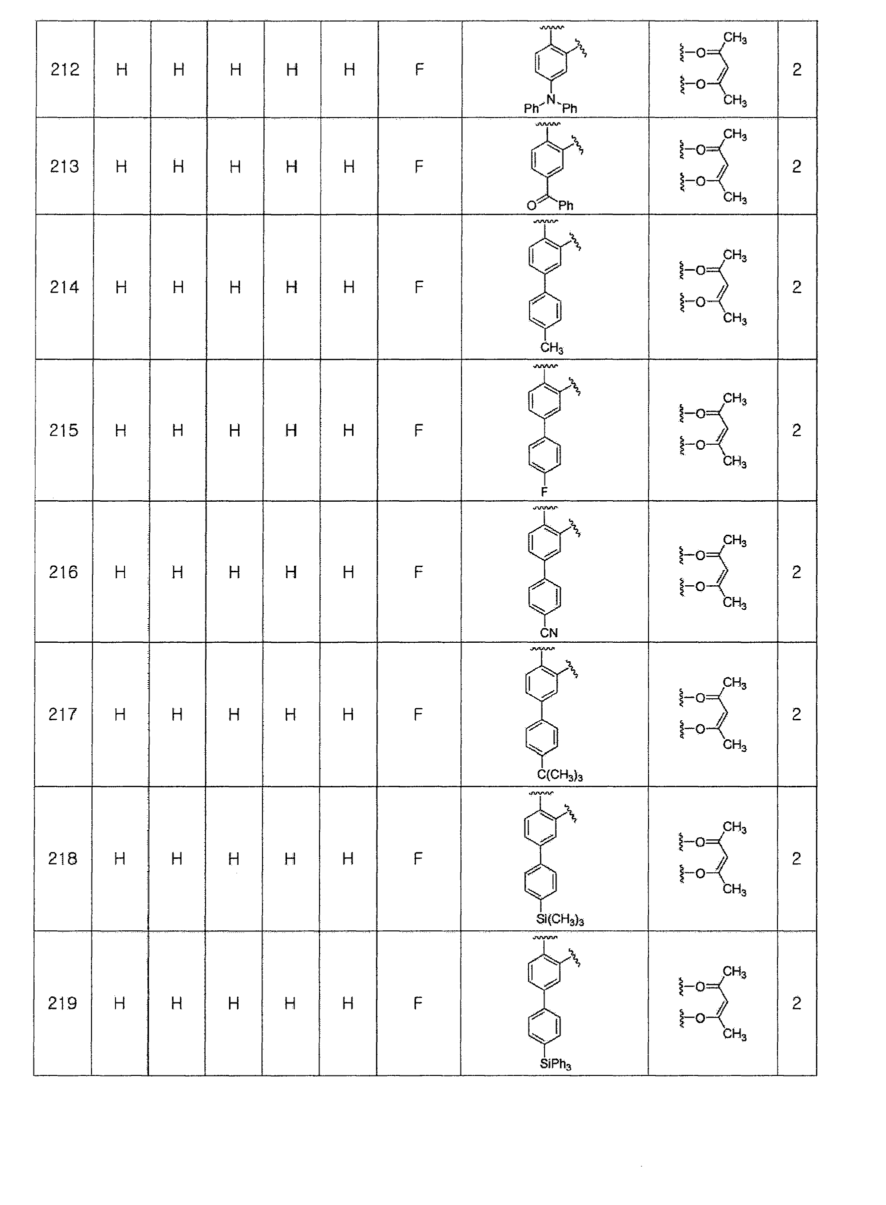

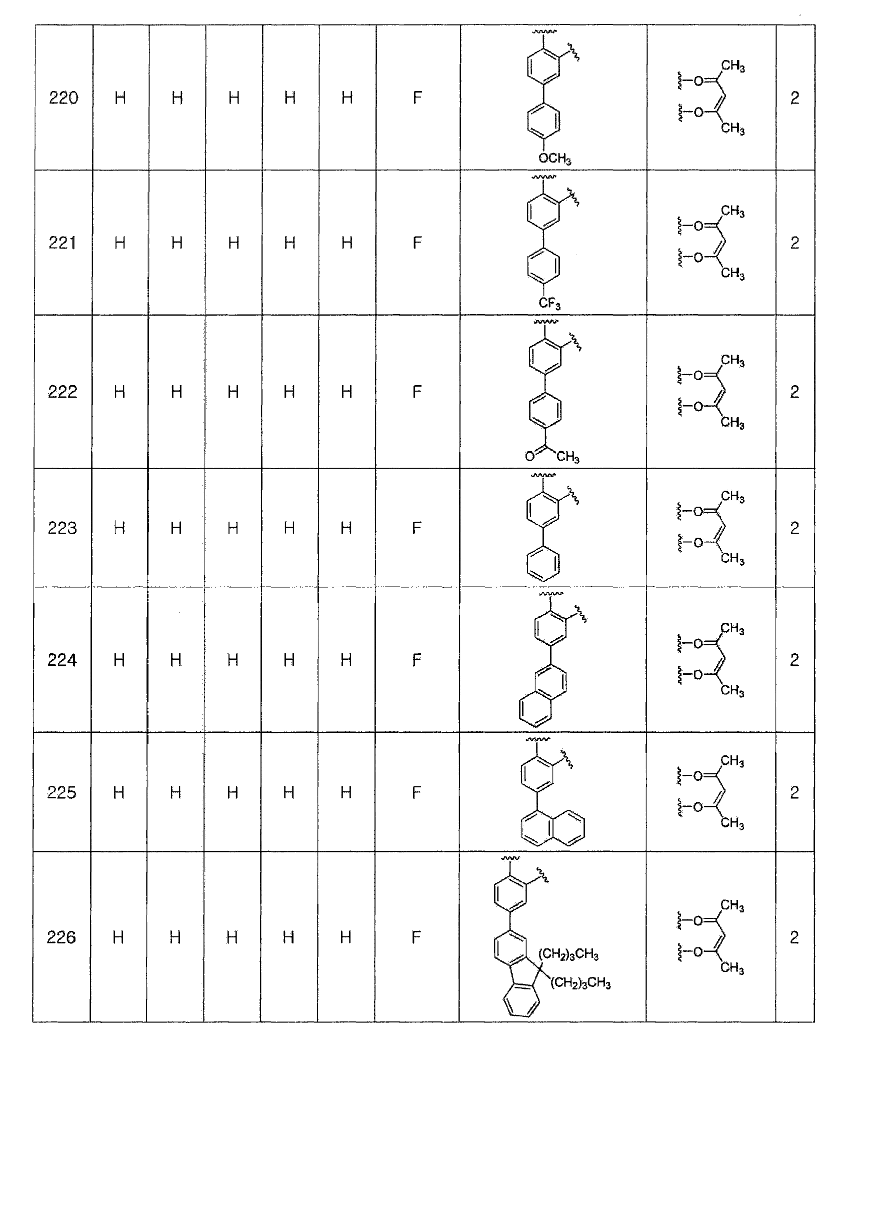

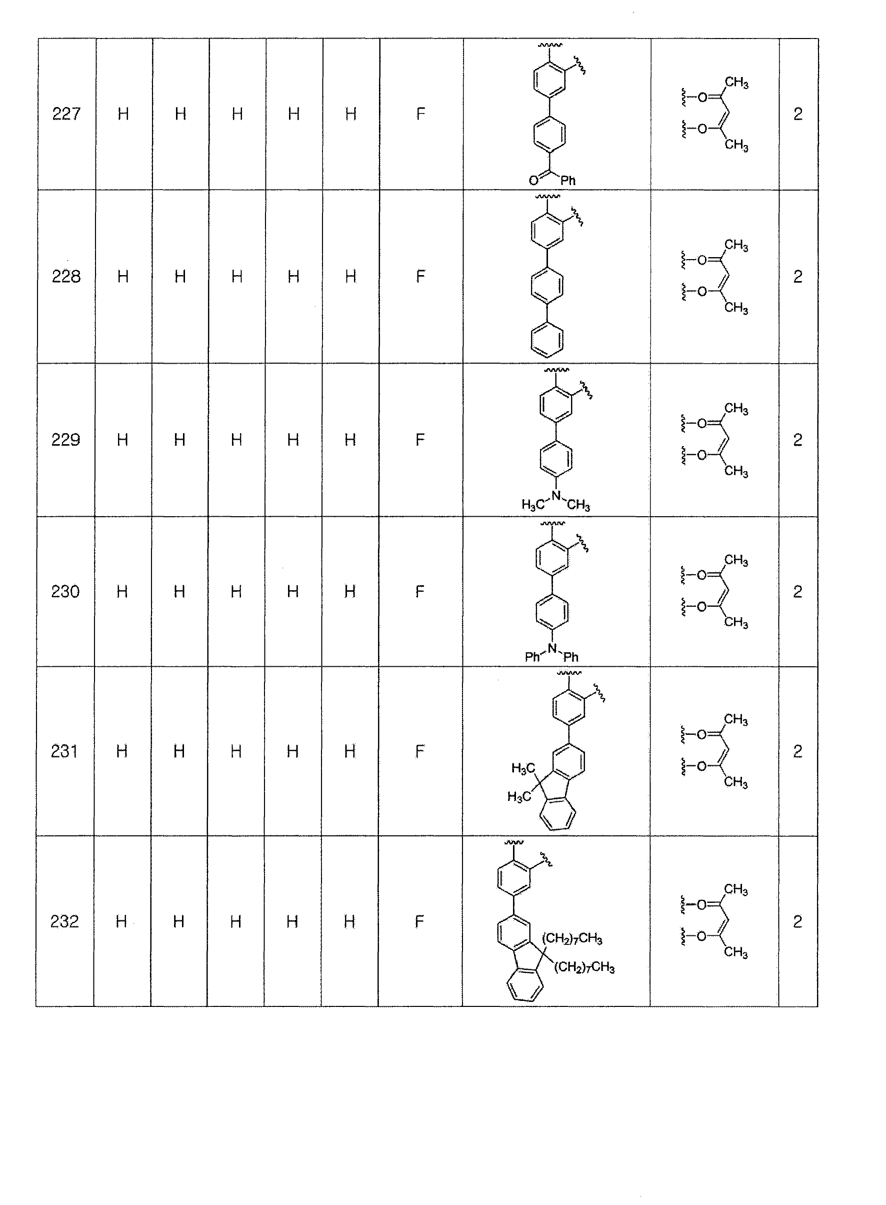

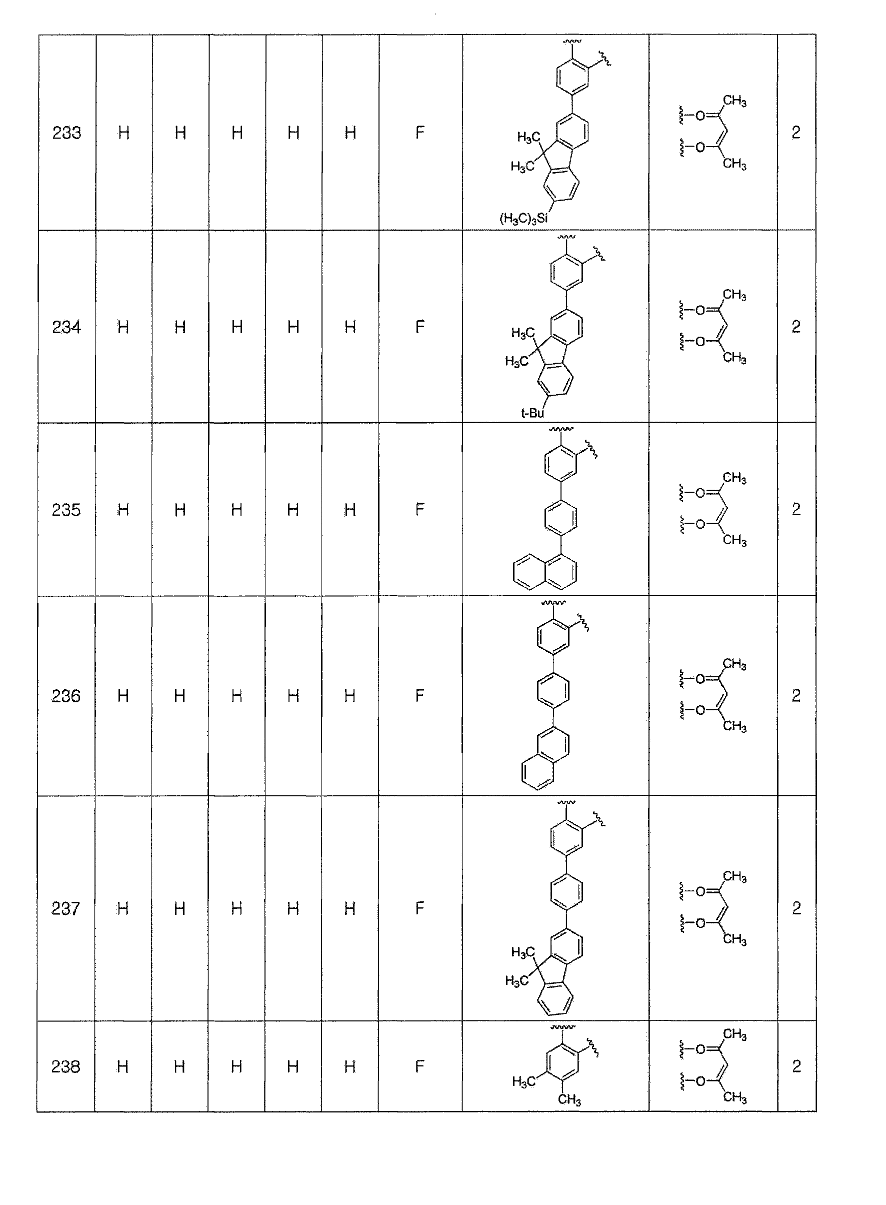

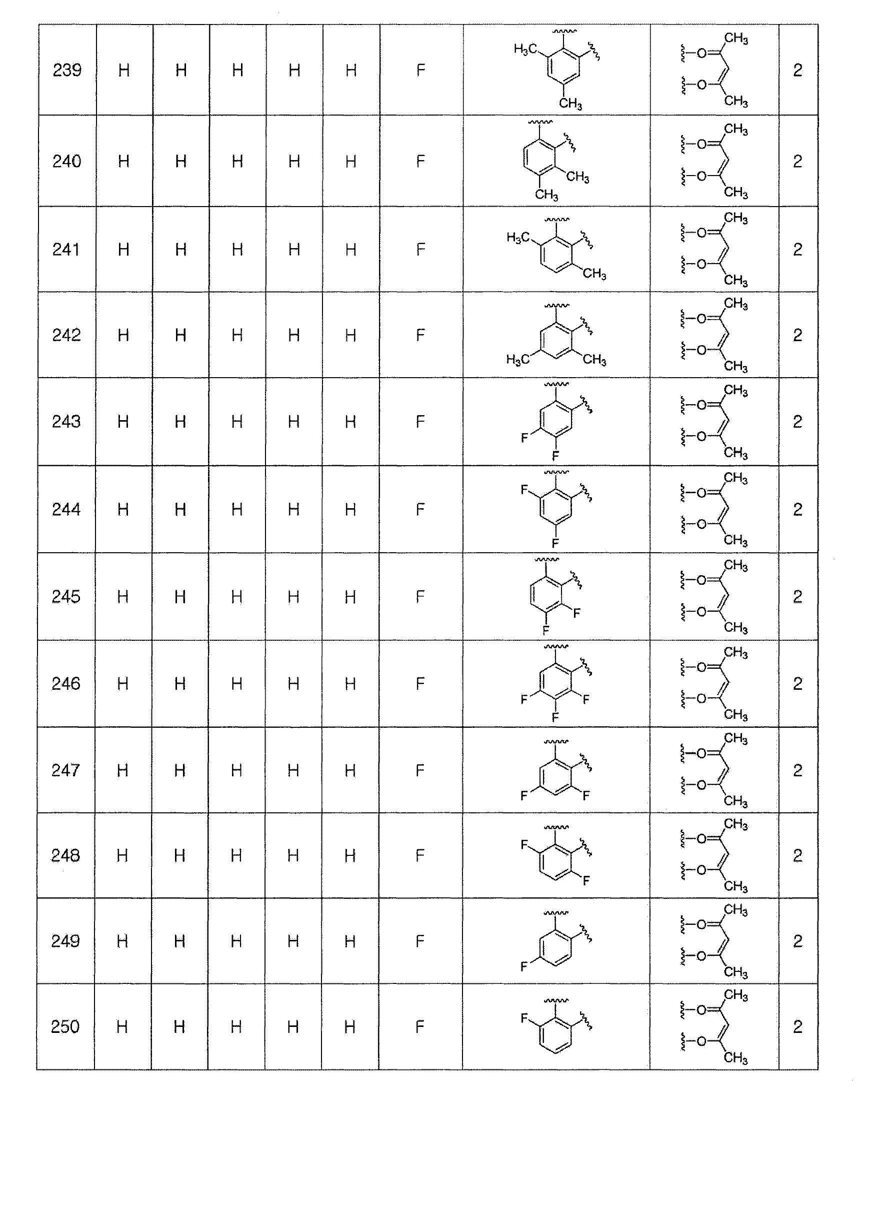

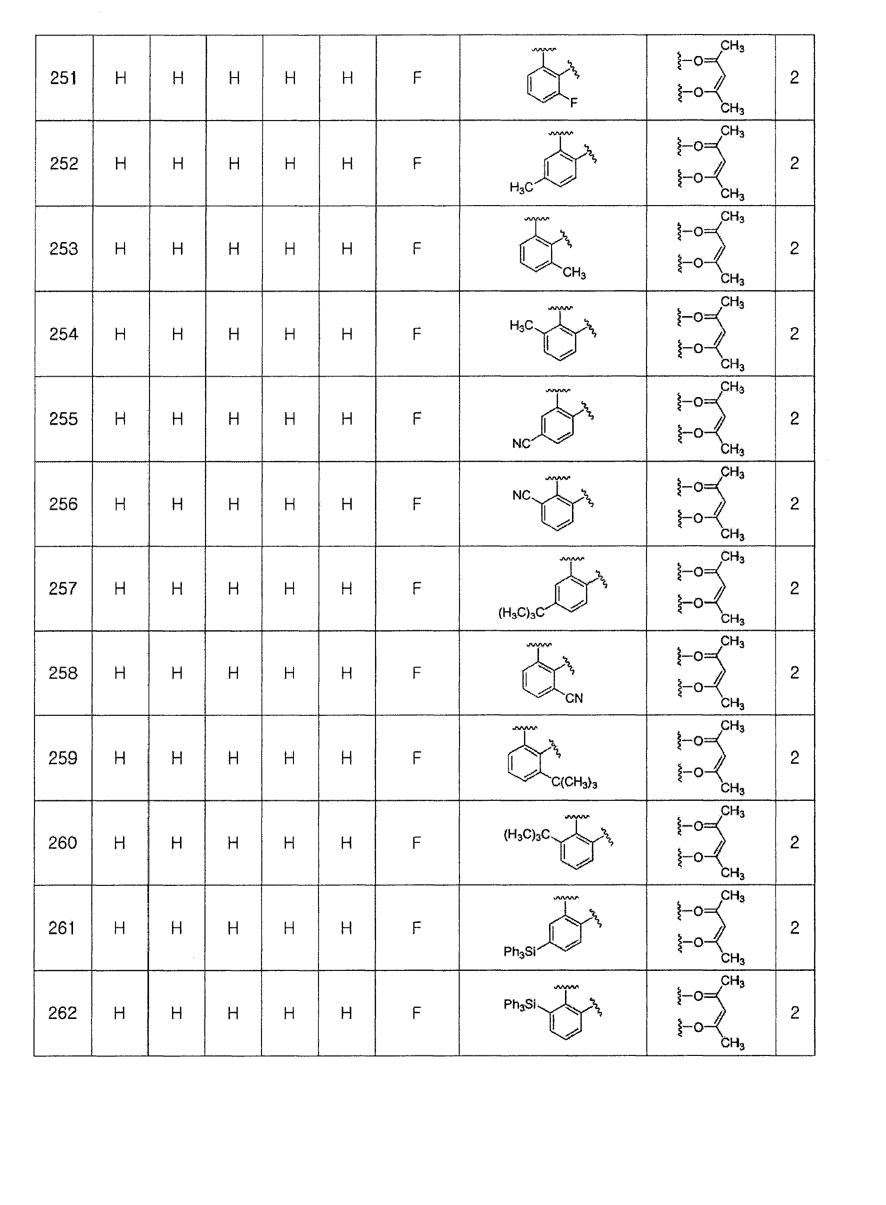

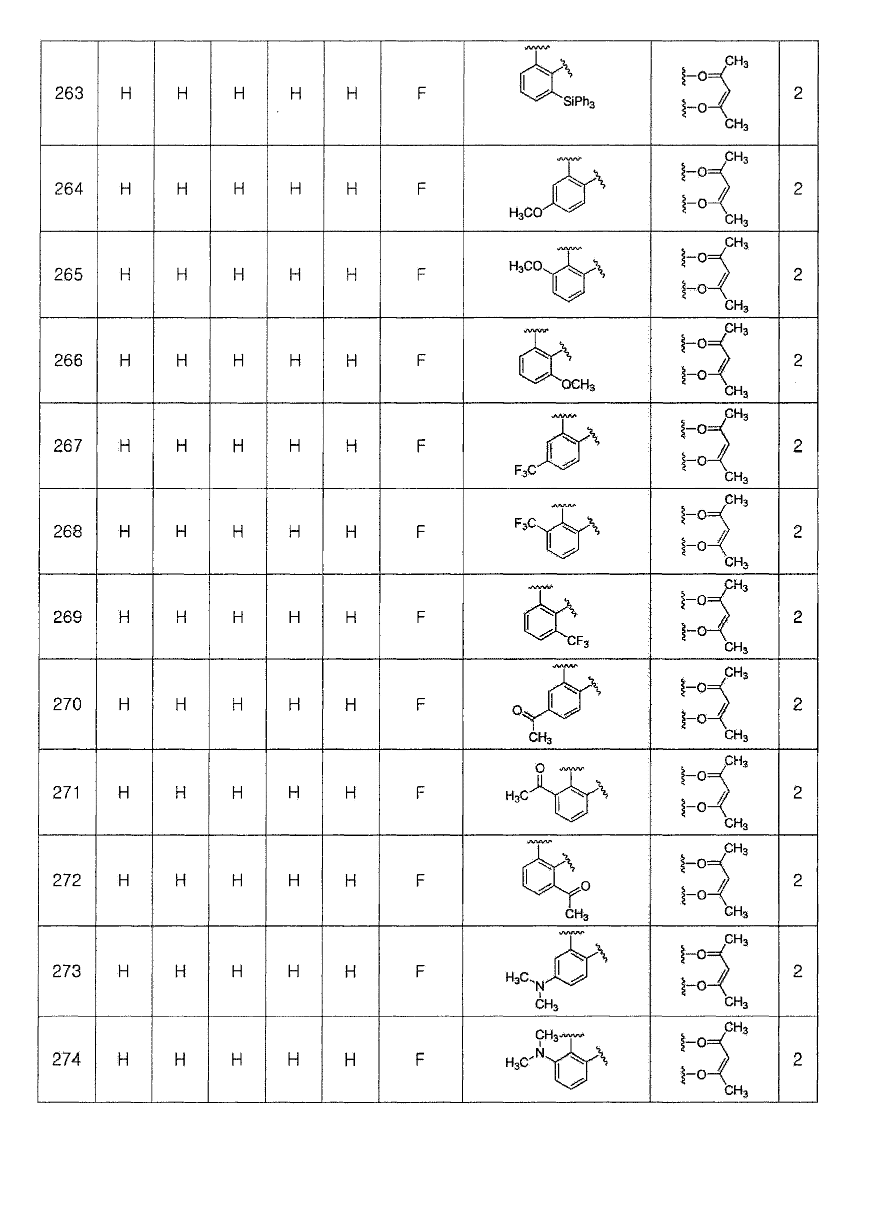

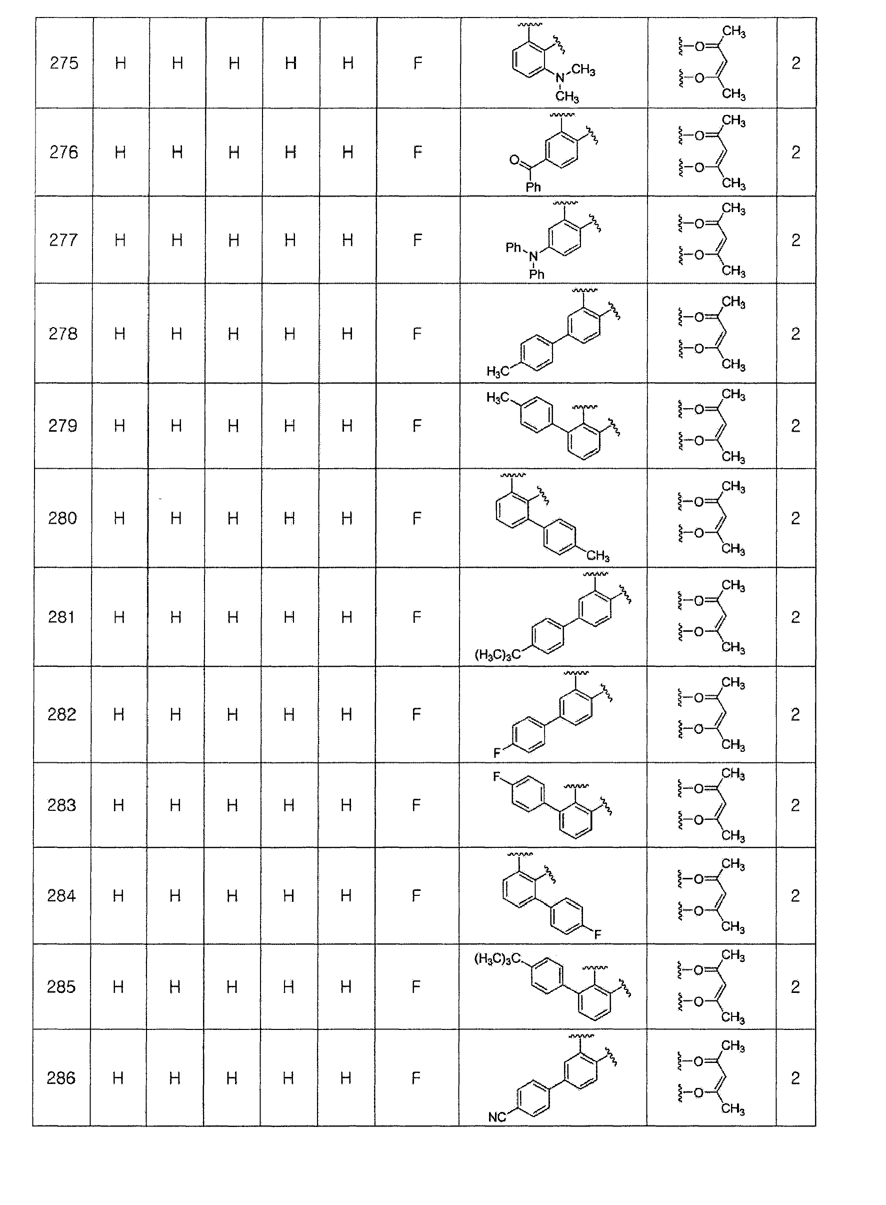

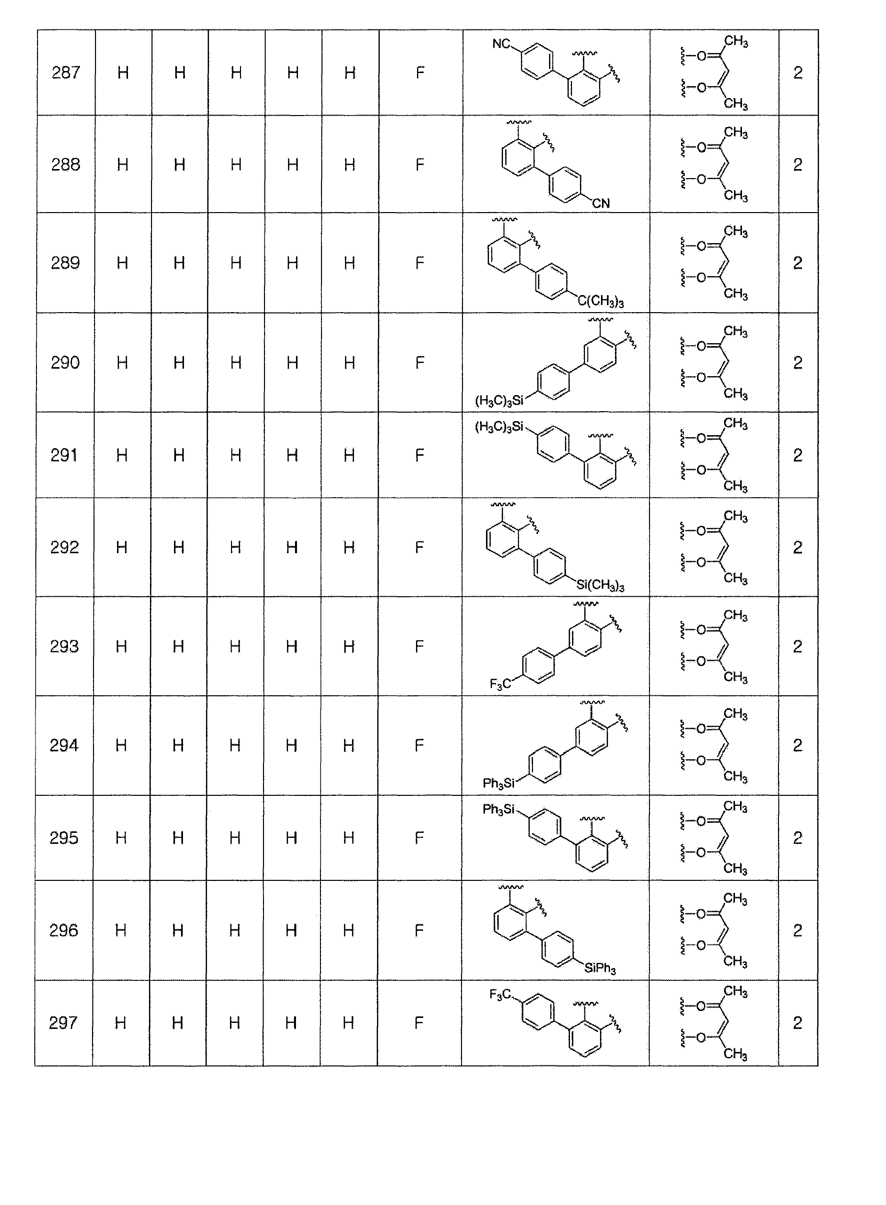

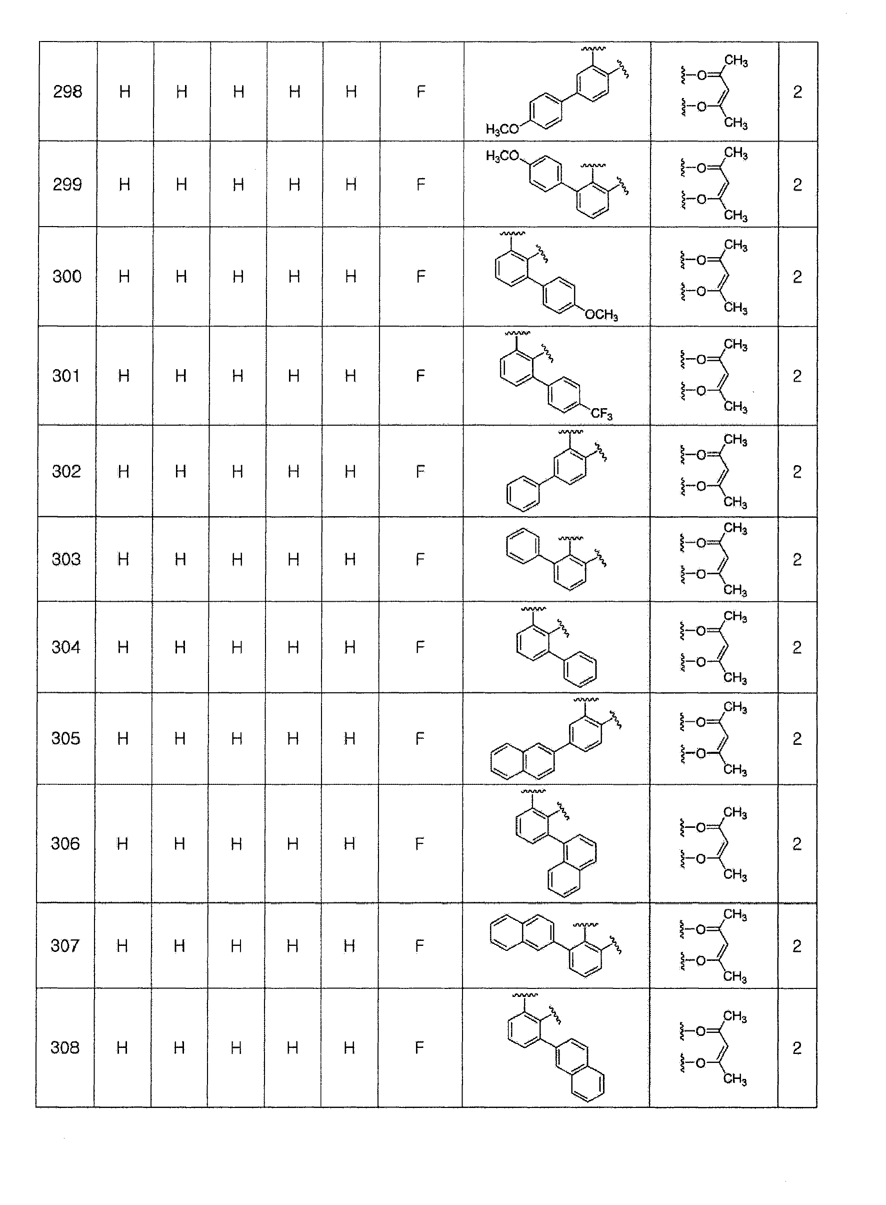

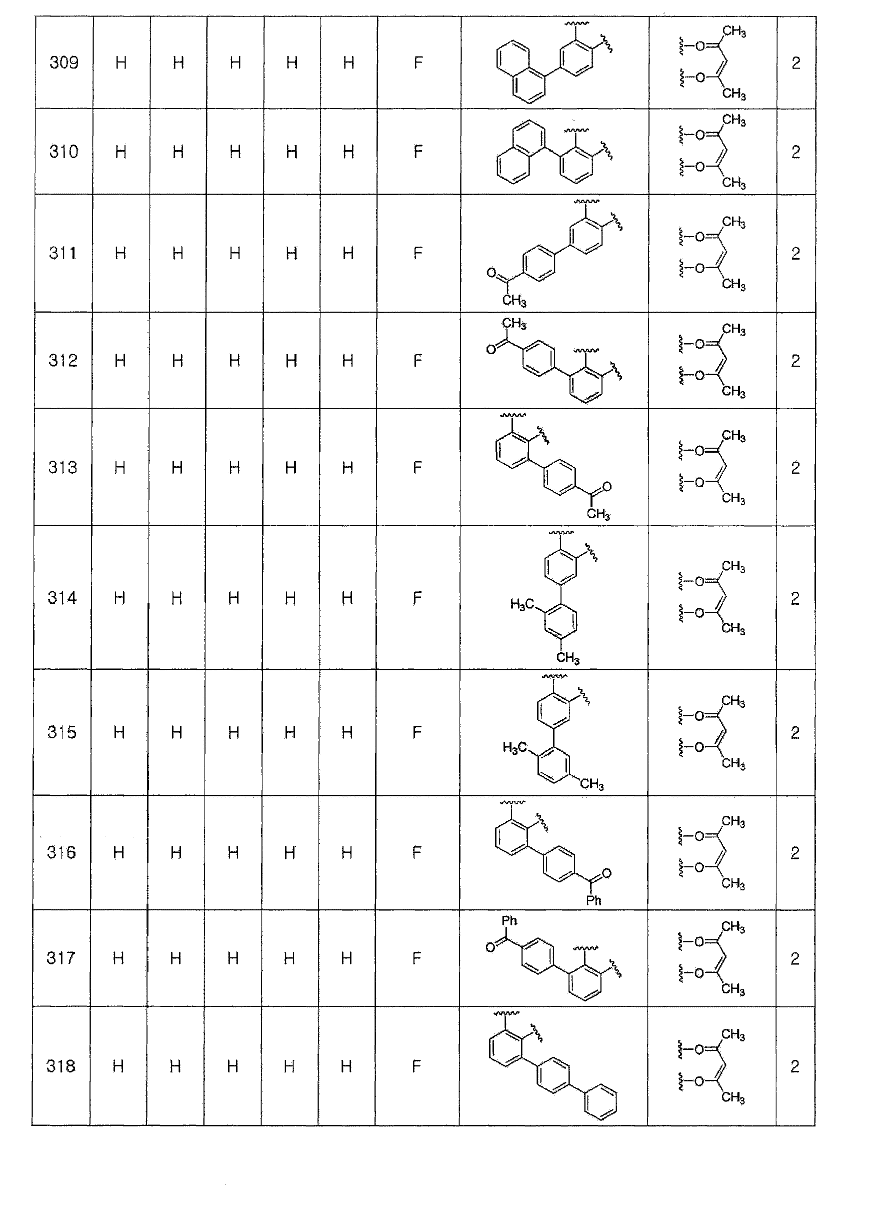

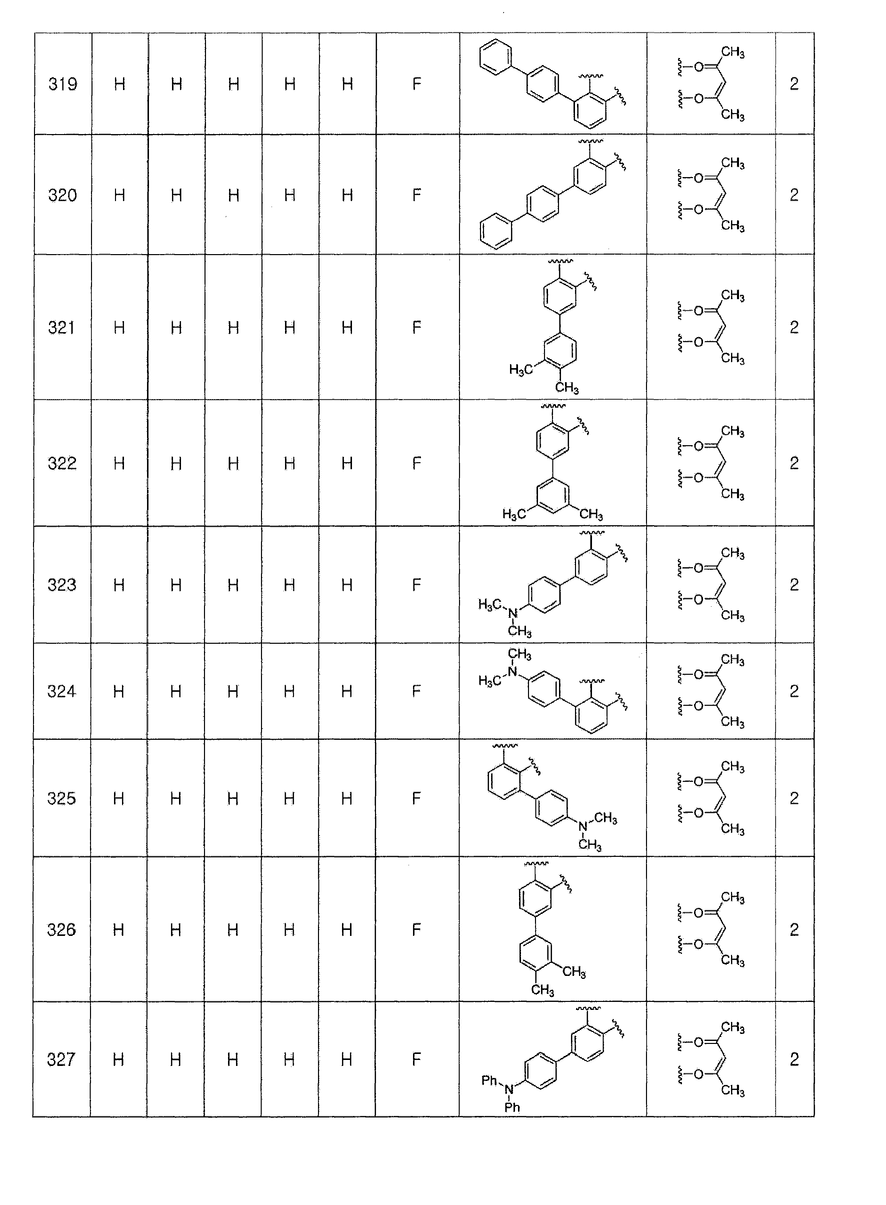

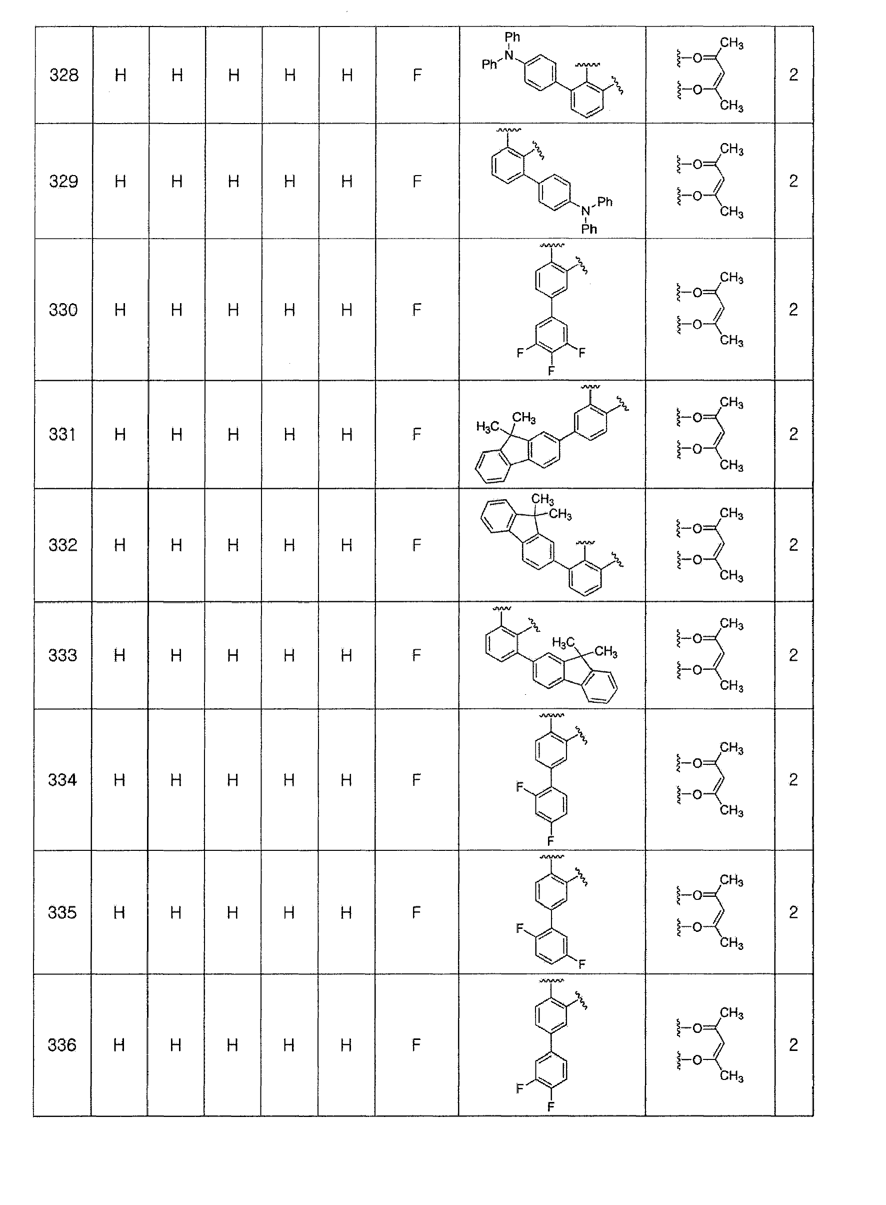

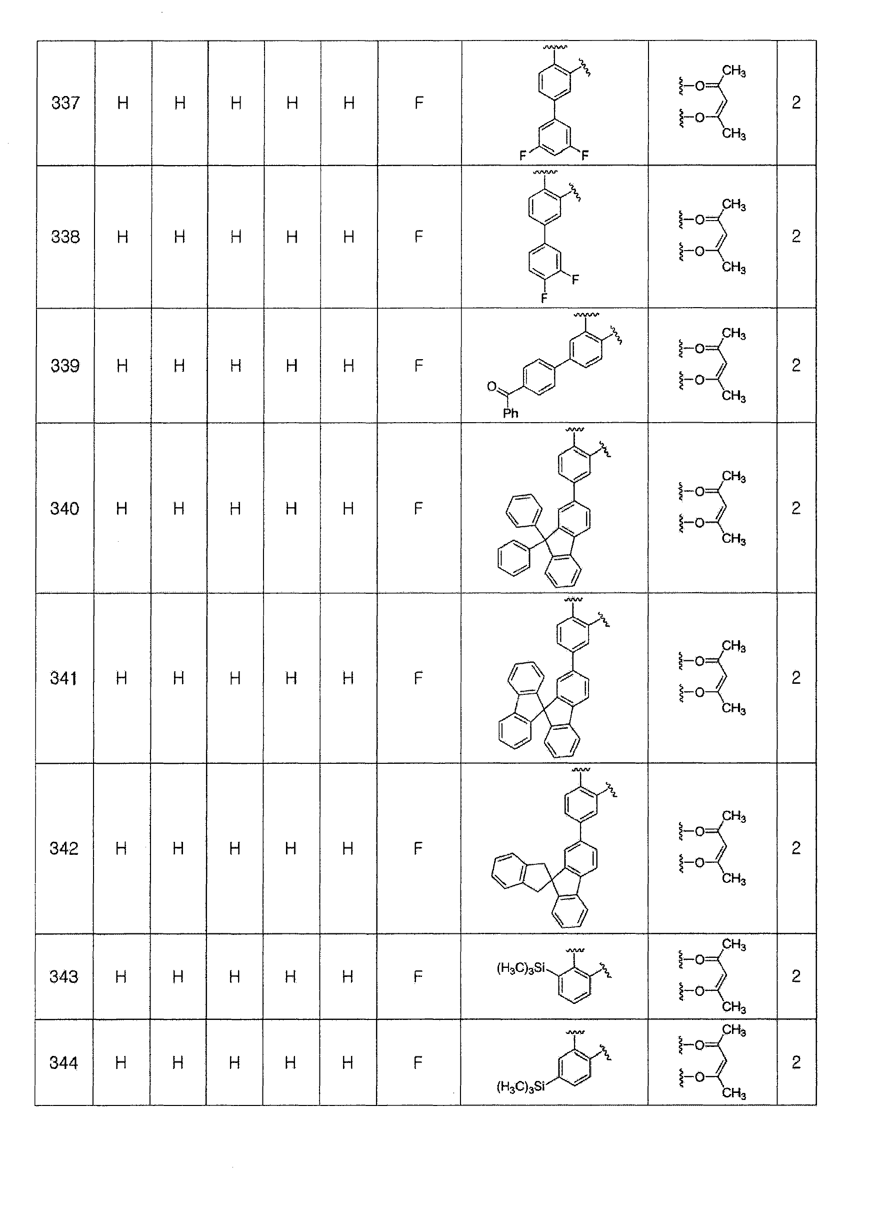

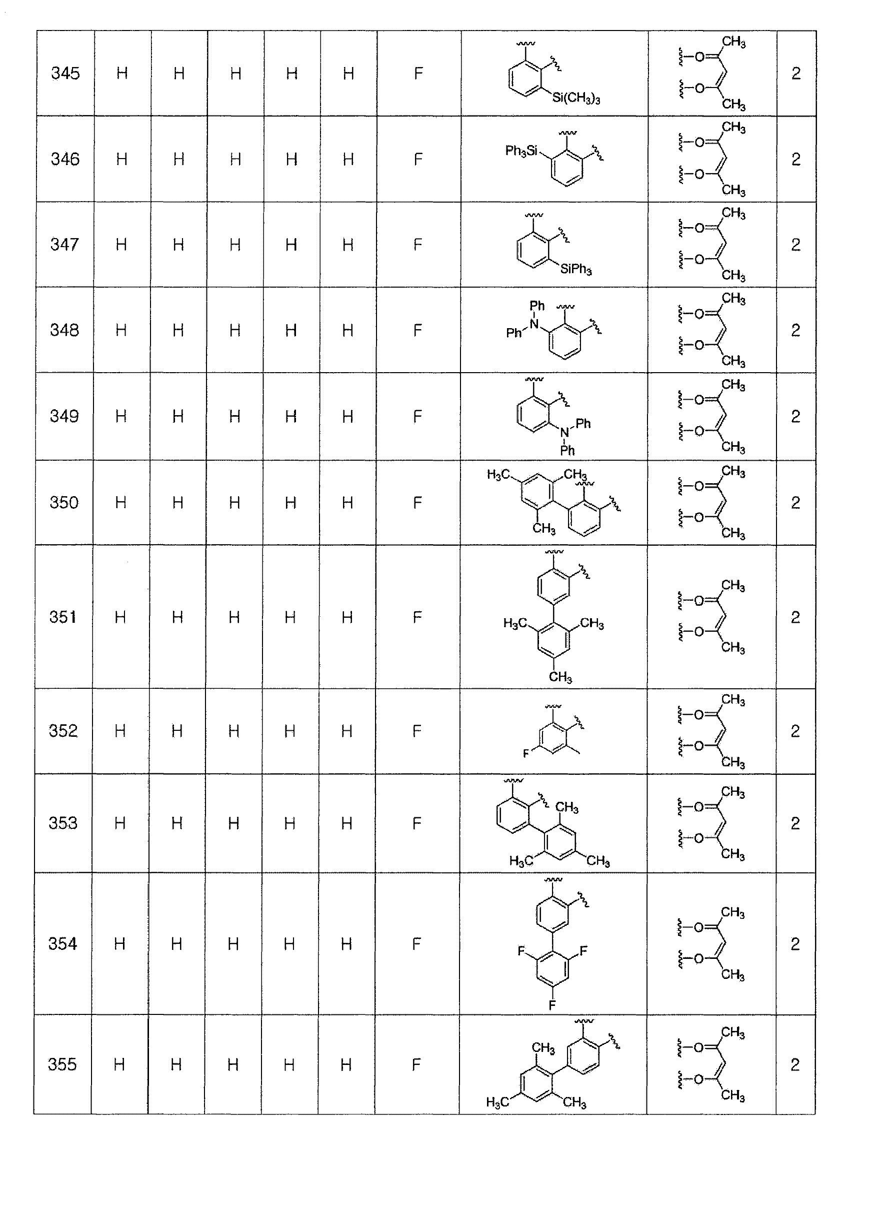

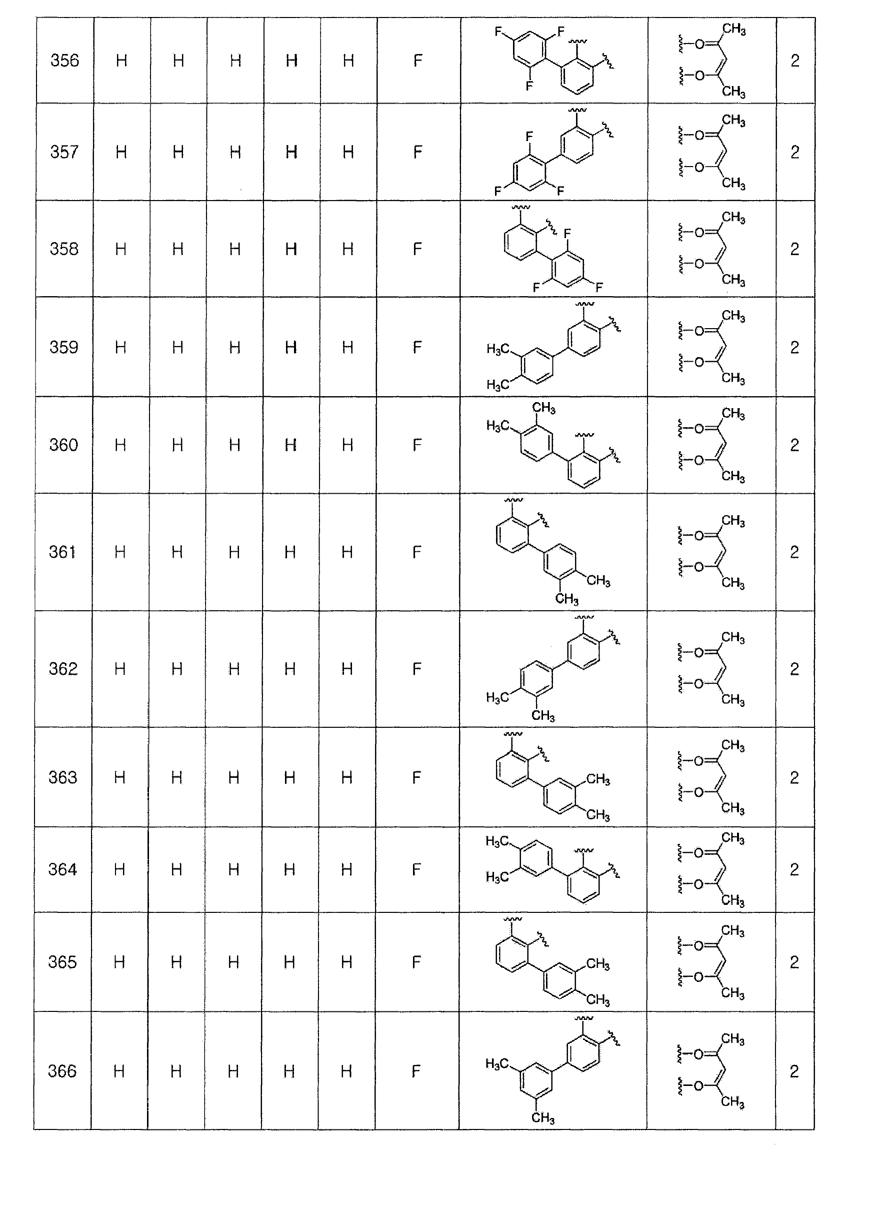

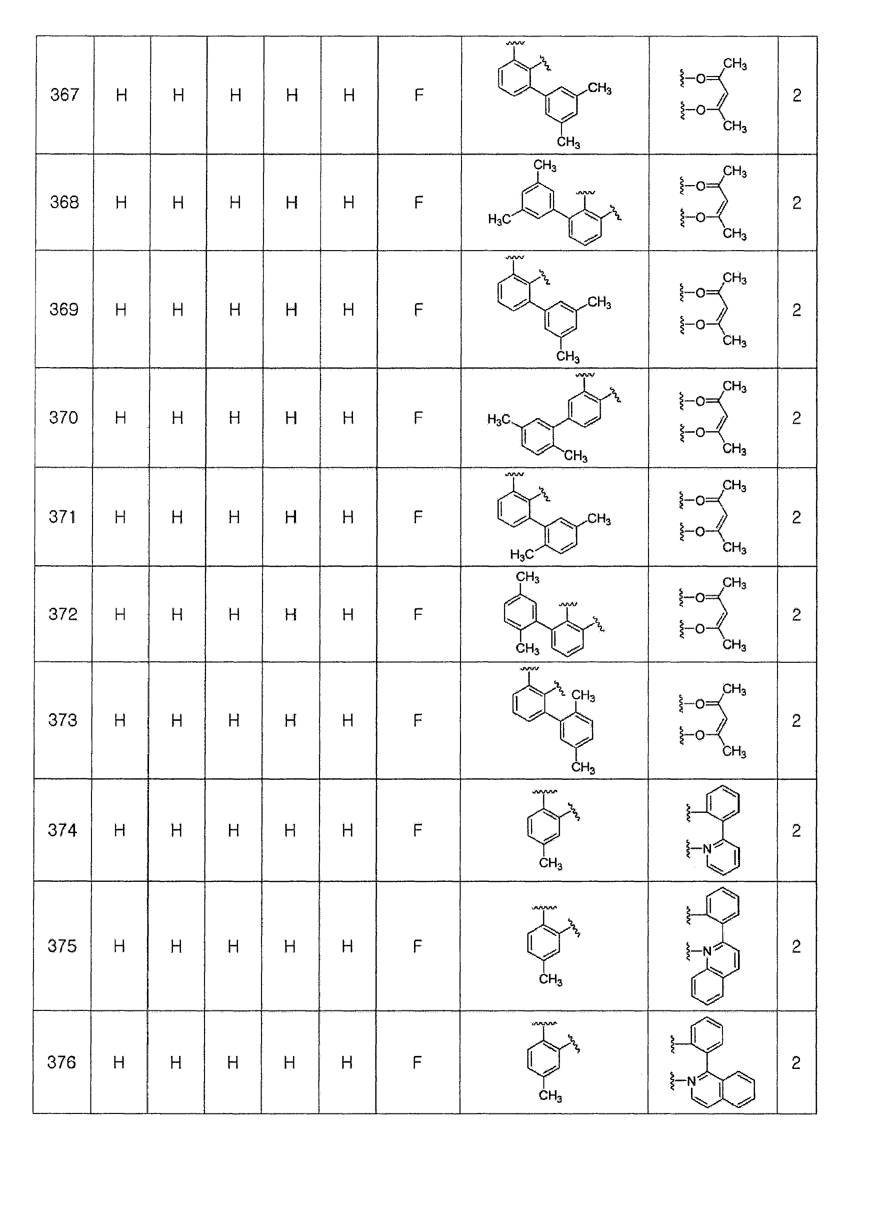

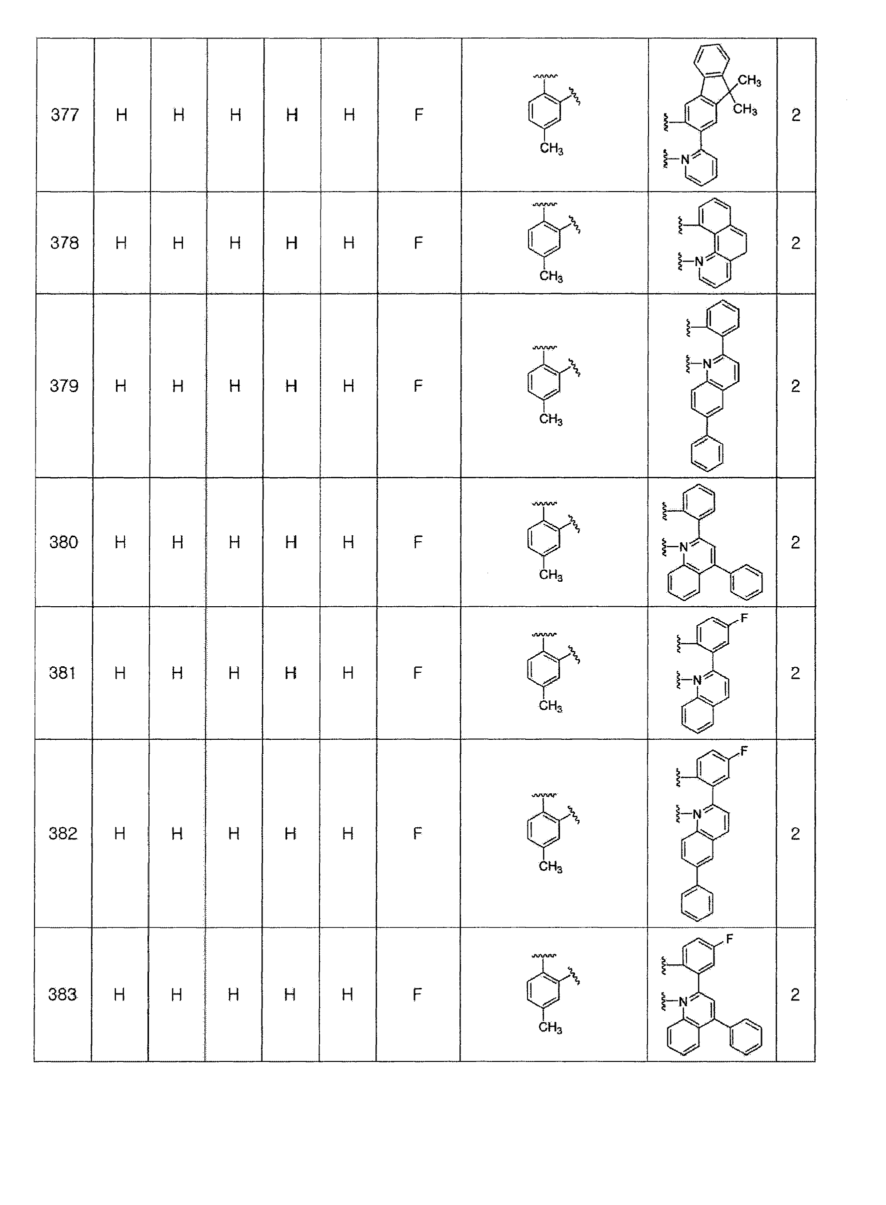

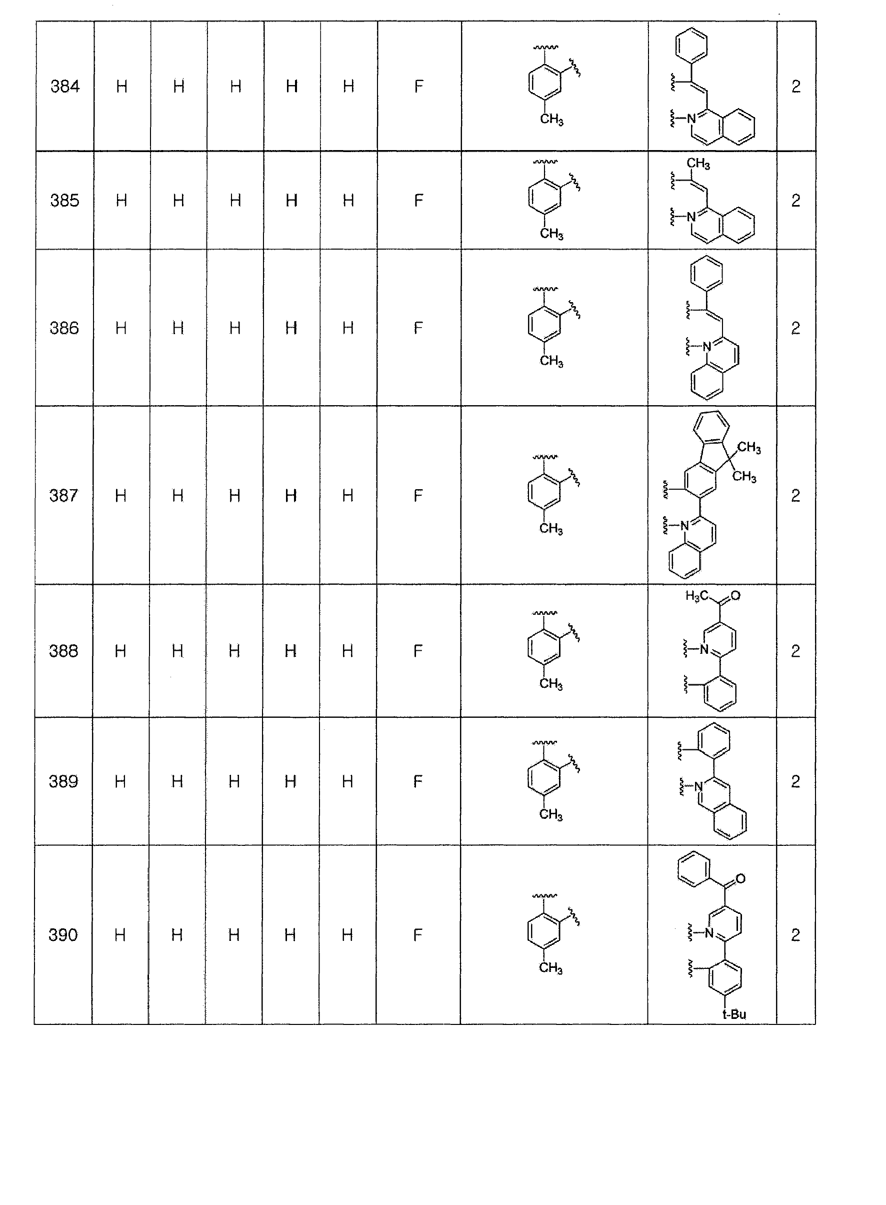

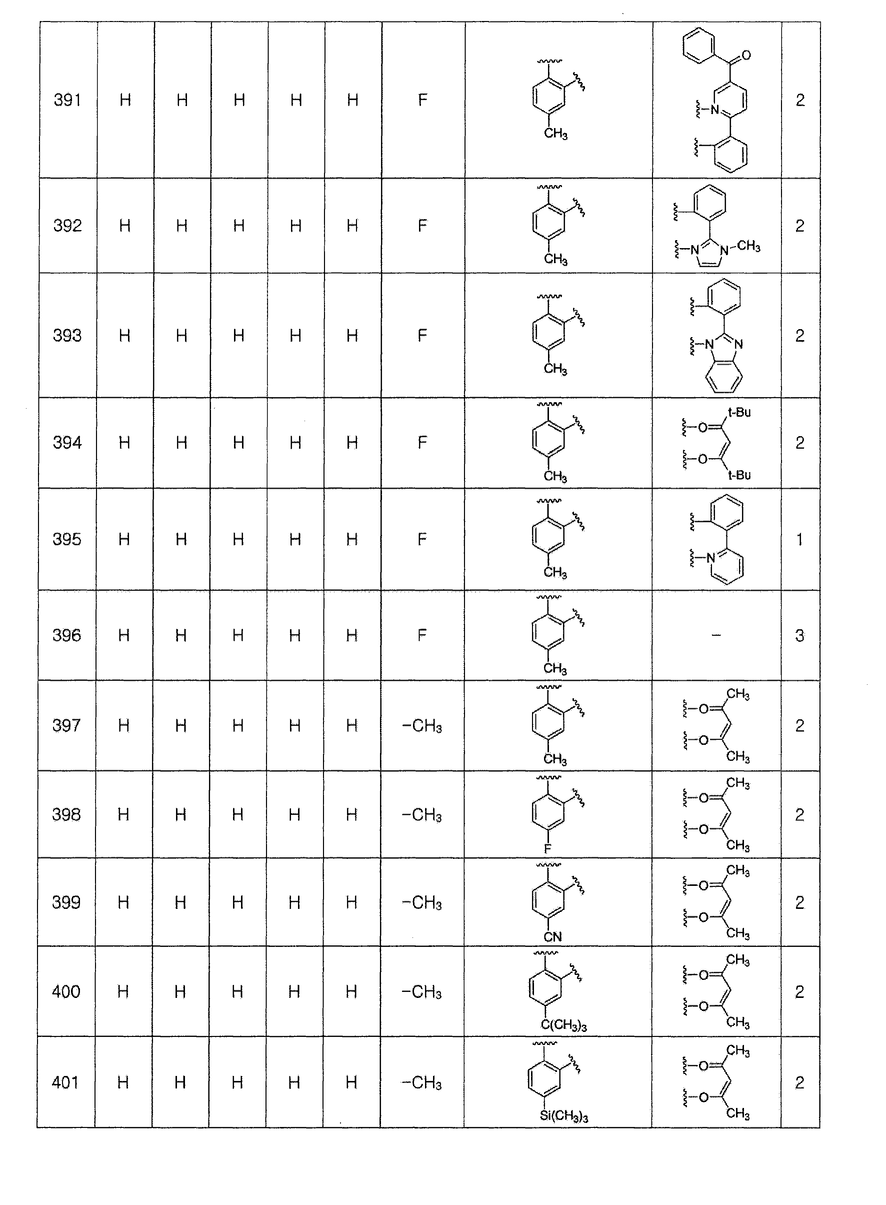

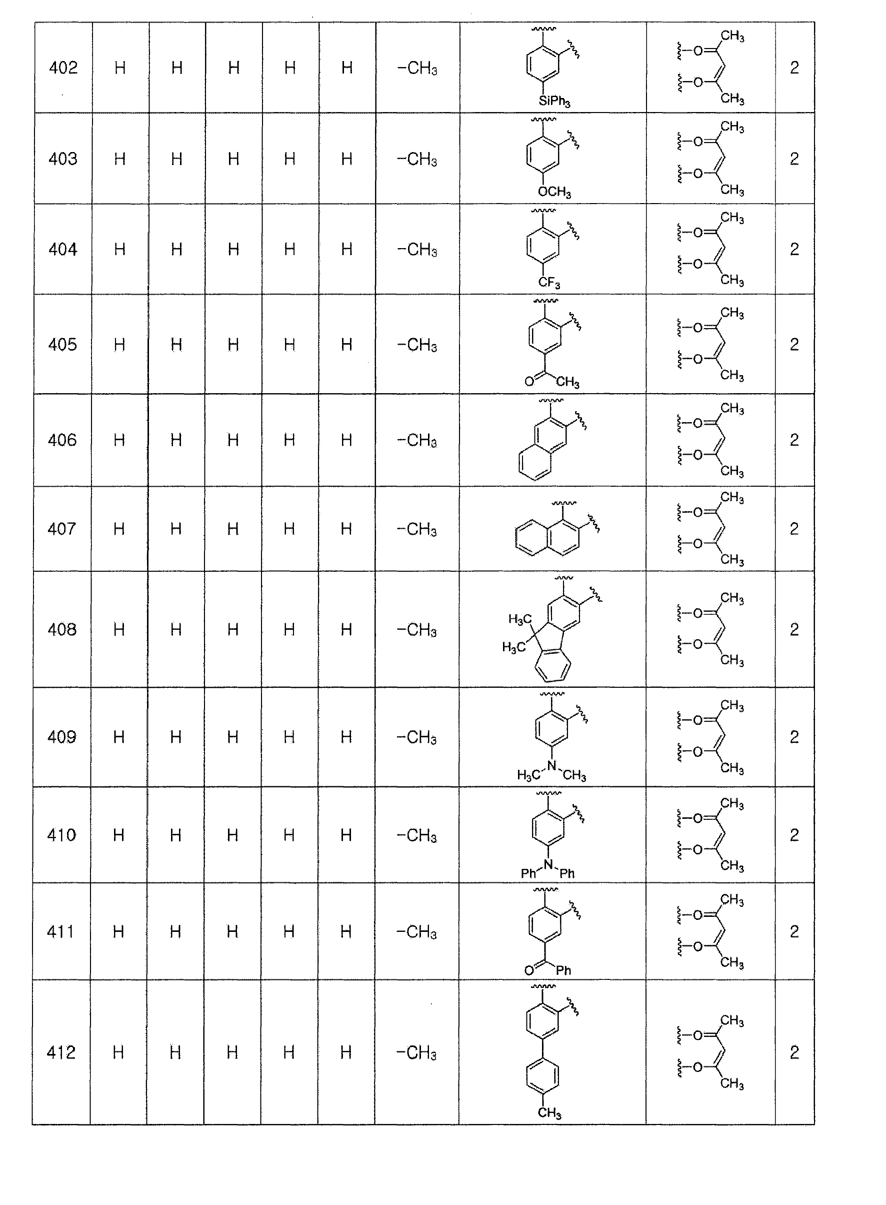

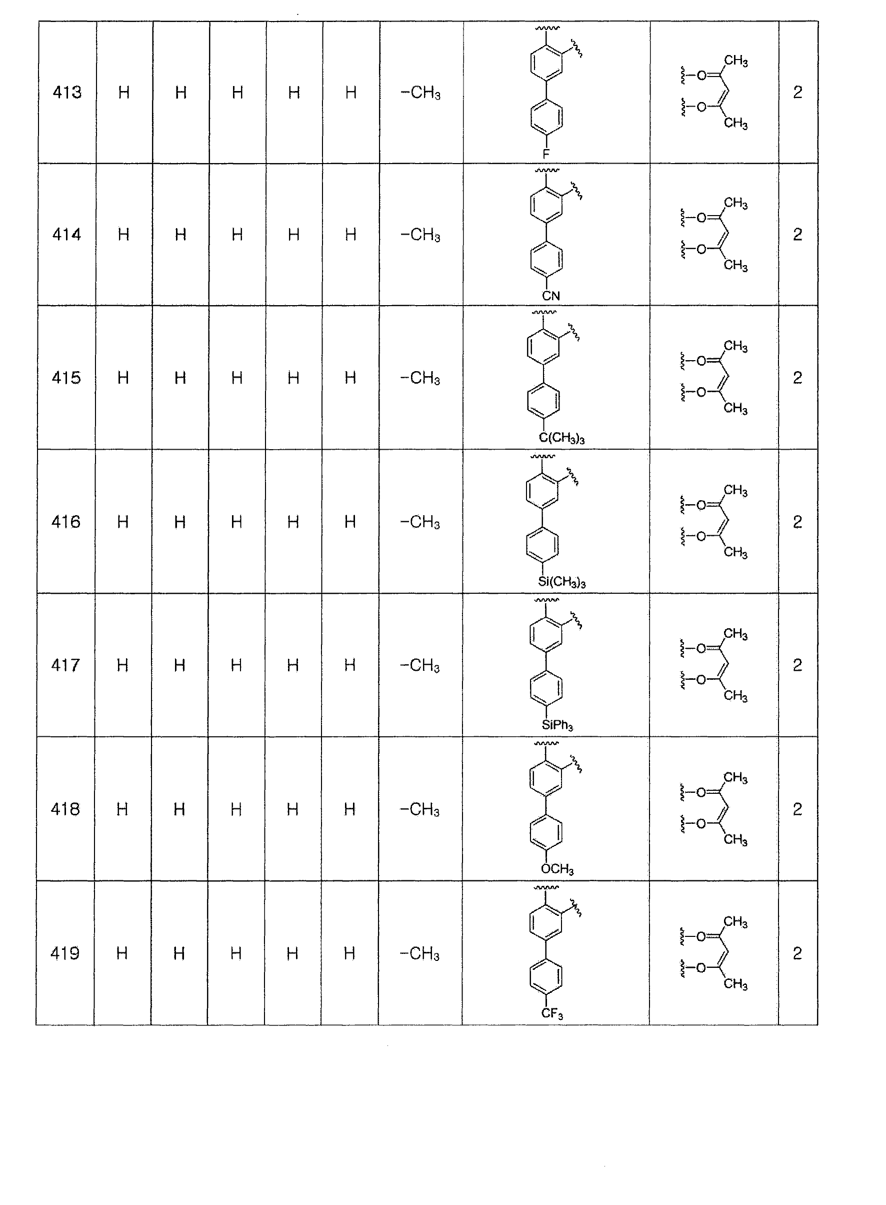

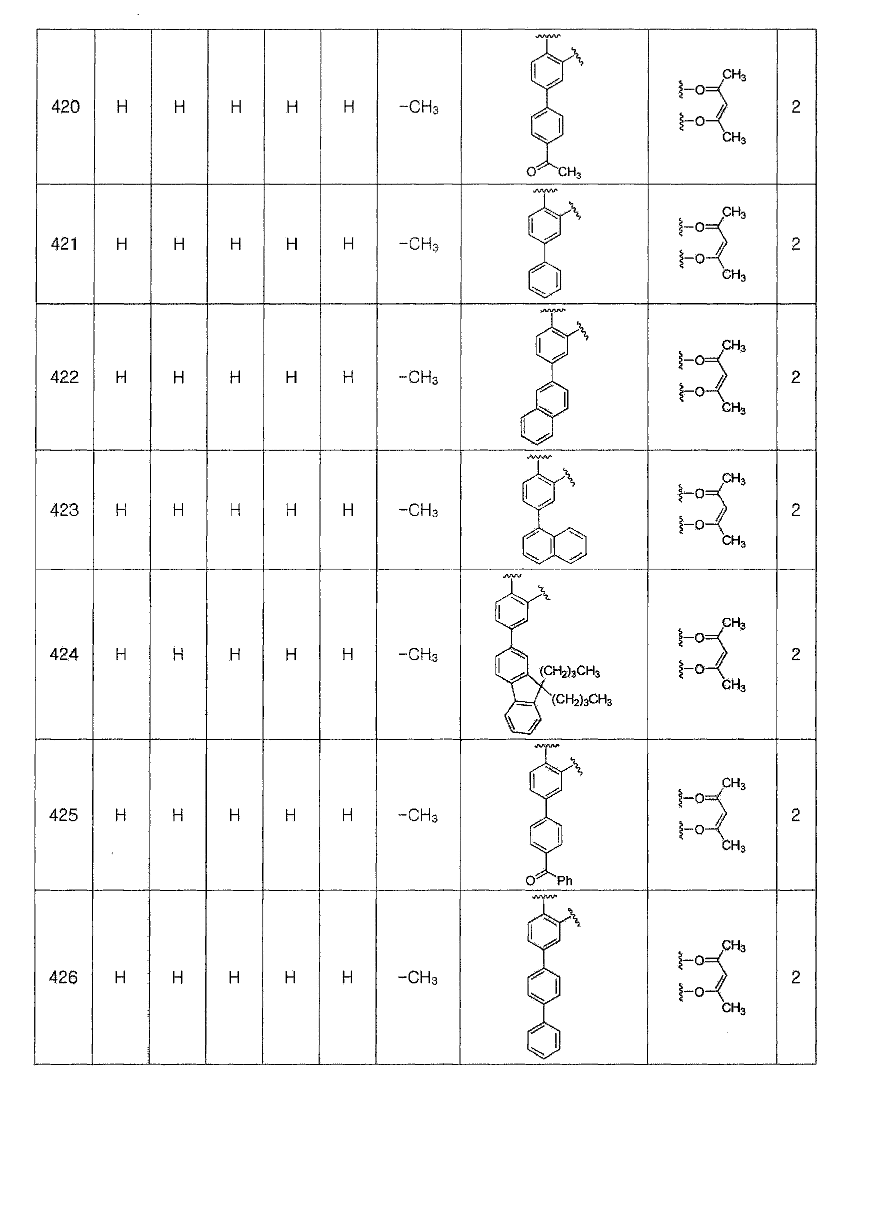

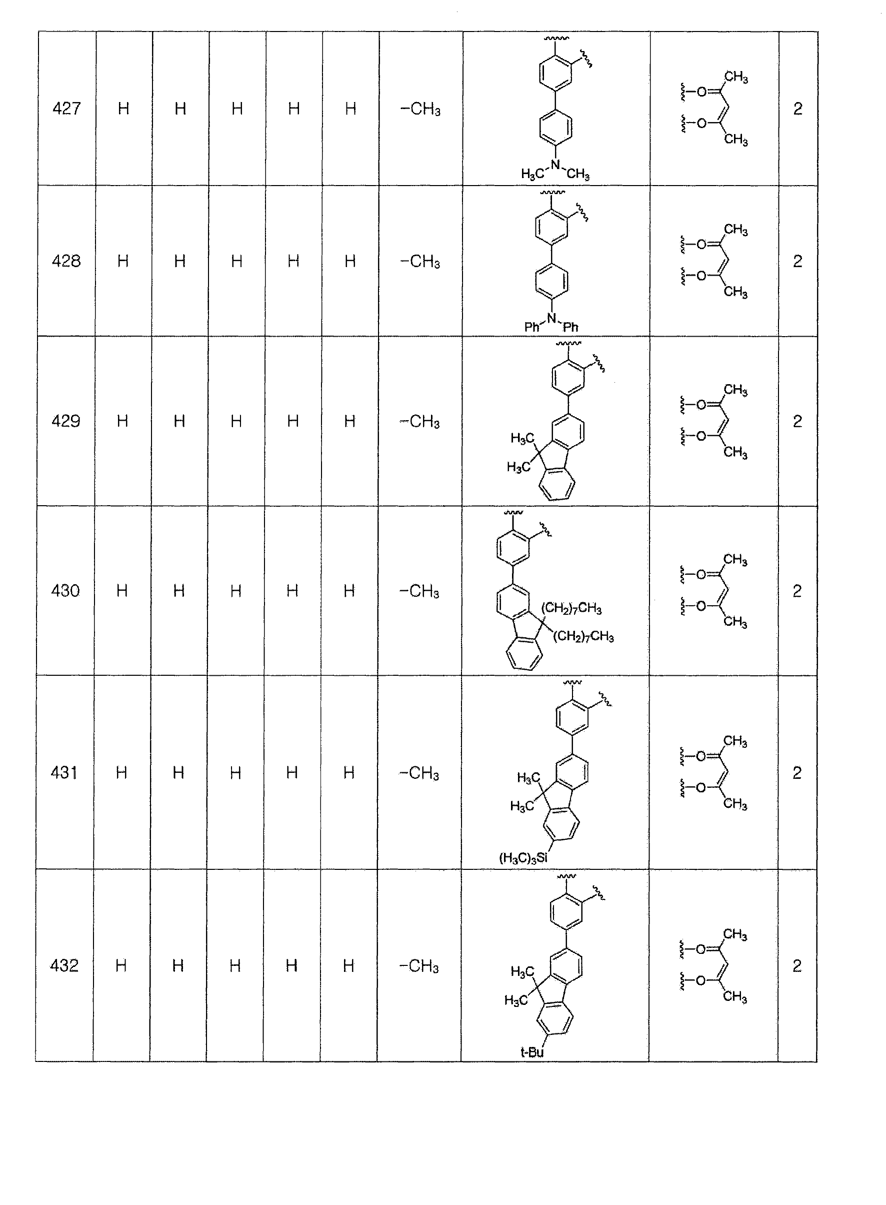

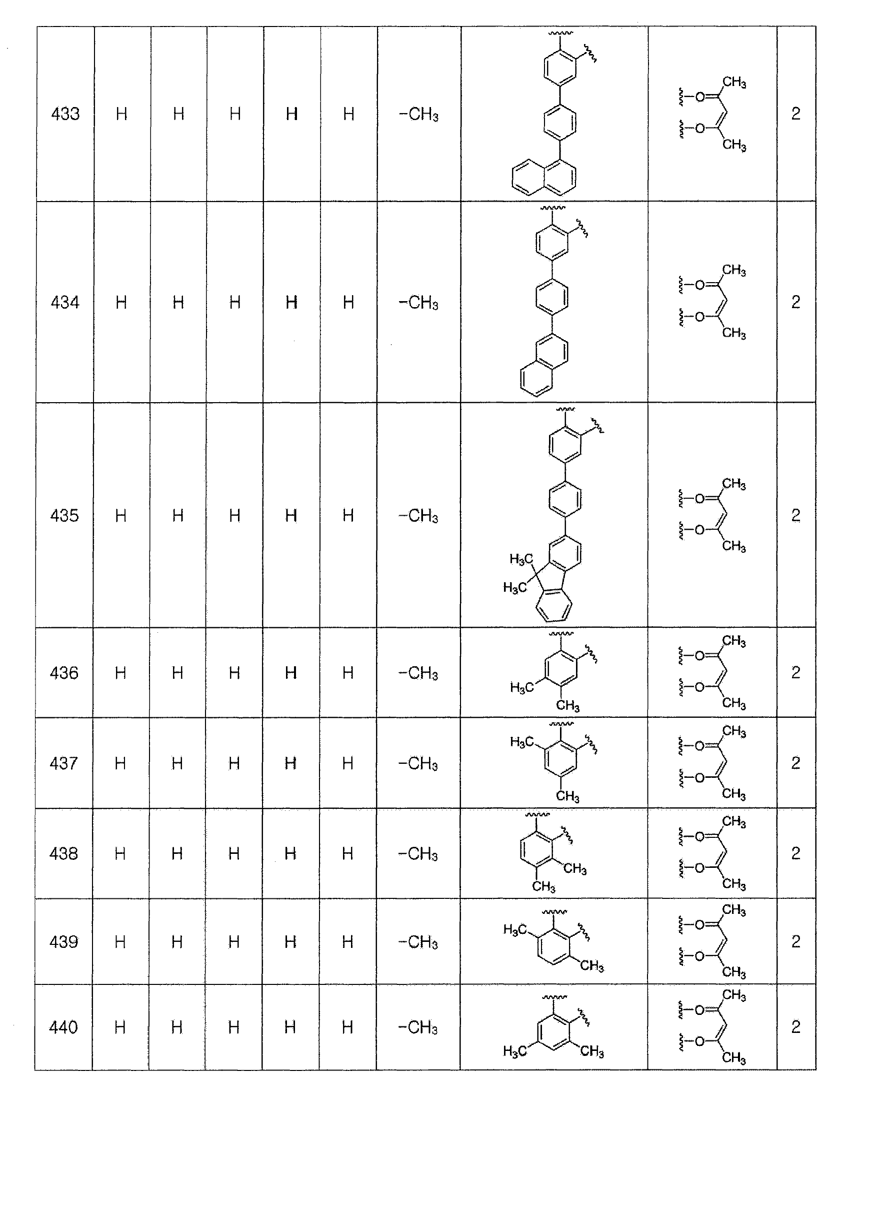

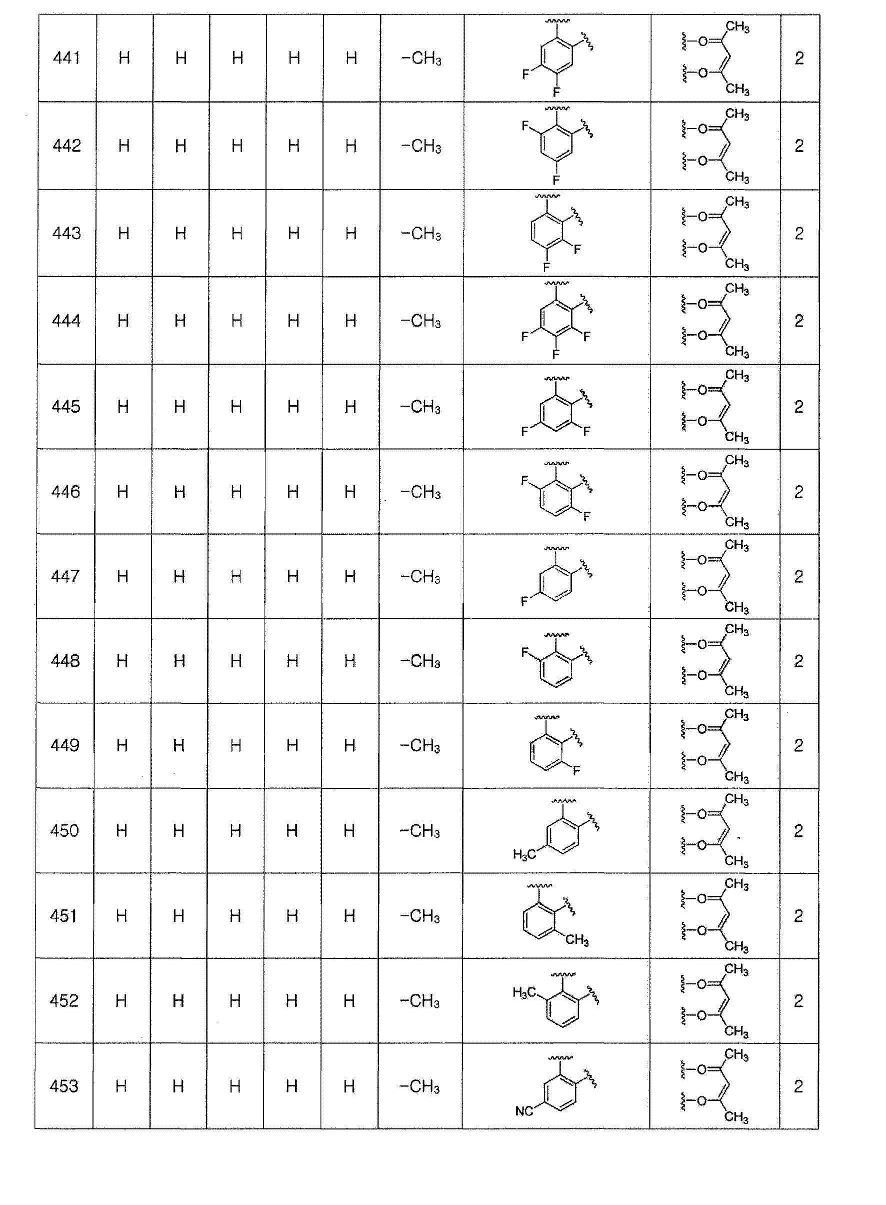

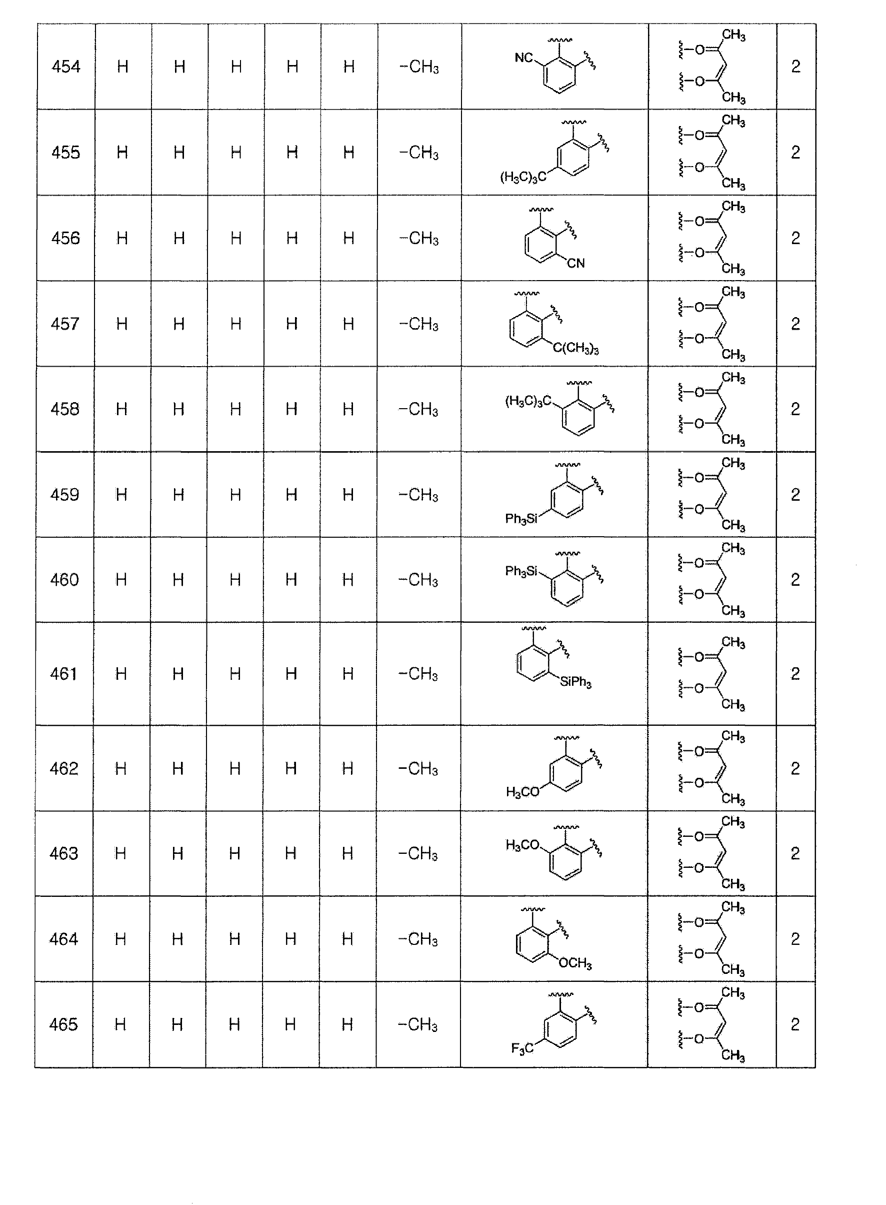

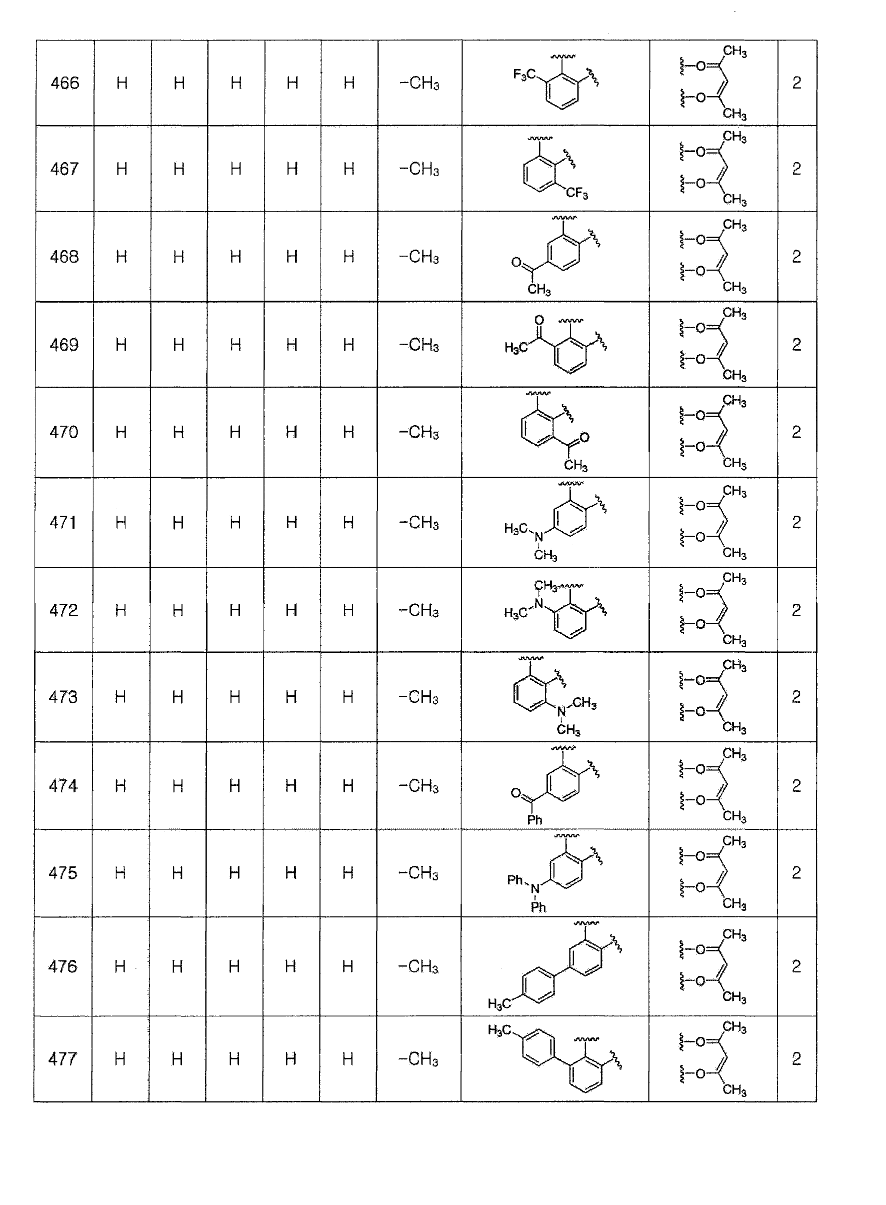

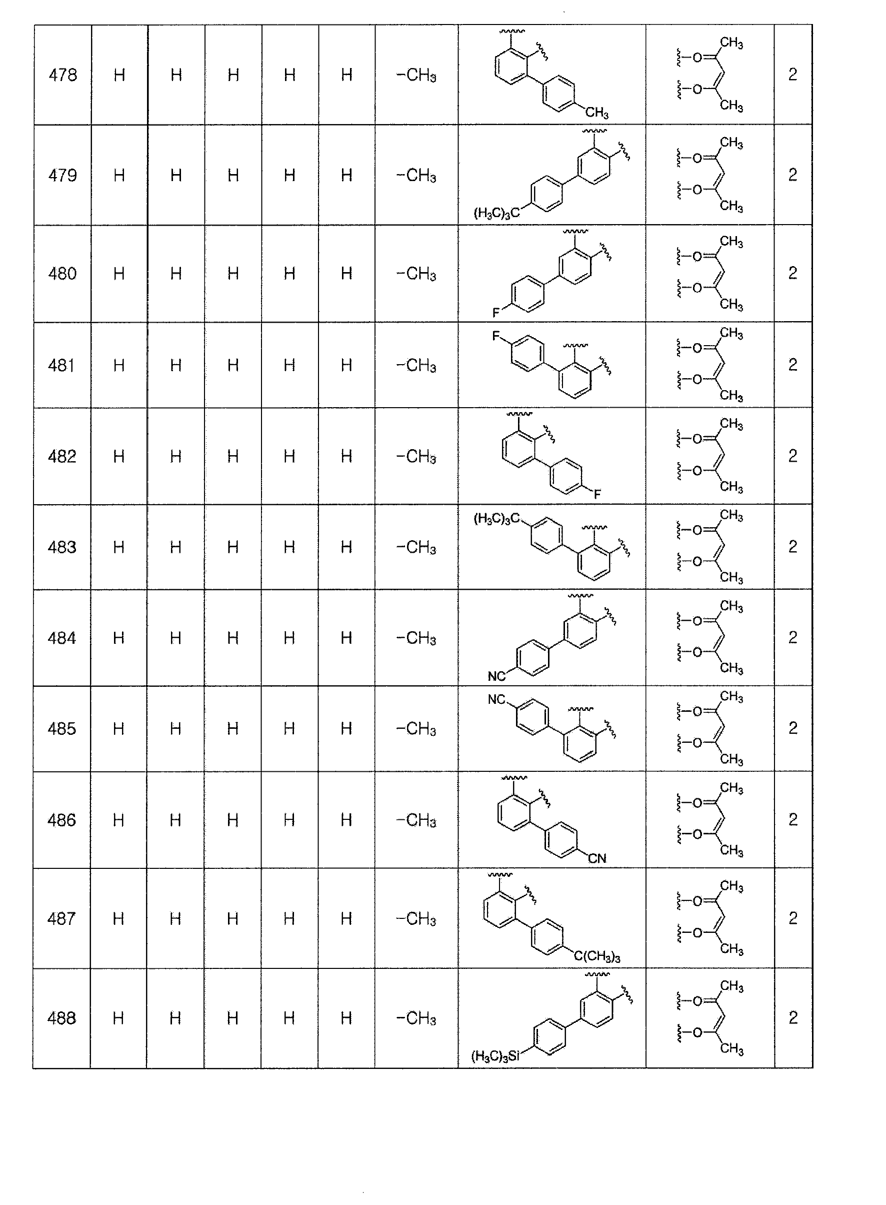

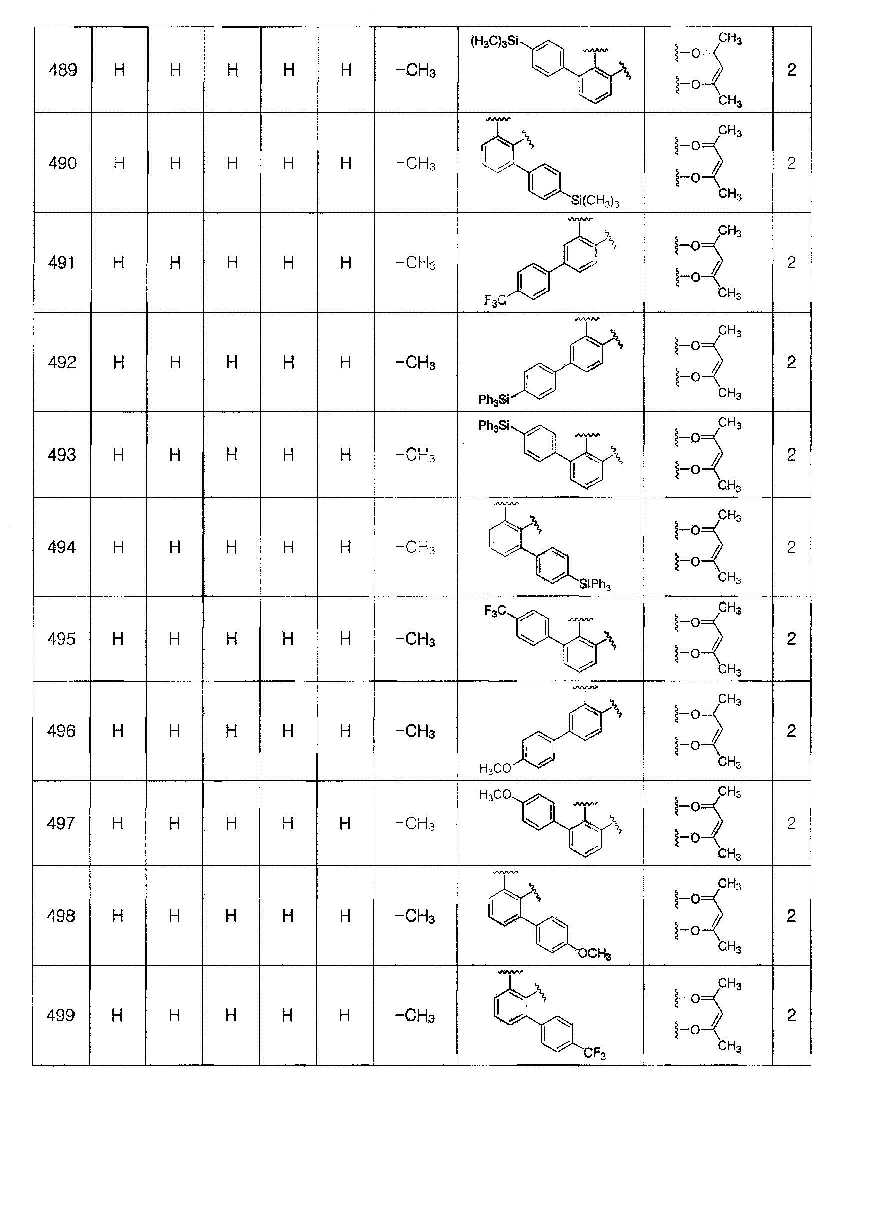

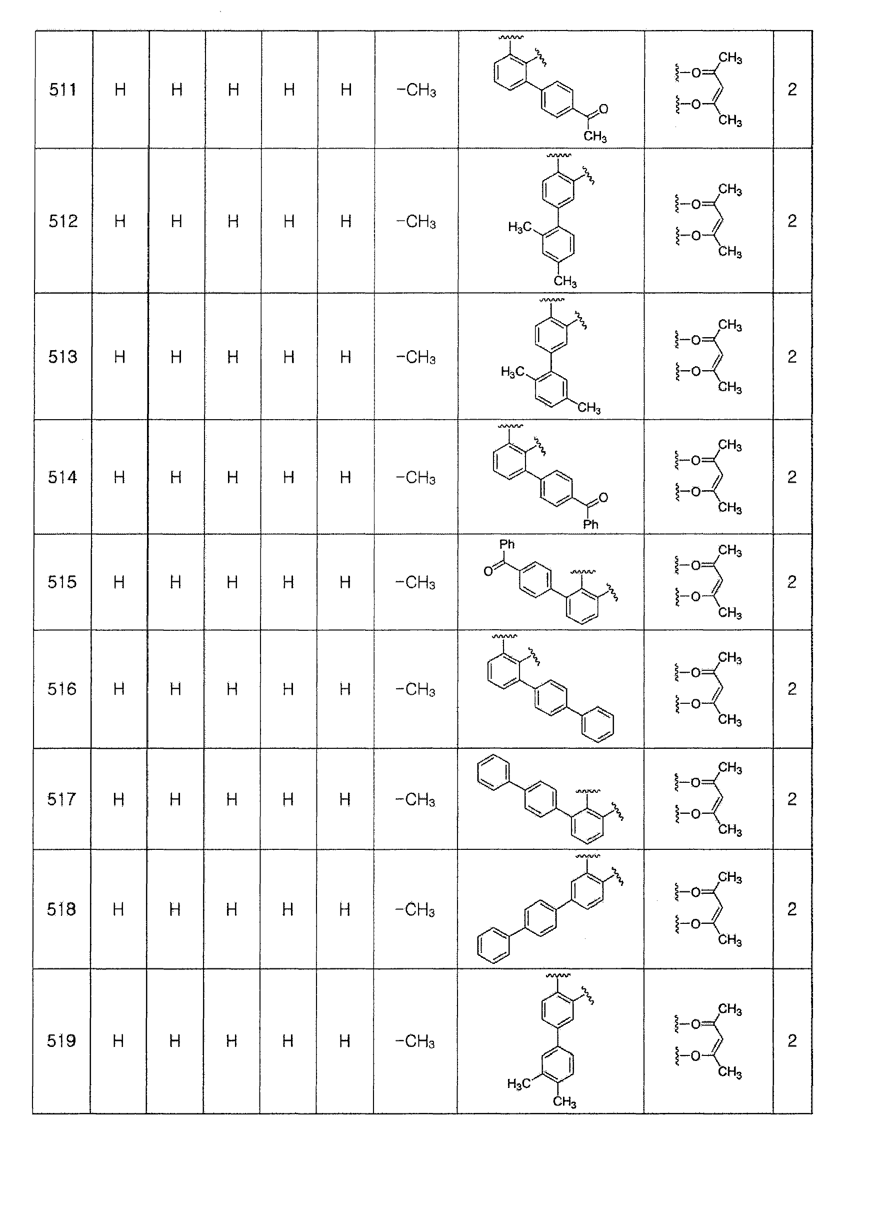

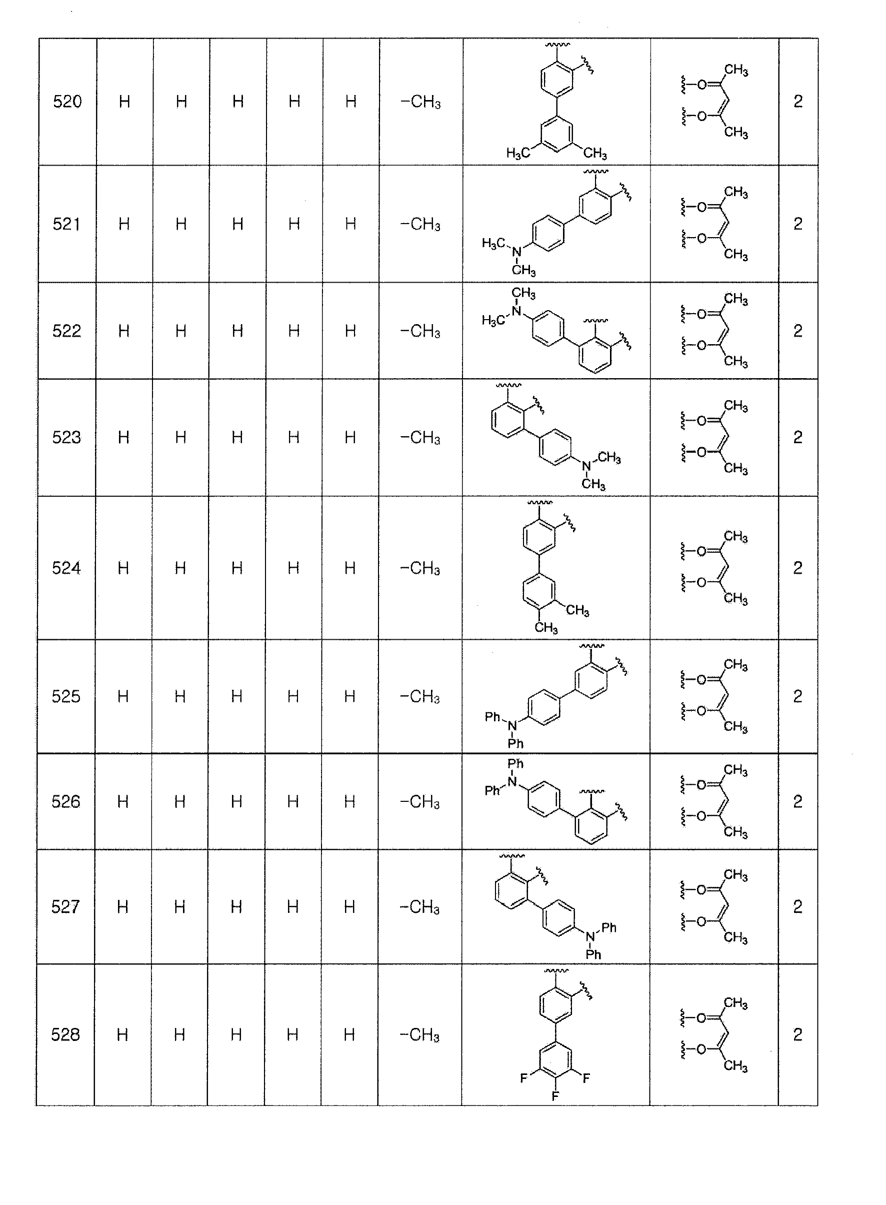

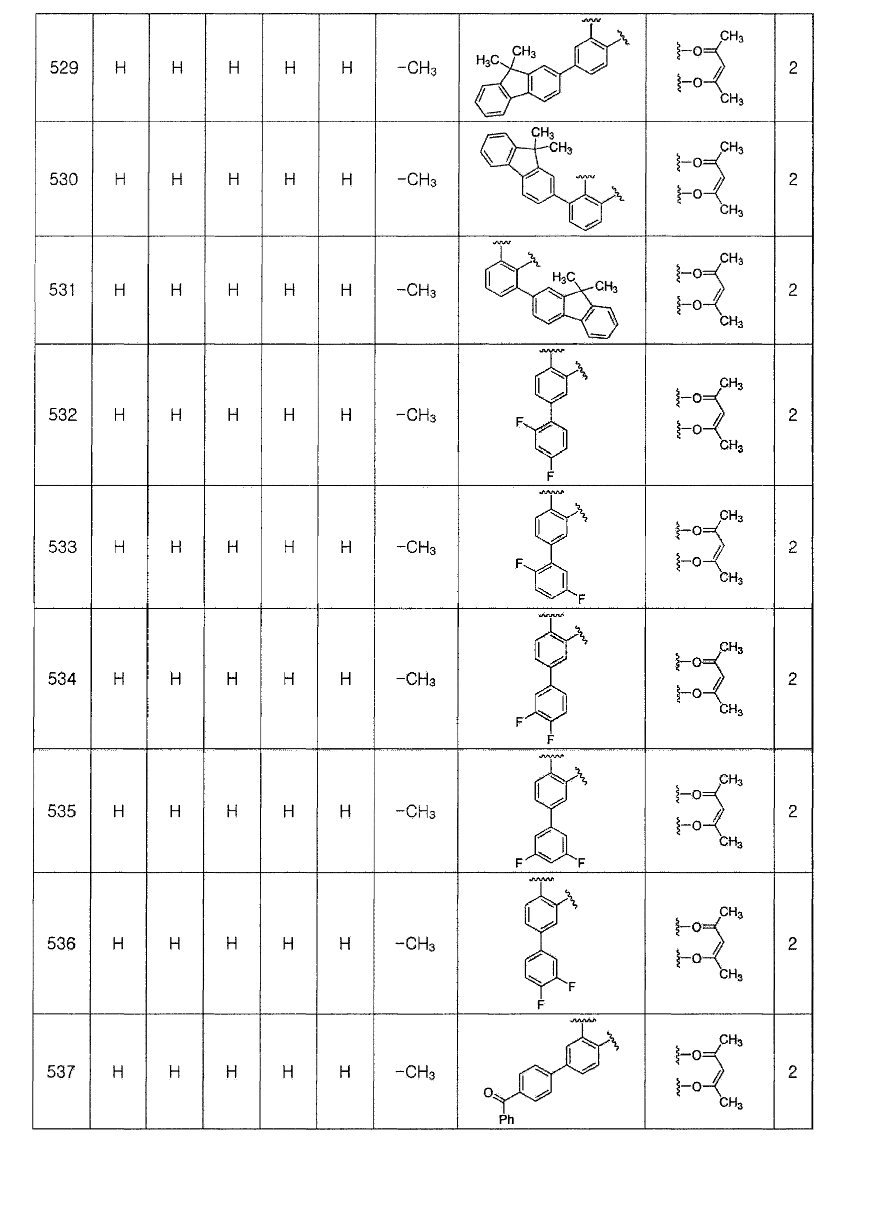

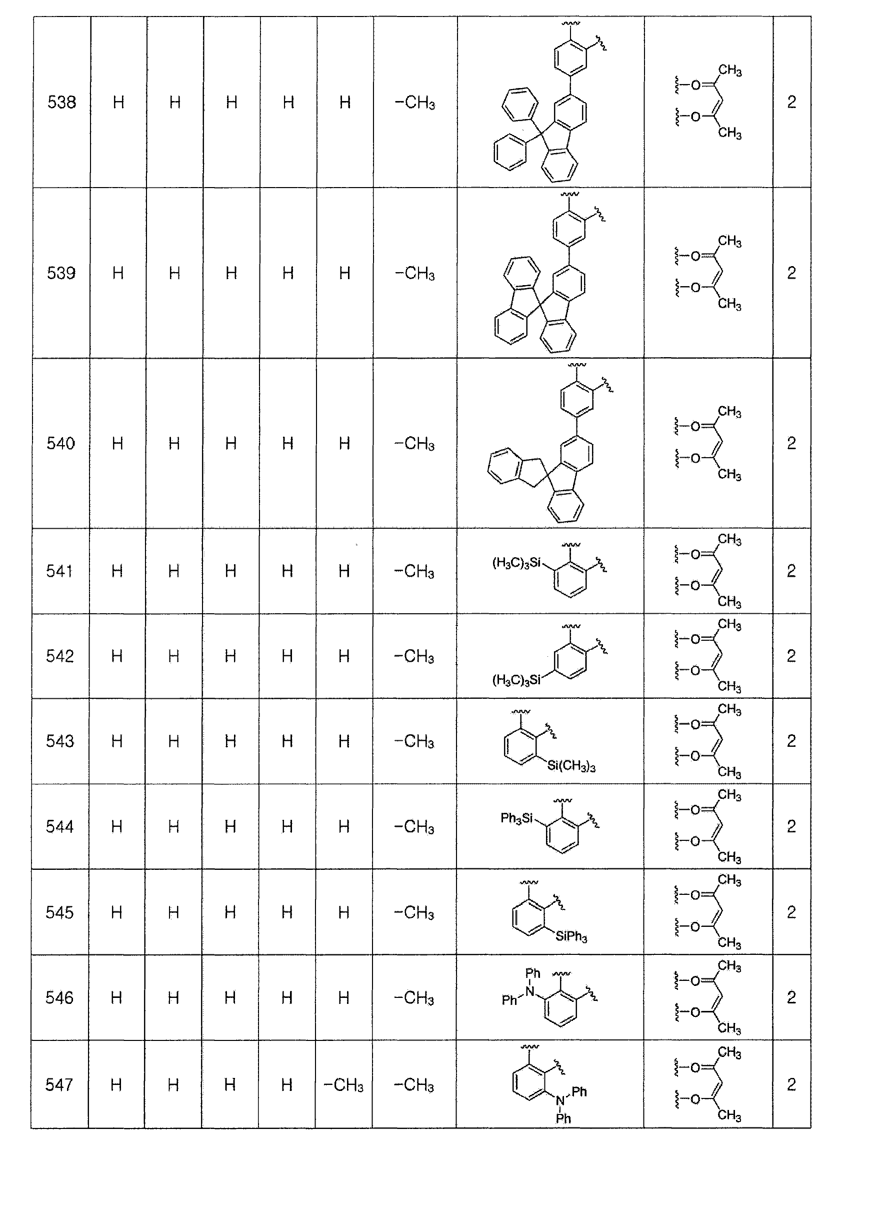

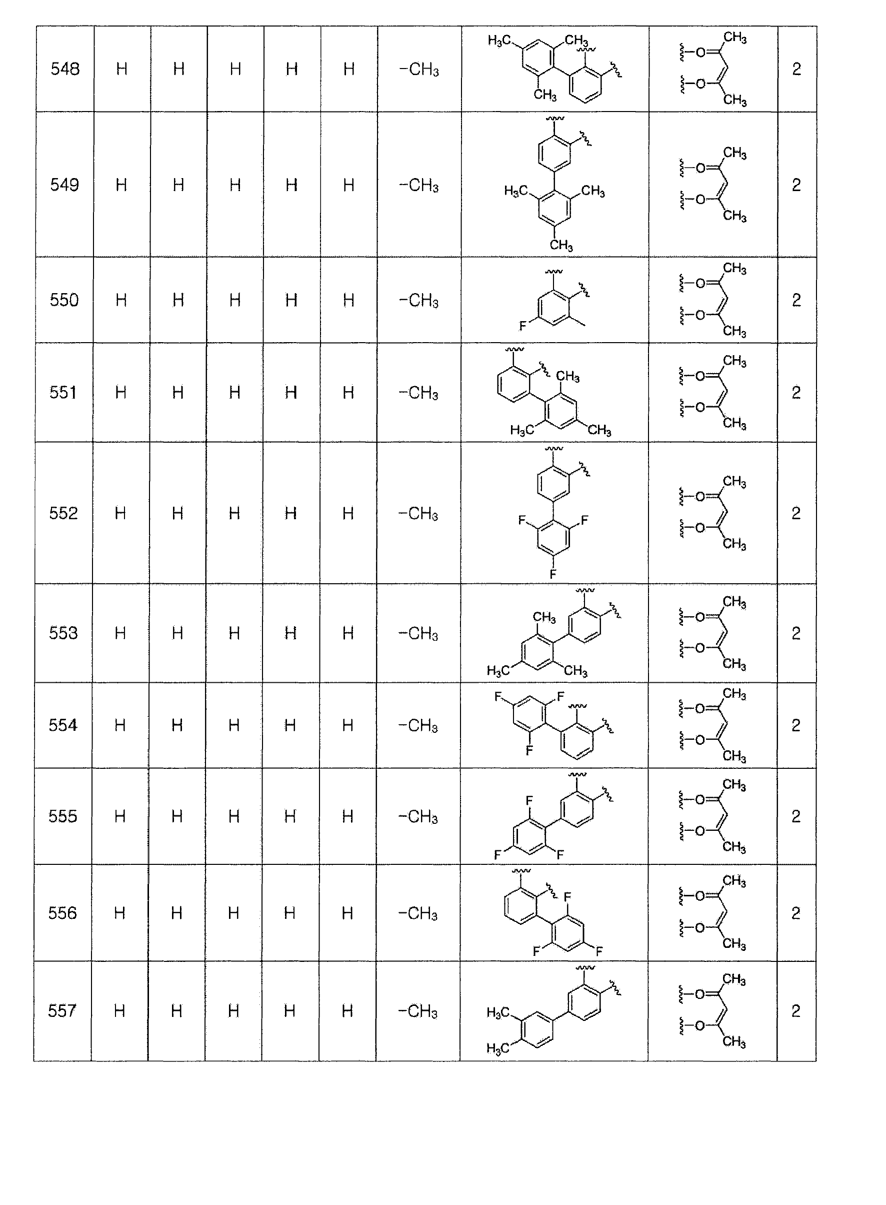

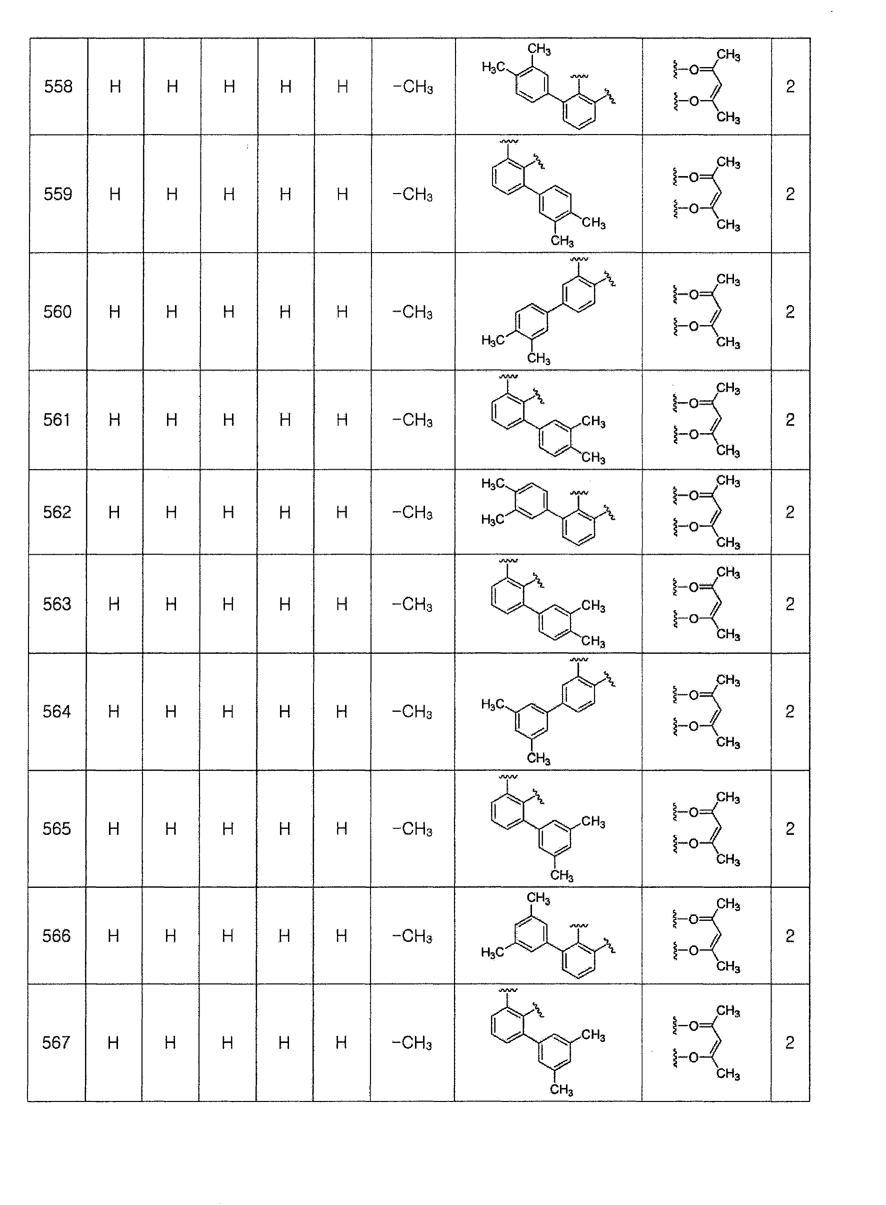

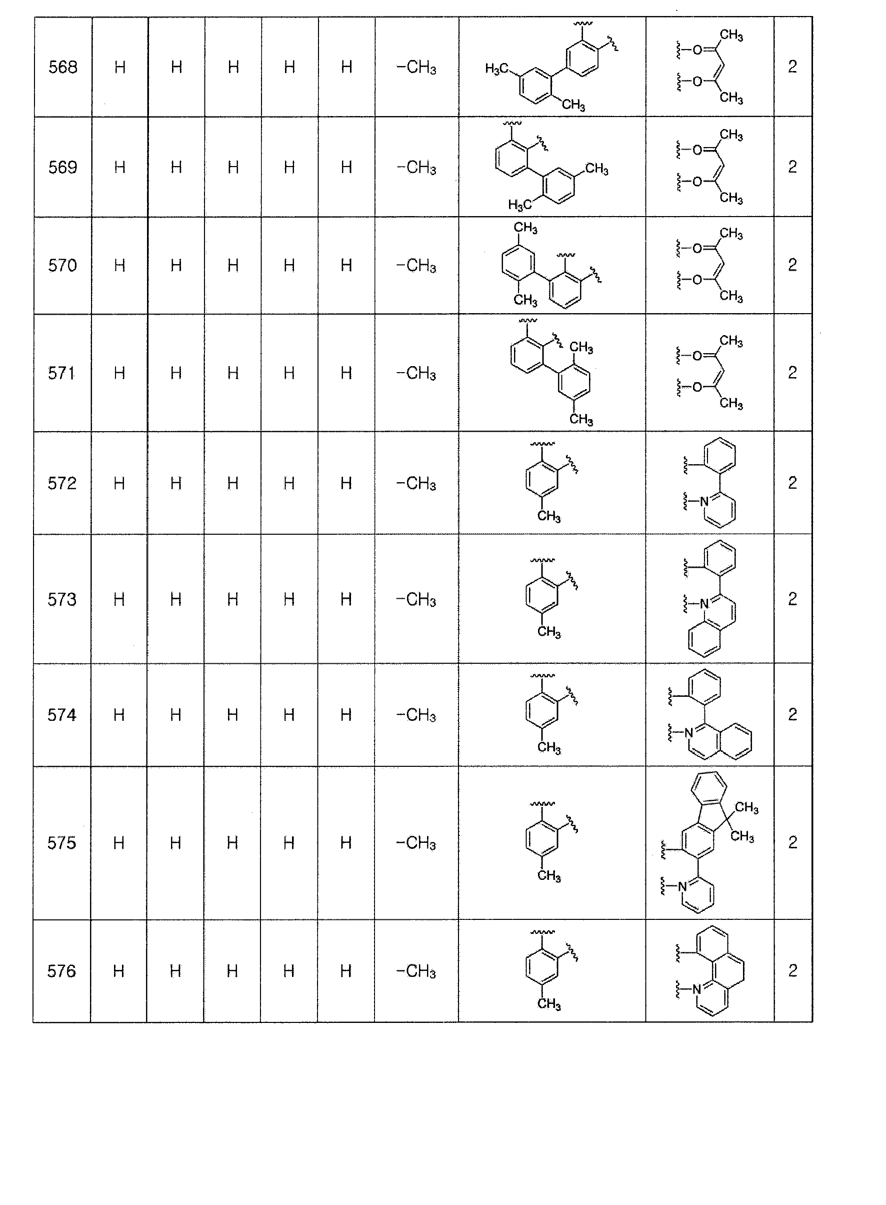

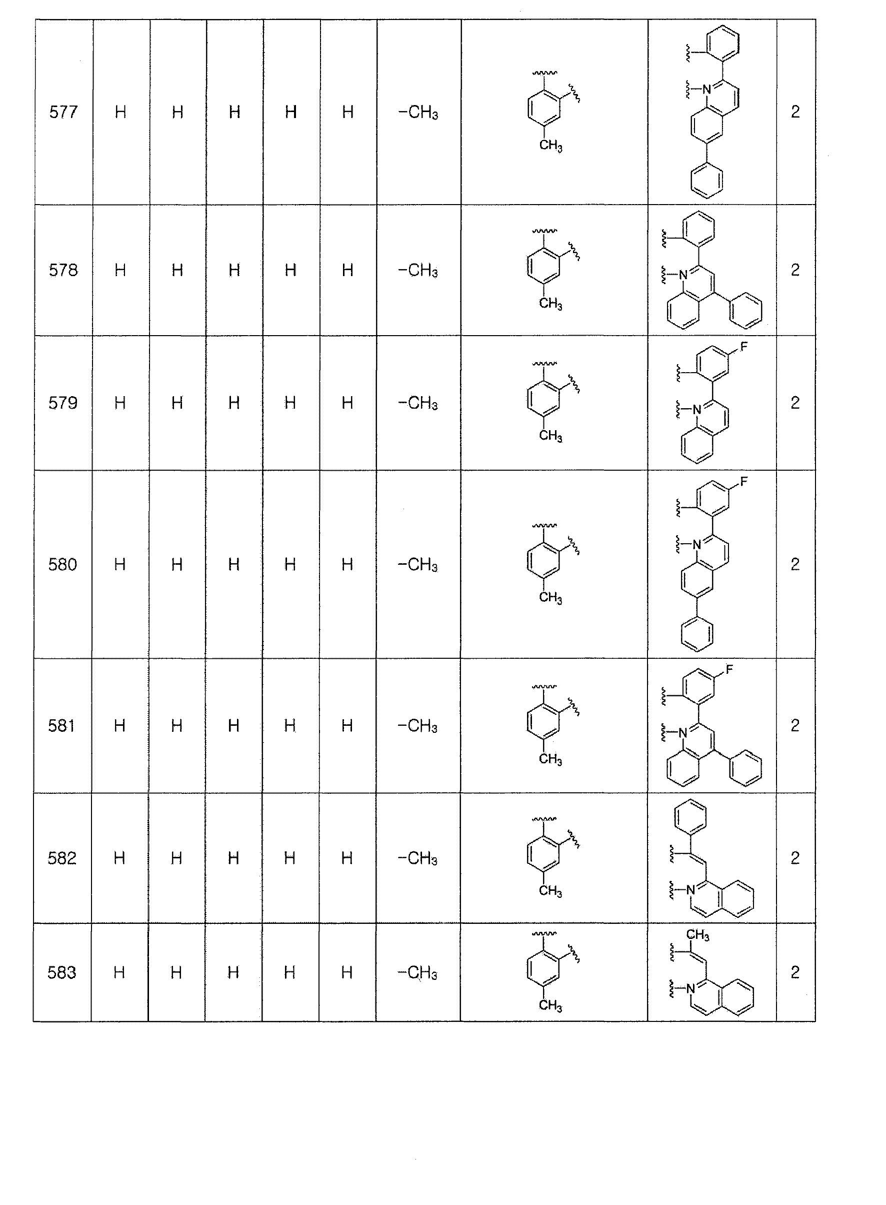

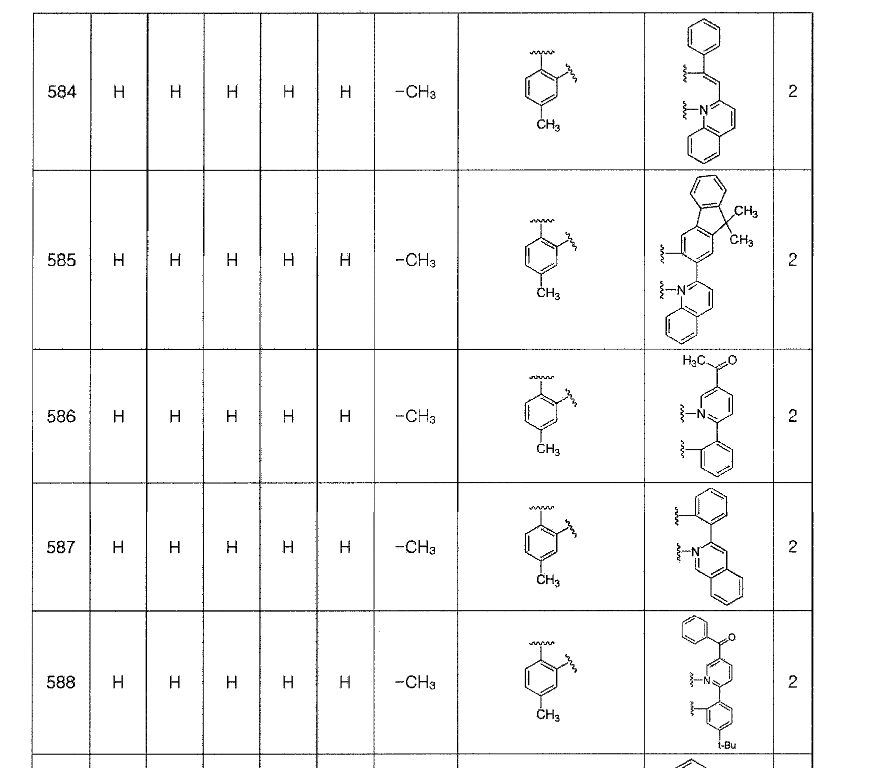

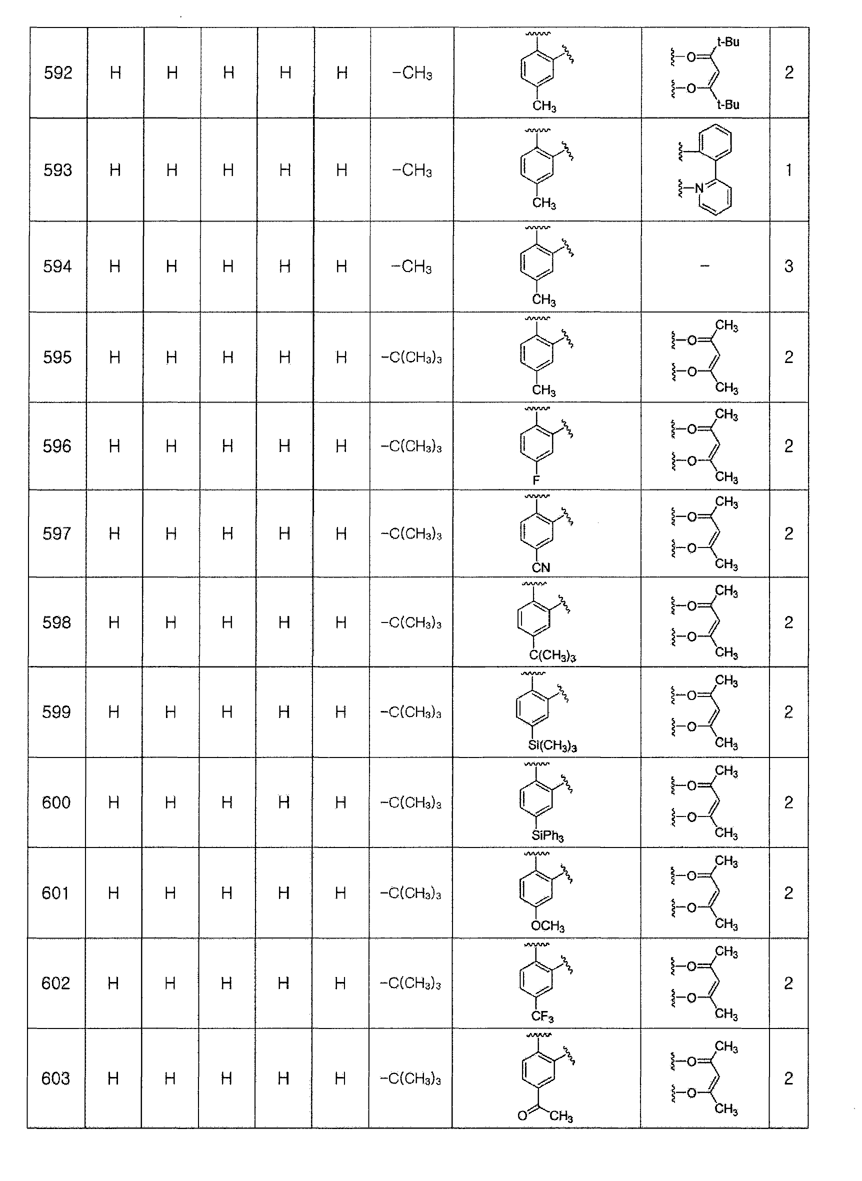

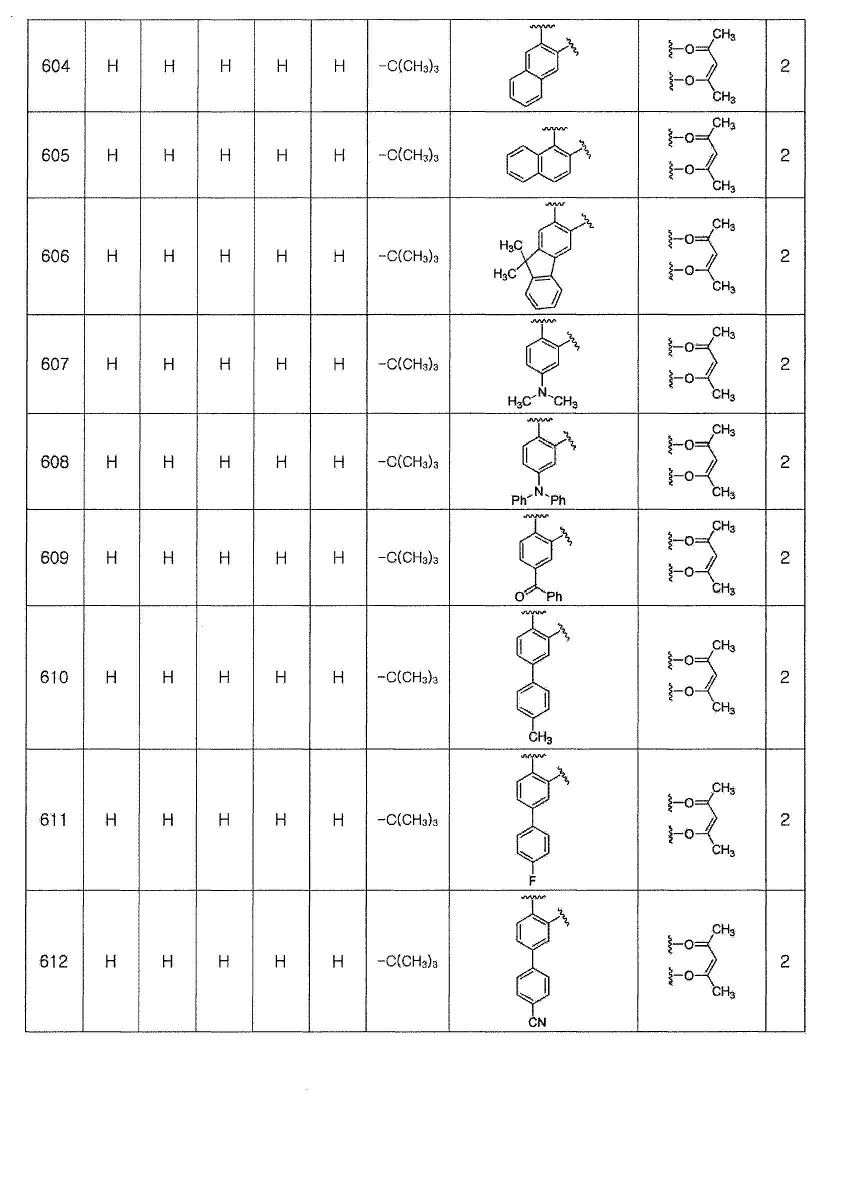

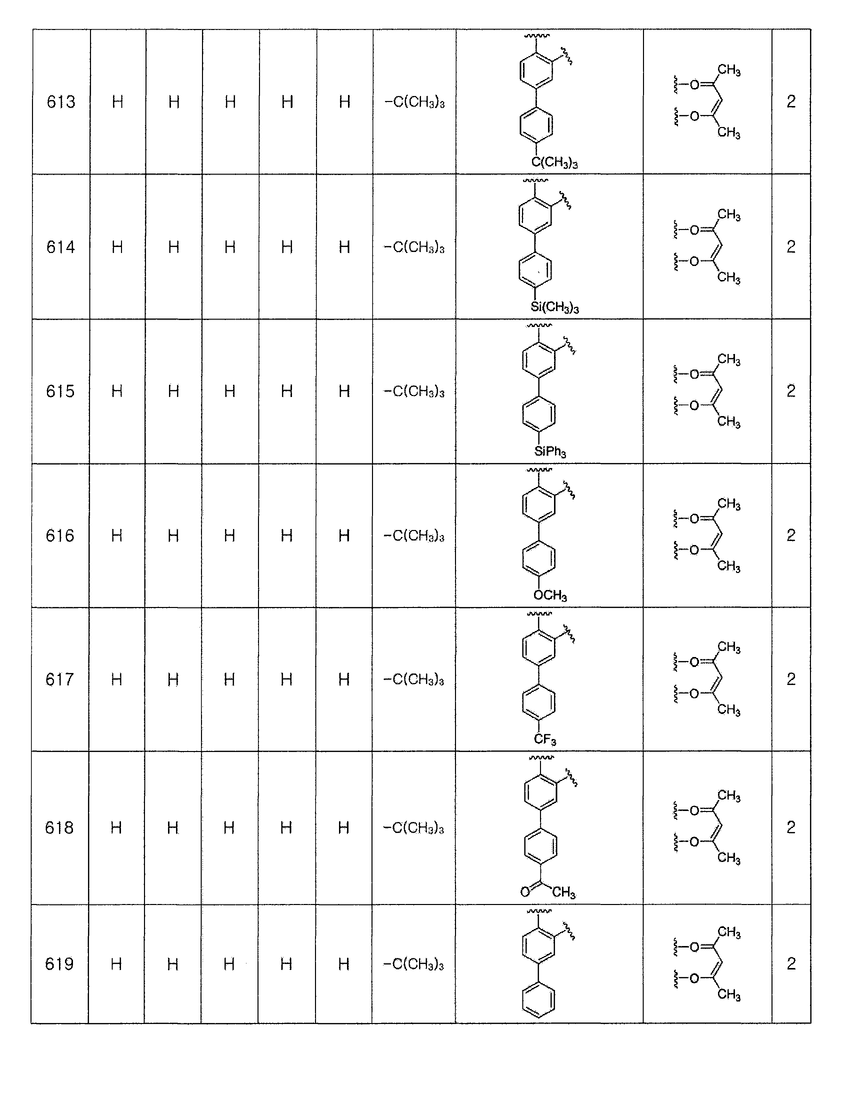

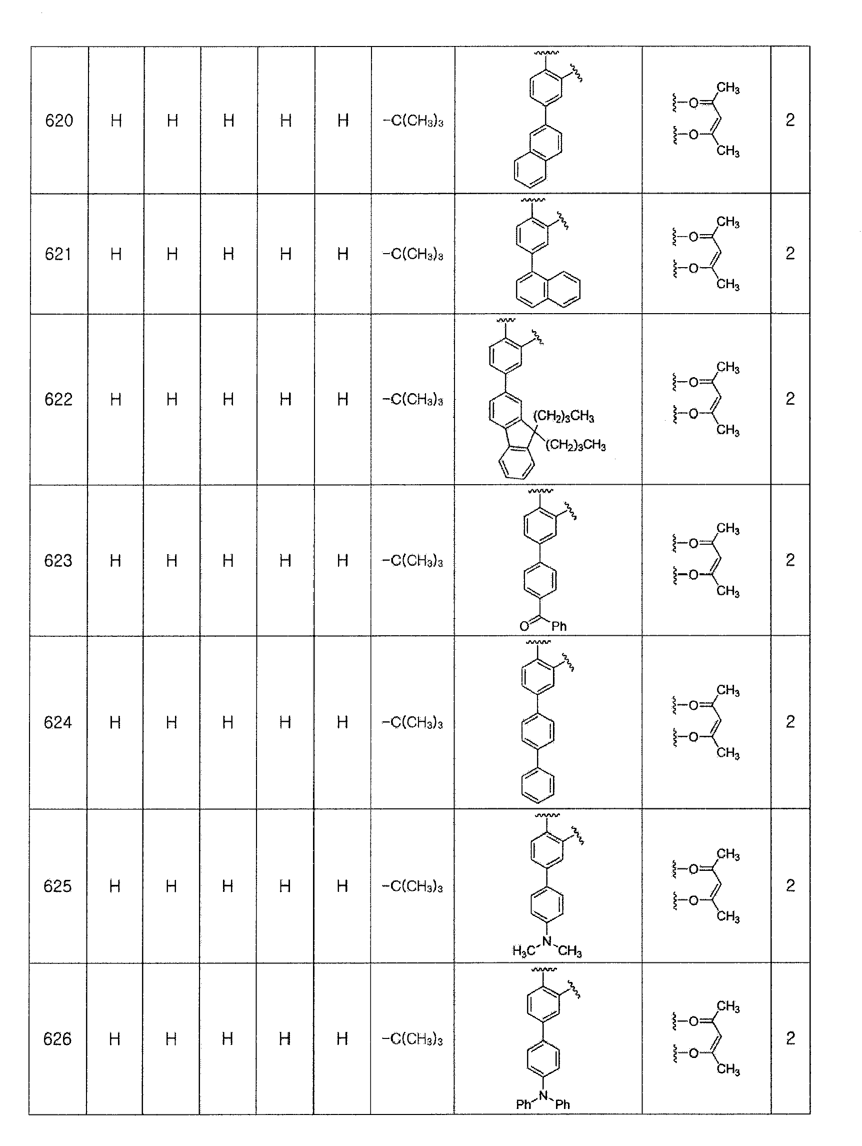

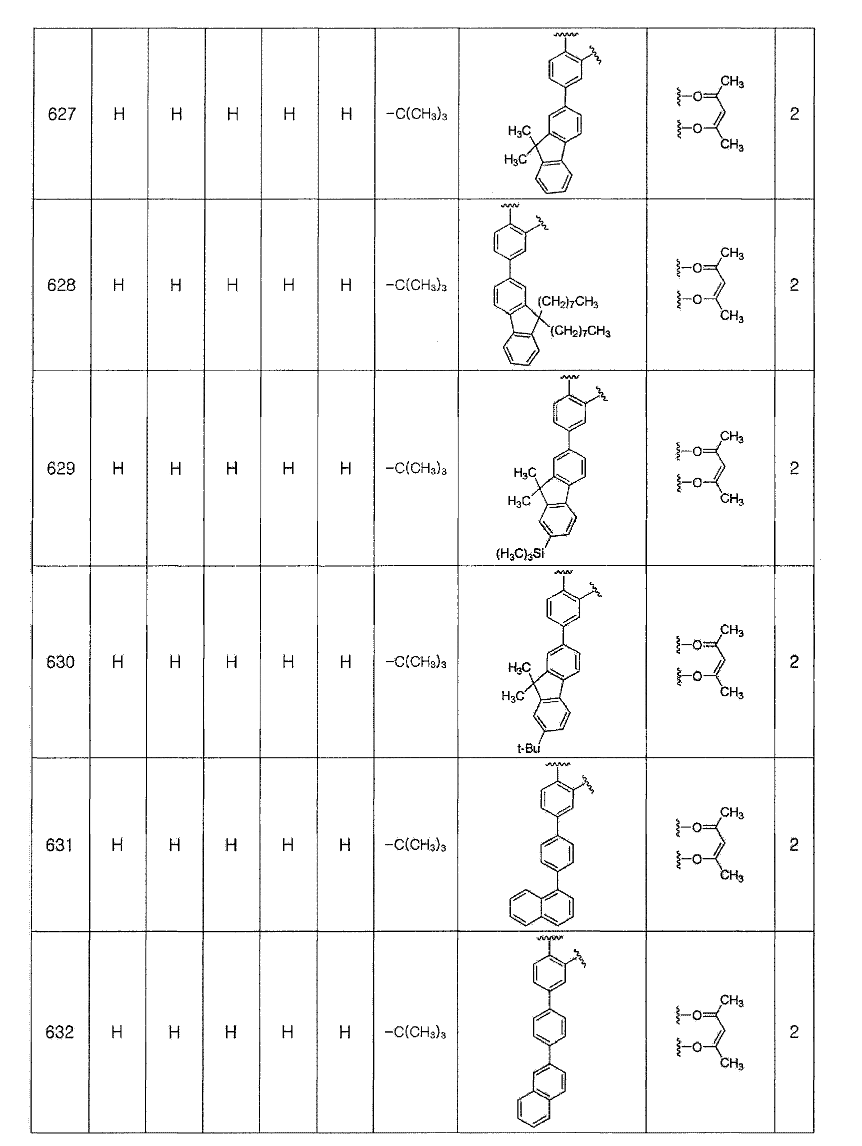

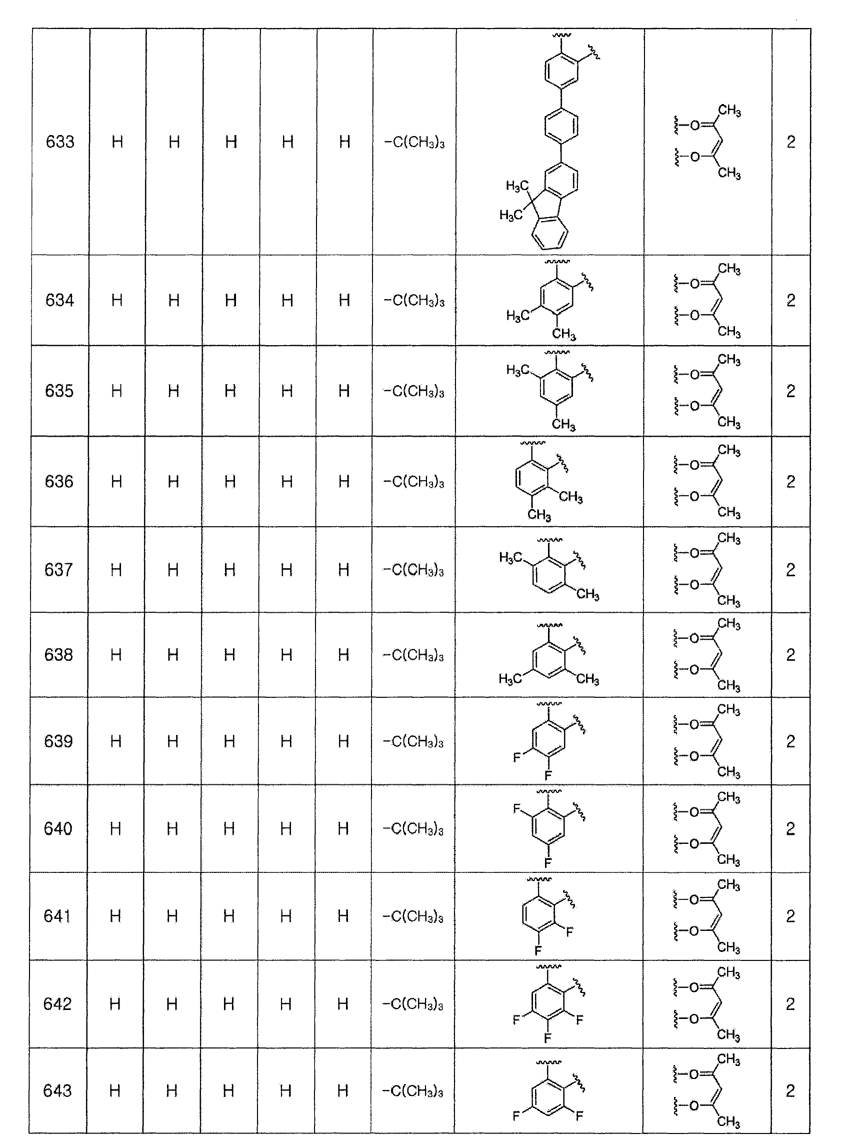

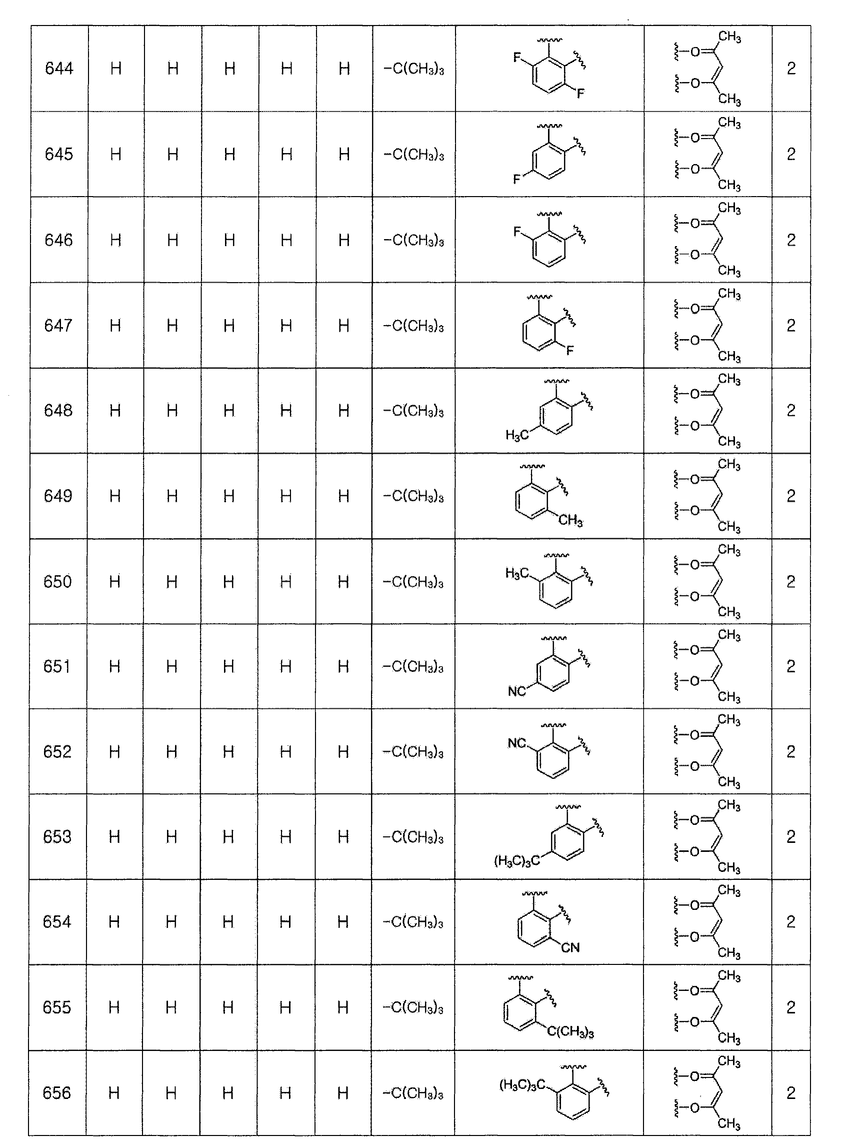

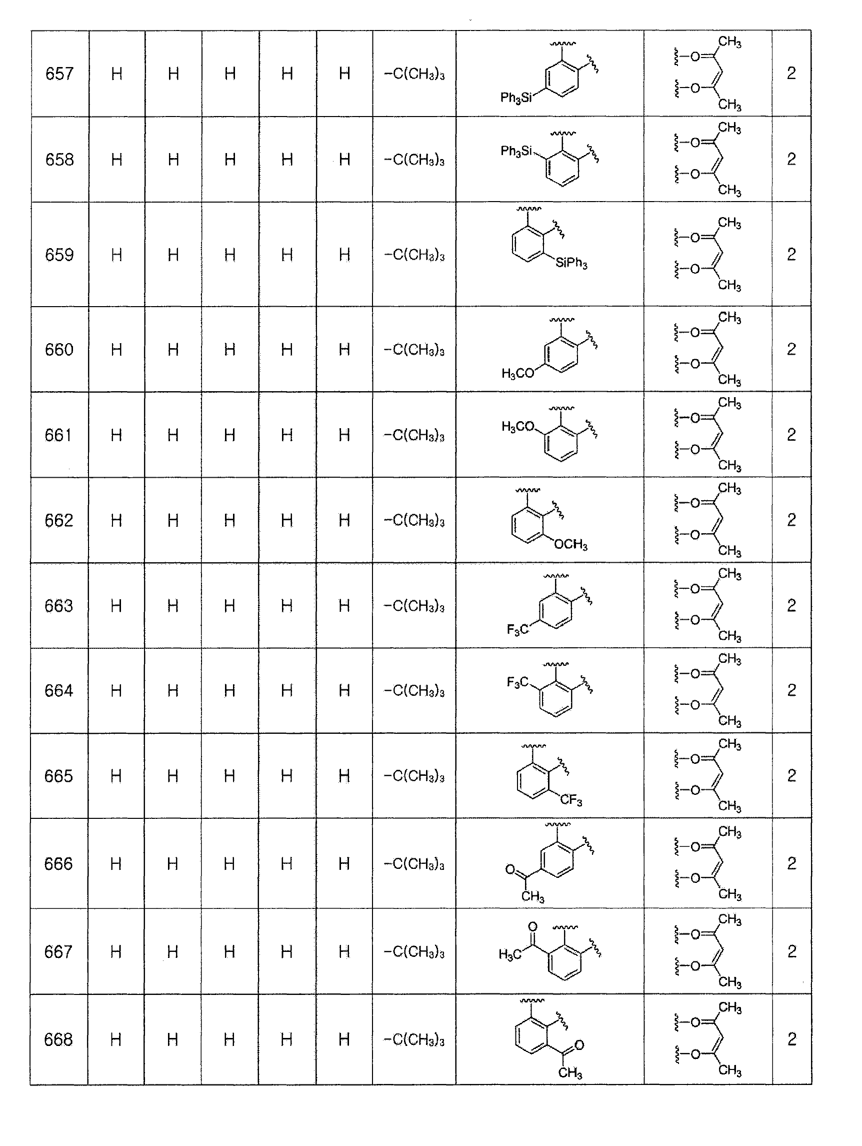

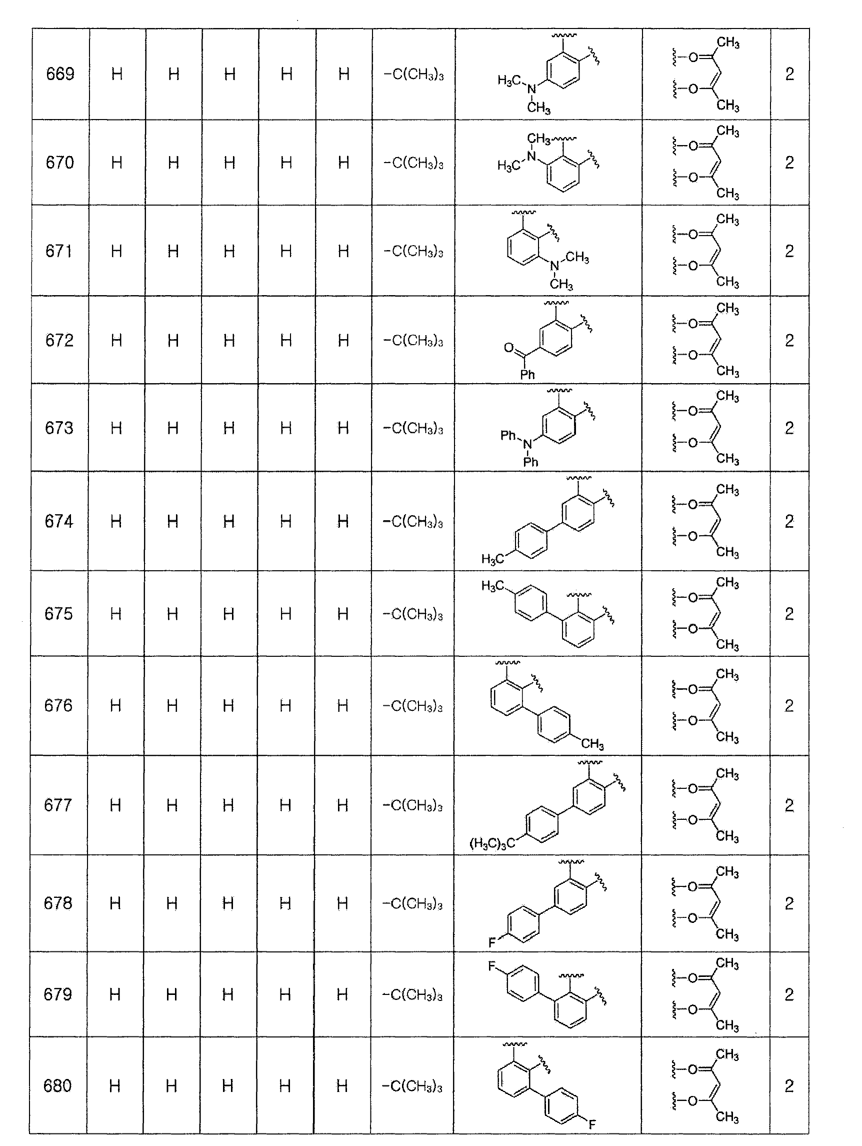

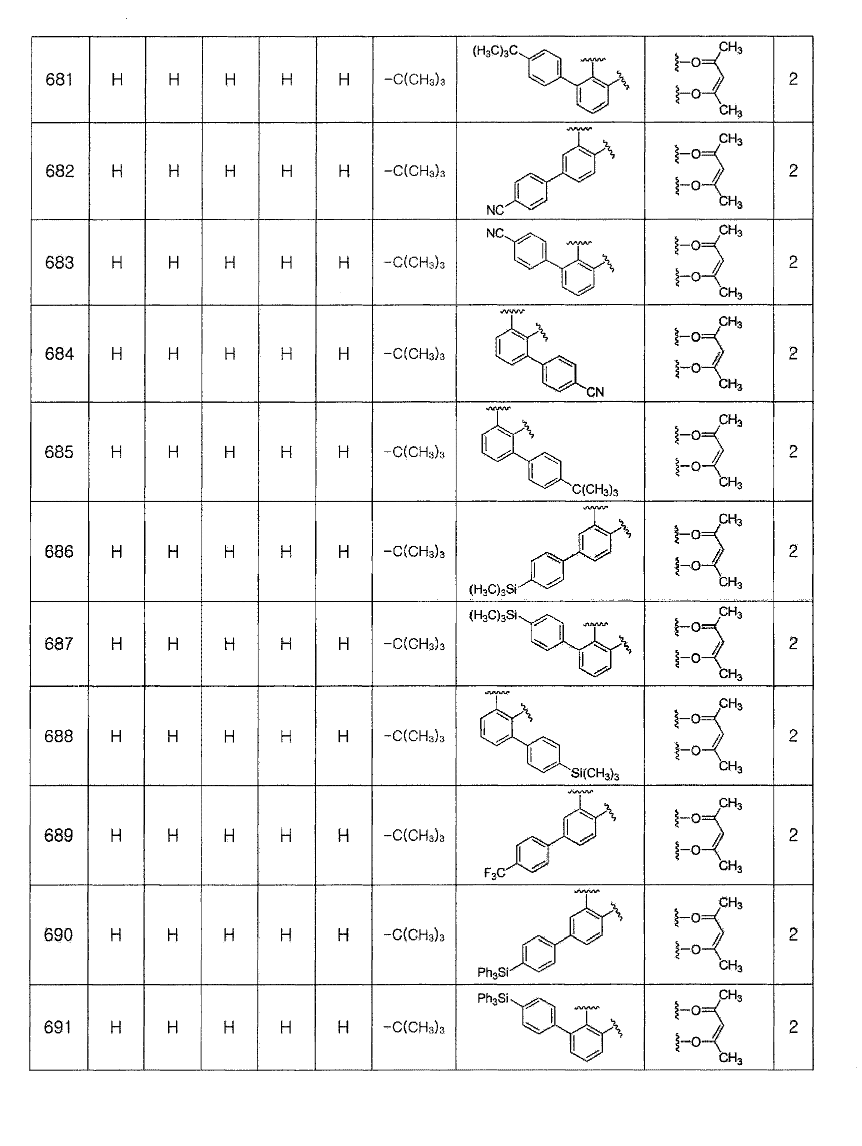

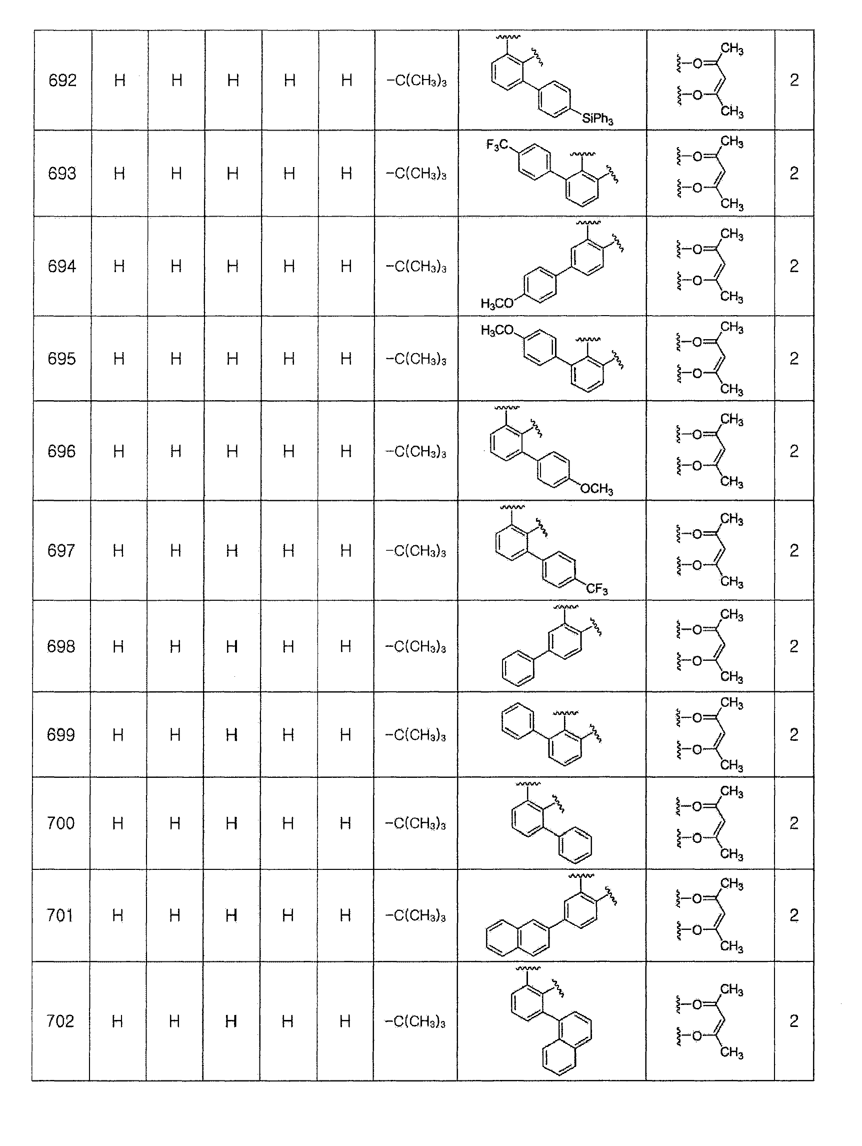

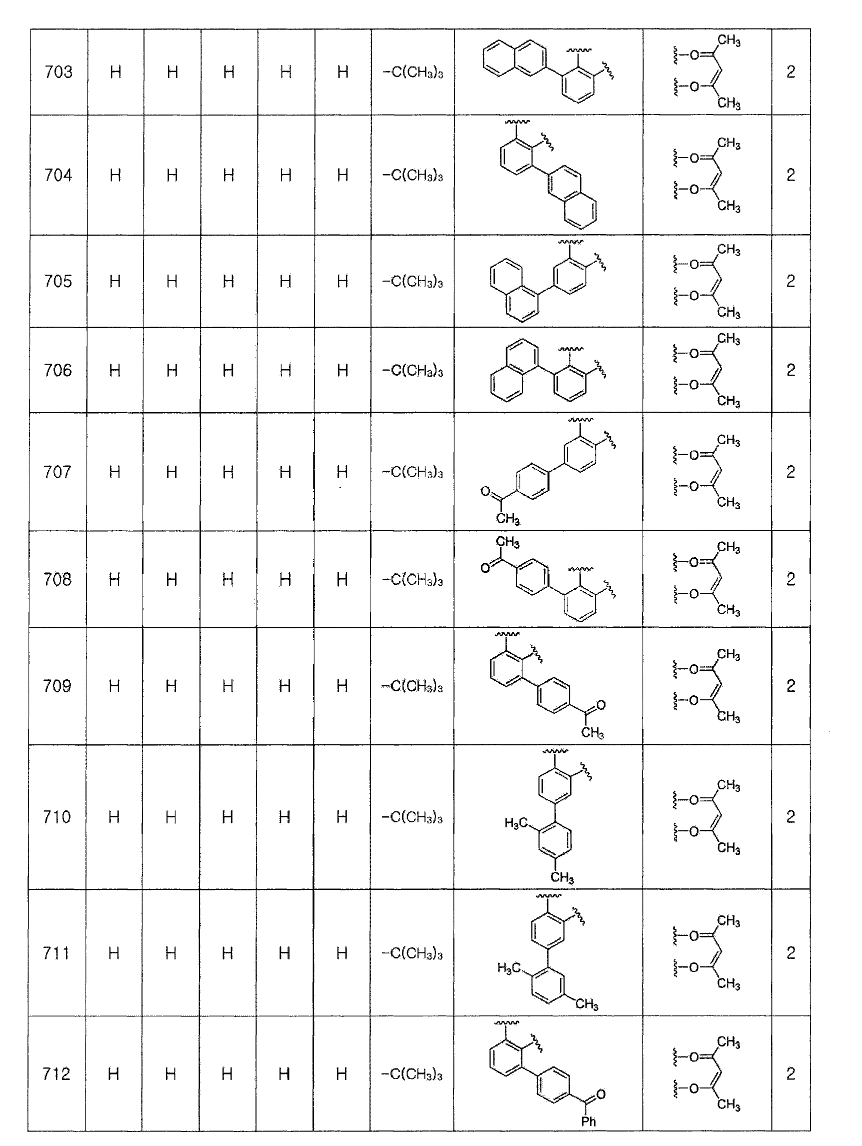

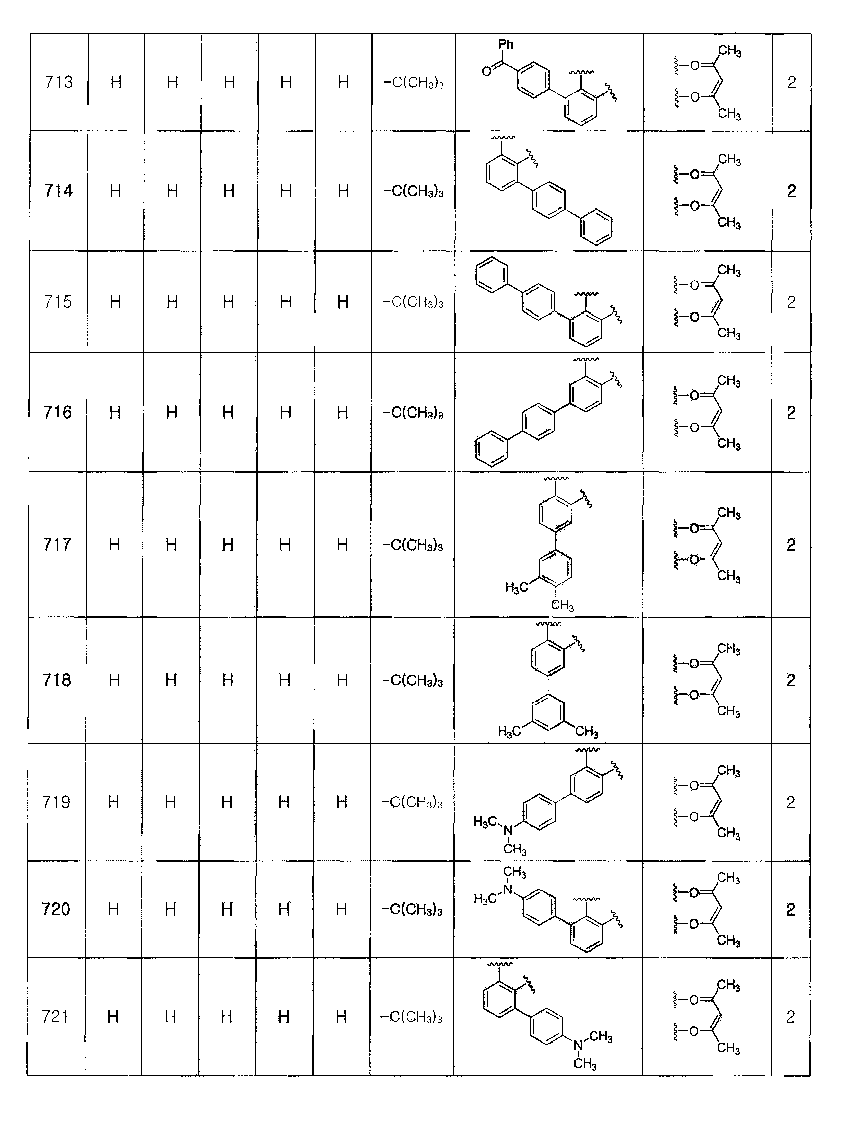

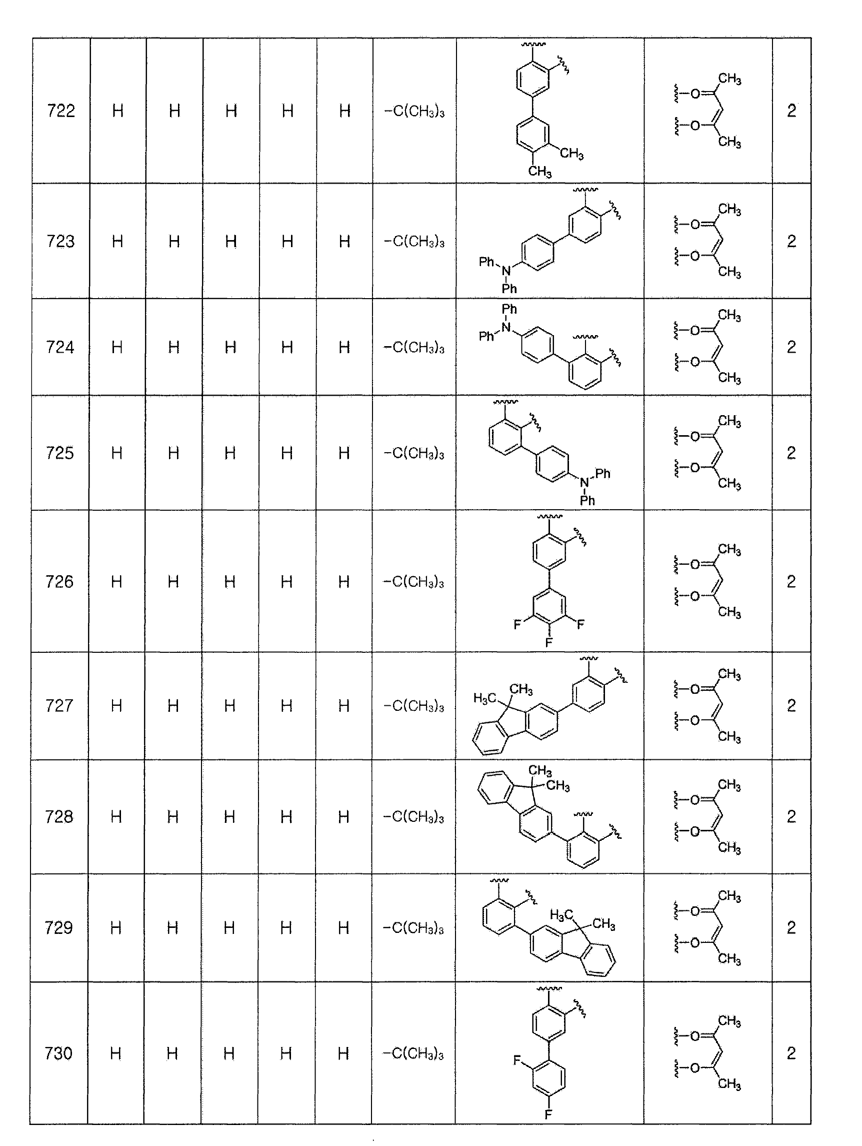

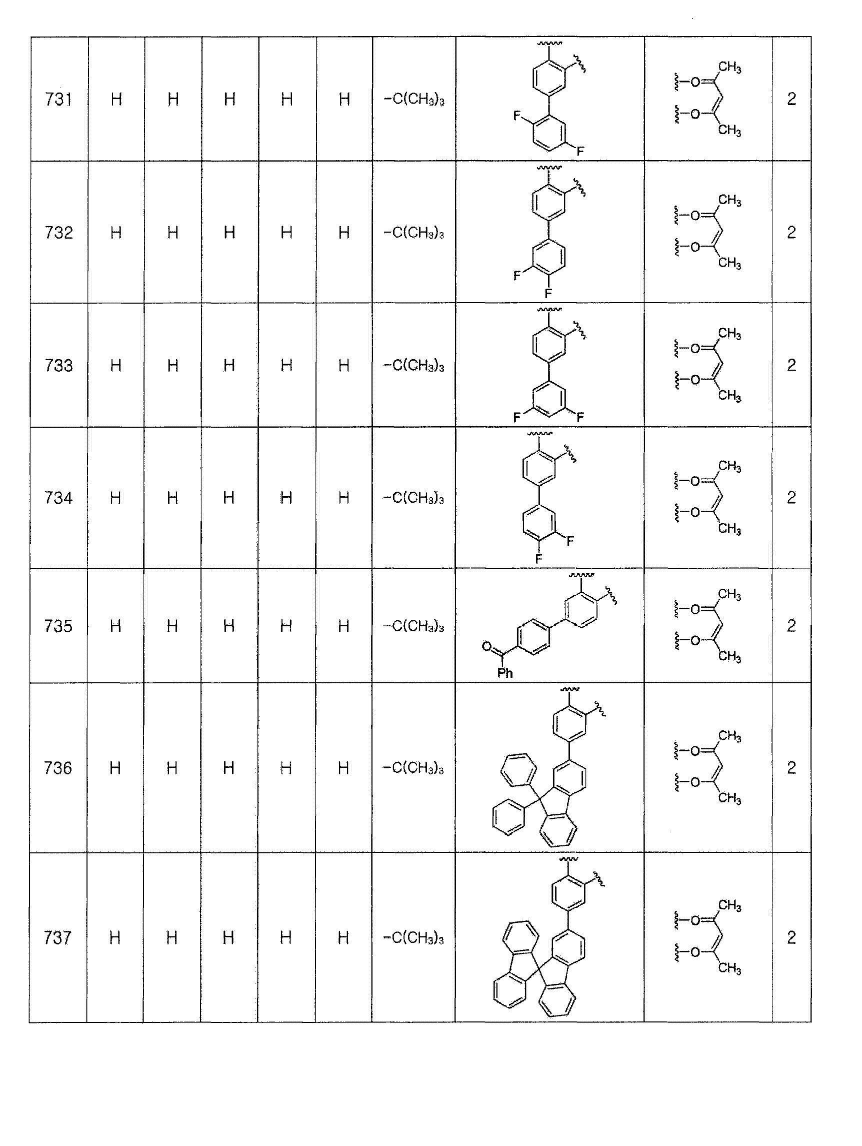

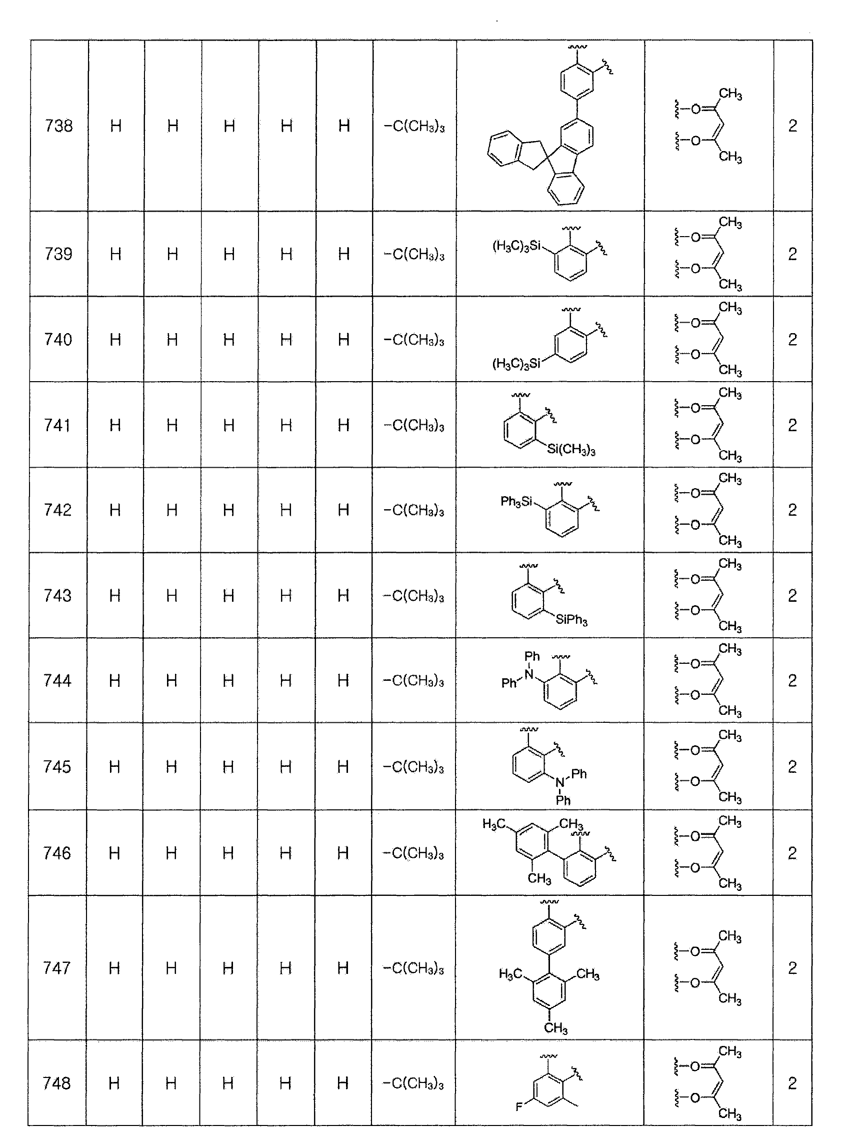

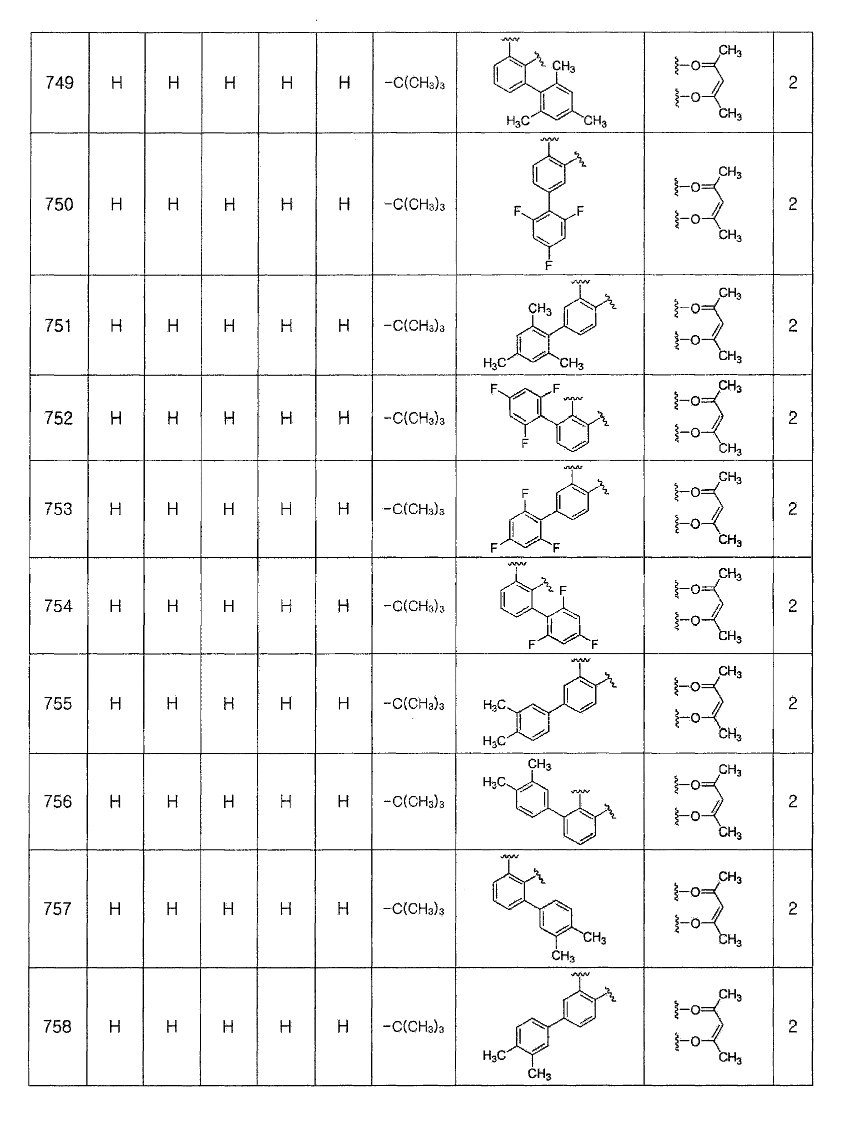

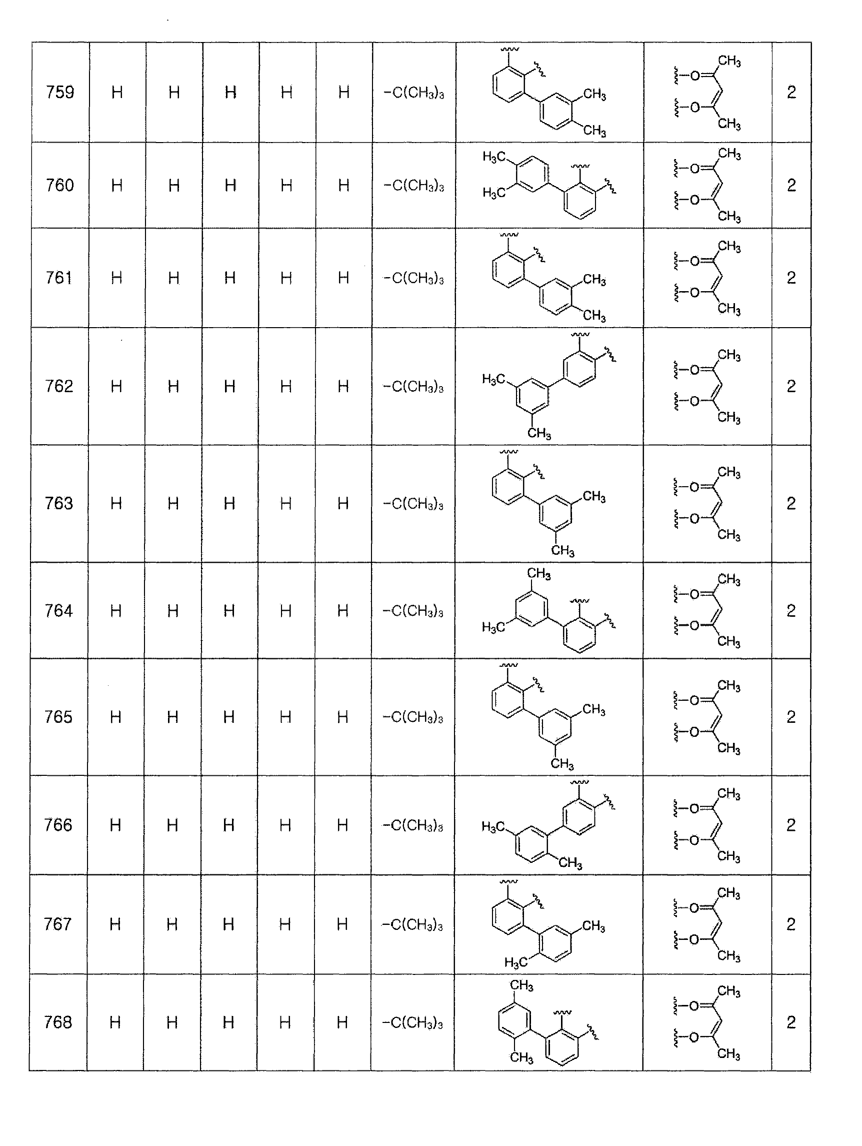

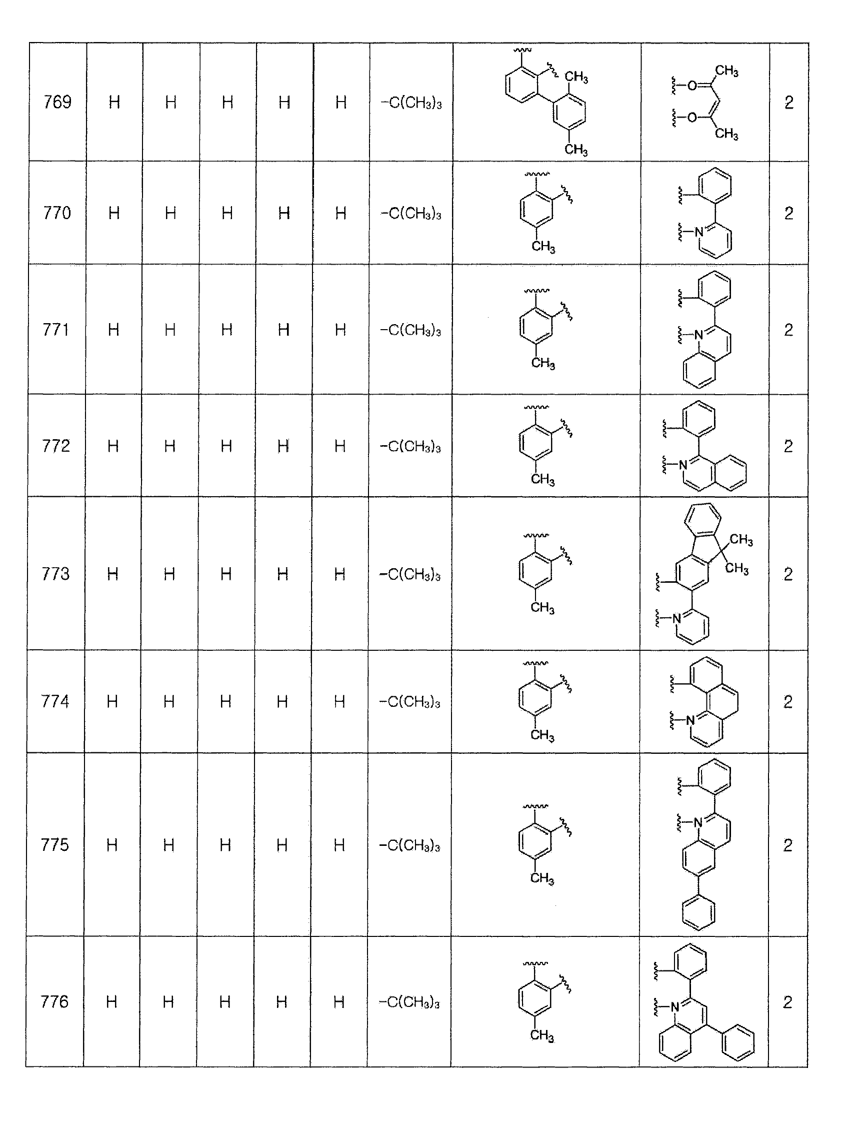

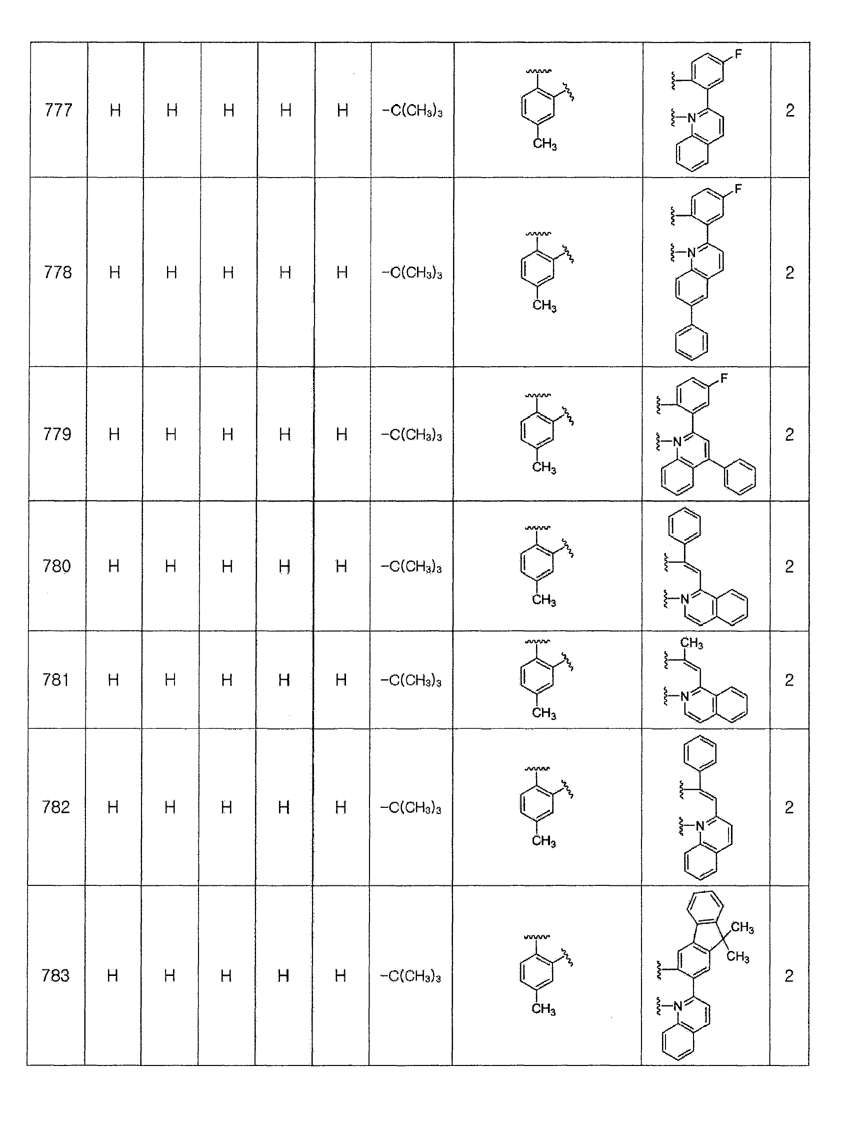

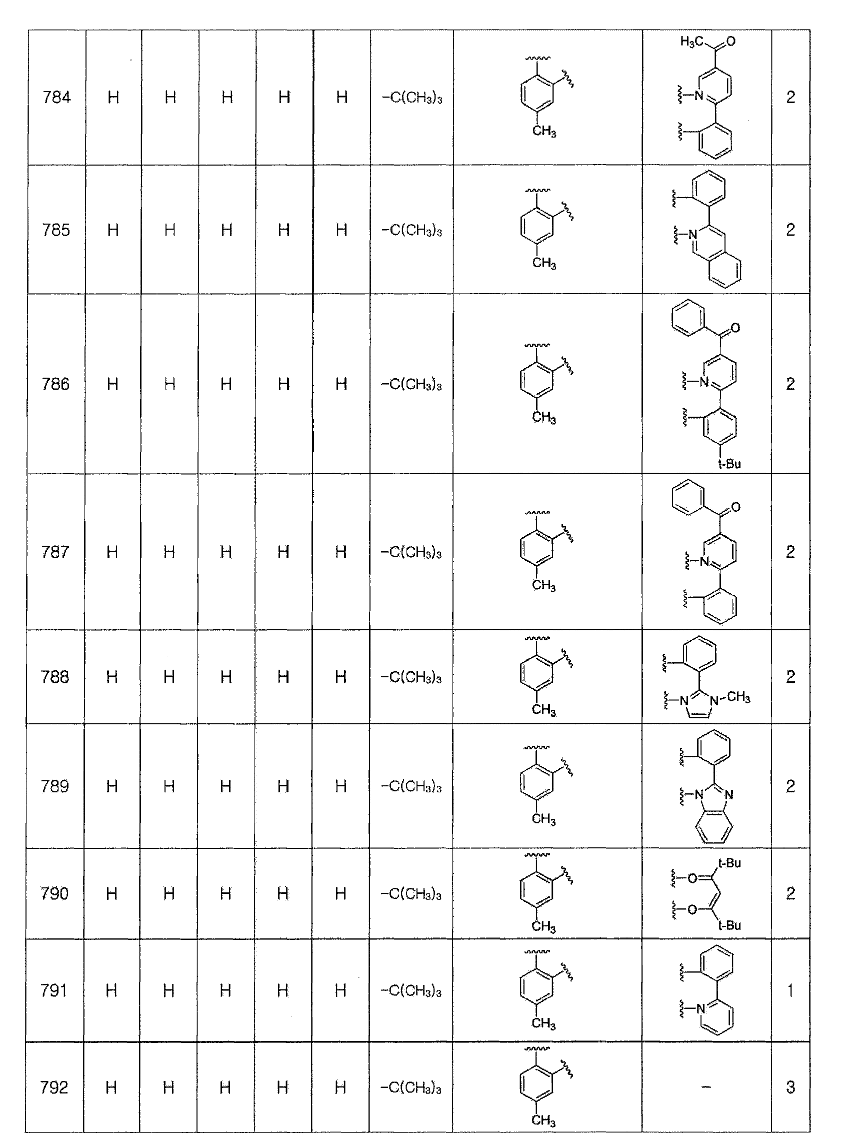

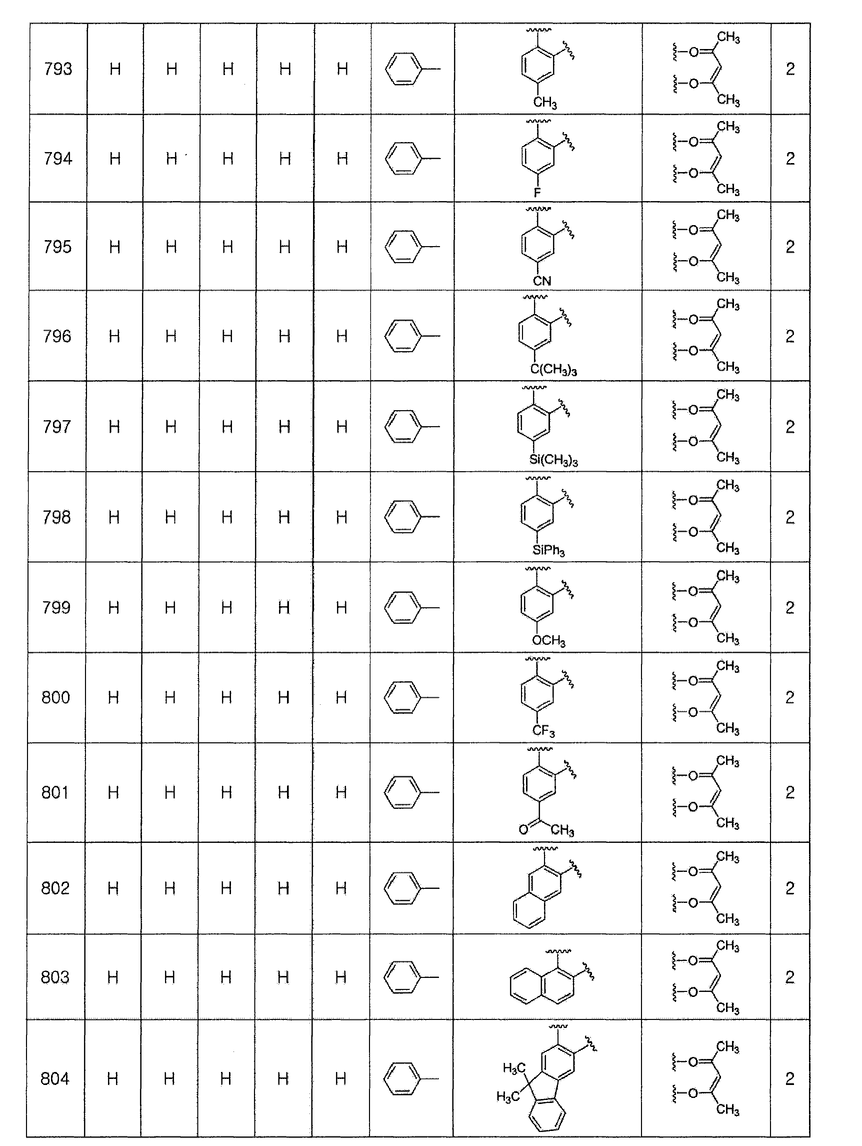

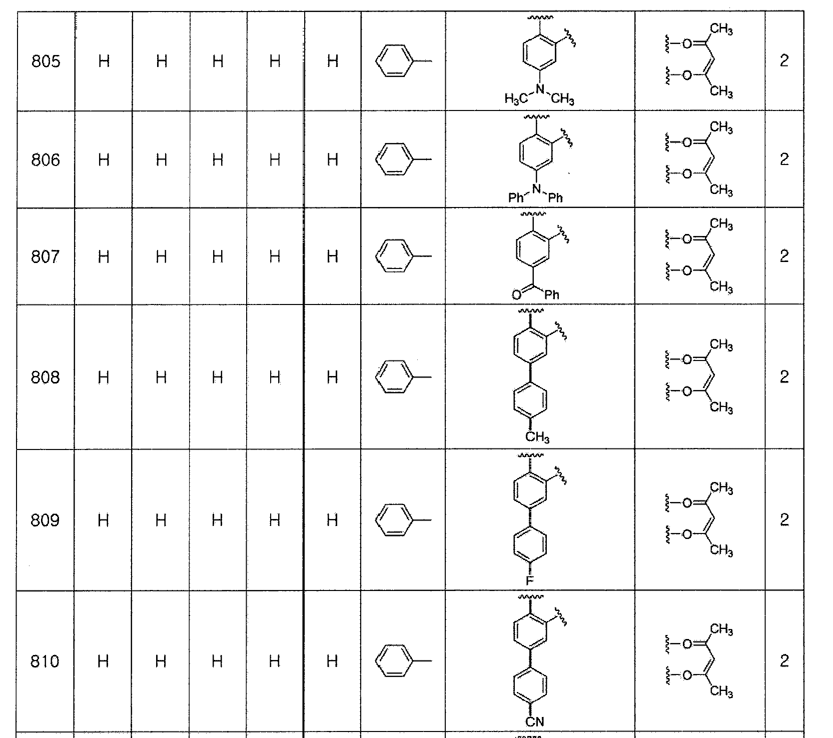

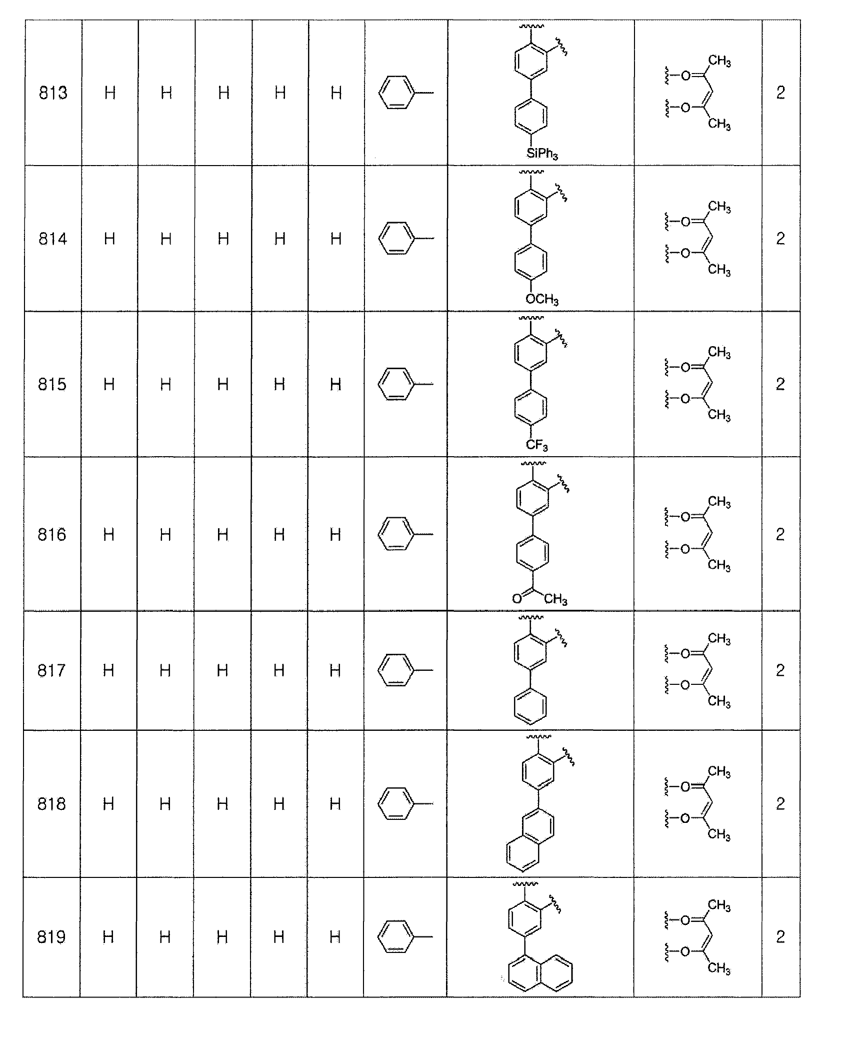

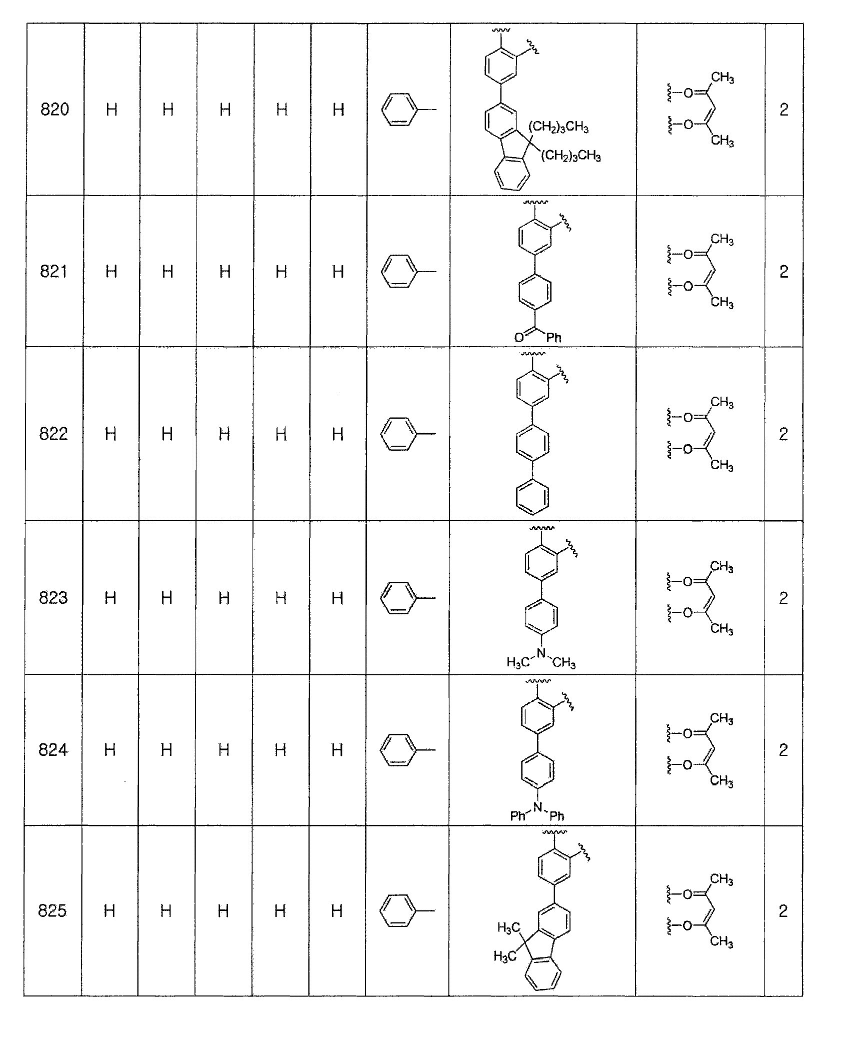

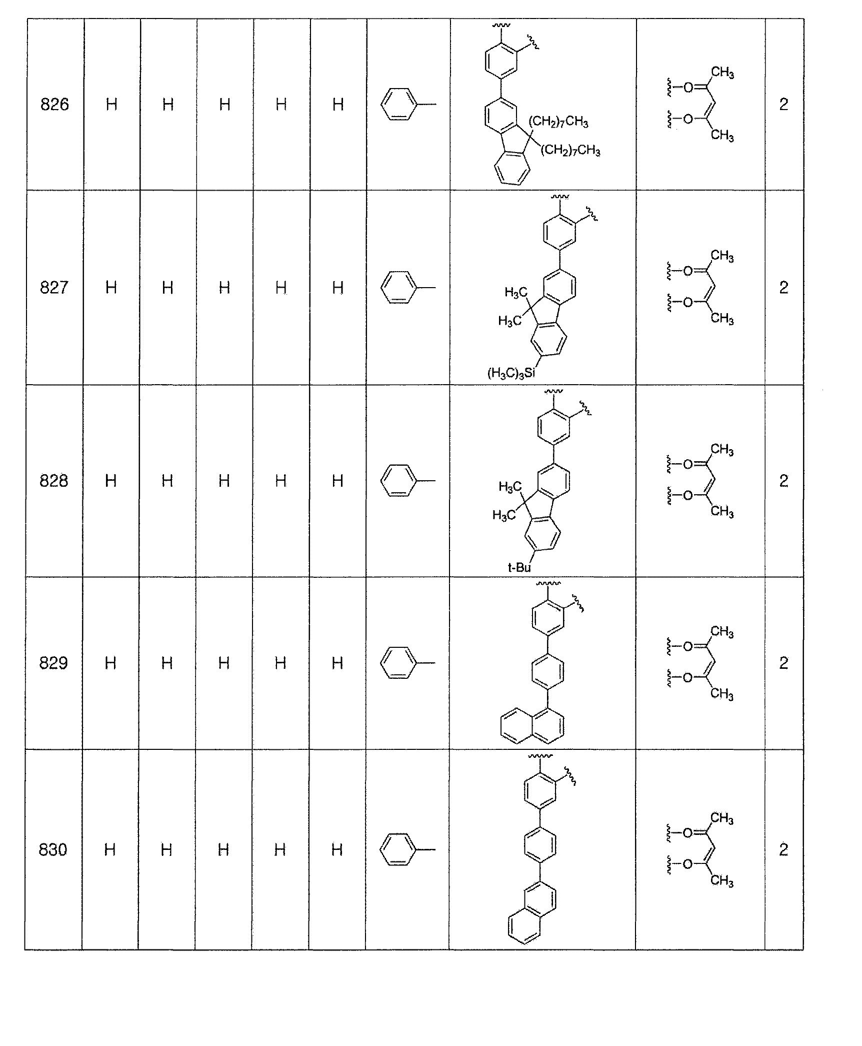

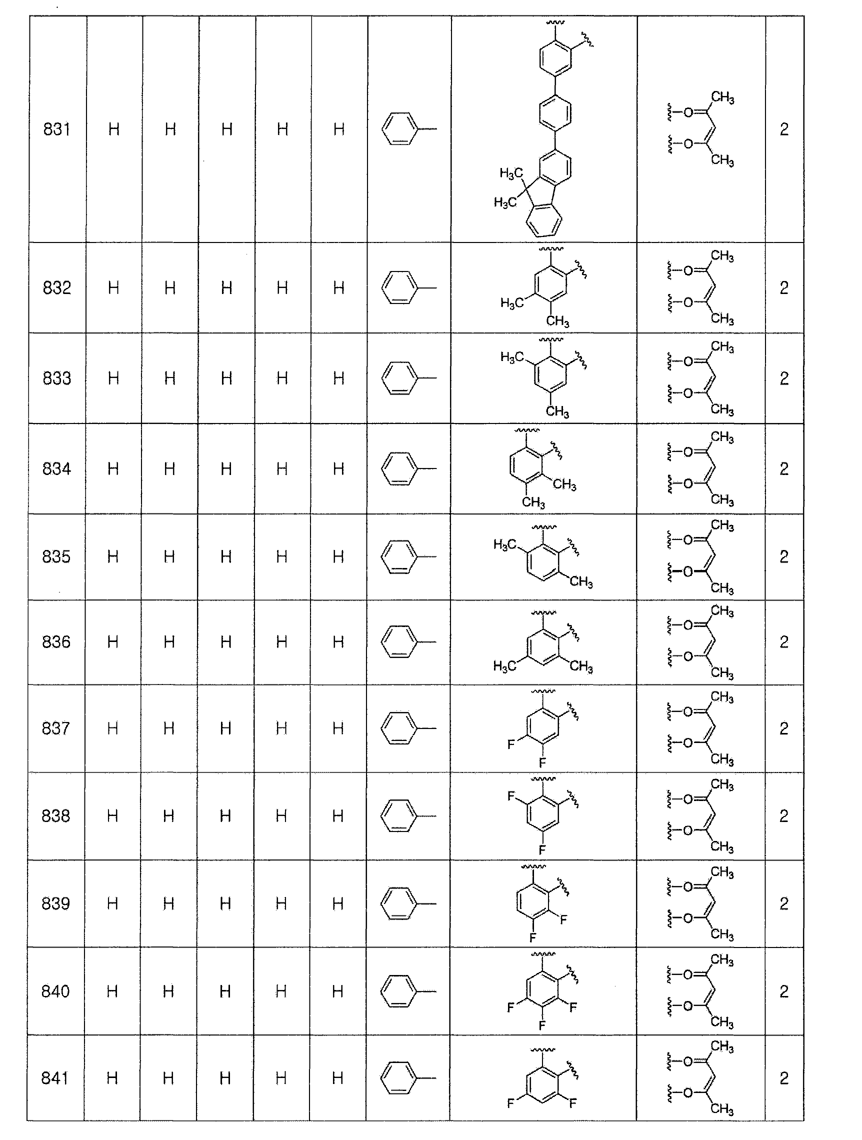

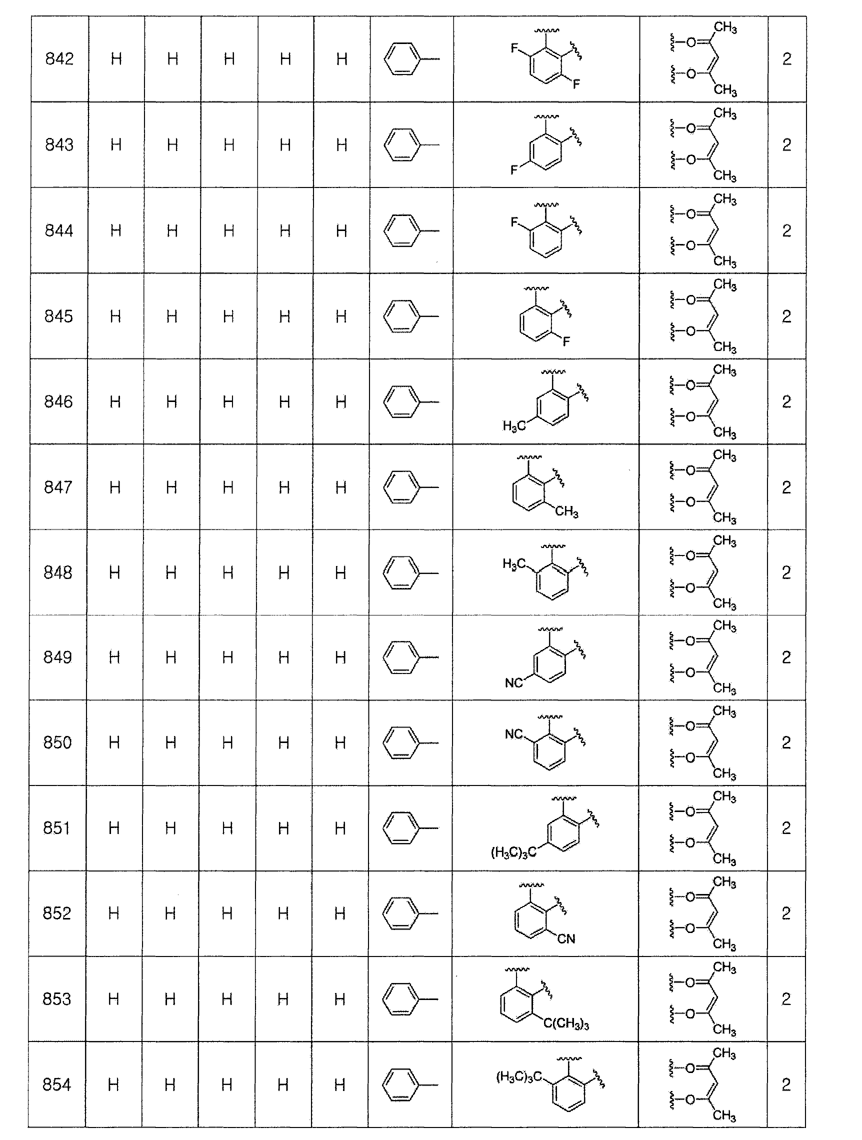

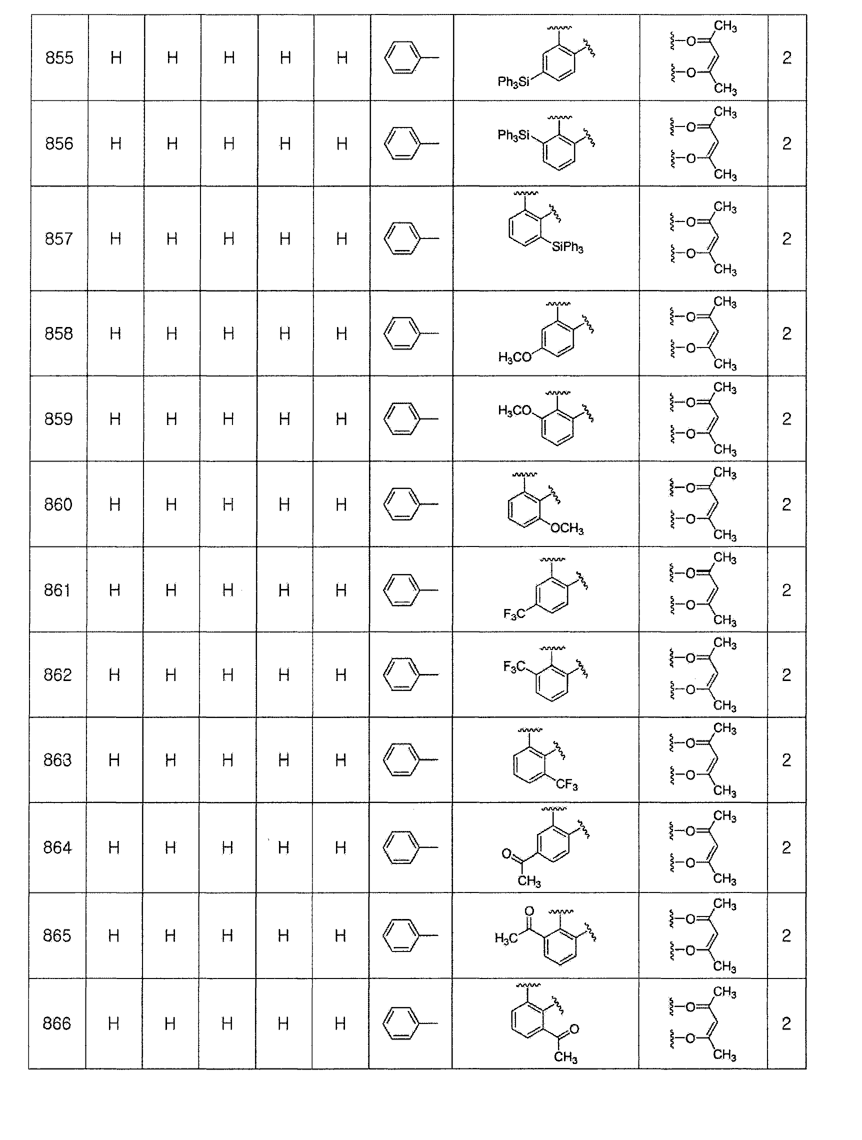

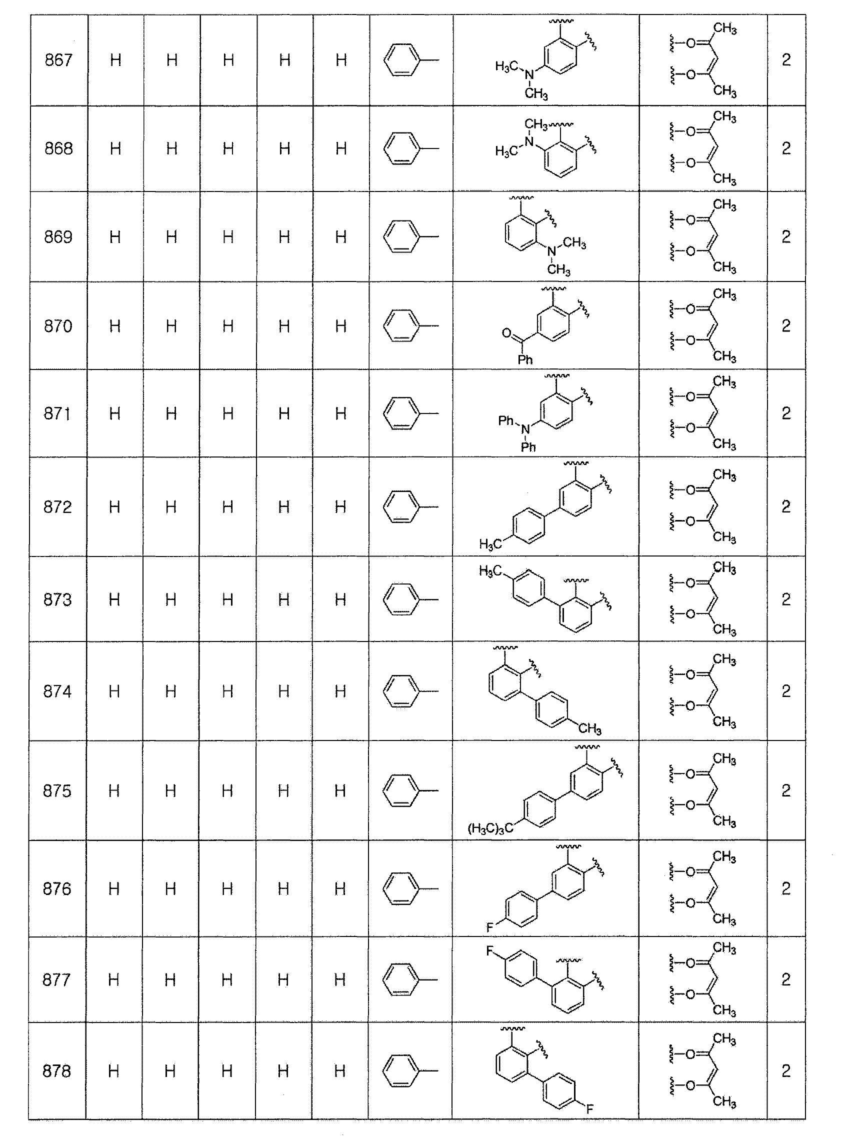

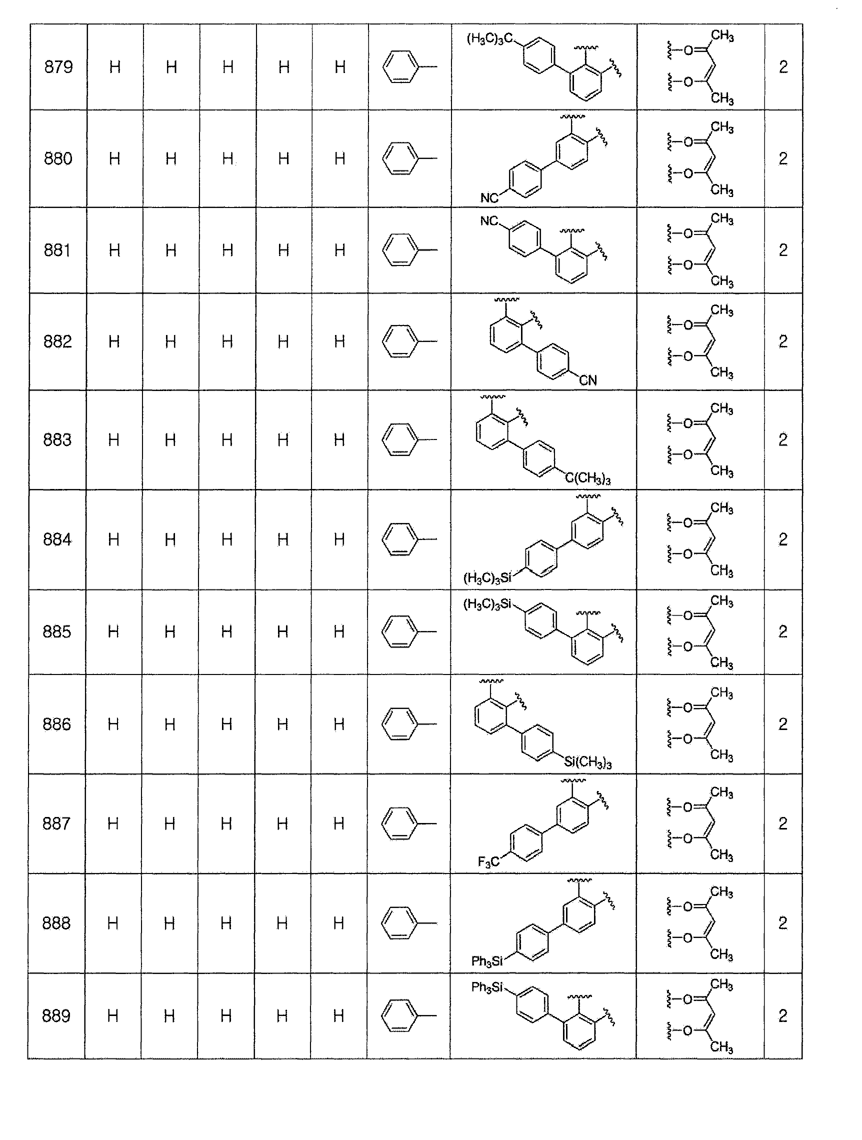

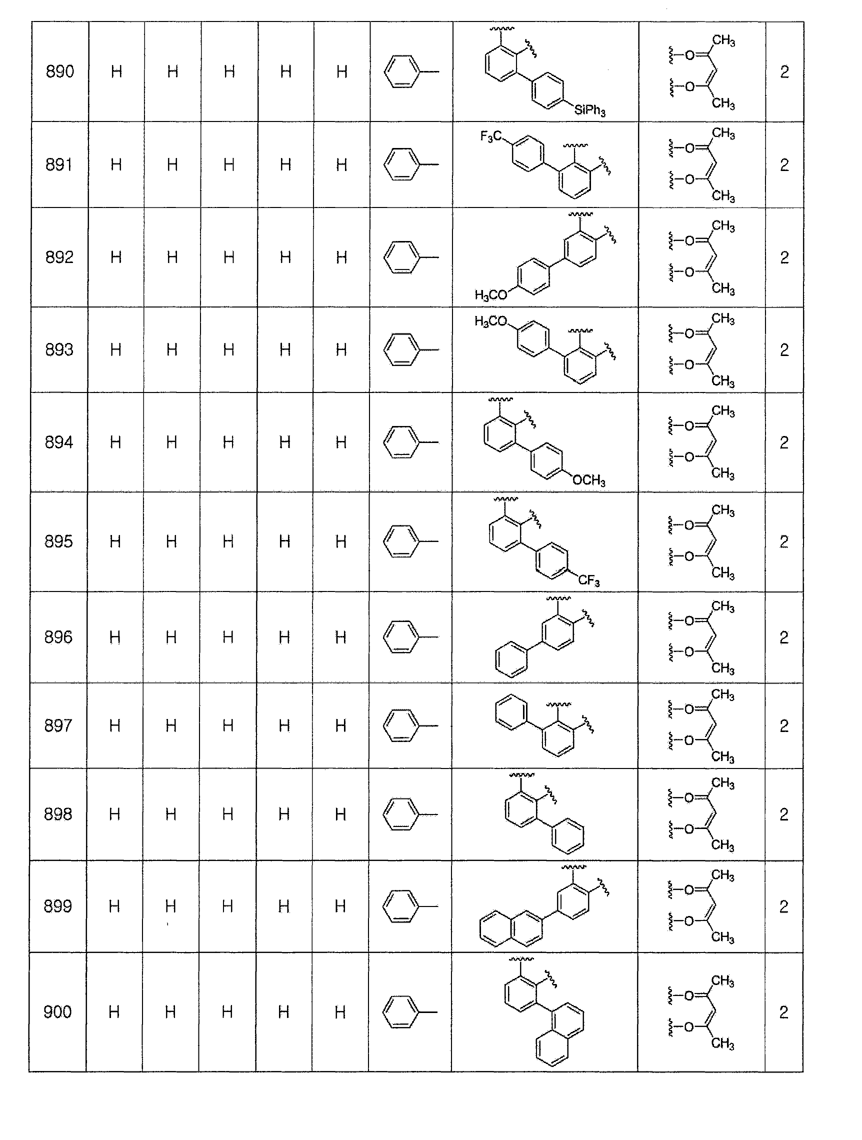

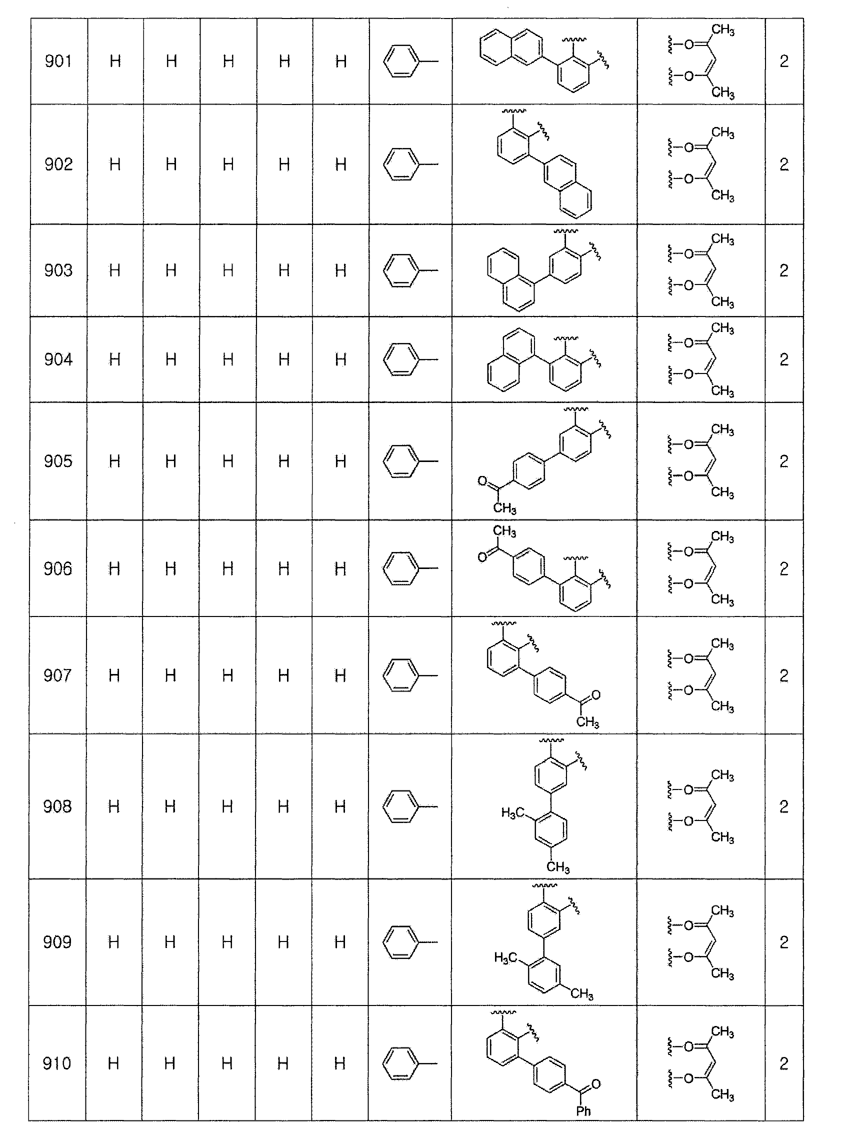

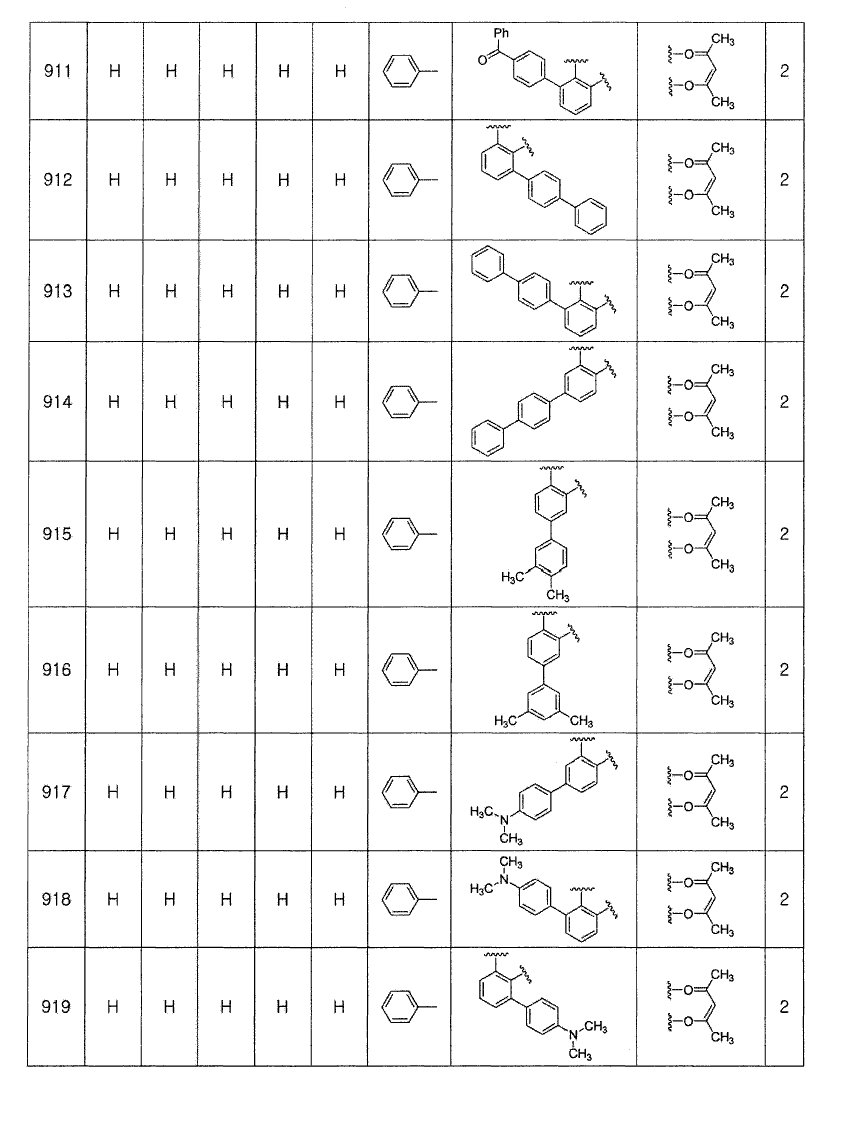

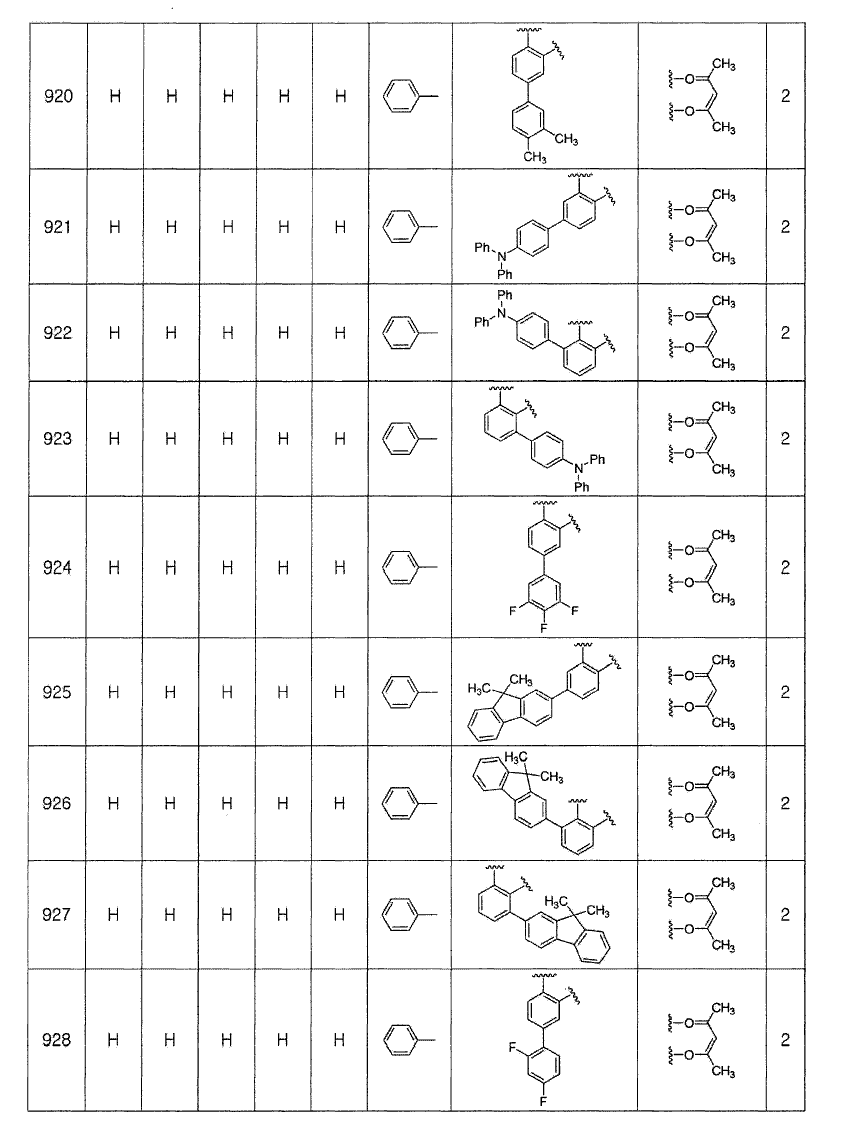

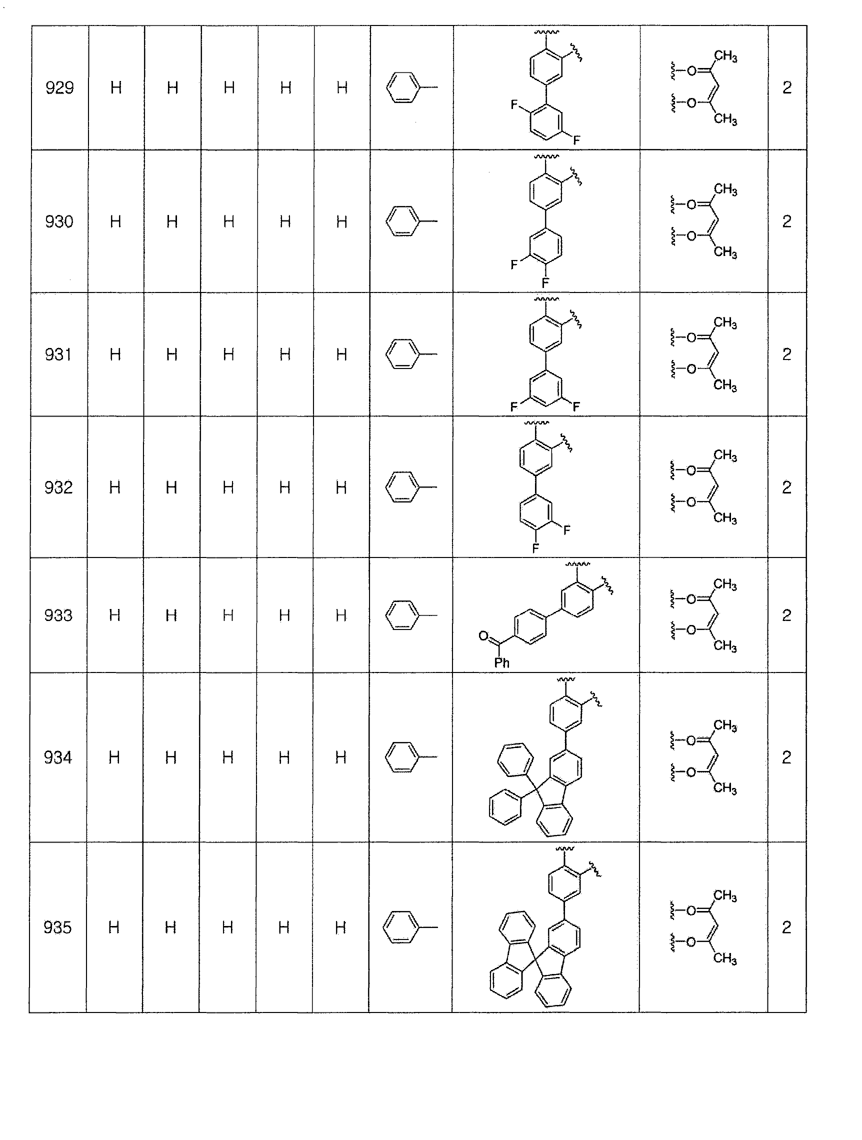

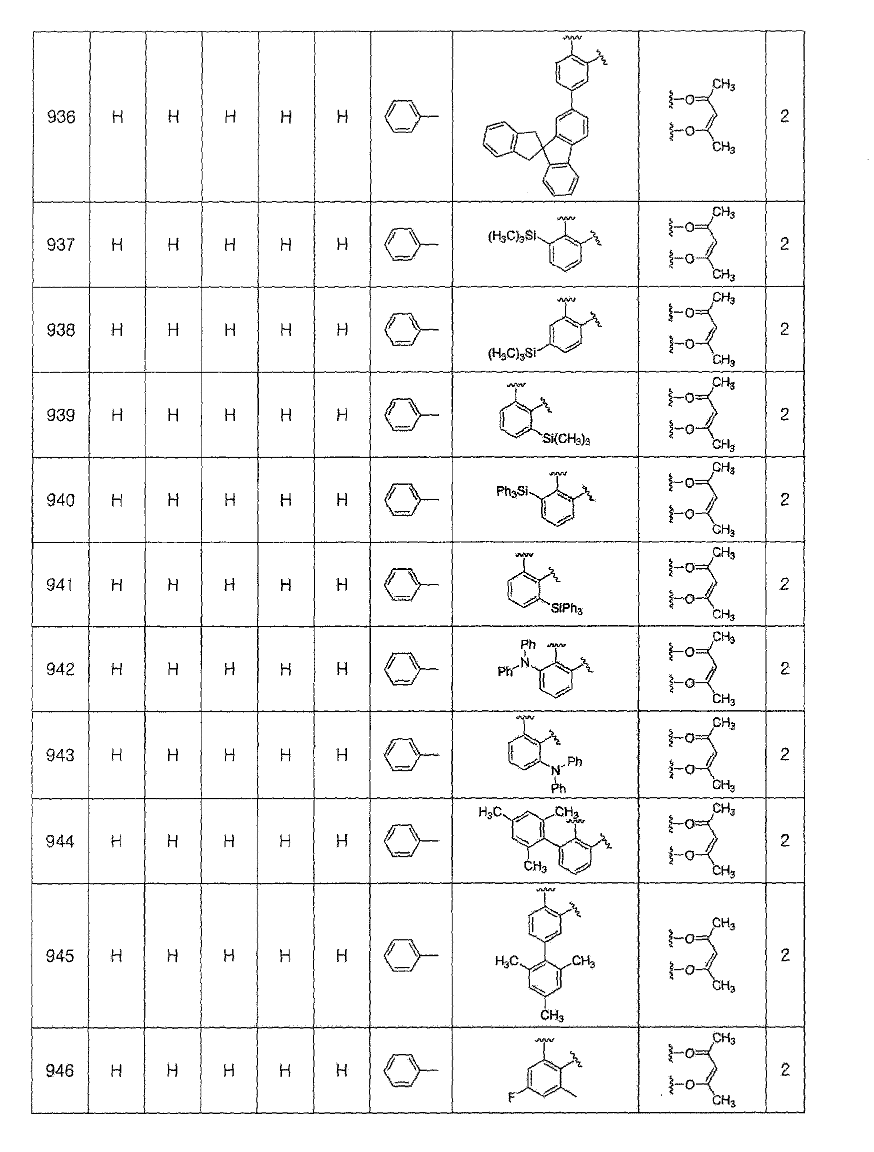

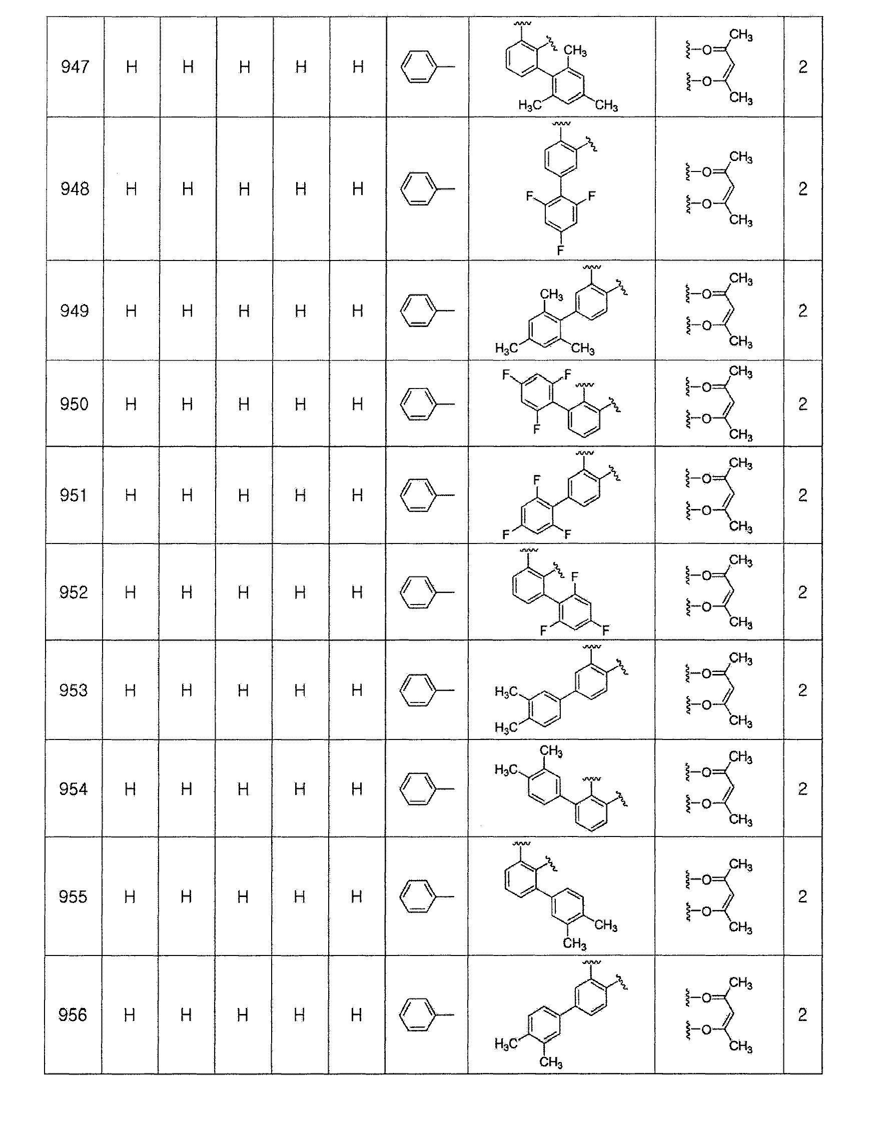

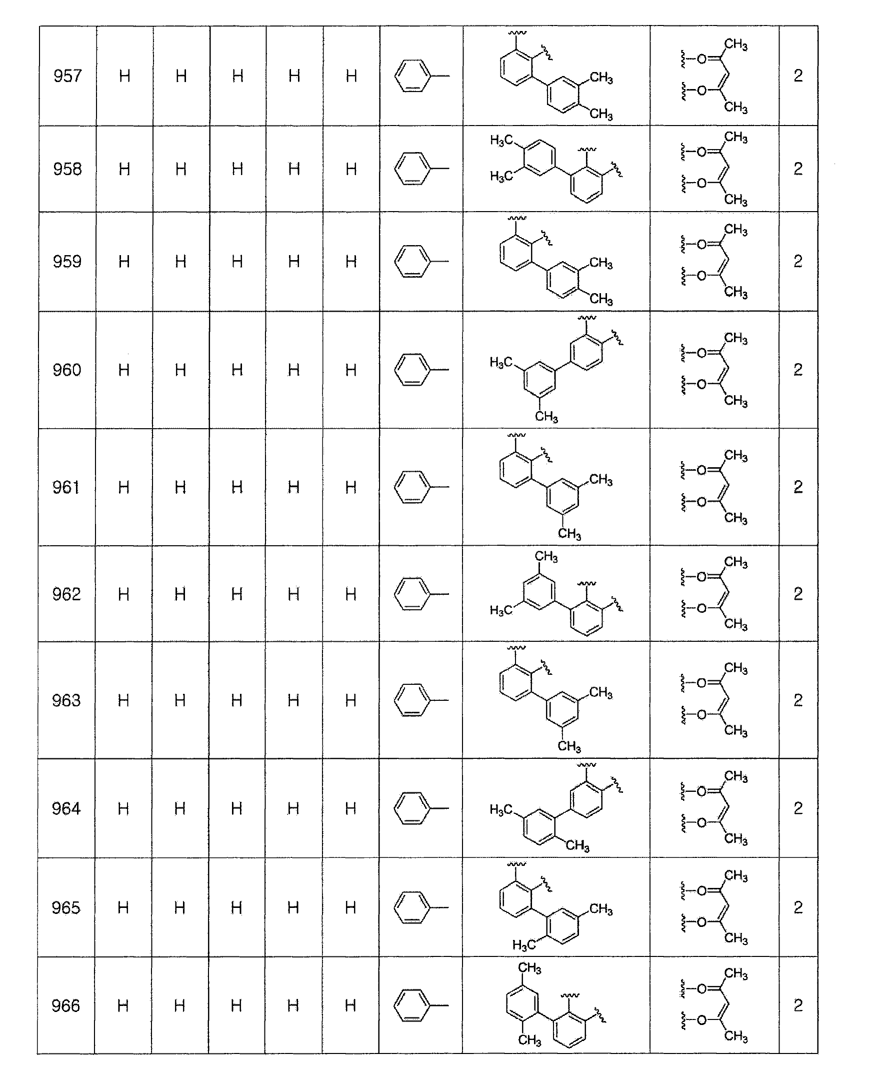

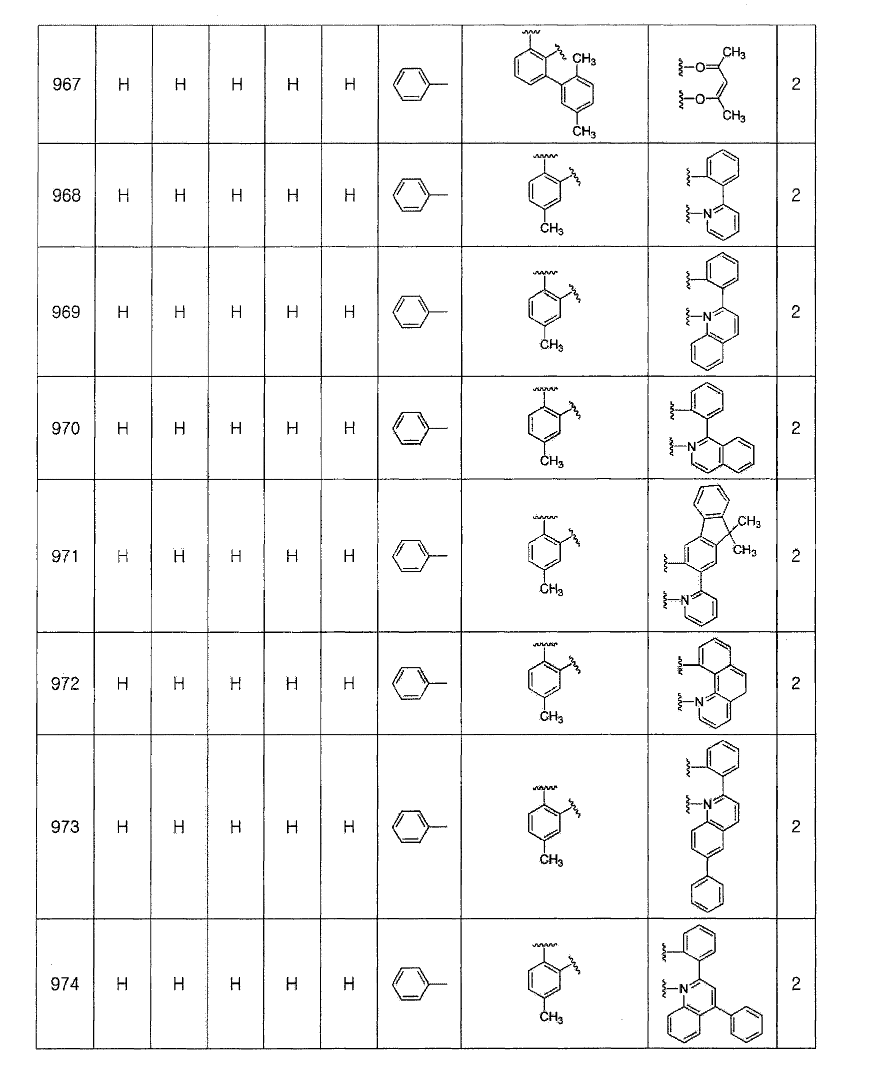

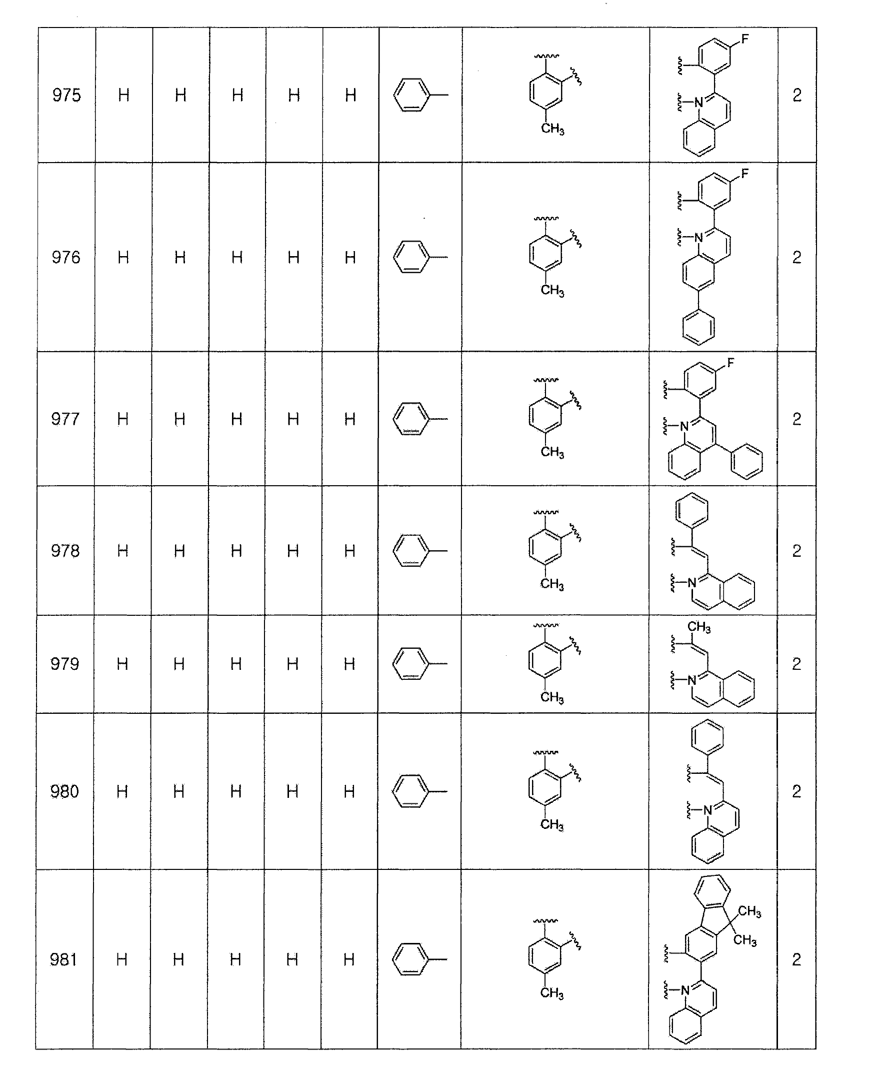

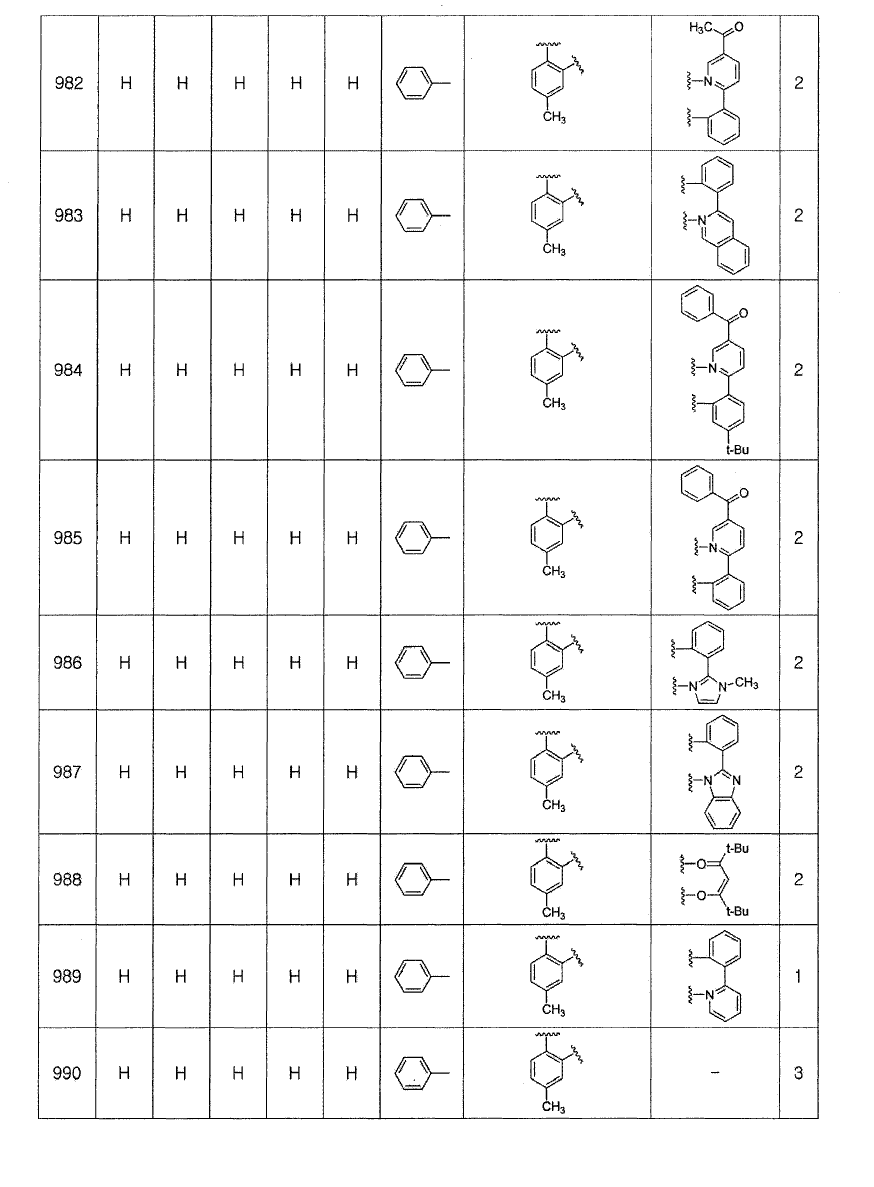

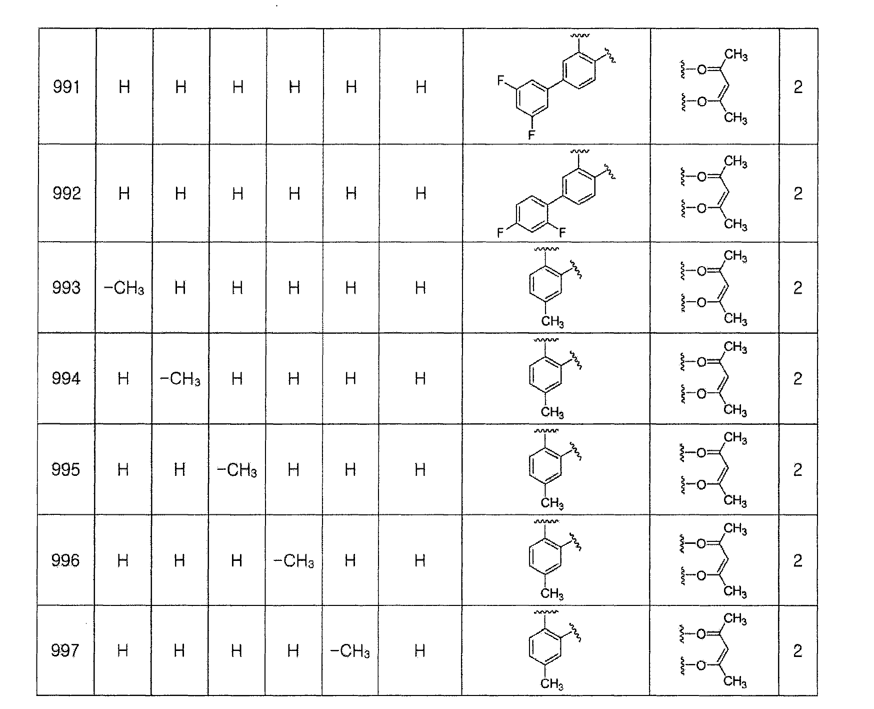

**Table 2**

| Compound No. | ¹H NMR(CDCl₃, 200 MHz) | MS/FAB | |
|---|---|---|---|
| | | found | calculated |
| 83 | δ = 8,2 (d, J=10.0 Hz, 2H), 8.1 (d, 2H), 7.7 (m, 2H), 7.6 (m, 4H), 7.5 (m, 2H), 7.4-7.48 (m, 12H), 7.32-7.35 (m, 8H). 7.2 (m, 2H). 5.7(s, 1H), 1.71 (s, 3H). 1.34 (m, 18H), 1.31(s, 3H) | 1115 | 1116.42 |
| 84 | δ = 8,2 (d, J=10.0 Hz, 2H), 8.1 (d, 2H), 7.7 (m, 2H), 7.6 (m, 4H), 7.4-7.5 (m, 14H), 7.32 (m, 4H). 7.22 (m, 2H). 7.03 (m, 4H), 5.7 (s, 1H), 1.71 (s, 3H). 1.31 (s, 3H) | 1039 | 1040.28 |
| 104 | δ = 8,2 (d, J=10.0 Hz, 2H), 8.1 (d, 2H), 7.7 (m, 2H), 7.6 (m, 4H), 7.5 (m, 2H), 7.4-7.48 (m, 12H), 7.32 (m, 8H). 7.22 (m, 4H). 5.7(s, 1H), 1.71 (s, 3H). 1.31 (s, 3H) | 1003 | 1004.29 |
| 107 | δ = 8,2 (d, J=10.0 Hz, 2H), 8.1 (d, 2H), 7.89 (d, 2H), 7.6-7.73 (m. 12H), 7.5-7.54 (m, 4H), 7.4-7.48 (m, 8H), 7.32 (m, 8H), 7.22 (m, 2H), 5.7(s, 1H), 1.71 (s, 3H). 1.31(s, 3H) | 1103 | 1104.32 |
| 133 | δ = 8,2 (d, J=10.0 Hz, 2H), 8.1 (d, 2H), 7.9 (d, 2H), 7.84 (d. 2H), 7.7-7.77 (m, 4H), 7.6 (m, 6H), 7.55 (m, 4H), 7.4-7.48 (m, 8H), 7.32-7.38 (m, 6H). 7.22-7.28 (m, 4H). 5.7(s, 1H), 1.71 (s, 3H). 1.67(m, 12H), 1.31(s, 3H) | 1235 | 1236.42 |
| 302 | δ = 8,2 (d, J=10.0 Hz, 2H), 8.1 (d, 2H), 7.7 (m, 2H), 7.6 (m, 4H), 7.4-7.5 (m, 14H), 7.32 (m, 4H). 7.22 (m, 2H). 7.03 (m, 4H), 5.7 (s, 1H), 1.71 (s, 3H). 1.31(s, 3H) | 1039 | 1040.26 |
| 698 | δ = 8,2 (d, J=10.0 Hz, 2H), 8.1 (d, 2H), 7.7 (m, 2H), 7.6 (m, 4H), 7.4-7.5 (m, 14H), 7.32-7.35 (m, 8H). 7.22 (m, 2H). 5.7 (s, 1H), 1.71 (s, 3H). 1.34 (m, 18H), 1.31(s, 3H) | 1115 | 1116.42 |
| 896 | δ = 8,2 (d, J=10.0 Hz, 2H), 8.1 (d, 2H), 7.7 (m, 2H), 7.6 (m, 4H), 7.4-7.54 (m, 22H), 7.32 (m, 8H). 7.22 (m, 4H). 5.7 (s, 1H), 1.71 (s, 3H), 1.31(s, 3H) | 1155 | 1156.36 |
| 991 | δ = 8,2 (d, J=10.0 Hz, 2H), 8.1 (d, 2H), 7.7 (m, 2H), 7.6 (m, 4H), 7.4-7.5 (m, 10H), 7.32 (m, 4H). 7.22 (m, 2H). 6.96 (m, 4H), 6.64 (m, 2H), 5.7 (s, 1H), 1.71 (s, 3H). 1.31(s, 3H) | 1075 | 1076.26 |
| 992 | δ = 8,2 (d, J=10.0 Hz, 2H), 8.1 (d, 2H), 7.7 (m, 2H), 7.6 (m, 4H), 7.4-7.5 (m, 12H), 7.32 (m, 4H). 7.22 (m, 2H). 6.74-6.80 (m, 4H), 5.7 (s, 1H), 1.71 (s, 3H). 1.31 (s, 3H) | 1075 | 1076.26 |

### [Example 1] Manufacture of an OLED (1)

An OLED device was manufactured by using an organic electroluminescent compound according to the invention.

First, a transparent electrode ITO thin film (15 Ω/□) (2) prepared from glass for OLED (produced by Samsung Corning) (1) was subjected to ultrasonic washing with trichloroethylene, acetone, ethanol and distilled water, sequentially, and stored in isopronanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

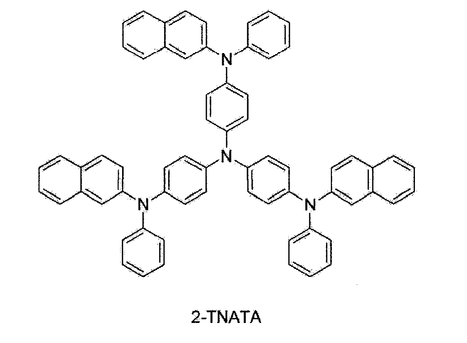

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

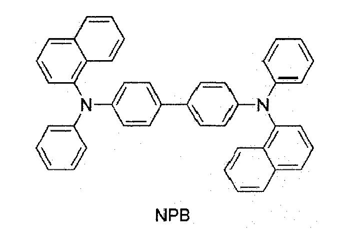

In another cell of said vacuum vapor-deposit device, charged was 4,4'-N,N'-dicarbazole-biphenyl (CBP) as an electroluminescent host material, and an organic electroluminescent compound (Compound 1) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 mol% on the basis of CBP.

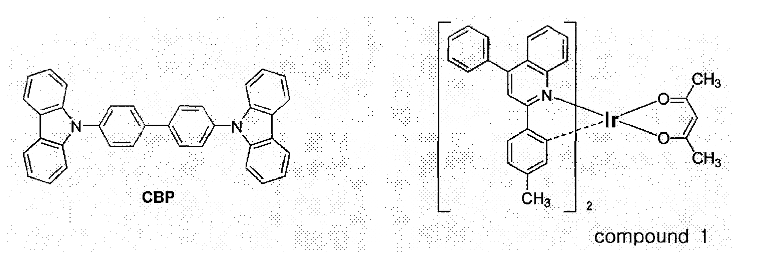

Then, on the electroluminescent layer, bis(2-methyl-8-quinolinato)(p-phenylphenolato)aluminum (III) (BAlq) was vapor-deposited as a hole blocking layer in a thickness of 10 nm in the same manner for NPB, tris(8-hydroxyquinoline)aluminum (III) (Alq) was vapor-deposited as an electron transport layer (6) in a thickness of 20 nm, and then lithium quinolate (Liq) was vapor-deposited as an electron injection layer (7) in a thickness of 1 to 2 nm. Thereafter, an Al cathode (8) was vapor-deposited in a thickness of 150 nm by using another vacuum vapor-deposit device to manufacture an OLED.

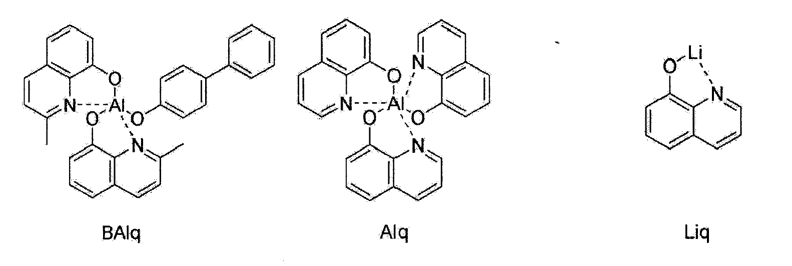

### [Example 2] Manufacture of an OLED (2)

An hole injection layer and a hole transport layer were formed according to the procedure of Example 1, and an electroluminescent layer was vapor-deposited as follows. In another cell of said vacuum vapor-deposit device, charged was H-40 as an electroluminescent host material, and an organic electroluminescent compound (Compound 780) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 mol% on the basis of the host. Then, a hole blocking layer, an electron transport layer and an electron injection layer were vapor-deposited according to the same procedure as in Example 1, and then Al cathode (8) was vapor-deposited in a thickness of 150 nm by using another vacuum vapor-deposit device to manufacture an OLED.

### [Example 3] Manufacture of an OLED (3)

A hole injection layer, a hole transport layer and an electroluminescent layer were formed according to the same procedure as in Example 2, and then an electron transport layer and an electron injection layer were vapor-deposited. Thereafter, Al cathode was vapor-deposited in a thickness of 150 nm by using another vacuum vapor-deposit device to manufacture an OLED.

In order to confirm the performance of the OLED's prepared according to Example 1 through Example 3, the luminous efficiency of the OLED's was measured at 10 mA/cm². Various properties are shown in Tables 3.

**Table 3**

| | Material | Host | Hole blocking layer | EL color | Operation voltage | Max. luminous efficiency (cd/A) |
|---|---|---|---|---|---|---|
| Ex. 1 | Compund 1 | CBP | BAlq | Red | 7.9 | 11.3 |
| | Compound 10 | CBP | BAlq | Red | 7.9 | 9.1 |
| | Compound 44 | CBP | BAlq | Red | 7.8 | 11.9 |
| | Compound 49 | CBP | BAlq | Red | 8.1 | 12.2 |
| | Compound 177 | CBP | BAlq | Red | 8.3 | 11.7 |
| | Compound 199 | CBP | BAlq | Red | 7.9 | 10.2 |
| | Compound 241 | CBP | BAlq | Red | 8.0 | 10.5 |
| | Compound 303 | CBP | BAlq | Red | 8.0 | 9.8 |
| | Compound 340 | CBP | BAlq | Red | 8.1 | 10.9 |
| | Compound 374 | CBP | BAlq | Red | 8.2 | 11.3 |
| | Compound 375 | CBP | BAlq | Red | 7.9 | 10.5 |
| | Compound 379 | CBP | BAlq | Red | 8.0 | 10.1 |
| | Compound 432 | CBP | BAlq | Red | 7.9 | 10.9 |
| | Compound 574 | CBP | BAlq | Red | 7.8 | 9.9 |
| | Compound 578 | CBP | BAlq | Red | 8.0 | 11.0 |
| | Compound 584 | CBP | BAlq | Red | 8.1 | 12.0 |
| | Compound 589 | CBP | BAlq | Red | 8.2 | 12.5 |
| | Compound 640 | CBP | BAlq | Red | 8.5 | 10.6 |
| | Compound 645 | CBP | BAlq | Red | 8.1 | 10.3 |
| | Compound 780 | CBP | BAlq | Red | 7.9 | 11.1 |
| | Compound 782 | CBP | BAlq | Red | 8.0 | 11.2 |
| | Compound 790 | CBP | BAlq | Red | 8.0 | 10.5 |
| | Compound 903 | CBP | BAlq | Red | 8.2 | 10.1 |
| Ex. 2 | Compound 10 | H-4 | BAlq | Red | 7.9 | 9.5 |
| | Compound 199 | H-2 | BAlq | Red | 7.9 | 10.3 |
| | Compound 375 | H-7 | BAlq | Red | 7.9 | 10.9 |
| | Compound 780 | H-40 | BAlq | Red | 7.8 | 11.1 |
| Ex. 3 | Compound 49 | H-8 | - | Red | 7.2 | 12.0 |
| | Compound 303 | H-12 | - | Red | 7.0 | 9.9 |
| | Compound 780 | H-40 | - | Red | 7.1 | 11.0 |
| | Compound 790 | H-64 | - | Red | 6.9 | 11.0 |

Compound (49), to which F was applied to the ligand, affected the HOMO level, and thus showed enhanced luminous efficiency, even though the color cooridinate was lowered as compared to the same before applying F. For Compounds (177), (584) and (589), 2-phenylquinoline, 2-styrylquinoline and phenyl(6-phenylpyridin-3-yl)methanone were incorporated, respectively, as a subsidiary ligand. They showed most excellent luminous efficiencies (11.7 cd/A, 12.0 cd/A and 12.5 cd/A, respectively) among the compounds according to the present invention. The compound to which ppy or 1-styrylquinoline was incorporated as a subsidiary ligand showed high luminous efficiency of 11 cd/A or more. Thus, the subsidiary ligands such as 2-phenylquinoline, 2-styrylquinoline, phenyl(6-phenylpyridin-3-yl)methanone, ppy and 1-styrylquinoline had a significant role to enhance the luminous efficiency of the compound.

With identical device structure, using the host according to the present invention instead of CBP did not provide significant change in efficiency, color coordinate and operation voltage. Thus it is anticipated that those hosts can be employed as a phosphorescent host, when being used with dopants according to the invention, instead of CBP as a conventional electroluminescent host. When the host according to the invention is employed without using a hole blocking layer, the device exhibits comparable or higher luminous efficiency as compared to that using conventional host, and provides decreased power consumption of the OLED due to lowered operation voltage by about 0.8 V ∼ 1.2 V. If the invention is applied to mass production of OLEDs, the time for mass production can be also reduced to give great benefit on its commercialization.

## Claims

1. An organic electroluminescent compound represented by Chemical Formula (1): 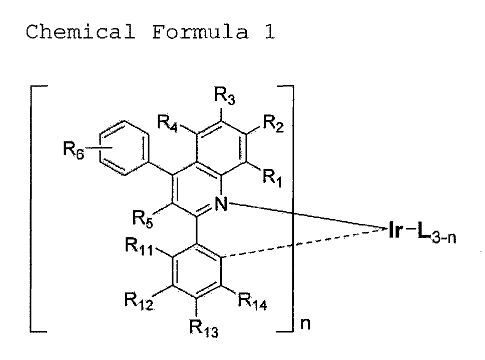 wherein, L is an organic ligand;
R₁ through R₅ independently represent hydrogen, (C₁-C₂₀)alkyl, (C₁-C₂₀) alkoxy, (C₃-C₁₂) cycloalkyl, halogen, tri (C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri (C₁-C₂₀) alkylsilyl, tri(C₆-C₂₀)arylsilyl, (C₁-C₂₀)alkoxy, (C₁-C₂₀) alkylcarbonyl, (C₆-C₂₀)arylcarbonyl, di (C₁-C₂₀)alkylamino, di (C₆-C₂₀) arylamino, phenyl, naphthyl, anthryl, fluorenyl, spirobifluorenyl or 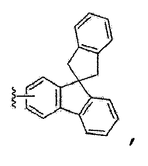 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri (C₆-C₂₀)arylsilyl, (C₁-C₂₀)alkylcarbonyl, (C₆-C₂₀)arylcarbonyl, di (C₁-C₂₀)alkylamino, di (C₆-C₂₀)arylamino and (C₆-C₂₀)aryl;
provided that R₁₁ through R₁₄ cannot be hydrogen all at the same time; and
n is an integer from 1 to 3.

2. The organic electroluminescent compound according to claim 1, which is selected from the compound represented by one of Chemical Formulas (2) to (5): 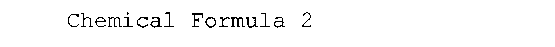 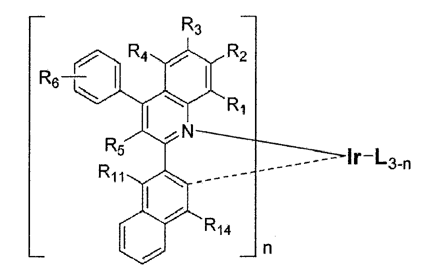 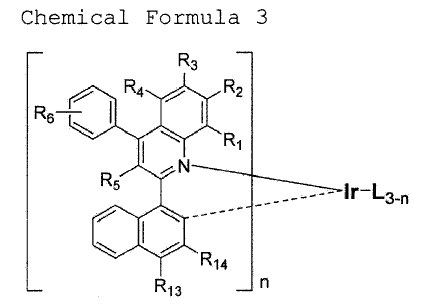 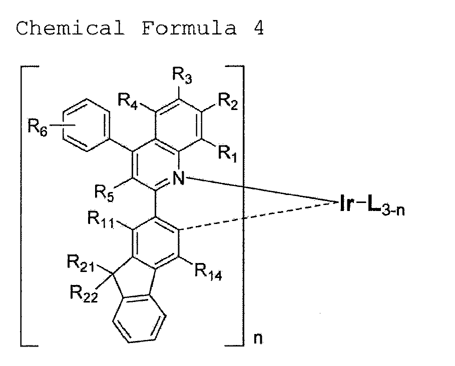 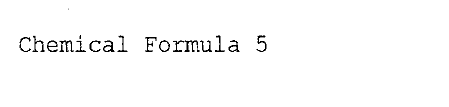 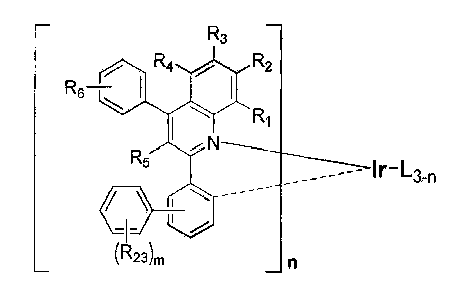 wherein, L, R₁, R₂, R₃, R₄, R₅, R₆, R₁₁, R₁₃, R₁₄ and n are defined as in Chemical Formula (1) of claim 1;
R₂₁ and R₂₂ independently represent hydrogen, (C₁-C₂₀)alkyl, (C₆-C₂₀)aryl, or R₂₁ and R₂₂ may be linked each other via (C₃-C₁₂)alkylene or (C₃-C₁₂)alkenylene with or without a fused ring to form an alicyclic ring, or a monocyclic or polycyclic aromatic ring;
R₂₃ represents (C₁-C₂₀) alkyl, halogen, cyano, tri(C₁-C₂₀)alkylsilyl, tri (C₆-C₂₀)arylsilyl, (C₁-C₂₀)alkoxy, (C₁-C₂₀)alkylcarbonyl, (C₆-C₂₀)arylcarbonyl, phenyl, di (C₁-C₂₀)alkylamino, di(C₆-C₂₀)arylamino, naphthyl, 9,9-di(C₁-C₂₀)alkylfluorenyl or 9,9-di(C₆-C₂₀)arylfluorenyl; and
m is an integer from 1 to 5.

3. The organic electroluminescent compound according to claim 1, wherein the ligand (L) has a structure represented by one of the following chemical formulas: 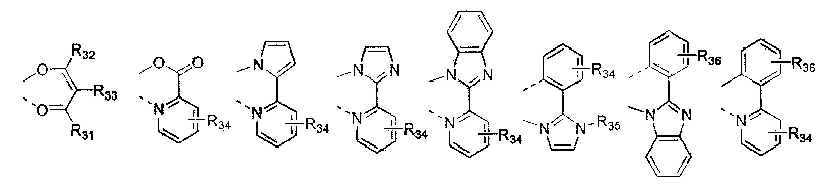 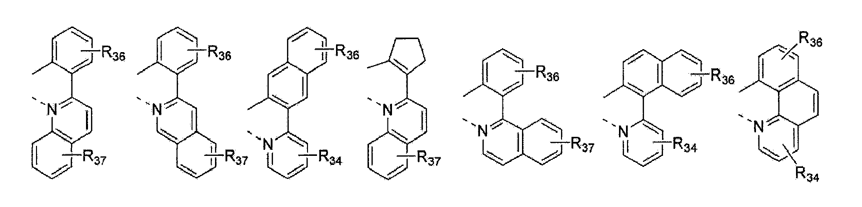 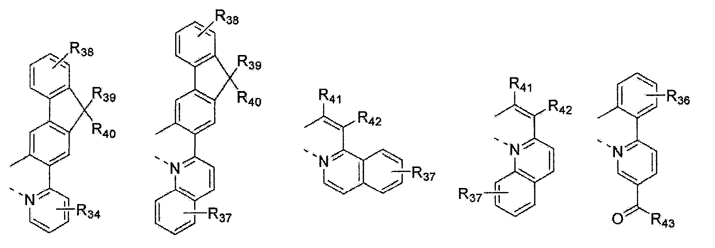 wherein, R₃₁ and R₃₂ independently represent hydrogen, (C₁-C₂₀)alkyl with or without halogen substituent(s), phenyl with or without (C₁-C₂₀)alkyl substituent(s), or halogen;
R₃₃ through R₃₈ independently represent hydrogen, (C₁-C₂₀)alkyl, phenyl with or without (C₁-C₂₀)alkyl substituent(s), tri(C₁-C₂₀)alkylsilyl or halogen;
R₃₉ through R₄₂ independently represent hydrogen, (C₁-C₂₀)alkyl or, phenyl with or without (C₁-C₂₀)alkyl substituent(s); and
R₄₃ represents (C₁-C₂₀)alkyl, phenyl with or without (C₁-C₂₀)alkyl, or halogen.

4. An organic electroluminescent device comprising
a first electrode;
a second electrode;
at least one organic layer(s) interposed between the first electrode and the second electrode;
wherein the organic layer comprises an electroluminescent region, which comprises one or more compound(s) An organic electroluminescent compound represented by Chemical Formula (1) : 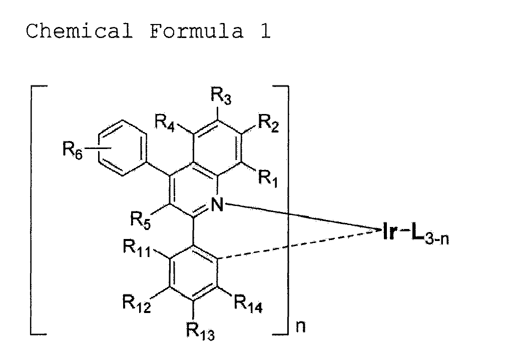 wherein, L is an organic ligand;
R₁ through R₅ independently represent hydrogen, (C₁-C₂₀)alkyl, (C₁-C₂₀)alkoxy, (C₃-C₁₂) cycloalkyl, halogen, tri(C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri(C₁-C₂₀)alkylsilyl, tri(C₆-C₂₀)arylsilyl, (C₁-C₂₀)alkoxy, (C₁-C₂₀)alkylcarbonyl, (C₆-C₂₀)arylcarbonyl, di (C₁-C₂₀)alkylamino, di (C₆-C₂₀)arylamino, phenyl, naphthyl, anthryl, fluorenyl, spirobifluorenyl or 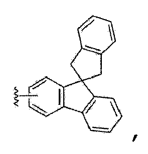 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent (s), (C₁-C₂₀)alkoxy, halogen, tri(C₁-C₂₀)alkylsilyl, tri (C₆-C₂₀)arylsilyl, (C₁-C₂₀)alkylcarbonyl, (C₆-C₂₀)arylcarbonyl, di (C₁-C₂₀)alkylamino, di (C₆-C₂₀)arylamino and (C₆-C₂₀)aryl;
provided that R₁₁ through R₁₄ cannot be hydrogen all at the same time; and
n is an integer from 1 to 3; and one or more host(s) selected from 1,3,5-tricarbazolylbenzene, polyvinylcarbazole, m-biscarbazolylphenyl, 4,4',4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane and compounds represented by one of Chemical Formulas (6) to (9). 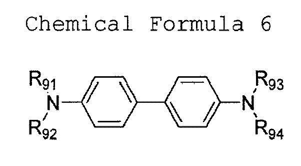 In Chemical Formula (6), R₉₁ through R₉₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl. 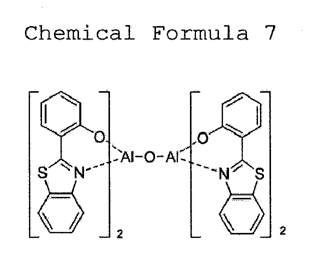 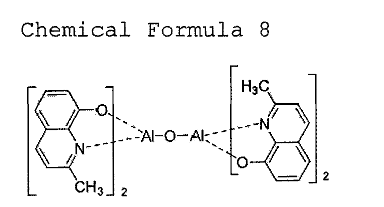 Chemical Formula 9 L¹L²M(Q)_{y}
wherein, the ligands, L¹ and L² independently represent one of the following structures: 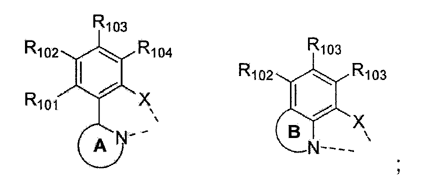 M is a bivalent or trivalent metal;
y is 0 when M is a bivalent metal, while y is 1 when M is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C1-C60)alkyl, phenyl or naphthyl with or without (C1-C60)alkyl substituent(s);
R₁₀₁ through R₁₀₄ independently represent hydrogen, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of ring A and R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

5. The organic electroluminescent device according to claim 4, wherein the organic layer comprises one or more compound(s) selected from a group consisting of arylamine compounds and styrylarylamine compounds, or one or more metal(s) selected from a group consisting of organic metals of Group 1, Group 2, 4^{th} period and 5^{th} period transition metals, lanthanide metals and d-transition elements.

6. The organic electroluminescent device according to claim 4, further comprising compounds having the electroluminescent peak with wavelength of blue and green at the same time.

7. The organic electroluminescent device according to claim 4, wherein the organic layer comprises an electroluminescent layer and a charge generating layer.

8. The organic electroluminescent device according to claim 4, wherein a mixed region of reductive dopant and organic substance, or a mixed region of oxidative dopant and organic substance is placed on the inner surface of one or both electrode(s) among the pair of electrodes.

9. An organic solar cell which comprises an organic electroluminescent compound An organic electroluminescent compound represented by Chemical Formula (1): 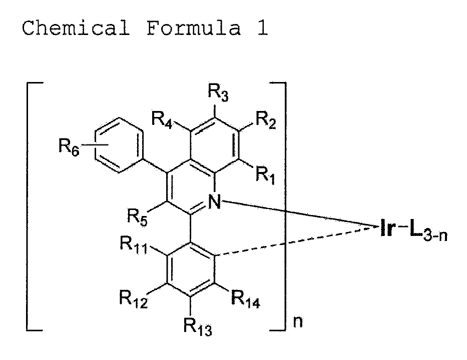 wherein, L is an organic ligand;
R₁ through R₅ independently represent hydrogen, (C₁-C₂₀)alkyl, (C₁-C₂₀)alkoxy, (C₃-C₁₂)cycloalkyl, halogen, tri(C₁-C₂₀)alkylsilyl or tri(C₆-C₂₀)arylsilyl;
R₆ represents hydrogen, (C₁-C₂₀)alkyl, halogen or (C₆-C₂₀)aryl;
R₁₁ through R₁₄ independently represent hydrogen, (C₁-C₂₀)alkyl, halogen, cyano, tri (C₁-C₂₀)alkylsilyl, tri (C₆-C₂₀)arylsilyl, (C₁-C₂₀)alkoxy, (C₁-C₂₀)alkylcarbonyl, (C₆-C₂₀)arylcarbonyl, di(C₁-C₂₀)alkylamino, di(C₆-C₂₀)arylamino, phenyl, naphthyl, anthryl, fluorenyl, spirobifluorenyl or 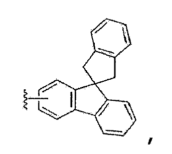 or each of R₁₁ through R₁₄ may be linked to another adjacent group from R₁₁ through R₁₄ via (C₃-C₁₂)alkylene or (C₃-C₁₂)alkenylene with or without a fused ring to form an alicyclic ring, or a monocyclic or polycyclic aromatic ring;
the alkyl, phenyl, naphthyl, anthryl, fluorenyl of R₁₁ through R₁₄, and the alicyclic ring, or the monocyclic or polycyclic aromatic ring formed therefrom by linkage via (C₃-C₁₂)alkylene or (C₃-C₁₂)alkenylene with or without a fused ring may be further substituted by one or more substituent(s) selected from (C₁-C₂₀)alkyl with or without halogen substituent(s), (C₁-C₂₀)alkoxy, halogen, tri(C₁-C₂₀)alkylsilyl, tri (C₆-C₂₀)arylsilyl, (C₁-C₂₀)alkylcarbonyl, (C₆-C₂₀)arylcarbonyl, di (C₁-C₂₀)alkylamino, di (C₆-C₂₀)arylamino and (C₆-C₂₀)aryl;
provided that R₁₁ through R₁₄ cannot be hydrogen all at the same time; and
n is an integer from 1 to 3.
